(19) Europäisches Patentamt / European Patent Office / Office européen des brevets

(11) **EP 2 023 412 A1**

(12) **EUROPEAN PATENT APPLICATION**
published in accordance with Art. 153(4) EPC

(43) Date of publication:
**11.02.2009 Bulletin 2009/07**

(51) Int Cl.:
**H01L 33/00** *(2006.01)*     **H01L 21/3065** *(2006.01)*

(21) Application number: **07742711.0**

(22) Date of filing: **30.04.2007**

(86) International application number:
**PCT/JP2007/059276**

(87) International publication number:
**WO 2007/126094 (08.11.2007 Gazette 2007/45)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **02.05.2006 JP 2006128611**
**02.05.2006 JP 2006128612**
**02.05.2006 JP 2006128613**
**09.05.2006 JP 2006130872**
**09.05.2006 JP 2006130873**
**09.05.2006 JP 2006130874**

(71) Applicant: **Mitsubishi Chemical Corporation**
**Minato-ku**
**Tokyo 108-0014 (JP)**

(72) Inventor: **HORIE, Hideyoshi**
**Ushiku-shi, Ibaraki 300-1295 (JP)**

(74) Representative: **Luderschmidt, Schüler & Partner**
**Patentanwälte**
**John-F.-Kennedy-Strasse 4**
**65189 Wiesbaden (DE)**

(54) **SEMICONDUCTOR LIGHT-EMITTING DEVICE**

(57) An etching process of the present invention has the steps of forming a metal-fluoride layer at least as a part of an etching mask 3 formed over a semiconductor layer 2 at a temperature of 150 ° C or higher; patterning this metal-fluoride layer; and etching the semiconductor layer using the patterned metal-fluoride layer 3 as a mask. Using this etching method, even an etching-resistant semiconductor layer such as a Group III-V nitride semiconductor can be easily etched by a relatively simpler process.

FIG. 1-1A

**Description**

Technical Field

The present invention relates to a compound semiconductor light-emitting-element, particularly a light-emitting diode (LED) having a GaN material. As used herein, the term "light-emitting diode" or "LED" encompasses light-emitting-elements in general which include a laser diode and a superluminescent diode and the like.

Background Art

Electron devices and light-emitting devices having a Group III-V compound semiconductor are well-known. In particular, there have been practically used as a light-emitting device an AlGaAs or AlGaInP material formed on a GaAs substrate for red luminescence and a GaAsP material formed on a GaP substrate for orange or yellow luminescence. An infrared light-emitting device using an InGaAsP material on an InP substrate is also known.

As the types of these devices, a light-emitting diode utilizing spontaneous emissive light (light-emitting diode: LED), a laser diode having an optical feedback function for deriving an induced emissive light (laser diode: LD) and a semiconductor laser are known. These devices have been used as, for example, a display device, a communication device, a light-source device for high-density optical recording, a device for high-precision optical processing and a medical device.

Since 1990s, as results of attempts for research and development of an $In_xAl_yGa_{(1-x-y)}N$ Group III-V compound semiconductor ($0 \le x \le 1$, $0 \le y \le 1$, $0 \le x+y \le 1$) containing nitrogen as a Group V element, the emission efficiency of the devices using the same has been significantly improved, and blue and green LEDs with high efficiency have been realized. Subsequent research and development have led to LEDs with high efficiency even in the ultraviolet region and recently blue LEDs have been marketed.

By integrating a phosphor with an ultraviolet or blue LED as an excitation light source, a white LED can be obtained. Since a white LED may be utilized as a next-generation lighting device, improvement in output and efficiency in an ultraviolet or blue LED to be an excitation light source has considerably higher industrial significance. At present, intense attempts are made for improving efficiency and output in a blue or ultraviolet in the light of applications in LED lighting.

For improving an output in an element, that is, improvement of the total radiation flux, increase of an element size and ensuring resistance to a large input power are essential. A known structure effective for improving an output and efficiency of a LED is a flip-chip mount structure. In this structure, a predetermined semiconductor layer is deposited on a sapphire substrate, an n-side electrode and a p-side electrode for current injection are formed on the side opposite to the substrate and the substrate side is a main light-extraction direction. Thus, a light from the light-emitting-element is not blocked and an electrode can be used as a light-reflecting surface, resulting in improvement in light-extraction efficiency.

However, since in a flip chip structure, a pair of the p- and the n-side electrodes are formed in the same side, it is necessary to carefully avoid short circuit between the p-side electrode and the n-side electrode and between these electrodes and the p-type or n-type semiconductor layer during a process for mounting the element on a submount (a substrate for interconnection or heat dissipation) by soldering. Thus, there have been suggested, for example, a variety of insulation-ensuring structures.

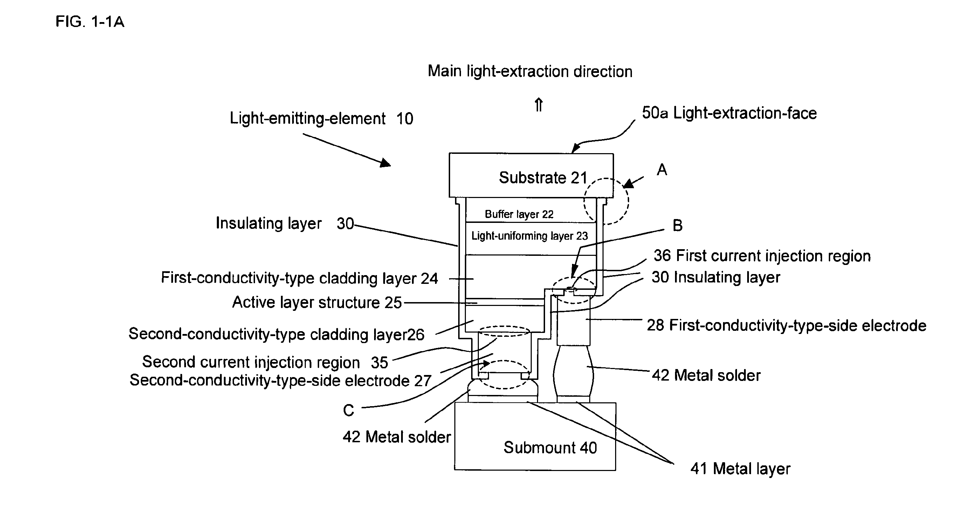

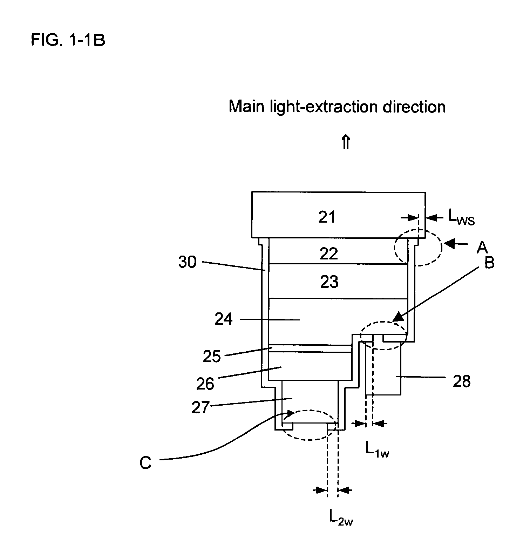

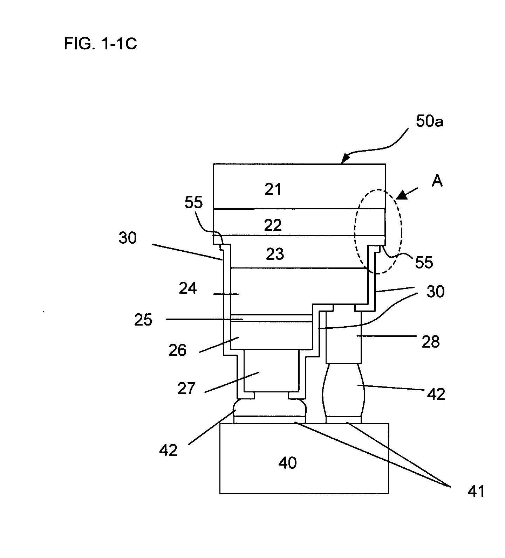

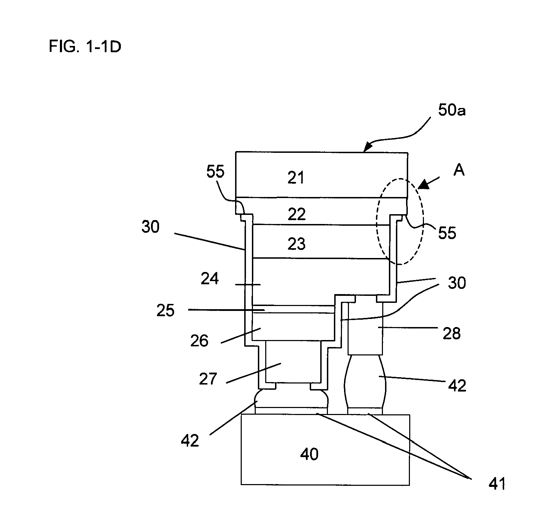

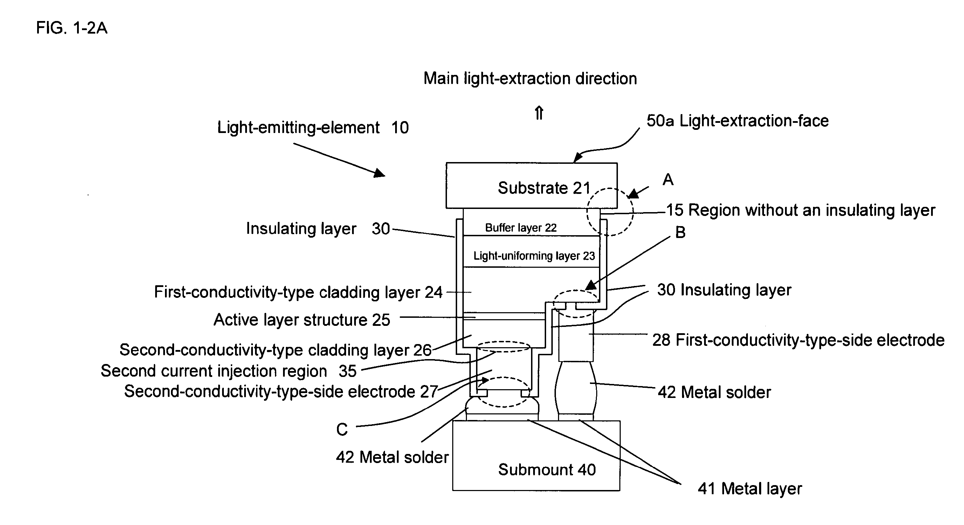

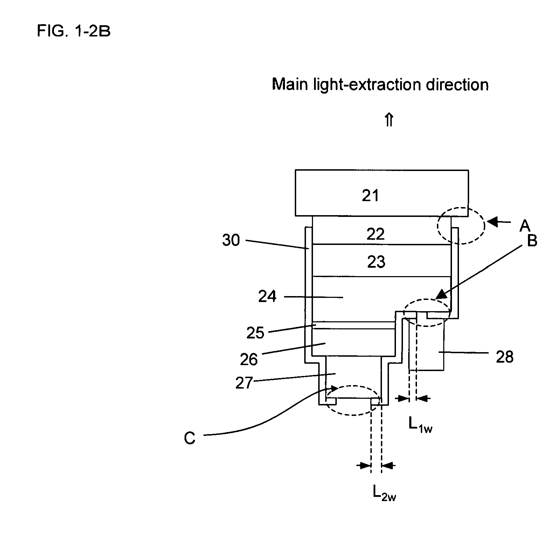

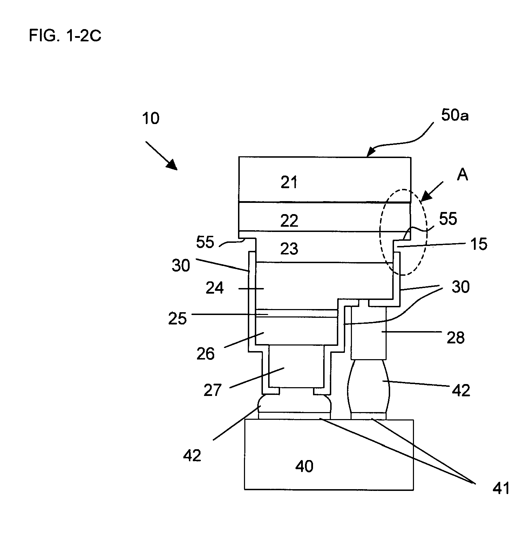

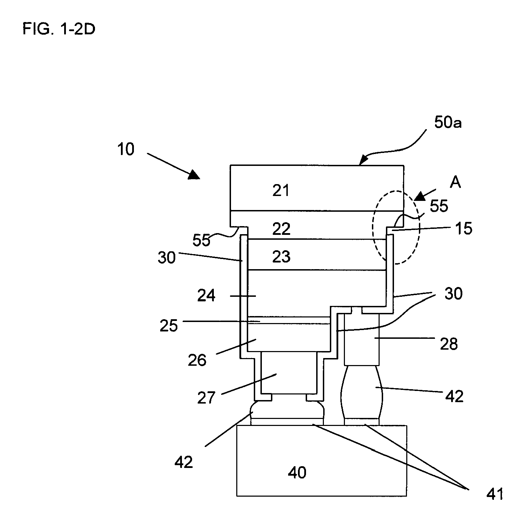

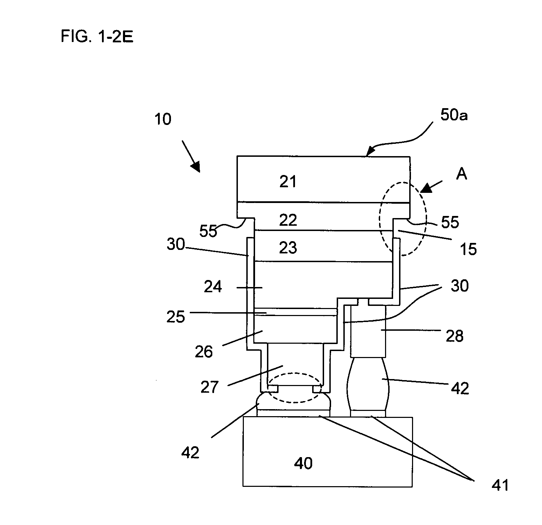

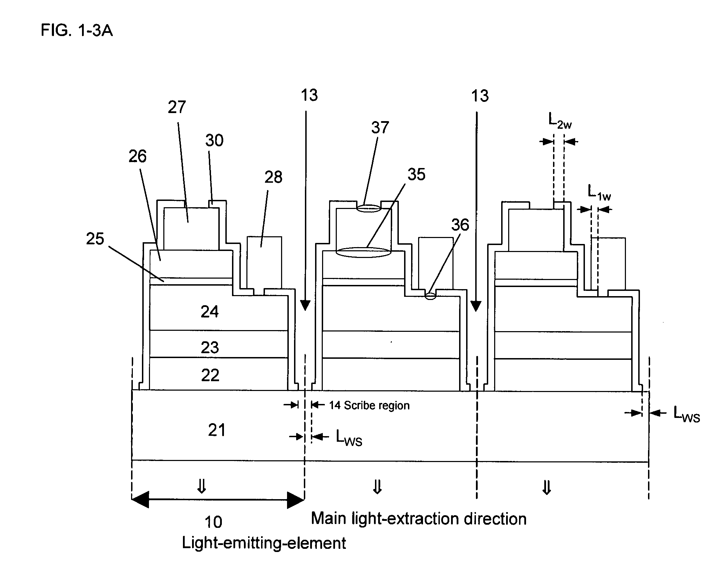

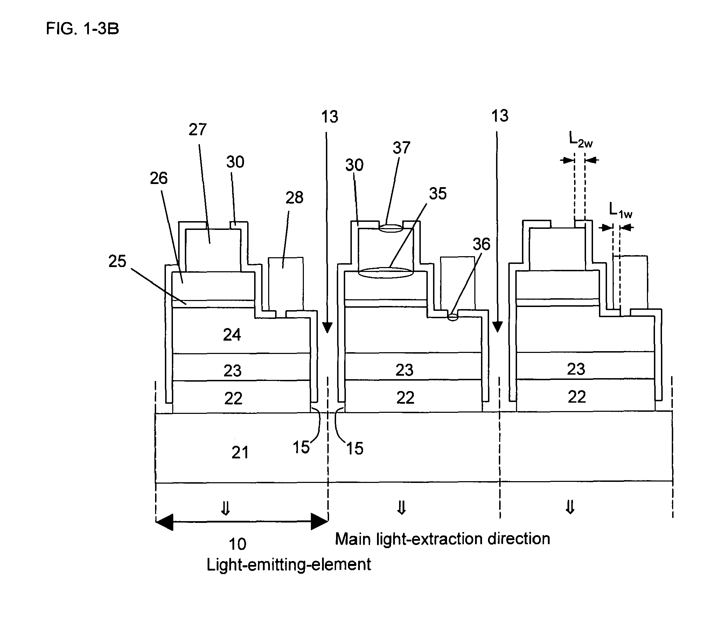

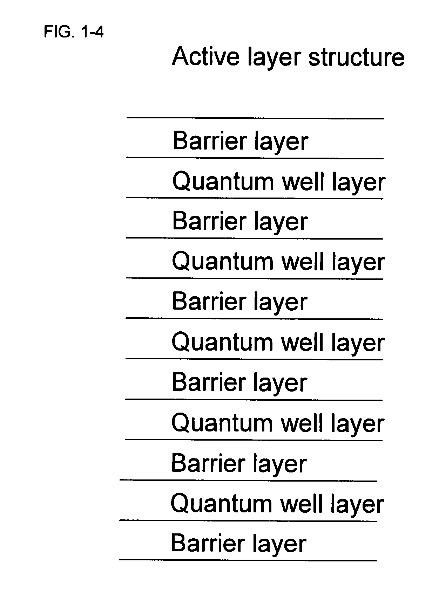

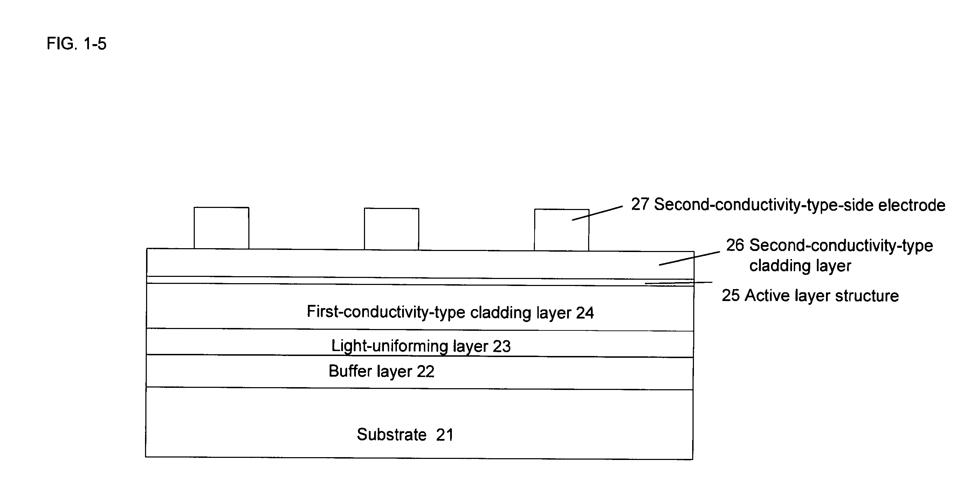

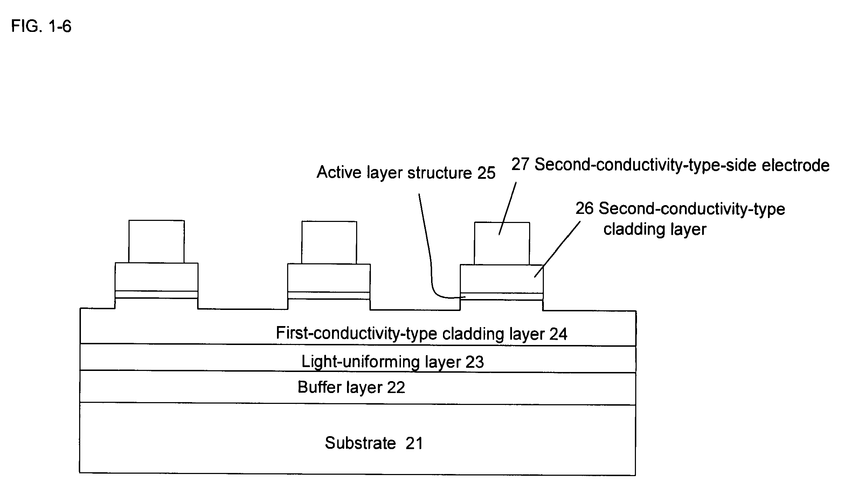

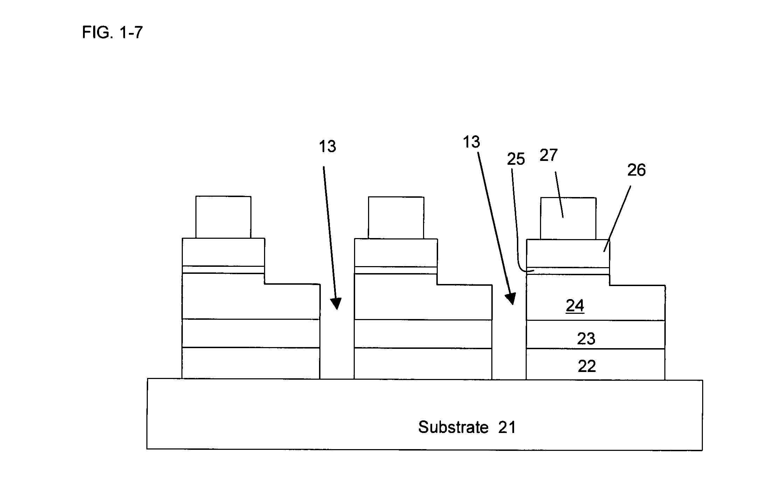

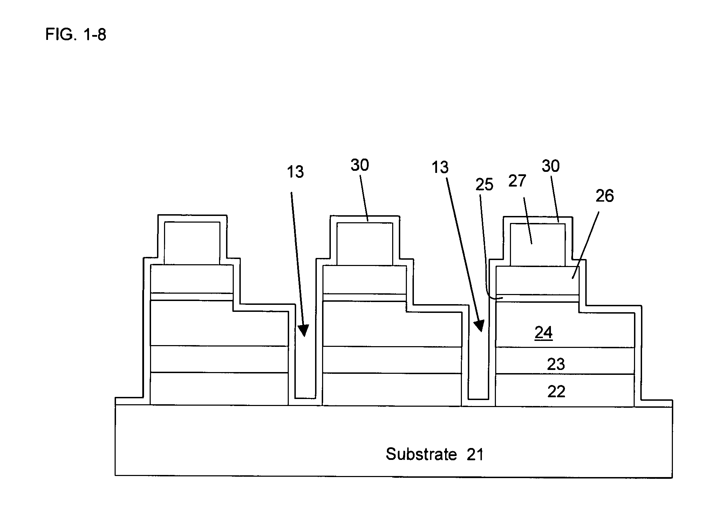

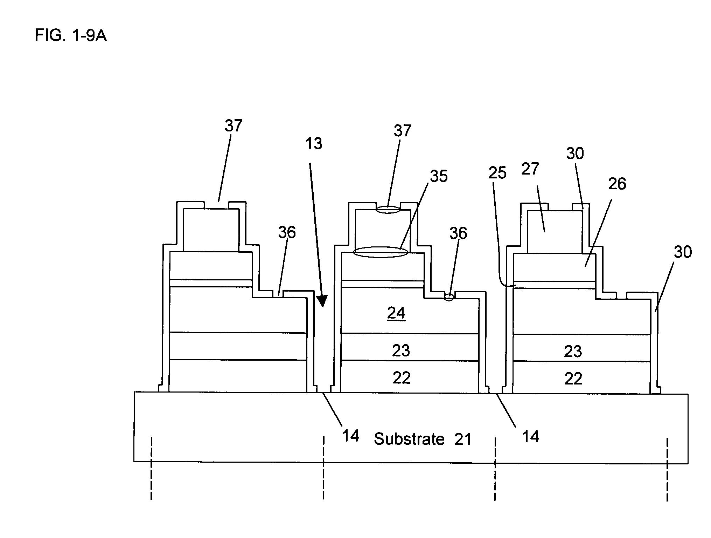

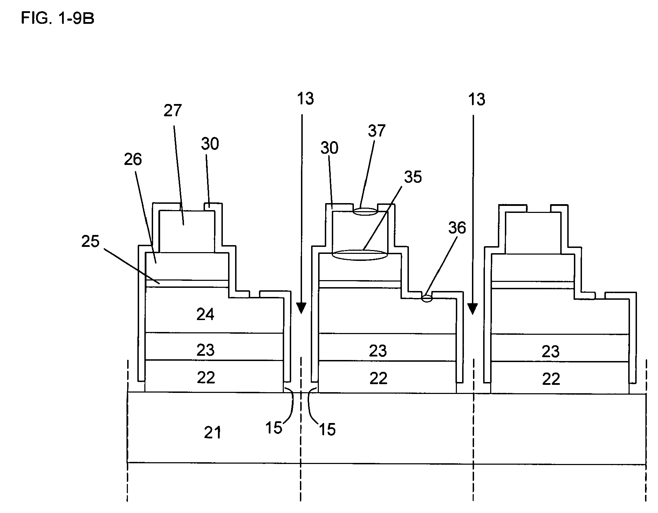

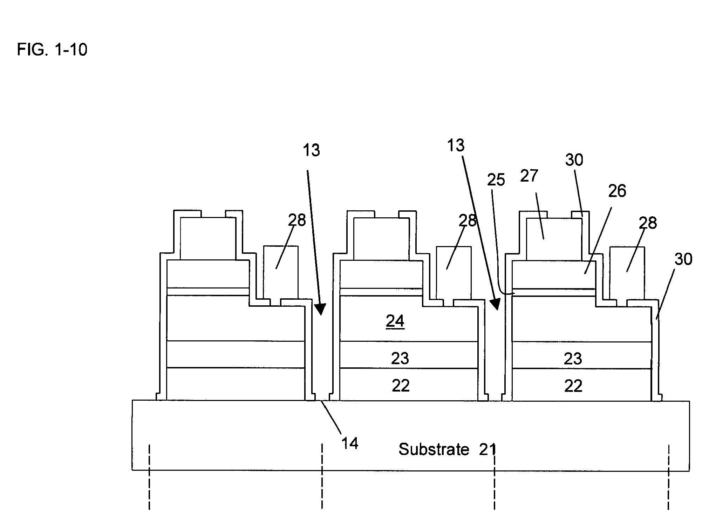

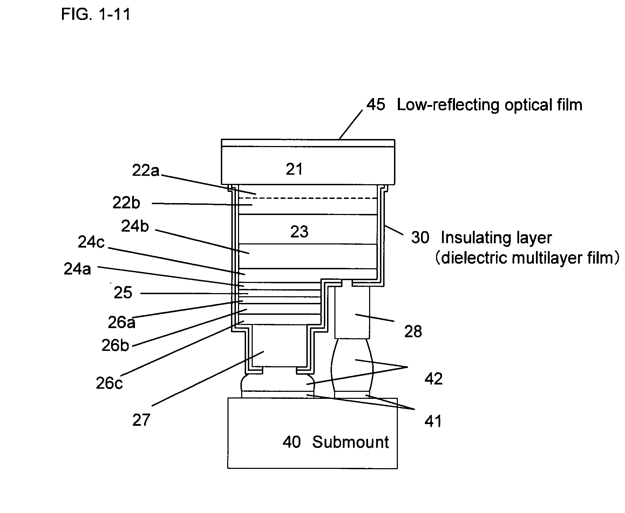

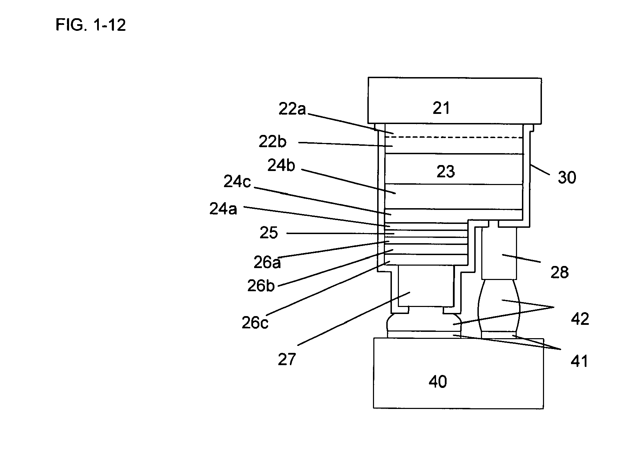

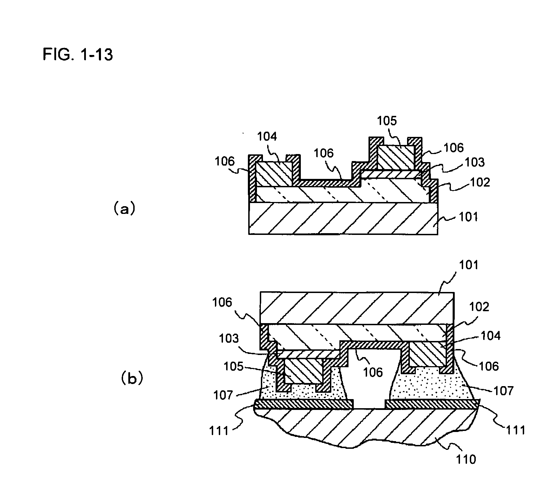

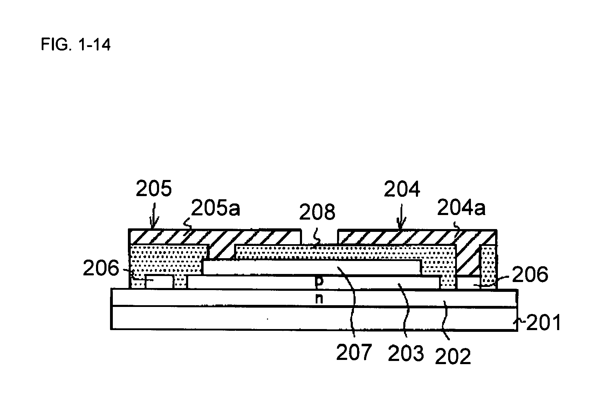

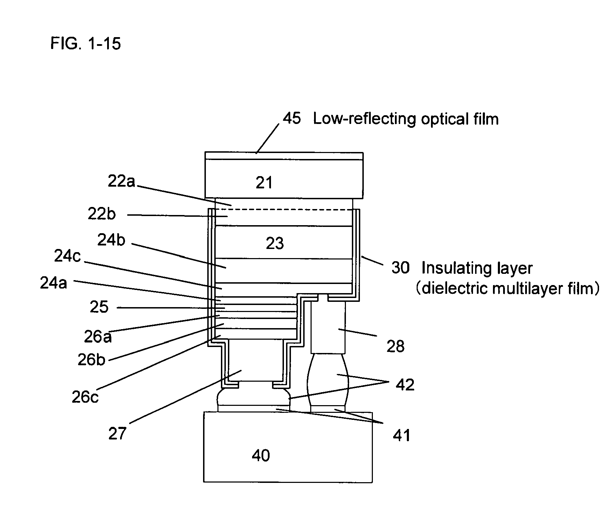

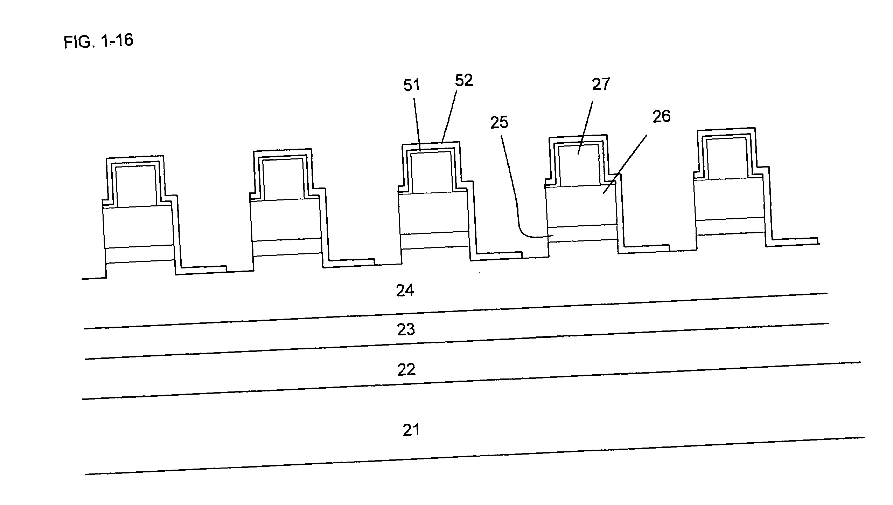

Japanese Patent No. 3453238 (Patent Reference 1) and Japanese Laid-open Patent Publication No. 2001-127348 (Patent Reference 2) have disclosed an element having a continuous insulating coating over the surfaces of an insulating substrate, an n-type nitride semiconductor layer and a p-type nitride semiconductor layer, extending from the end face of the n-type nitride semiconductor layer to the electrode-side surface. FIGs. 1-13(a) and (b) show an element structure described in Patent Reference 1. For preparing this structure, first, on a sapphire substrate 101 are sequentially grown an n-type nitride semiconductor layer 102 and a p-type nitride semiconductor layer 103, and then the edge portions of the n-type layer 102 and the p-type layer 103 are removed by dry-etching by RIE to the surface of the sapphire substrate 101 such that the shape shown in FIG. 1-13(a) is obtained. Then, the p-type layer 103 and the n-type layer 102 are partly dry-etched by RIE, to expose the n-type layer 102 such that the shape shown in FIG. 1-13 is obtained. After the etching, a negative electrode (n-side electrode) 104 and a positive electrode (p-side electrode) 105 are formed on the surfaces of the n-type layer 102 and the p-type layer 103, respectively. $SiO_2$ insulating coating 106 is formed such that it covers the end face (i.e. sidewall) of the etched n-type layer 102 and the electrode-side surface of the n-type layer 102, to prepare a light-emitting-element shown in FIG. 1-13. Here, on the surfaces of the negative electrode 104 and the positive electrode 105, the exposed portions are formed for the use of bonding. Then, the negative electrode 104 and the positive electrode 105 are connected to a conductive part 111 on an interconnection substrate 110 via a conductive adhesive 107, to obtain the mount structure shown in FIG. 1-13(b).

Since the semiconductor end face is covered by the insulating material, this structure is effective in preventing electric short circuit, but the electrode material tends to be deteriorated when forming the insulating layer (the insulating film). In the p-side electrode, Au is frequently used as a layer to be exposed in the surface and therefore resistant to deterioration, but, particularly in the n-side electrode, for example, an Al-containing material is often used as a material having a higher reflectance and capable of easily forming ohmic contact with the n-type GaN material, leading to susceptibility to influence of the process of depositing an insulating layer. An insulating film is formed from a material such as $SiO_2$, $TiO_2$, $Al_2O_3$ and $Si_3N_4$ by, for example, evaporation, sputtering or CVD, and in any case, a part of the n-side electrode material as a whole is inevitably attacked by, for example, oxidation or nitriding even when an exposed part is appropriately covered by a mask. Therefore, the injection of a large current for operation of an element with a high output leads to significant influence of deterioration in the electrode material and thus might cause deterioration in the element. Furthermore, if the exposed part in the electrode is formed by etching after forming the insulating layer, the exposed part itself is influenced by the etching process and sometimes the electrode material itself may be etched. For example, Al is easily etched by an etchant such as HF which can etch an insulating film. This problem is similarly applied to the element described in Patent Reference 2.

It can be, therefore, concluded that the structure described in Patent References 1 and 2 is not a structure formed considering a process history that should be considered in high-output operation of an element as well as the damage to the constituent materials of the element by the process history, and thus is an inappropriate structure for high-output operation. This problem is similarly applied to the element described in Patent Reference 2.

Furthermore, in the structure described in Patent Reference 1, the insulating film is formed over the sidewall of the n-side nitride semiconductor layer and the whole peripheral surface of the substrate in the element. Therefore, an insulating layer tends to be detached, after completing a wafer process, in the step of scribing (scratching for element separation) by the use of diamond for separating individual LED elements or the step of scribing by the used of a high-output laser. Detachment of the insulating layer causes short circuit during mounting, leading to reduction in an yield in the element preparation. The element described in Patent Reference 2 also has the structural problem similar to Patent Reference 1.

In terms of a small LED element, Japanese Laid-open Patent Publication No. 2003-17757 (Patent Reference 3) has proposed a flip-chip type element structure mainly for increasing the areas of a p-side electrode and an n-side electrode (See FIG. 1-14). For preparing this flip-chip type light-emitting-element, first, on a sapphire substrate 201 is grown an n-type layer 202 by vapor deposition growth or evaporation, over which is then grown a p-type layer 203. Subsequently, a part of the periphery of the p-type layer 203 is removed by, for example, etching and then a first connection layer (a part of the electrode) 206 is formed on around the n-type layer 202 while a second connection layer (a part of the electrode) 207 is formed on the p-type layer 203 by, for example, evaporation. Then, the whole surface is subjected to insulating coating by growing an insulating layer 208 such as an oxide film, and then the unnecessary part in the insulating layer 208 is removed by photolithography. Finally, a first electrode 204 and a second electrode 205 are formed and individual chips are formed to obtain a light-emitting-element structure.

In this structure, both electrode layers in which good ohmic contact should be ensured (the first and the second connection layers) are subjected to the history of insulating layer formation. In particular, when using an electrode material containing, for example, Al or Ag in the electrode part where good ohmic contact with a semiconductor material should be ensured (the first and the second connection layers), it tends to be oxidized during forming the oxide film. This structure is not a structure formed considering the damage to the constituent material for the element by a process history, and thus is inappropriate to high-output operation. Furthermore, since an unnecessary part of the insulating layer is removed after forming it over the whole surface having the electrode, etching damage is significant in an electrode material containing, for example, Al or Ag. In other words, such a device configuration does not allow a manufacturing process taking element deterioration during high-output operation into account.

In Patent Reference 3, as shown in FIG. 1-14, the first semiconductor layer (n-type layer 202) remains at the periphery of the element, so that damage may remain in the first semiconductor layer in the scribing step for element separation. Furthermore, since the first semiconductor layer (n-type layer 202) is kept exposed, the first semiconductor layer part may short-circuit by solder during flip-chip mounting, and thus it is not appropriate as an insulating layer configuration for flip-chip mount.

Furthermore, Japanese Laid-open Patent Publication No. 1999-251633 (Patent Reference 4) has disclosed a structure where an insulating layer is formed on a p-side electrode (positive electrode) and an n-side electrode (negative electrode) is superimposed on a part of the p-side electrode (positive electrode) via an insulating film. In this structure, an area of the n-side electrode can be effectively increased in a small GaN LED. However, since there are a semiconductor layer and an electrode layer at the periphery of the element, damage may remain in the semiconductor layer and the electrode may be detached during the scribing step for element separation.

Similarly, Japanese Laid-open Patent Publication No. 2000-114595 (Patent Reference 5) has also disclosed a structure where an insulating layer is formed on a p-side electrode (positive electrode) and an n-side electrode (negative electrode) is superimposed on a part of the p-side electrode (positive electrode) via an insulating film for effectively increasing an area of the n-side electrode. Again, in this structure, since there is a semiconductor layer at the periphery of the element, damage may remain in the semiconductor layer during the scribing step for element separation.

Apart from the problems described above, viewing a light-extraction surface in an element as a light-emitting face, there may be seen a dark part due to the electrode part formed by removing the active layer, and ununiformity in brightness in the light-extraction surface due to the generation of unevenness in current injection in the active layer. Such ununiformity becomes more significant in a larger element. For applying the element as a next-generation illuminating device, the presence of a dark part or generation of ununiformity is undesirable.

Patent Reference 1: Japanese Patent No. 3453238;
Patent Reference 2: Japanese Laid-open Patent Publication No. 2001-127348;
Patent Reference 3: Japanese Laid-open Patent Publication No. 2003-17757;
Patent Reference 4: Japanese Laid-open Patent Publication No. 1999-251633;
Patent Reference 5: Japanese Laid-open Patent Publication No. 2000-114595.

Disclosure of the Invention

Subject to be solved by the Invention

As described above, a conventional light-emitting diode structure cannot eliminate various possible damages in manufacturing process steps, and is, therefore, inadequately resistant to a large power input and inadequately insulative, resulting in difficulty in giving an LED with improved output and efficiency. Furthermore, there has been a need for improving uniformity of a light-emitting face.

An objective of the present invention is to provide a flip-chip mount type semiconductor light-emitting-element capable of emitting blue or ultraviolet light with higher output and higher efficiency. Further, an objective of the present invention in a particular aspect is to provide a flip-chip mount type semiconductor light-emitting-element with improved uniformity in brightness in a light-extraction-face.

Means to solve the Subject

The present invention relates to a compound semiconductor light-emitting-element comprising, on a substrate transparent to an emission wavelength, a compound semiconductor thin-film crystal layer having a first-conductivity-type semiconductor layer containing a first-conductivity-type cladding layer, an active layer structure and a second-conductivity-type semiconductor layer containing a second-conductivity-type cladding layer; a second-conductivity-type-side electrode; and a first-conductivity-type-side electrode, in which a main light-extraction direction is the side of the substrate, wherein:

the first-conductivity-type-side electrode and the second-conductivity-type-side electrode are not spatially overlapped and are formed on the opposite side to the main light-extraction direction;
the light-emitting-element comprises a light-uniforming layer, for improving uniformity of a light outgoing from a light-extraction-face, between the substrate and the first-conductivity-type semiconductor layer, and optionally a buffer layer between the substrate and the light-uniforming layer;
at the edge of the light-emitting-element, sidewalls of at least the first-conductivity-type semiconductor layer, the active layer structure and the second-conductivity-type semiconductor layer form a setback-sidewall-surface which recedes from the edge of the substrate on a sidewall surface of the thin-film crystal layer; and
the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) at least, covering the setback-sidewall-surface at a position distant from the light-emitting-element edge.

The present invention also relates to a compound semiconductor light-emitting-element comprising a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer in this order; a second-conductivity-type-side electrode; and a first-conductivity-type-side electrode, in which a main light-extraction direction is a buffer layer side in relation to the active layer structure, wherein:

the first-conductivity-type-side electrode and the second-conductivity-type-side electrode are not spatially overlapped and are formed on the opposite side to the main light-extraction direction;

the light-emitting-element comprises a light-uniforming layer, for improving uniformity of a light outgoing from a light-extraction-face, between the buffer layer and the first-conductivity-type semiconductor layer;

at the edge of the light-emitting-element, sidewalls of at least the first-conductivity-type semiconductor layer, the active layer structure and the second-conductivity-type semiconductor layer form a setback-sidewall-surface, which has receded when forming a light-emitting-element separation-trench in a manufacturing process, on a sidewall surfaces of the thin-film crystal layers;

the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) in relation to the setback-sidewall-surface of the thin-film crystal layer,

(i) if a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer,

at least, the insulating layer being formed from a position distant from the light-emitting-element edge, or

(ii) if the light-uniforming layer and the buffer layer form a setback-sidewall-surface in combination and an edge-step-face is not present,

the insulating layer being not formed at least on the part of the buffer layer at the side of main light-extraction direction but covering the setback-sidewall-surface from the intermediate portion of the buffer layer or the light-uniforming layer; and

the light-emitting-element further comprises a support supporting the light-emitting-element, to which the first-conductivity-type-side electrode and the second-conductivity-type-side electrode are connected.

The present invention also relate to a process for manufacturing a light-emitting-element, comprising

step (a): depositing a buffer layer and a light-uniforming layer on a substrate in this order;

step (b): depositing a thin-film crystal layer having at least a first-conductivity-type semiconductor layer containing a first-conductivity-type cladding layer, an active layer structure and a second-conductivity-type semiconductor layer containing a second-conductivity-type cladding layer, in this order from the side of the substrate;

step (c): forming a second-conductivity-type-side electrode on the surface of the second-conductivity-type semiconductor layer;

first etching step (d): etching a part of the region where the second-conductivity-type-side electrode is not formed, to expose a part of the first-conductivity-type semiconductor layer;

second etching step (e): for forming a light-emitting-element separation-trench separating adjacent light-emitting-elements, etching a part of the region where the second-conductivity-type-side electrode is not formed, from its surface, to such a depth (i) that at least a part of the light-uniforming layer is removed, (ii) that at least a part of the buffer layer is removed, or (iii) that the etching reaches at least the substrate, whereby forming the light-emitting-element separation-trench;

step (f): forming an insulating layer on the whole surface including the second-conductivity-type-side electrode, the first-conductivity-type semiconductor layer exposed by the first etching step and the inside of the light-emitting-element separation-trench;

step (g): removing the insulating layer in a region including at least the trench center of the trench bottom surface in the light-emitting-element separation-trench,

step (h): removing a part of the insulating layer formed on the first-conductivity-type semiconductor layer to form an opening to be a first current injection region,

step (i): removing a part of the insulating layer formed on the surface of the second-conductivity-type-side electrode to expose a part of the second-conductivity-type-side electrode, and

step (j): forming a first-conductivity-type-side electrode in contact with the first current injection region opened in step (h).

The present invention also relates to a compound semiconductor light-emitting-element comprising, on a substrate transparent to an emission wavelength, a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer; a second-conductivity-type-side electrode; and a first-conductivity-type-side electrode, in which a main light-extraction direction is the side of the substrate,

wherein:

the first-conductivity-type-side electrode and the second-conductivity-type-side electrode are not spatially overlapped and are formed on the opposite side to the main light-extraction direction; at the edge of the light-emitting-element, sidewalls of at least the first-conductivity-type semiconductor layer, the active layer structure and the second-conductivity-type semiconductor layer form a setback-sidewall-surface which recedes from the edge of the substrate on a sidewall surface of the thin-film crystal layers; and the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) at least, covering the setback-sidewall-surface at a position distant from the light-emitting-element edge.

The present invention also relates to a compound semiconductor light-emitting-element comprising a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer in this order; a second-conductivity-type-side electrode; and a first-conductivity-type-side electrode, in which a main light-extraction direction is a buffer layer side in relation to the active layer structure, wherein:

the first-conductivity-type-side electrode and the second-conductivity-type-side electrode are not spatially overlapped and are formed on the opposite side to the main light-extraction direction; the light-emitting-element comprises a support supporting the light-emitting-element, to which the first-conductivity-type-side electrode and the second-conductivity-type-side electrode are connected; at the edge of the light-emitting-element, sidewalls of at least the first-conductivity-type semiconductor layer, the active layer structure and the second-conductivity-type semiconductor layer form a setback-sidewall-surface, which has receded when forming a light-emitting-element separation-trench in a manufacturing process, on a sidewall surfaces of the thin-film crystal layers; the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) in relation to the setback-sidewall-surface of the thin-film crystal layer,

(i) if a part of the buffer layer form a setback-sidewall-surface in combination and forms an edge-step-face with the non-setback-sidewall-surface which has not receded in the buffer layer, at least, the insulating layer being formed from a position distant from the light-emitting-element edge, or (ii) if the buffer layer form a setback-sidewall-surface in combination and an edge-step-face is not formed, the insulating layer being not formed at least on the part of the buffer layer at the side of main light-extraction direction but covering the setback-sidewall-surface from the intermediate portion of the buffer layer or the light-uniforming layer,

The present invention also relate to a process for manufacturing a light-emitting-element, comprising step (a): depositing a buffer layer on a substrate; step (b): depositing a thin-film crystal layer having at least a first-conductivity-type semiconductor layer containing a first-conductivity-type cladding layer, an active layer structure and a second-conductivity-type semiconductor layer containing a second-conductivity-type cladding layer, in this order from the side of the substrate; step (c): forming a second-conductivity-type-side electrode on the surface of the second-conductivity-type semiconductor layer; first etching step (d): etching a part of the region where the second-conductivity-type-side electrode is not formed, to expose a part of the first-conductivity-type semiconductor layer; second etching step (e): for forming a light-emitting-element separation-trench separating adjacent light-emitting-elements, etching a part of the region where the second-conductivity-type-side electrode is not formed, from its surface, to such a depth (i) that at least a part of the buffer layer is removed or (ii) that the etching reaches at least the substrate, whereby forming the light-emitting-element separation-trench; step (f): forming an insulating layer on the whole surface including the second-conductivity-type-side electrode, a first-conductivity-type semiconductor layer exposed by the first etching step and the inside of the light-emitting-element separation-trench;

step (g): removing the insulating layer in a region including at least the trench center of the trench bottom surface in the light-emitting-element separation-trench,

step (h): removing a part of the insulating layer formed on the first-conductivity-type semiconductor layer to form an opening to be a first current injection region,

step (i): removing a part of the insulating layer formed on the surface of the second-conductivity-type-side electrode to expose a part of the second-conductivity-type-side electrode, and

step (j): forming a first-conductivity-type-side electrode in contact with the first current injection region opened in step (h).

Brief Description Of The Drawings

FIG. 1-1A shows an example of a light-emitting-element according to the first aspect disclosed in Section A.
FIG. 1-1B shows positional relationship in an example of a light-emitting-element of the present invention disclosed in Section A.
FIG. 1-1C shows an example of a light-emitting-element according to the first aspect disclosed in Section A.
FIG. 1-1D shows an example of a light-emitting-element according to the first aspect disclosed in Section A.
FIG. 1-2A shows an example of a light-emitting-element according to the second aspect disclosed in Section A.
FIG. 1-2B shows positional relationship in an example of a light-emitting-element of the present invention disclosed in Section A.
FIG. 1-2C shows an example of a light-emitting-element according to the second aspect disclosed in Section A.
FIG. 1-2D shows an example of a light-emitting-element according to the second aspect disclosed in Section A.
FIG. 1-2E shows an example of a light-emitting-element according to the second aspect disclosed in Section A.
FIG. 1-3A shows a structure before completion of an example of a light-emitting-element according to the first aspect disclosed in Section A.
FIG. 1-3B shows a structure before completion of an example of a light-emitting-element according to the second aspect disclosed in Section A.
FIG. 1-4 schematically shows an active layer structure disclosed in Section A.
FIG. 1-5 is a process cross-sectional view illustrating an example of a manufacturing process disclosed in Section A.
FIG. 1-6 is a process cross-sectional view illustrating an example of a manufacturing process disclosed in Section A.
FIG. 1-7 is a process cross-sectional view illustrating an example of a manufacturing process disclosed in Section A.
FIG. 1-8 is a process cross-sectional view illustrating an example of a manufacturing process disclosed in Section A.
FIG. 1-9A is a process cross-sectional view illustrating an example of a manufacturing process disclosed in Section A (first aspect).
FIG. 1-9B is a process cross-sectional view illustrating an example of a manufacturing process disclosed in Section A (second aspect).
FIG. 1-10 is a process cross-sectional view illustrating an example of a manufacturing process disclosed in Section A.
FIG. 1-11 shows a light-emitting-element manufactured in Examples A-1 and -3 disclosed in Section A.
FIG. 1-12 shows a light-emitting-element manufactured in Examples A-5 and -6 disclosed in Section A.
FIG. 1-13 shows a conventional light-emitting-element.
FIG. 1-14 shows a conventional light-emitting-element.
FIG. 1-15 shows a light-emitting-element manufactured in Examples A-2 and -4 disclosed in Section A.
FIG. 1-16 is a process cross-sectional view illustrating one embodiment of a manufacturing process for a light-emitting-element of the present invention disclosed in Section A.
FIG. 2-1A shows an example of a light-emitting-element according to the first aspect disclosed in Section B.

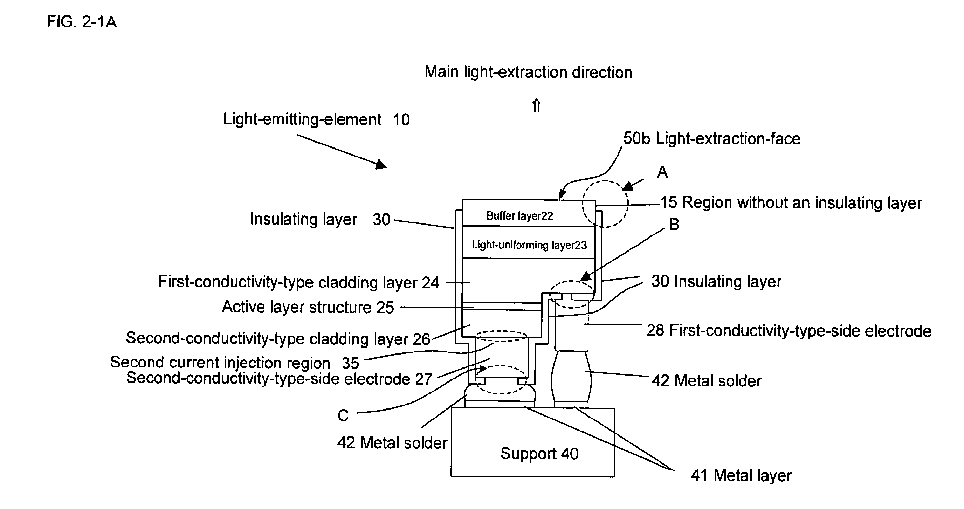

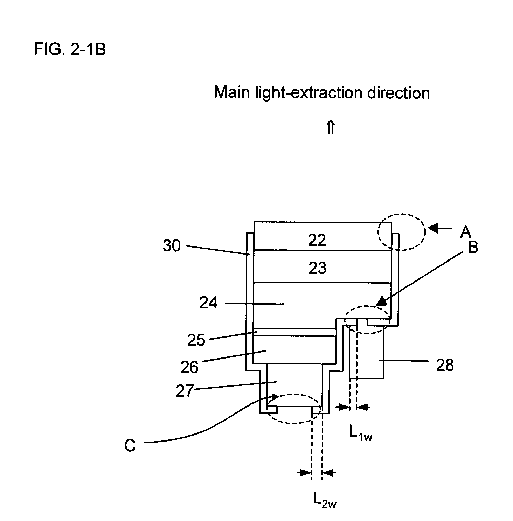

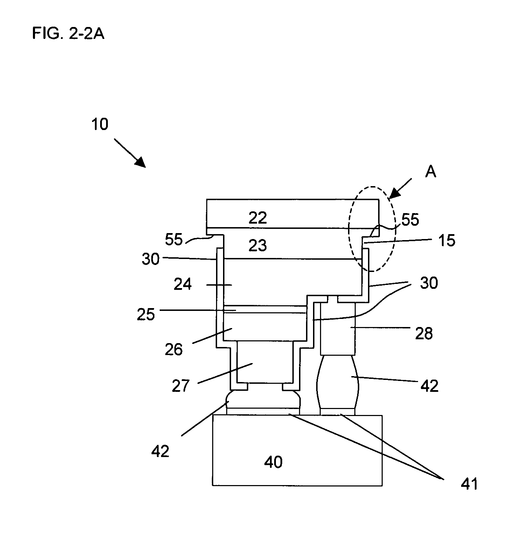

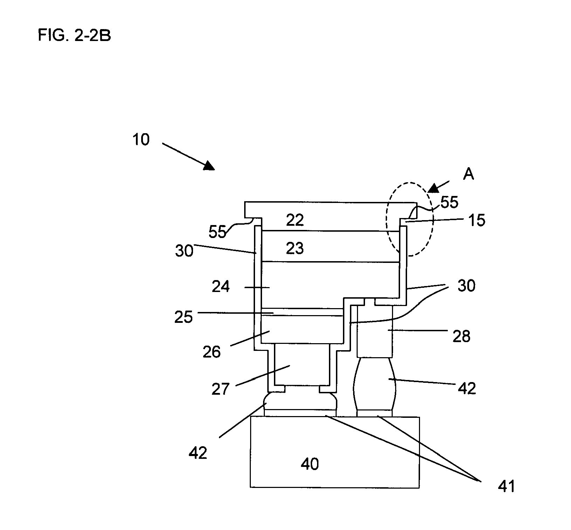

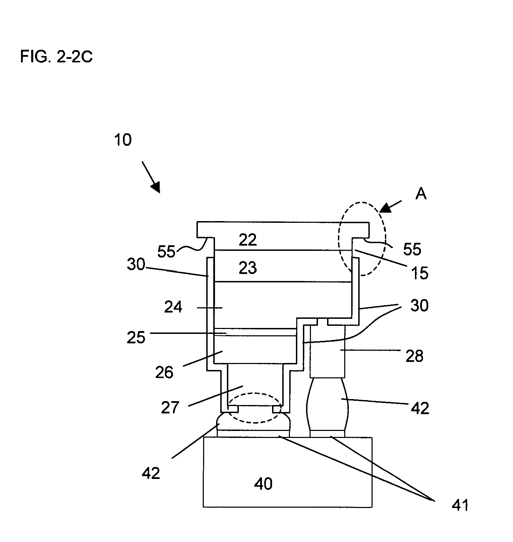

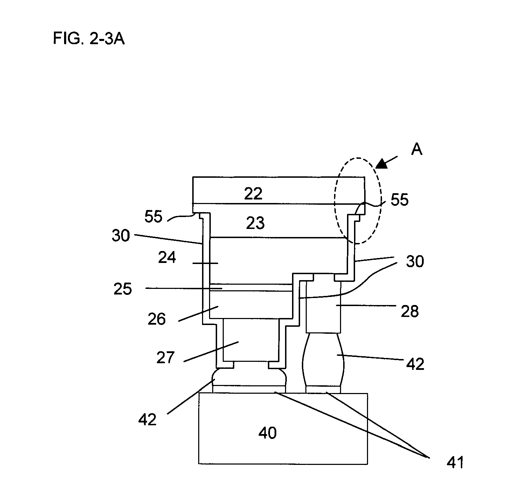

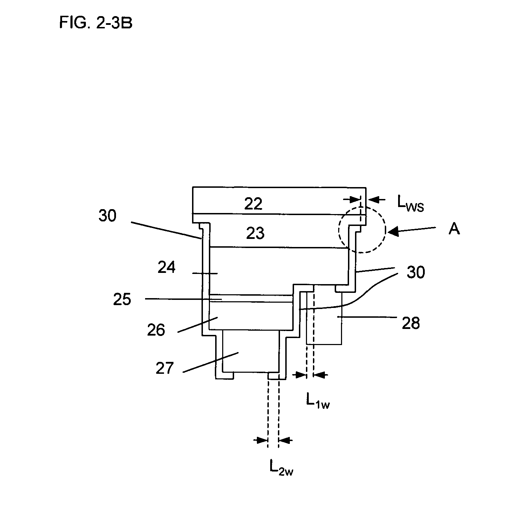

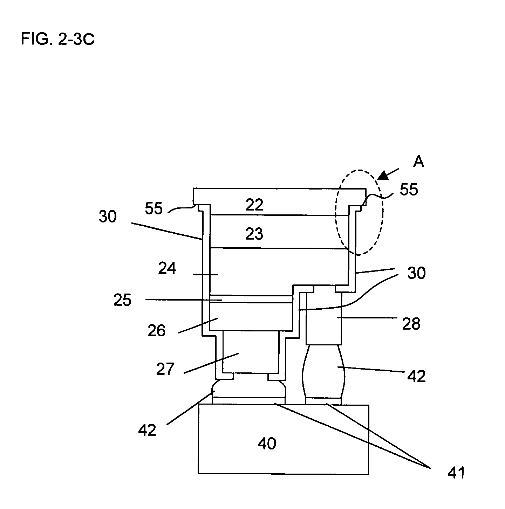

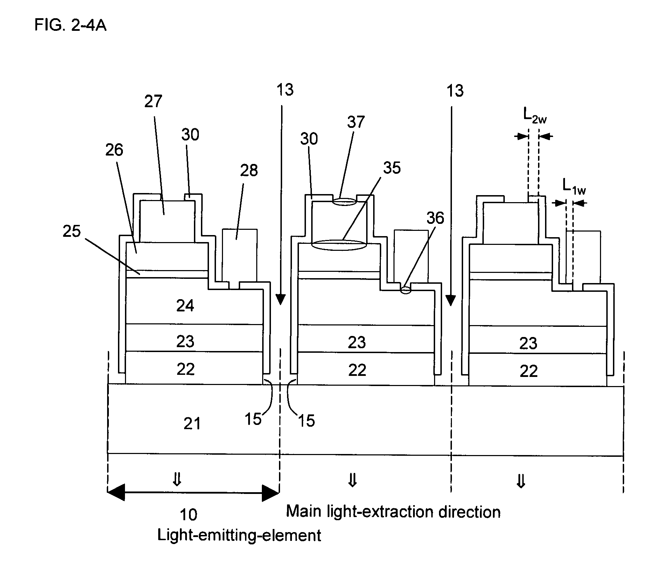

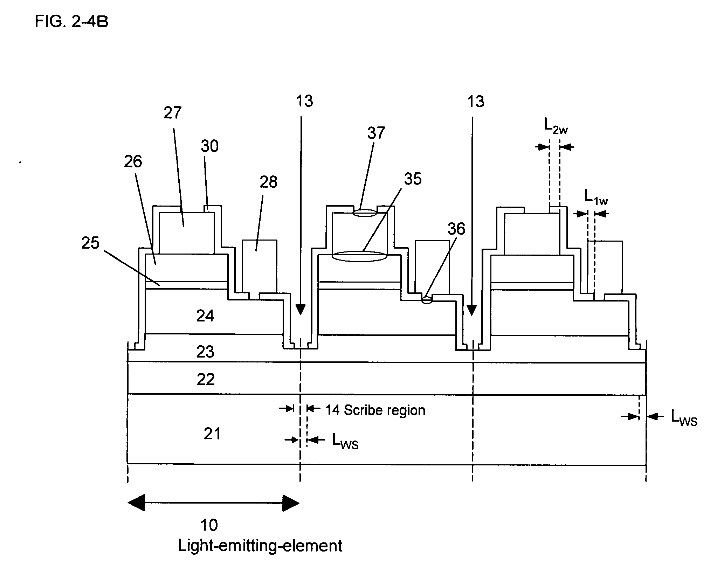

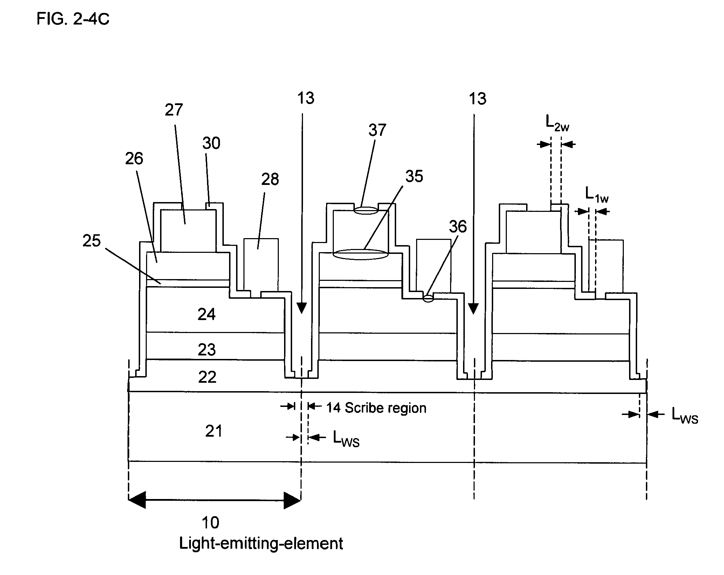

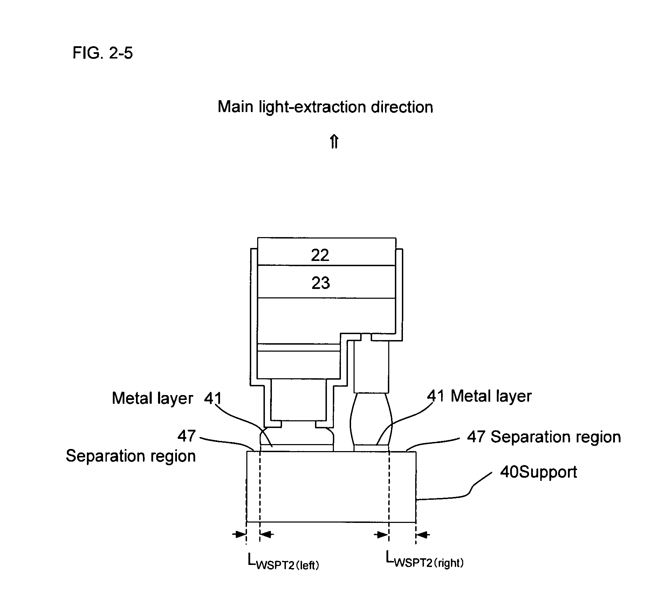

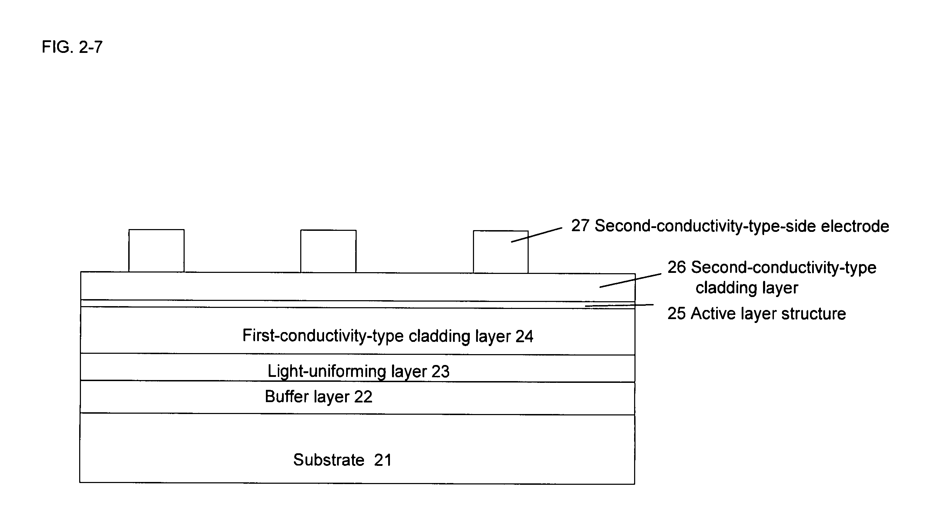

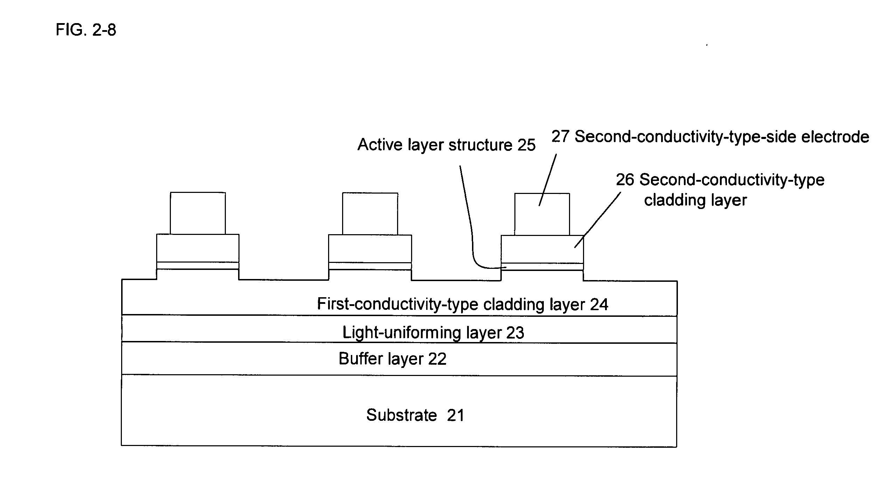

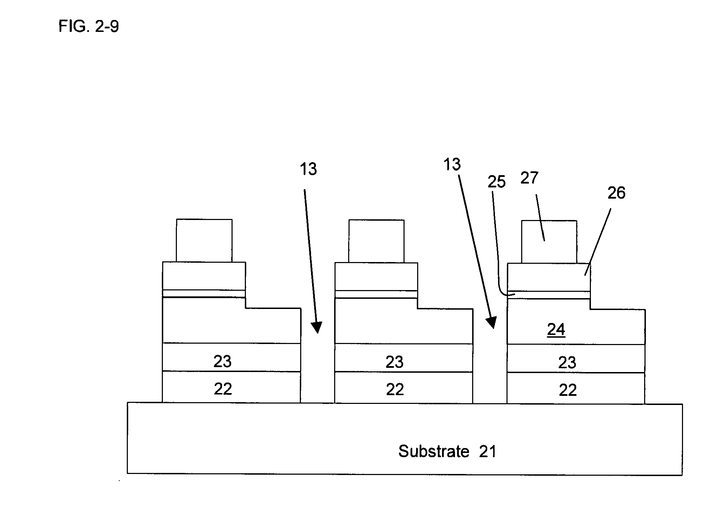

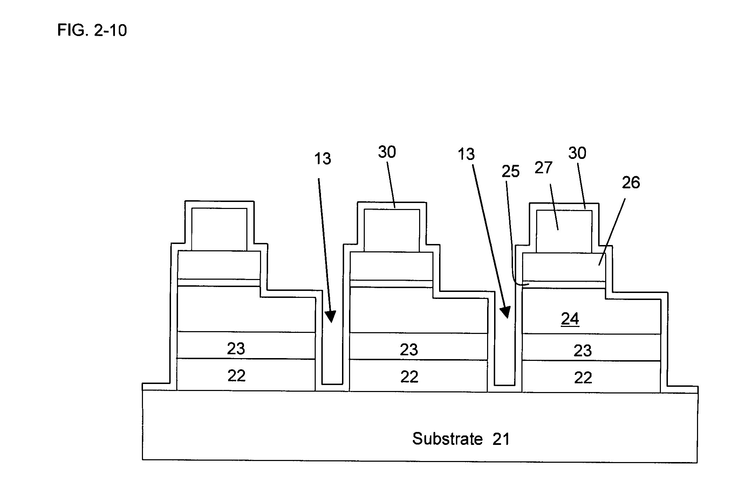

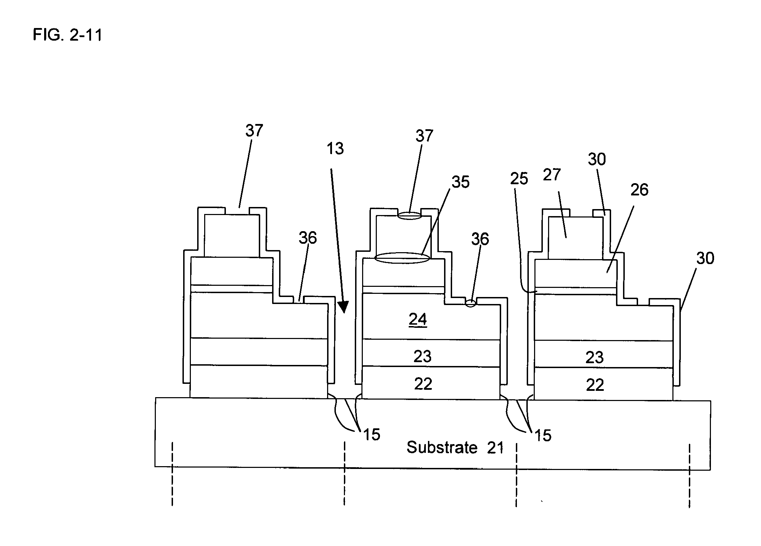

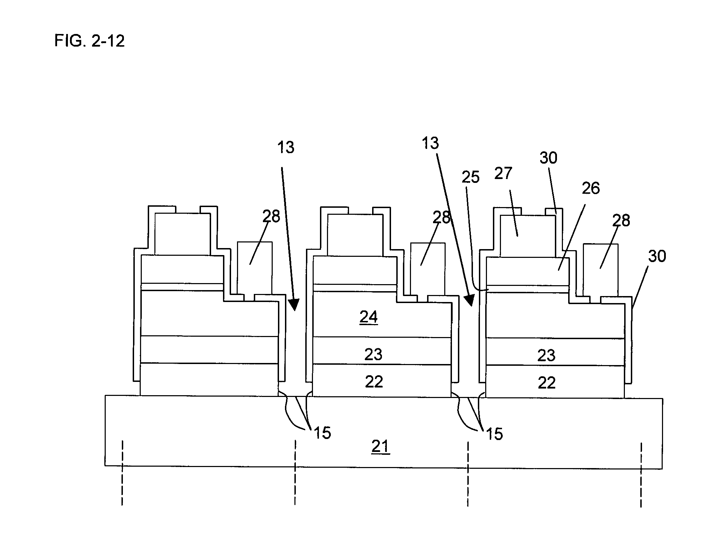

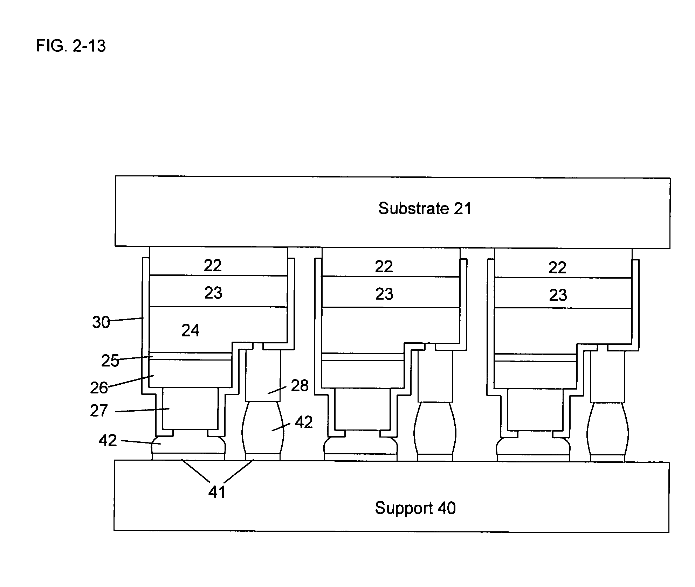

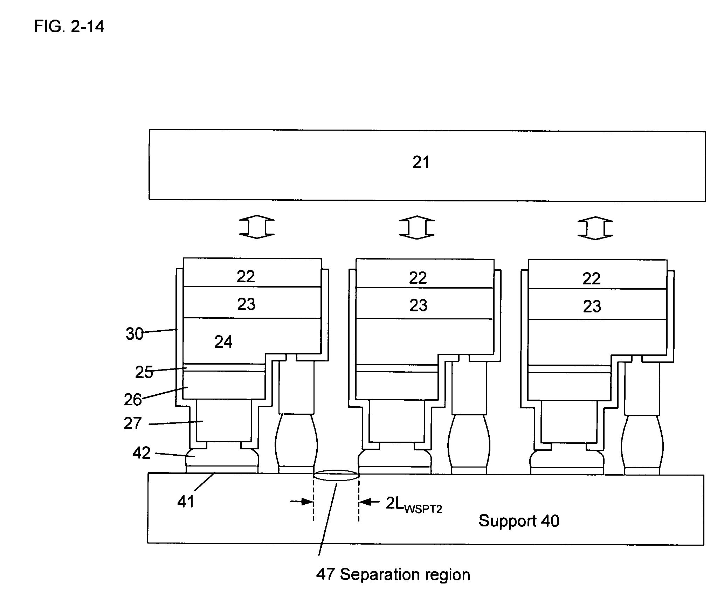

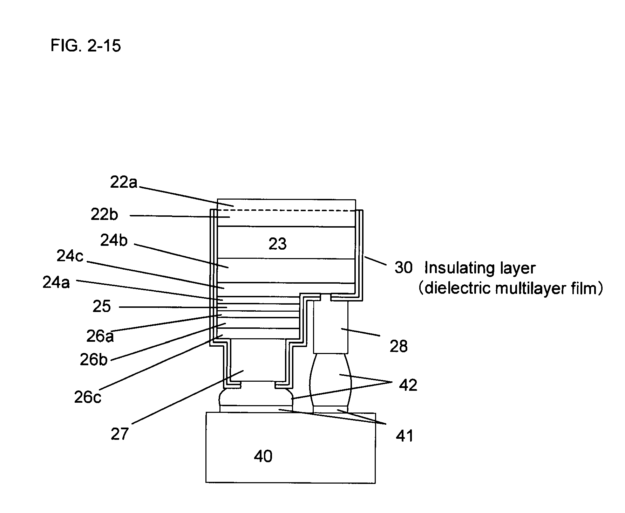

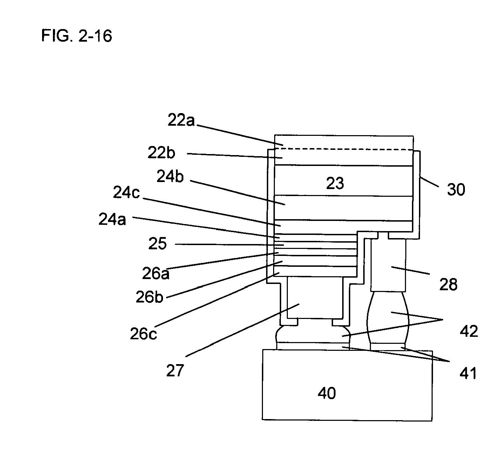

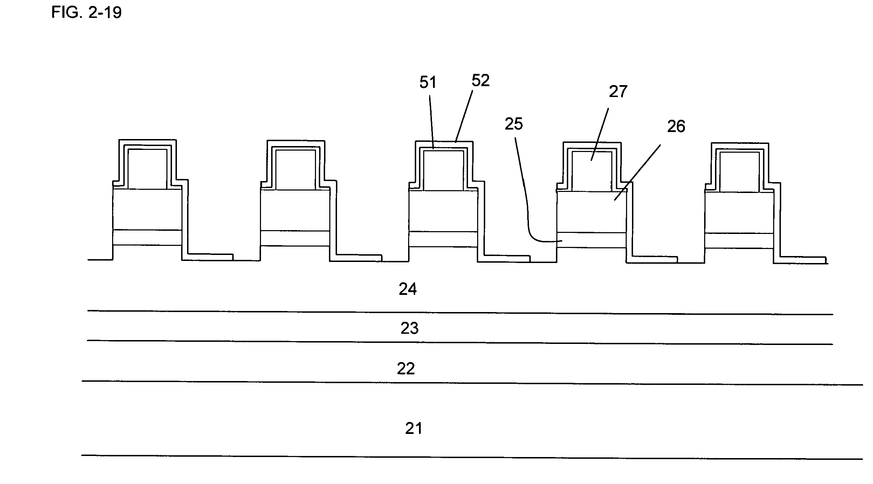

FIG. 2-1B shows positional relationship in a light-emitting-element according to the first aspect disclosed in Section B.
FIG. 2-2A shows an example of a light-emitting-element according to the first aspect disclosed in Section B.
FIG. 2-2B shows an example of a light-emitting-element according to the first aspect disclosed in Section B.
FIG. 2-2C shows an example of a light-emitting-element according to the first aspect disclosed in Section B.
FIG. 2-3A shows an example of a light-emitting-element according to the second aspect disclosed in Section B.
FIG. 2-3B shows positional relationship in a light-emitting-element according to the second aspect disclosed in Section B.
FIG. 2-3C shows an example of a light-emitting-element according to the second aspect disclosed in Section B.
FIG. 2-4A shows an example of a structure before completion of a light-emitting-element according to the first aspect disclosed in Section B.
FIG. 2-4B shows an example of a structure before completion of a light-emitting-element according to the second aspect disclosed in Section B.

FIG. 2-4C shows an example of a structure before completion of a light-emitting-element according to the second aspect disclosed in Section B.

FIG. 2-5 shows positional relationship in a light-emitting-element of the present invention disclosed in Section B.

FIG. 2-7 is a process cross-sectional view illustrating an example of a manufacturing process disclosed in Section B.

FIG. 2-8 is a process cross-sectional view illustrating an example of a manufacturing process disclosed in Section B.

FIG. 2-9 is a process cross-sectional view illustrating an example of a manufacturing process disclosed in Section B.

FIG. 2-10 is a process cross-sectional view illustrating an example of a manufacturing process disclosed in Section B.

FIG. 2-11 is a process cross-sectional view illustrating an example of a manufacturing process disclosed in Section B.

FIG. 2-12 is a process cross-sectional view illustrating an example of a manufacturing process disclosed in Section B.

FIG. 2-13 is a process cross-sectional view illustrating an example of a manufacturing process disclosed in Section B.

FIG. 2-14 is a process cross-sectional view illustrating an example of a manufacturing process disclosed in Section B.

FIG. 2-15 shows a light-emitting-element manufactured in Example B-1 disclosed in Section B.

FIG. 2-16 shows a light-emitting-element manufactured in Example B-3 disclosed in Section B.

FIG. 2-19 is a process cross-sectional view illustrating one embodiment of a manufacturing process for a light-emitting-element of the present invention disclosed in Section B.

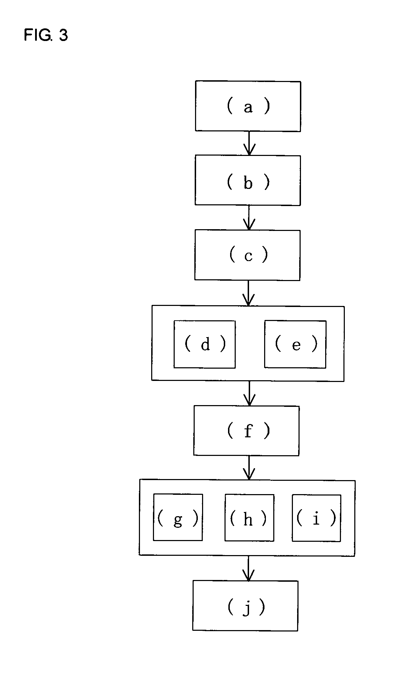

FIG. 3 is a flow chart illustrating the step order of a manufacturing process.

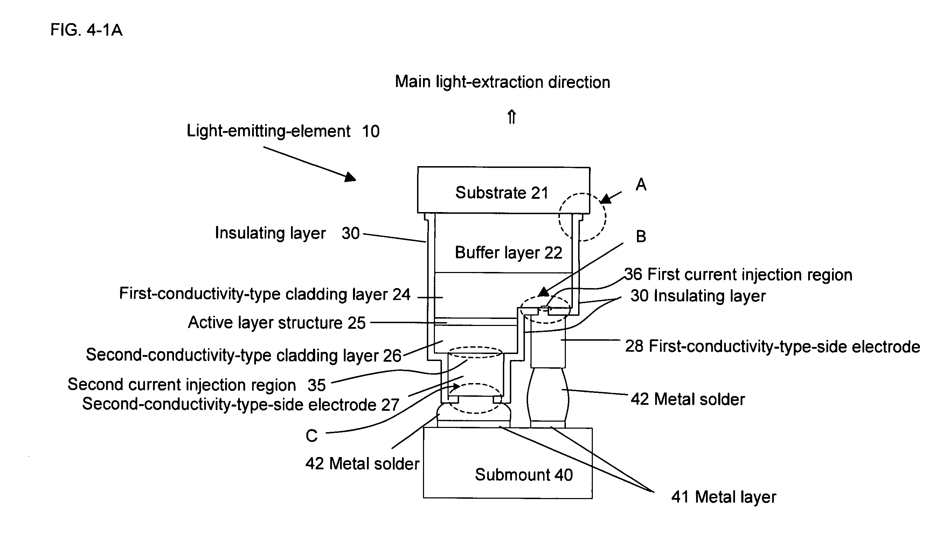

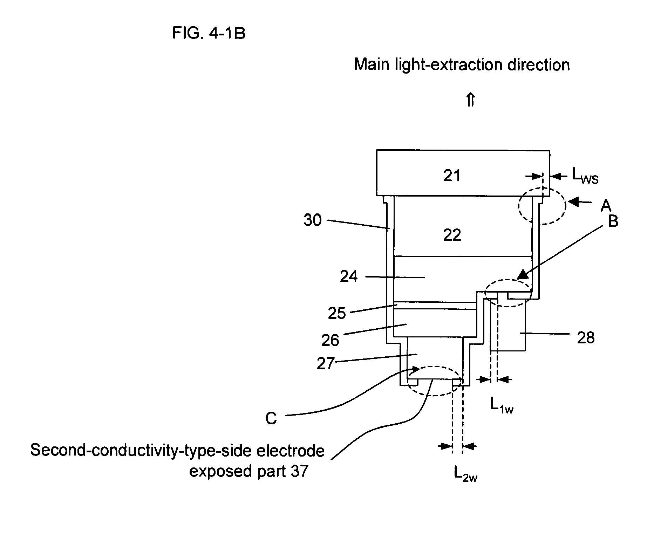

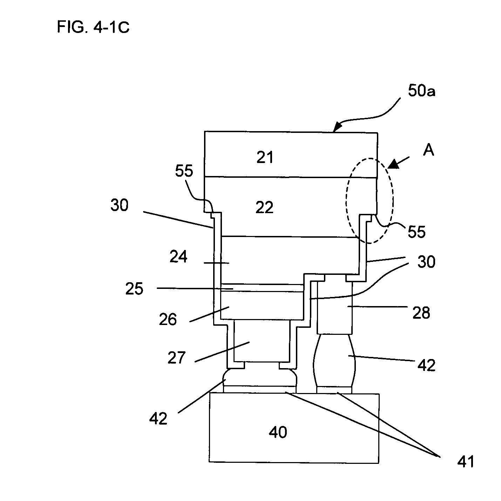

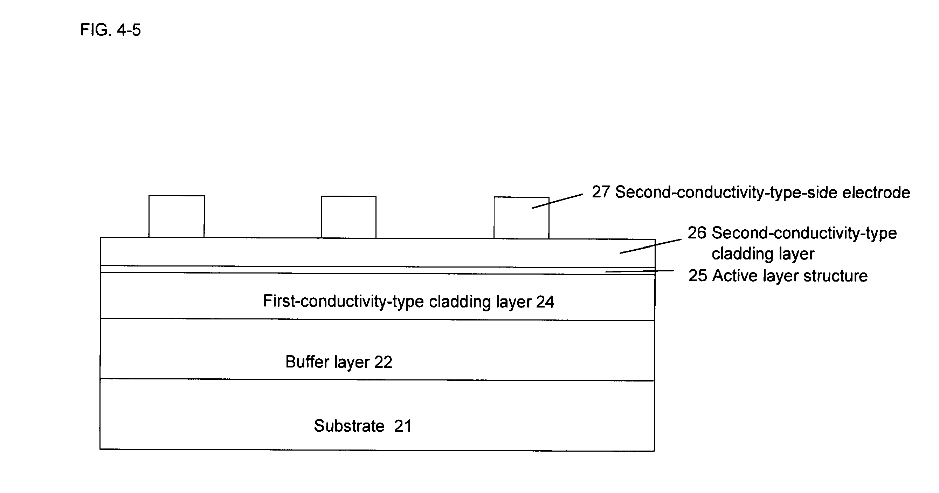

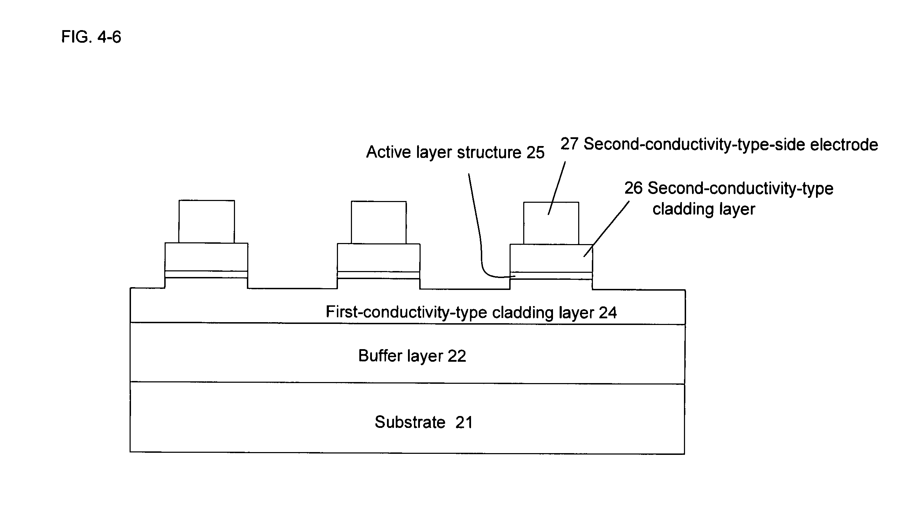

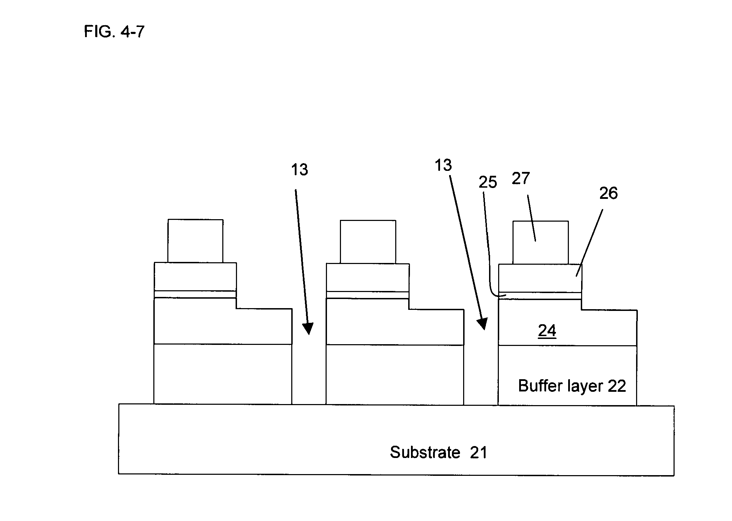

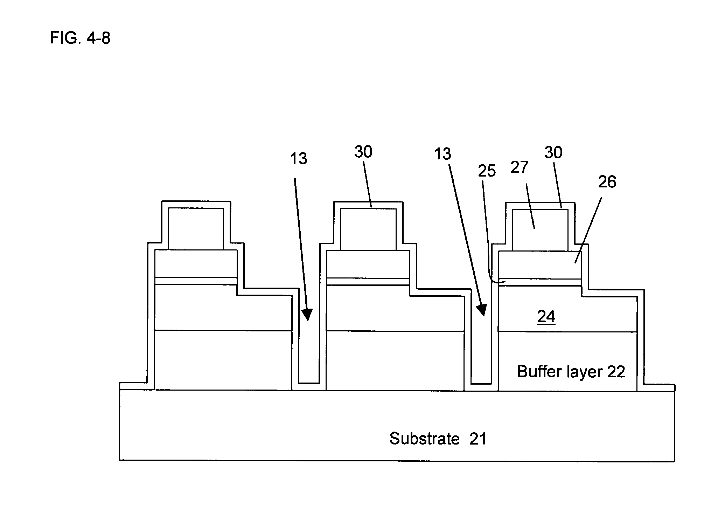

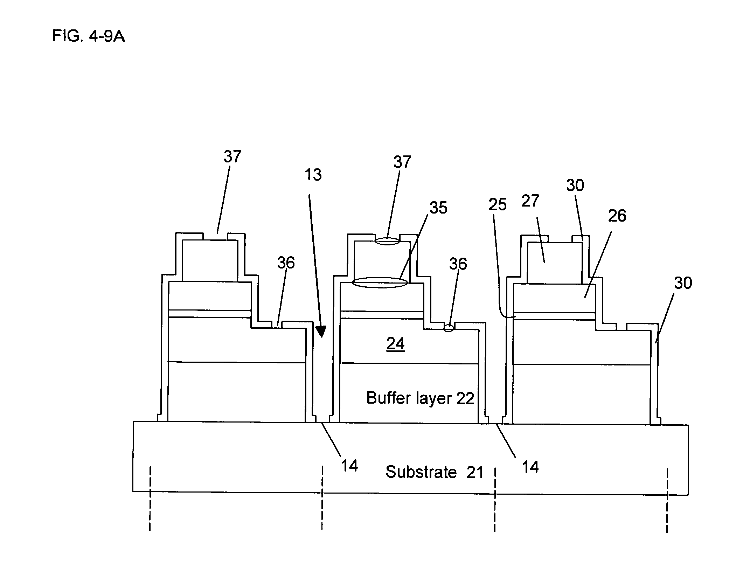

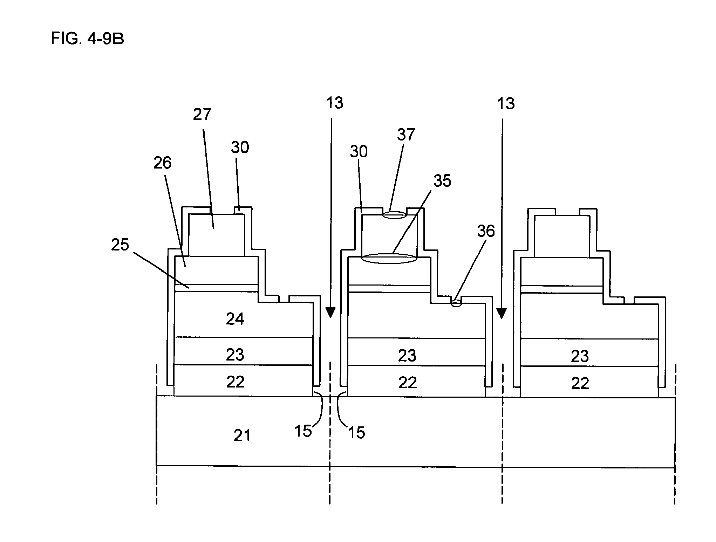

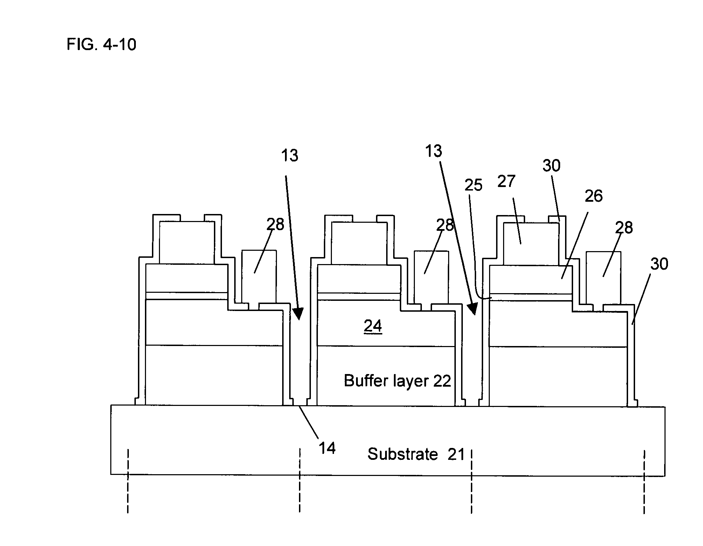

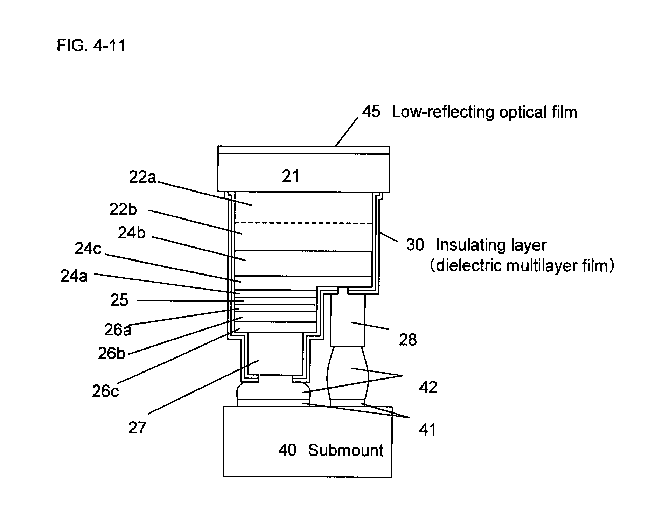

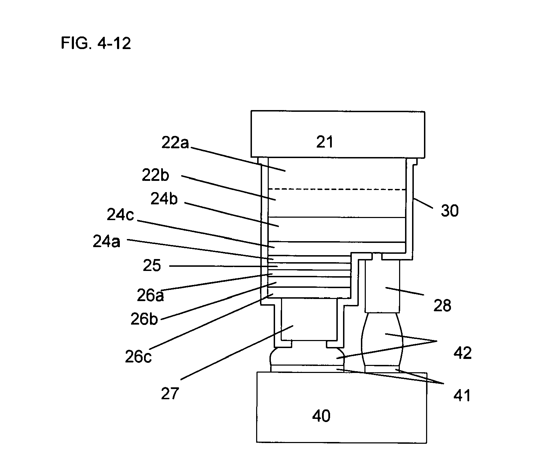

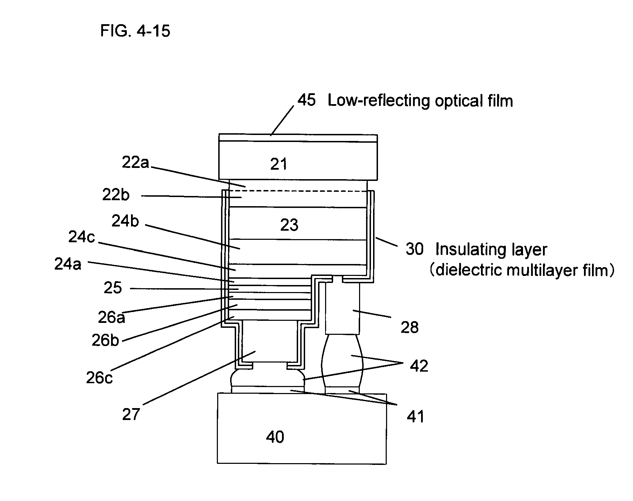

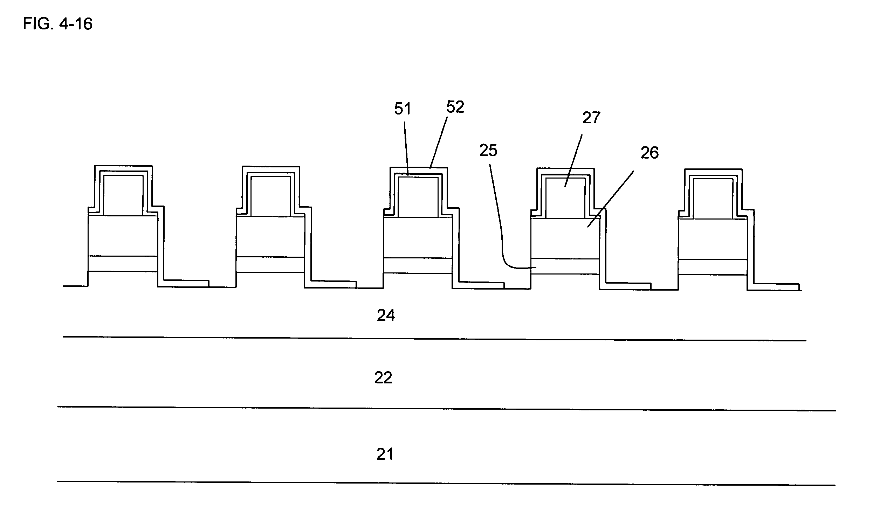

FIG. 4-1A shows an example of a light-emitting-element according to the first aspect disclosed in Section D.

FIG. 4-1B shows positional relationship in an example of a light-emitting-element of the present invention disclosed in Section D.

FIG. 4-1C shows an example of a light-emitting-element according to the first aspect disclosed in Section D.

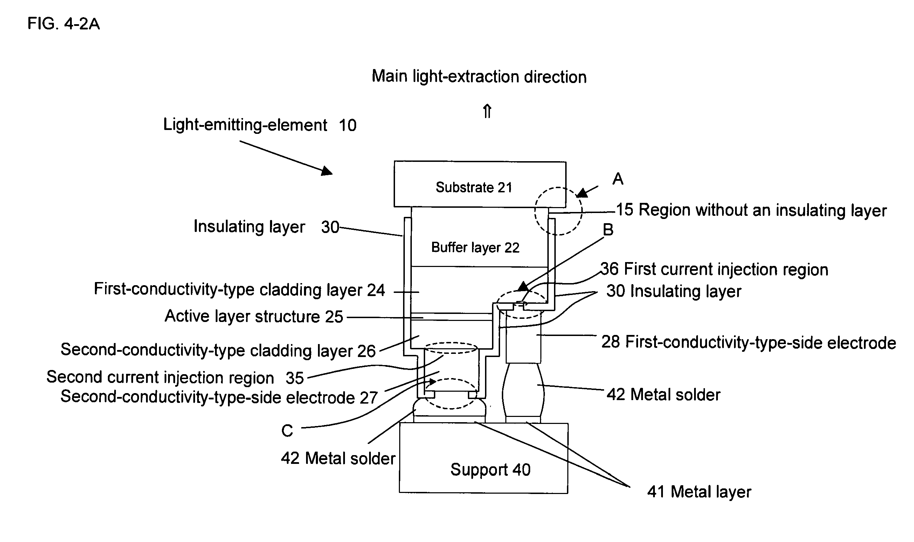

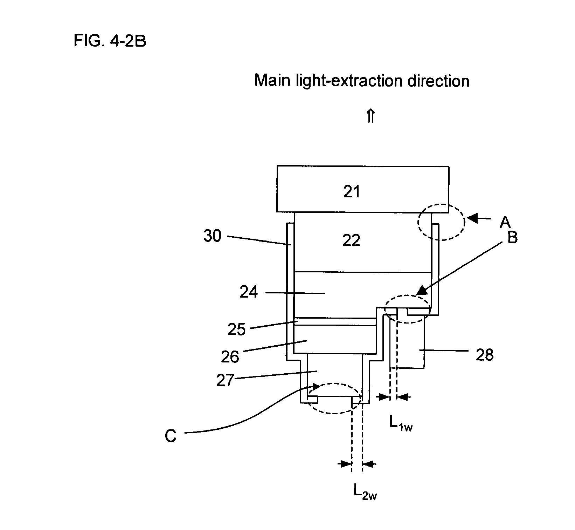

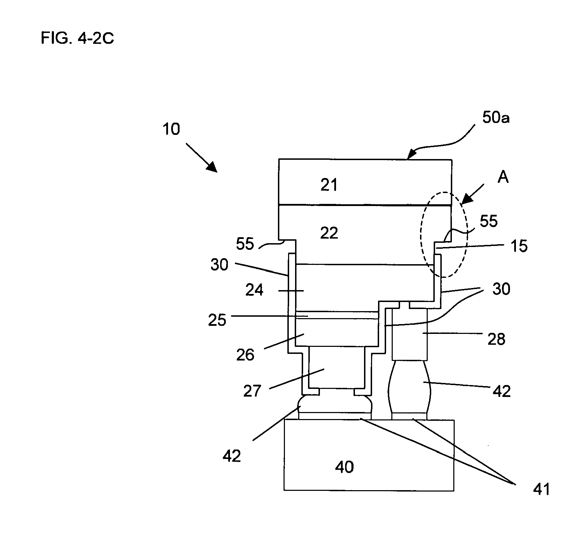

FIG. 4-2A shows an example of a light-emitting-element according to the second aspect disclosed in Section D.

FIG. 4-2B shows positional relationship in an example of a light-emitting-element of the present invention disclosed in Section D.

FIG. 4-2C shows an example of a light-emitting-elenient according to the second aspect disclosed in Section D.

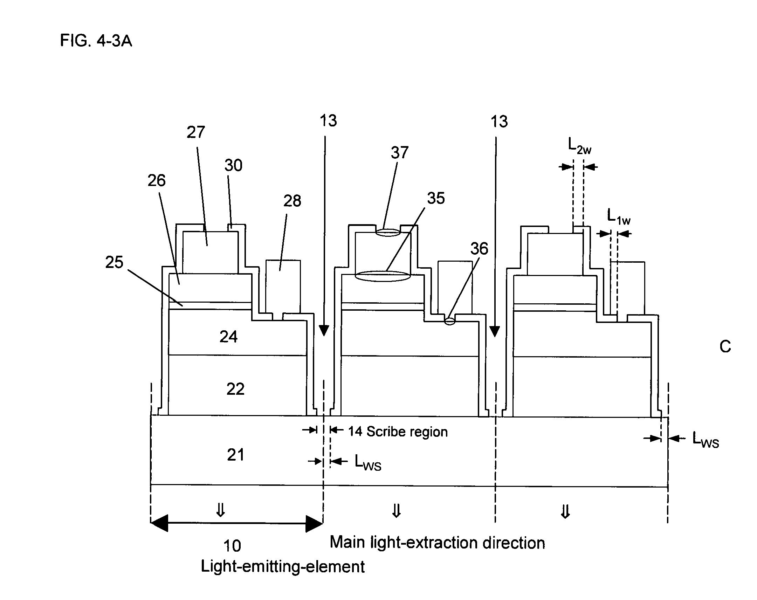

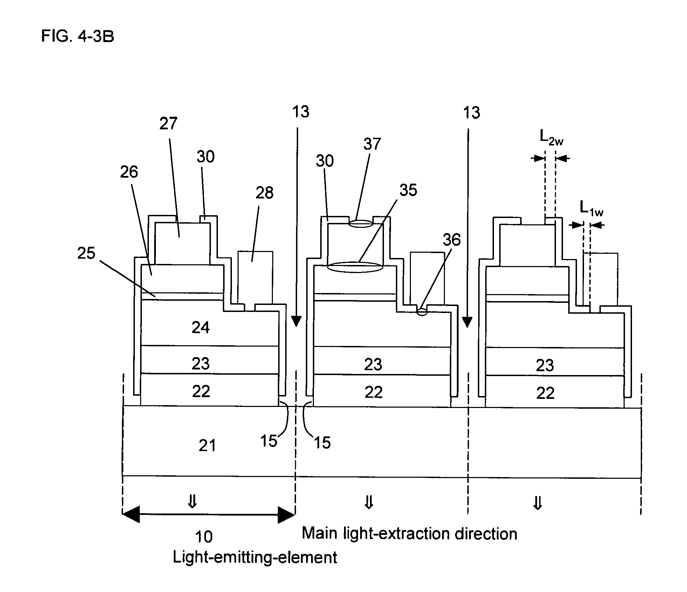

FIG. 4-3A shows a structure before completion of an example of a light-emitting-element according to the first aspect disclosed in Section D.

FIG. 4-3B shows a structure before completion of an example of a light-emitting-element according to the second aspect disclosed in Section D.

FIG. 4-5 is a process cross-sectional view illustrating an example of a manufacturing process disclosed in Section D.

FIG. 4-6 is a process cross-sectional view illustrating an example of a manufacturing process disclosed in Section D.

FIG. 4-7 is a process cross-sectional view illustrating an example of a manufacturing process disclosed in Section D.

FIG. 4-8 is a process cross-sectional view illustrating an example of a manufacturing process disclosed in Section D.

FIG. 4-9A is a process cross-sectional view illustrating an example (the first aspect) of a manufacturing process disclosed in Section D.

FIG. 4-9B is a process cross-sectional view illustrating an example (the second aspect) of a manufacturing process disclosed in Section D.

FIG. 4-10 is a process cross-sectional view illustrating an example of a manufacturing process disclosed in Section D.

FIG. 4-11 shows a light-emitting-element manufactured in Examples D-1 and -3 disclosed in Section D.

FIG. 4-12 shows a light-emitting-element manufactured in Examples D-5 and -6 disclosed in Section D.

FIG. 4-15 shows a light-emitting-element manufactured in Examples D-2 and -4 disclosed in Section D.

FIG. 4-16 is a process cross-sectional view illustrating one embodiment of a manufacturing process for a light-emitting-element of the present invention disclosed in Section D.

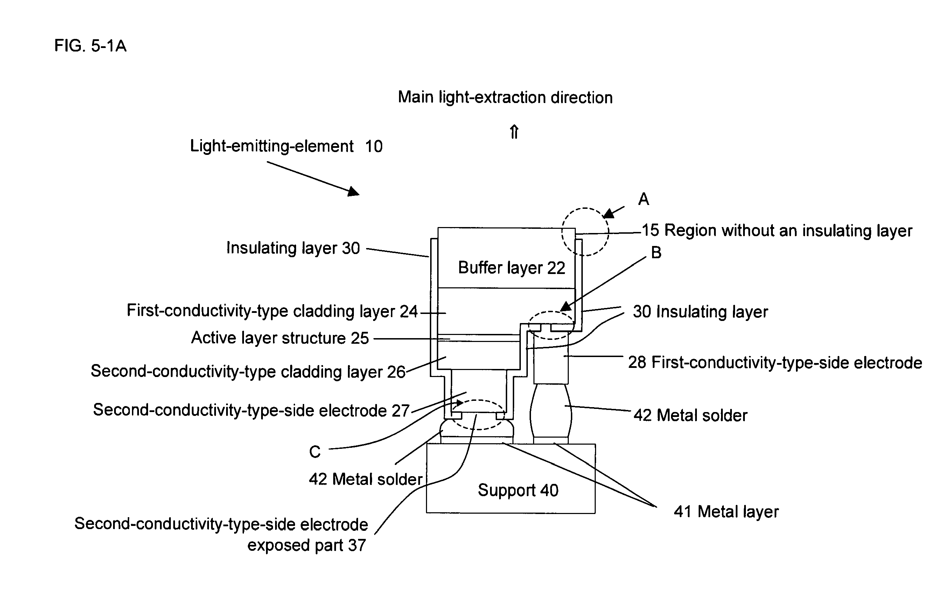

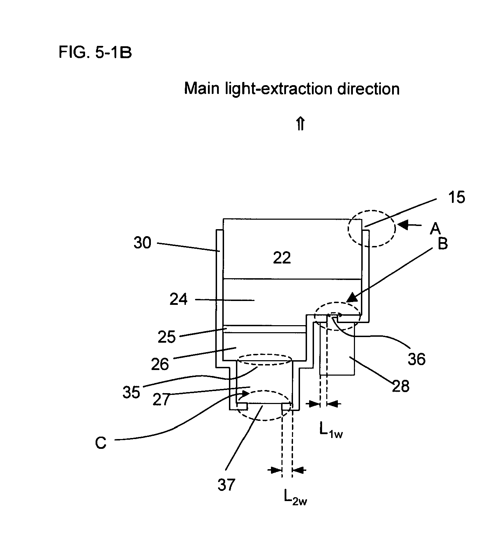

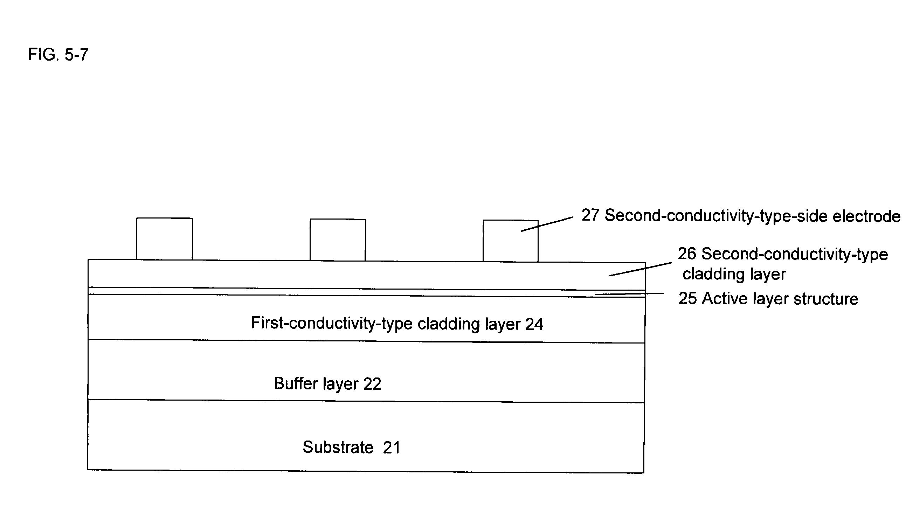

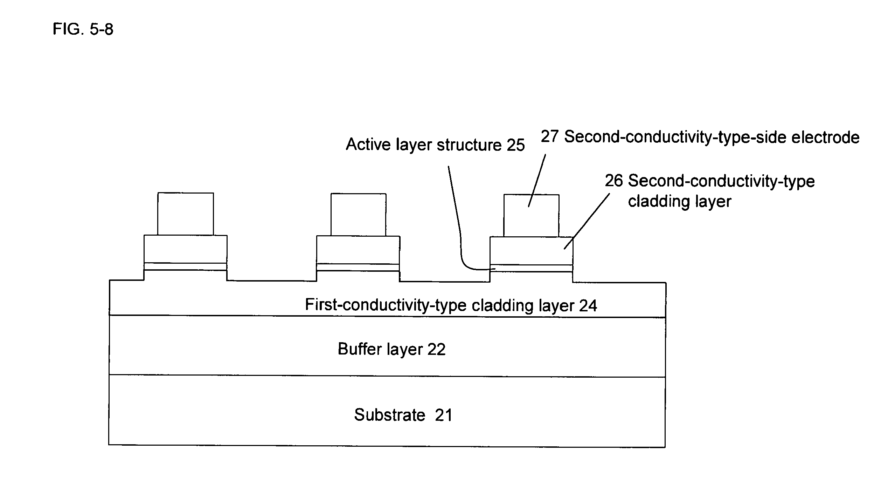

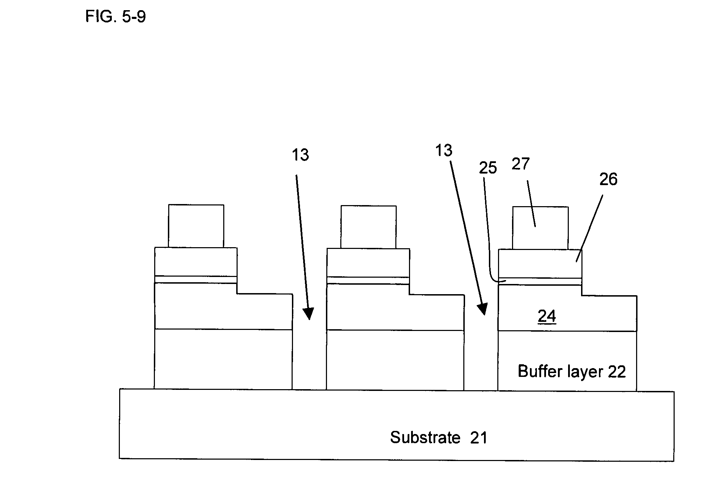

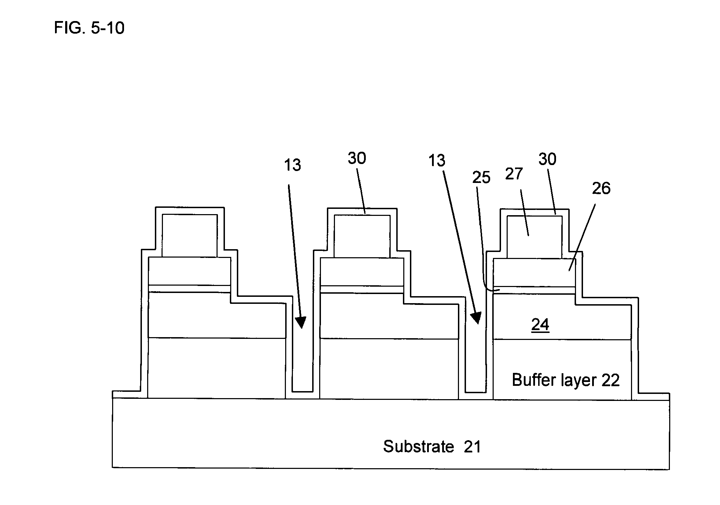

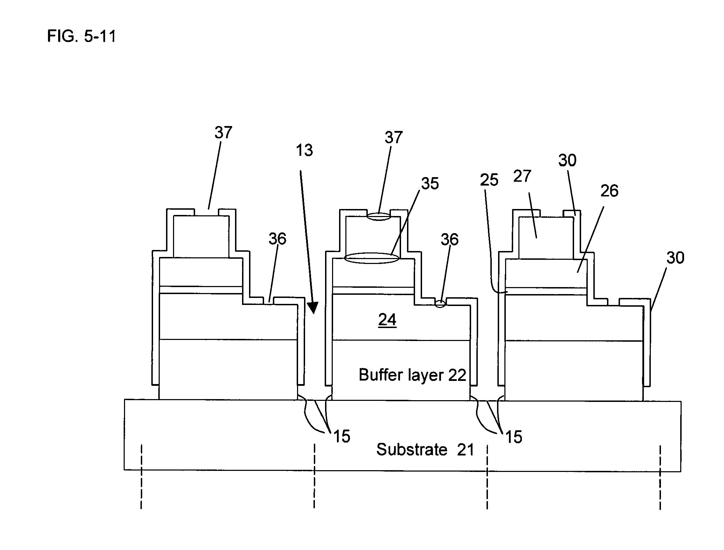

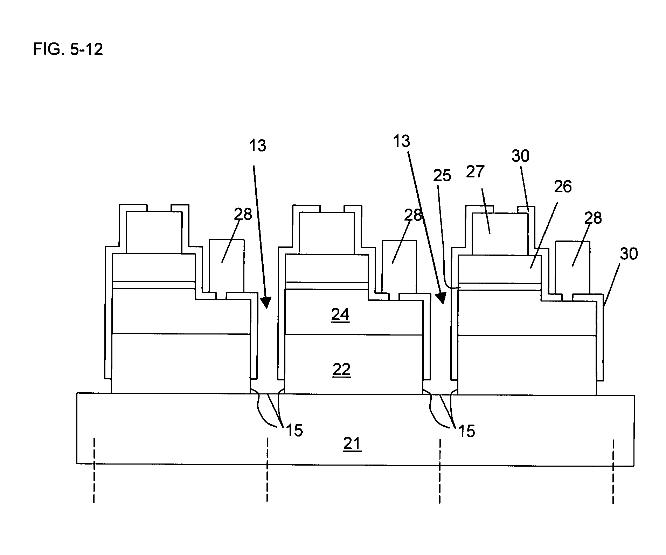

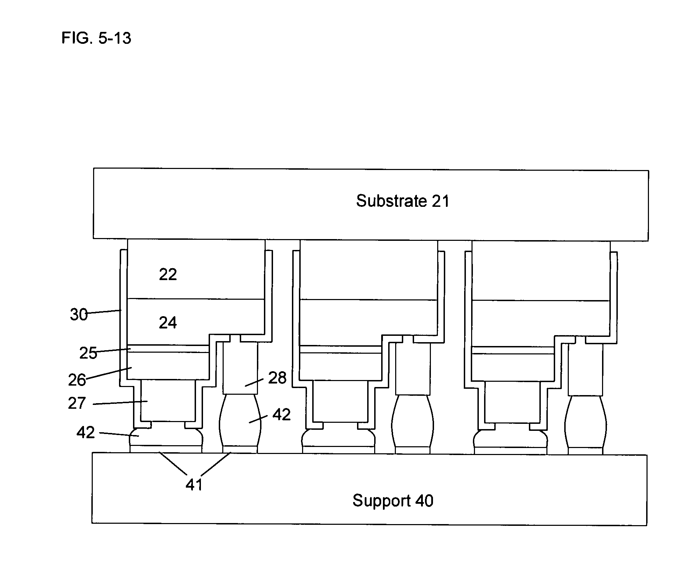

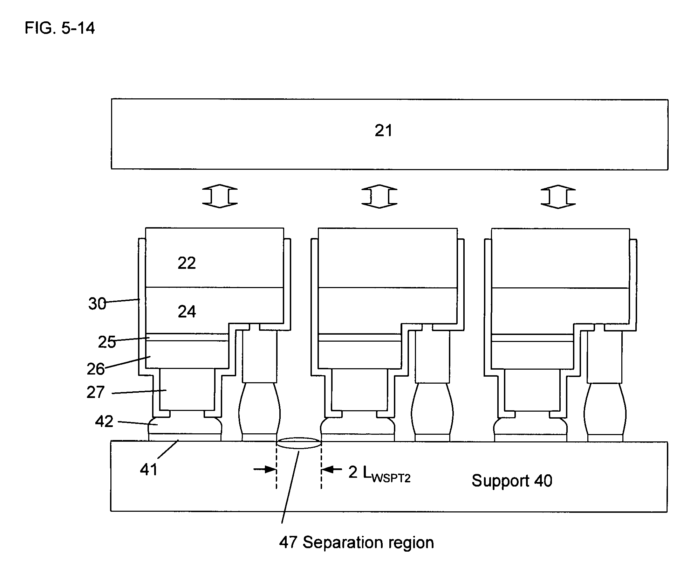

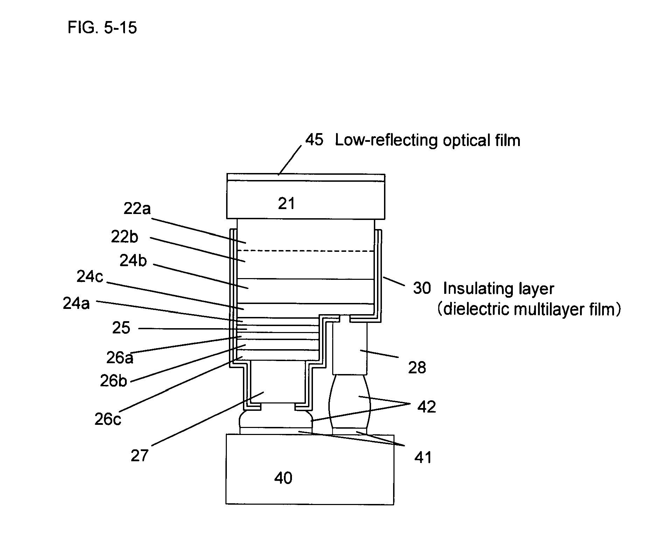

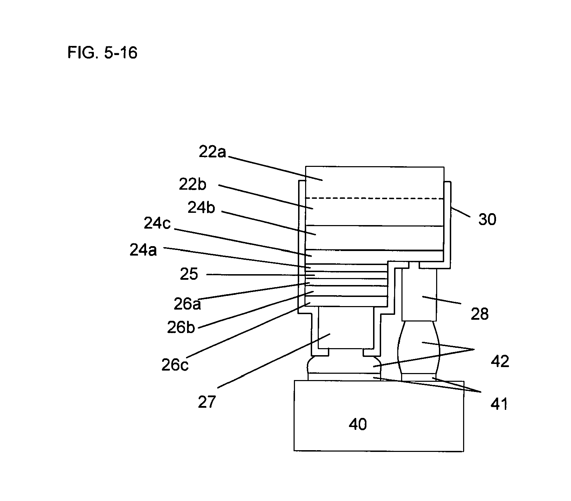

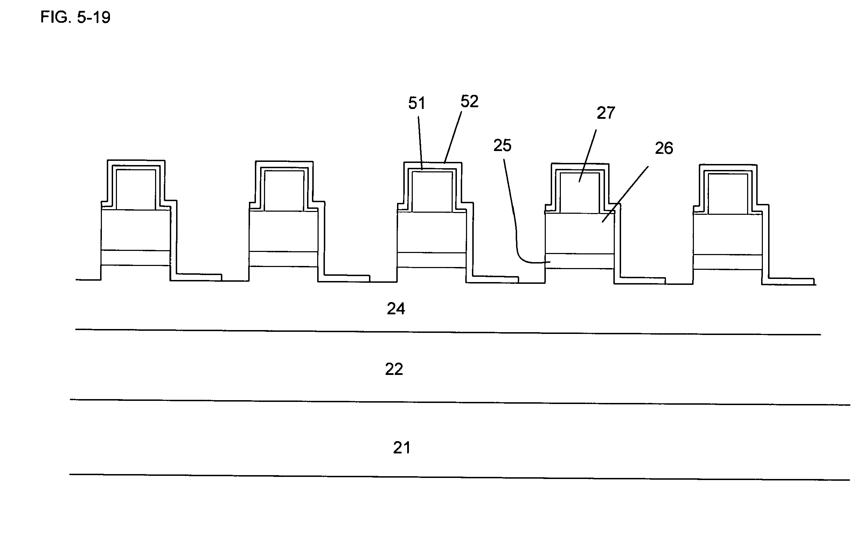

FIG. 5-1A shows an example of a light-emitting-element according to the first aspect disclosed in Section E.

FIG. 5-1B shows positional relationship in a light-emitting-element according to the first aspect disclosed in Section E.

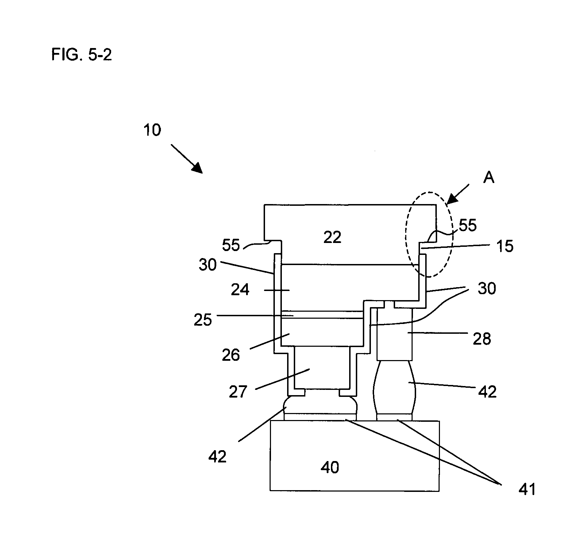

FIG. 5-2 shows an example of a light-emitting-element according to the first aspect disclosed in Section E.

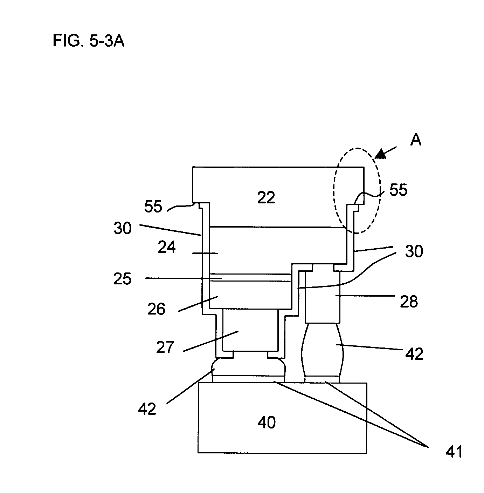

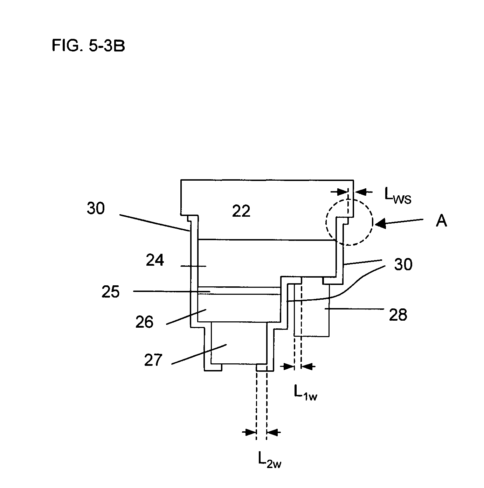

FIG. 5-3A shows an example of a light-emitting-element according to the second aspect disclosed in Section E.

FIG. 5-3B shows positional relationship in a light-emitting-element according to the second aspect disclosed in Section E.

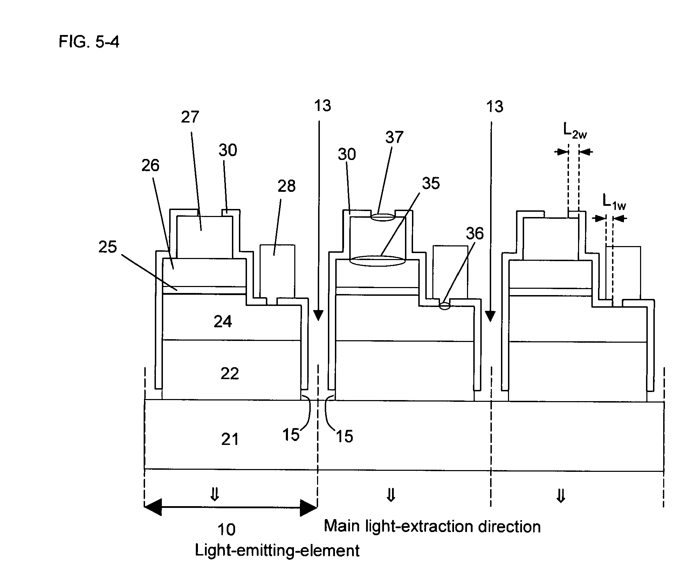

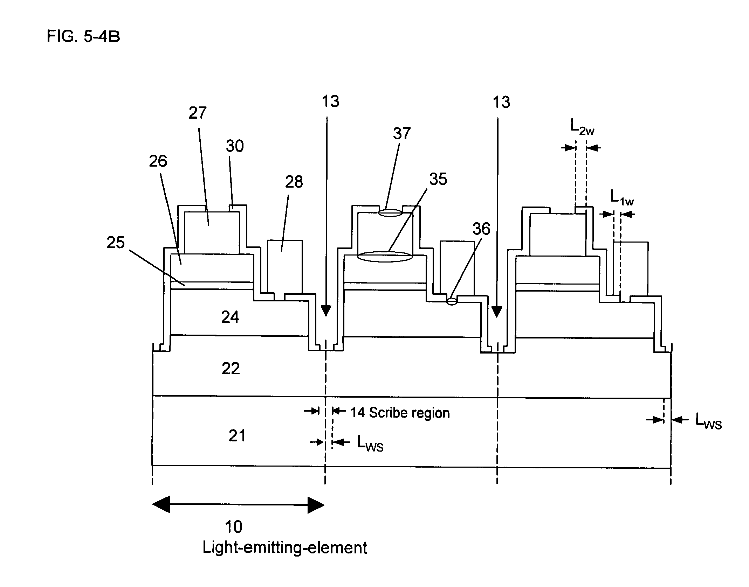

FIG. 5-4A shows an example of a structure before completion of a light-emitting-element according to the first aspect disclosed in Section E.

FIG. 5-4B shows an example of a structure before completion of a light-emitting-element according to the second aspect disclosed in Section E.

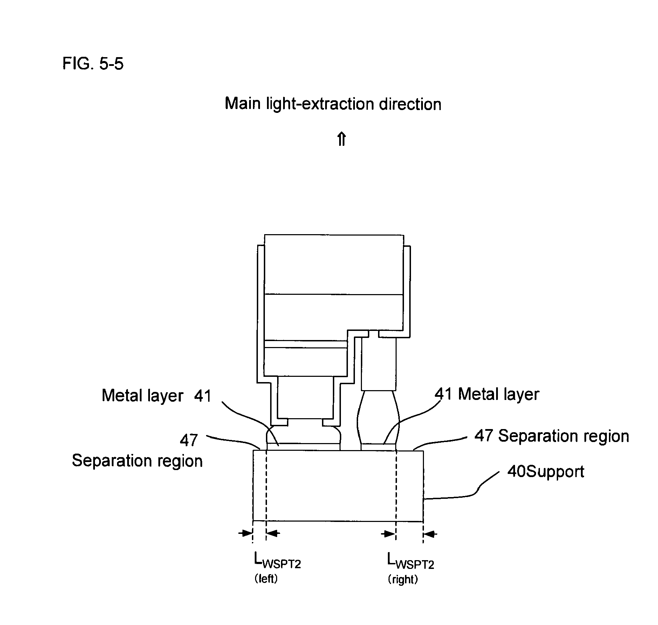

FIG. 5-5 shows positional relationship in a light-emitting-element according to an aspect of the present invention disclosed in Section E.

FIG. 5-7 is a process cross-sectional view illustrating an example of a manufacturing process disclosed in Section E.

FIG. 5-8 is a process cross-sectional view illustrating an example of a manufacturing process disclosed in Section E.

FIG. 5-9 is a process cross-sectional view illustrating an example of a manufacturing process disclosed in Section E.

FIG. 5-10 is a process cross-sectional view illustrating an example of a manufacturing process disclosed in Section E.

FIG. 5-11 is a process cross-sectional view illustrating an example of a manufacturing process disclosed in Section E.

FIG. 5-12 is a process cross-sectional view illustrating an example of a manufacturing process disclosed in Section E.

FIG. 5-13 is a process cross-sectional view illustrating an example of a manufacturing process disclosed in Section E.

FIG. 5-14 is a process cross-sectional view illustrating an example of a manufacturing process disclosed in Section E.

FIG. 5-15 shows a light-emitting-element manufactured in Example E-1 disclosed in Section E.

FIG. 5-16 shows a light-emitting-element manufactured in Example E-2 disclosed in Section E.

FIG. 5-19 is a process cross-sectional view illustrating one embodiment of a manufacturing process for a light-emitting-element of the present invention disclosed in Section E.

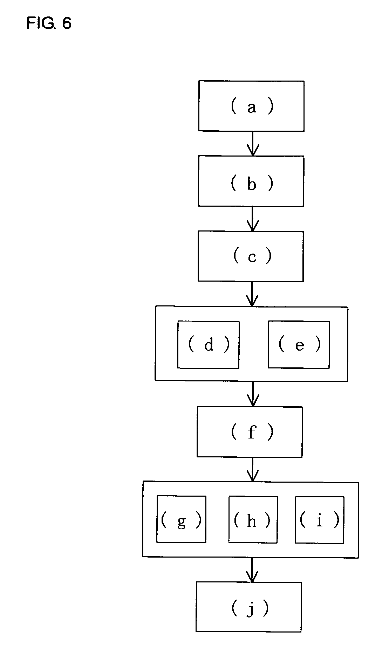

FIG. 6 is a flow chart illustrating the step order of a manufacturing process.

In the drawings, the symbols have the following meanings; 10: light-emitting-element, 13: light-emitting-element separation-trench, 14: scribe region, 15: region without an insulating layer (i.e. region where an insulating layer is not formed), 21: substrate, 22: buffer layer, 22a: first buffer layer, 22b: second buffer layer, 23: light-uniforming layer, 24: first-conductivity-type cladding layer, 24a: first-conductivity-type first cladding layer, 24b: first-conductivity-type second cladding layer, 24c: first-conductivity-type (n-type) contact layer, 25: active layer structure, 26: second-conductivity-type cladding layer, 26a: second-conductivity-type first cladding layer, 26b: second-conductivity-type second cladding layer, 26c: second-conductivity-type (p-type) contact layer, 27: second-conductivity-type-side electrode, 28: first-conductivity-type-side electrode, 30: insulating layer, 35: second current injection region, 36: first current injection region, 37: exposed surface of a second-conductivity-type-side electrode, 40: submount, 41: metal layer, 42: metal solder, 45: low-reflecting optical film, 50a: light-extraction-face, 50b: light-extraction-face, 51: first etching mask ($SiN_x$ and so on), 52: second etching mask (metal fluoride mask) and 55: edge-step-face.

Best Mode for Carrying the Invention

In the present application, the term, "stacked" or "overlap" may refer to, in addition to the state that materials are directly in contact with each other, the state that even when being not in contact with each other, one material spatially overlaps the other material when one is projected to the other, as long as it does not depart from the gist of the invention. The term, "over or on···(under ···)" may also refer to, in addition to the state that materials are directly in contact with each other and one is placed on (under) the other, the state that even when being not in contact with each other, one is placed over (below) the other, as long as it does not depart from the gist of the invention. Furthermore, the term, "after ··· (before or prior to ···)" may be applied to not only the case where one event occurs immediately after (before) another event, but also the case where a third event intervenes between one event and another subsequent (preceding) event. The term, "contact" may refer to, in addition to the case where "materials are directly in contact with each other", the case where "materials are indirectly in contact with each other via a third member without being not directly in contact with each other" or where "a part where materials are directly in contact with each other and a part where they are indirectly in contact with each other via a third member are mixed", as long as it fits the gist of the present invention.

Furthermore, in the present invention, the term, "thin-film crystal growth" may refer to formation of a thin-film layer, an amorphous layer, a microcrystal, a polycrystal, a single crystal or a stacked structure of these in a crystal growth apparatus by, for example, MOCVD(Metal Organic Chemical Vapor Deposition), MBE(Molecular Beam Epitaxy), plasma assisted MBE, PLD(Pulsed Laser Deposition), PED(Pulsed Electron Deposition), VPE(Vapor Phase Epitaxy) or LPE (Liquid Phase Epitaxy), including, for example, a subsequent carrier activating process of a thin-film layer such as heating and plasma treatment.

There will be described the present invention dividing it Sections A to F. In the description for each Section, the term "the present invention", may refer to, in addition to the invention related to a structure or process generally described in the Section, the invention related to a structure or process described in any other Section. However, when it is obvious that the term refers to the invention related to the structure or process described in the Section and is inconsistent with the invention of the other Sections, the term exclusively refers to the invention related to the structure or process described in the Section.

«Section A»

The invention disclosed in Section A relates to the followings.

[1] A compound semiconductor light-emitting-element comprising, on a substrate transparent to an emission wavelength, a compound semiconductor thin-film crystal layer having a first-conductivity-type semiconductor layer containing a first-conductivity-type cladding layer, an active layer structure and a second-conductivity-type semiconductor layer containing a second-conductivity-type cladding layer; a second-conductivity-type-side electrode; and a first-conductivity-type-side electrode, in which a main light-extraction direction is the side of the substrate, wherein:

the first-conductivity-type-side electrode and the second-conductivity-type-side electrode are not spatially overlapped and are formed on the opposite side to the main light-extraction direction;

the light-emitting-element comprises a light-uniforming layer, for improving uniformity of a light outgoing from a light-extraction-face, between the substrate and the first-conductivity-type semiconductor layer, and optionally a buffer layer between the substrate and the light-uniforming layer;

at the edge of the light-emitting-element, sidewalls of at least the first-conductivity-type semiconductor layer, the active layer structure and the second-conductivity-type semiconductor layer form a setback-sidewall-surface which recedes from the edge of the substrate on a sidewall surface of the thin-film crystal layer; and

the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) at least, covering the setback-sidewall-surface at a position distant from the light-emitting-element edge.

[2] The light-emitting-element as described in [1], having, in relation to the setback-sidewall-surface of the thin-film crystal layer, a configuration

(i) where a part of the light-uniforming layer forms a setback-sidewall-surface in combination and forms an edge-step-face with a non-setback-sidewall-surface which has not receded in the light-uniforming layer, or

(ii) where parts of the light-uniforming layer and of the buffer layer form a setback-sidewall-surface in combination and forms an edge-step-face with a non-setback-sidewall-surface which has not receded in the buffer layer, or

(iii) where the whole of the light-uniforming layer and of the buffer layer have receded and the exposed part of the substrate forms an edge-step-face; and

wherein the insulating film covers the edge-step-face from a position distant from the light-emitting-element edge, and the surface in line with the setback-sidewall-surface in the first-conductivity-type semiconductor layer.

[3] The light-emitting-element as described in [1], having, in relation to the setback-sidewall-surface of the thin-film crystal layer, a configuration

(i) where a part of the light-uniforming layer forms a setback-sidewall-surface in combination and forms an edge-step-face with a non-setback-sidewall-surface which has not receded in the light-uniforming layer, or

(ii) where parts of the light-uniforming layer and of the buffer layer form a setback-sidewall-surface in combination and forms an edge-step-face with a non-setback-sidewall-surface which has not receded in the buffer layer, or

(iii) where the whole of the light-uniforming layer and of the buffer layer have receded and the exposed part of the substrate forms an edge-step-face; and

wherein the insulating film covers at least a part of the setback-sidewall-surface of the light-uniforming layer and the buffer layer and does not cover the edge-step-face.

[4] The light-emitting-element as described in any of [1] to [3], wherein the light-uniforming layer is a layer formed between the substrate and the first-conductivity-type cladding layer as a part of the thin-film crystal layer.

[5] The light-emitting-element as described in any of [1] to [4], wherein when an average refractive index of the substrate is $n_{sb}$ and an average refractive index of the light-uniforming layer is $n_{oc}$ and an average refractive index of the first-conductivity-type semiconductor layer is $n_1$, each at an emission wavelength, the relation:

$$n_{sb} < n_{oc} \text{ and } n_1 < n_{oc}$$

is satisfied.

[6] The light-emitting-element as described in any of [1] to [5], wherein when an emission wavelength of the light-emitting-element is $\lambda$ (nm), an average refractive index of the substrate is $n_{sb}$ and an average refractive index of the light-uniforming layer is $n_{oc}$, each at an emission wavelength, and a physical thickness of the light-uniforming layer is $t_{oc}$ (nm) and where a relative refractive index difference $\Delta_{(oc\text{-}sb)}$ between the light-uniforming layer and the substrate is defined as:

$$\Delta_{(oc\text{-}sb)} \equiv ((n_{oc})^2 - (n_{sb})^2)/(2 \times (n_{oc})^2),$$

$t_{oc}$ is selected such that the relation:

$$(\sqrt{(2 \times \Delta_{(oc\text{-}sb)})} \times n_{oc} \times \pi \times t_{oc})/\lambda \geq \pi/2$$

is satisfied.

[7] The light-emitting-element as described in any of [1] to [6], wherein when an emission wavelength of the light-emitting-element is $\lambda$ (nm), an average refractive index of the light-uniforming layer at an emission wavelength is $n_{oc}$, an average refractive index of the first-conductivity-type semiconductor layer at an emission wavelength is $n_1$ and a physical thickness of the light-uniforming layer is $t_{oc}$ (nm) and a relative refractive index difference $\Delta_{(oc\text{-}1)}$ between the light-uniforming layer and the first-conductivity-type semiconductor layer is defined as

$$\Delta_{(oc\text{-}1)} \equiv ((n_{oc})^2 - (n_1)^2)/(2 \times (n_{oc})^2),$$

$t_{oc}$ is selected such that the relation:

$$(\sqrt{(2 \times \Delta_{(oc\text{-}1)})} \times n_{oc} \times \pi \times t_{oc})/\lambda \geq \pi/2$$

is satisfied.

[8] The light-emitting-element as described in any of [1] to [7],

$$0.5 \leq \rho_{oc} \quad .$$

[9] The light-emitting-element as described in any of [1] to [8], wherein the light-uniforming layer has a stacked structure consisting of multiple layers.

[10] The light-emitting-element as described in any of [1] to [9], wherein the narrowest width $L_{1w}$ of a part where the first-conductivity-type-side electrode is contacting the insulating layer is 5 $\mu$m or more.

[11] The light-emitting-element as described in any of [1] to [10], wherein the narrowest width $L_{2w}$ of a part where the second-conductivity-type-side electrode is covered by the insulating layer is 15 $\mu$m or more.

[12] The light-emitting-element as described in [11], wherein the $L_{2w}$ is 100 $\mu$m or more.

[13] The light-emitting-element as described in any of [1] to [12], wherein the narrowest width $L_{ws}$ of an end-face-part on the substrate surface exposed by recession of the sidewall surface of the thin-film crystal layer and uncovered by the insulating layer is 15 $\mu$m or more.

[14] The light-emitting-element as described in any of [1] to [13], wherein the first-conductivity-type-side electrode comprises a layer made of material containing an element selected from the group consisting of Ti, Al, Ag, Mo and a combination of two or more of these.

[15] The light-emitting-element as described in any of [1] to [14], wherein the second-conductivity-type-side electrode comprises a layer made of material containing an element selected from the group consisting of Ni, Pt, Pd, Mo, Au and a combination of two or more of these.

[16] The light-emitting-element as described in any of [1] to [15], wherein the insulating layer is a single layer of material selected from the group consisting of $SiO_x$, $AlO_x$, $TiO_x$, $TaO_x$, $HfO_x$, $ZrO_x$, $SiN_x$, $AlN_x$, $AlF_x$, $BaF_x$, $CaF_x$, $SrF_x$ and $MgF_x$.

[17] The light-emitting-element as described in any of [1] to [15], wherein the insulating layer is a dielectric multilayer film consisting of multiple layers.

[18] The light-emitting-element as described in [17], wherein at least one of the layers constituting the insulating layer is made of material containing fluoride.

[19] The light-emitting-element as described in [18], wherein the fluoride is selected from the group consisting of $AlF_x$, $BaF_x$, $CaF_x$, $SrF_x$ and $MgF_x$.

[20] The light-emitting-element as described in any of [1] to [19], wherein when R2 is a reflectance of reflection by the light-uniforming layer, of a light having an emission wavelength of the light-emitting-element vertically incoming from the first-conductivity-type semiconductor layer side to the light-uniforming layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

(Relation 1) R2 < R12
(Relation 2) R2 < R11
(Relation 3) R2 < R1q

are satisfied.

[21] The light-emitting-element as described in any of [1] to [20], wherein the substrate is selected from the group consisting of sapphire, SiC, GaN, $LiGaO_2$, ZnO, $ScAlMgO_4$, $NdGaO_3$ and MgO.

[22] The light-emitting-element as described in any of [1] to [21], wherein the surface of the light-extraction side of the substrate is not flat.

[23] The light-emitting-element as described in any of [1] to [22], wherein when R3 is a reflectance of reflection by the substrate, of a light having an emission wavelength of the light-emitting-element vertically incoming from the light-uniforming layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

R4 < R3

is satisfied.

[24] The light-emitting-element as described in any of [1] to [23], wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

[25] The light-emitting-element as described in any of [1] to [24], wherein the active layer structure consists of quantum well layer and barrier layer and when B is the number of the barrier layer and W is the number of the quantum well layer, B and W satisfy the relation:

B = W+1.

[26] The light-emitting-element as described in any of [1] to [25], wherein the first-conductivity-type is n-type and the second-conductivity-type is p-type.

[27] The light-emitting-element as described in any of [1] to [25], wherein the first-conductivity-type-side electrode and the second-conductivity-type-side electrode are bonded to a submount having a metal layer via a solder.

According to the invention disclosed in this Section, there can be provided a flip-chip mount type semiconductor light-emitting-element capable of emitting blue or ultraviolet light with higher output and higher efficiency and with higher uniformity in brightness in a light-extraction-face.

In the structure of the invention disclosed in this Section, process damage in each step in the manufacturing process is eliminated, so that a highly reliable element is provided without deterioration in the functions of the light-emitting-element.

FIGs. 1-1A and 1-2A show a typical example of a compound semiconductor light-emitting-element according to the invention disclosed in this Section (hereinafter, simply referred to as "light-emitting-element"). FIGs. 1-1B and 1-2B are figures in which some portions of FIGs. 1-1A and 1-2A are omitted, respectively for explanation and FIGs. 1-3A and 1-3B are figures showing structures in the course of the manufacturing process for detailing the structure of the light-emitting-element. The present invention will be described with reference to FIGs. 1-1A to 1-3B.

A light-emitting-element according to the invention disclosed in this Section has, as shown in FIGs. 1-1A and 1-2A, on a substrate 21, a compound semiconductor thin-film crystal layer having a buffer layer 22, a light-uniforming layer 23, a first-conductivity-type semiconductor layer containing a first-conductivity-type cladding layer 24, a second-conductivity-type semiconductor layer containing a second-conductivity-type cladding layer 26, and an active layer structure 25 sandwiched between the first and the second-conductivity-type semiconductor layers; a second-conductivity-type-side electrode 27; and a first-conductivity-type-side electrode 28.

On a part of the second-conductivity-type cladding layer 26, the second-conductivity-type-side electrode 27 is disposed and the part where the second-conductivity-type cladding layer 26 and the second-conductivity-type-side electrode 27 are in contact with each other is a second current injection region 35. In this configuration, parts of the second-conductivity-type cladding layer and the active layer structure, and a part of the first-conductivity-type cladding layer are removed. The first-conductivity-type-side electrode 28 is disposed in contact with the first-conductivity-type cladding layer 24 exposed in the removed part, so that the second-conductivity-type-side electrode 27 and the first-conductivity-type-side electrode 28 are disposed on the same side in relation to the substrate. The second-conductivity-type-side electrode 27 and the first-conductivity-type-side electrode 28, each, is connected to metal layer 41 on a submount 40 via metal solder 42.

In the present invention, the first-conductivity-type-side electrode and the second-conductivity-type-side electrode are not spatially overlapped. This means that as shown in FIGs. 1-1A and 1-2A, when the first-conductivity-type-side electrode 28 and the second-conductivity-type-side electrode 27 are projected to the substrate surface, their shadows are not overlapped.

An insulating layer 30 is formed for preventing unintended short circuit due to a solder or a conductive paste material for mounting entering/going around, for example, "between the second-conductivity-type-side electrode and the first-conductivity-type-side electrode" or "a sidewall of a thin-film crystal layer such as an active layer structure" during flip-chip mounting. At the same time, in the present invention, an insulating layer is disposed at the optimal position for avoiding influence of damage on element performance or on an yield.

The light-emitting-element according to the invention disclosed in this Section may have a different configuration in two portions, that is, (I) a step shape of an edge in a light-emitting-element and (II) a shape of an insulating film in a light-emitting-element edge. In terms of (I) the step shape of the edge in a light-emitting-element, there are generally three options, depending on an etching depth when forming a light-emitting-element separation-trench for element separation in the manufacturing process, i.e. (i) the depth to the intermediate portion of the light-uniforming layer, (ii) the depth to the intermediate portion of the buffer layer (in the presence of the buffer layer, the same shall apply hereinafter) and (iii) the depth to the substrate surface (or deeper). Furthermore, the wall surface of the light-emitting-element separation-trench recedes from the element edge after element separation. In the present invention, the surface that has been appeared as sidewall surface after forming the light-emitting-element separation-trench is, therefore, referred as a "setback-sidewall-surface" in the element after element separation. The sidewall surface appearing in the element edge by the element separation is called a "non-setback-sidewall-surface". Then, in the edge of the light-emitting-element, a step face is formed between the setback-sidewall-surface and the non-setback-sidewall-surface, which is called an "edge-step-face".

Depending on the depth (i) to (iii) in the light-emitting-element separation-trench, in the case of (i), a part of the light-uniforming layer forms a setback-sidewall-surface in combination with a thin-film crystal layer while the remaining (in the main light-extraction direction side) sidewall of the light-uniforming layer forms a non-setback-sidewall-surface, and there is an edge-step-face on the edge of the light-uniforming layer. Similarly, in the case of (ii), there is an edge-step-face on the edge of the buffer layer. In the case of (iii), both sidewalls of the light-uniforming layer and the buffer layer form setback-sidewall-surface (because they are a sidewall surface of the light-emitting-element separation-trench), so that the exposed part of the substrate is an edge-step-face.

The shape corresponding to (i) is shown in FIGs. 1-1C and 1-2C. The shape corresponding to (ii) is shown in FIGs. 1-1D, 1-2D and 1-2E. The shape corresponding to (iii) is shown in FIGs. 1-1A (1-1B) and 1-2A (1-2B).

In terms of (II) the shape of the insulating film in the light-emitting-element edge, there are options, in the manufacturing process, (i) removing only the insulating layer in the region including the middle part over the trench bottom surface while leaving the insulating layer formed in the sidewall of the light-emitting-element separation-trench and (ii) removing a part of the insulating layer on the sidewall within the trench, in addition to the whole insulating layer formed in the trench bottom surface. In a light-emitting-element thus manufactured, there are provided two shapes, that is, (i) a shape where the insulating film is in contact with the trench bottom surface and (ii) a shape where the insulating film is present apart from the trench bottom surface. The shape corresponding to (i) is shown in FIGs. 1-1A (1-1B), 1-1C and 1-1D. The shape corresponding to (ii) is shown in FIGs. 1-2A (1-2B), 1-2C, 1-2D and 1-2E.

A shape of the light-emitting-element of the invention disclosed in this Section will be described, dividing it into (i) a first aspect and (ii) a second aspect, depending on (II) the shape of the insulating film of the light-emitting-element edge.

First aspect

A configuration belonging to the first aspect is shown in FIGs. 1-1A to 1-1D. First, there will be described a typical embodiment using FIG. 1-1A. At least the sidewall surfaces of the first-conductivity-type semiconductor layer, the active layer structure and the second-conductivity-type semiconductor layer among the thin-film crystal layers have receded from the edge of the substrate. This shape is seen in all the embodiments of the present invention. It is because, as shown in FIG. 1-3A, after depositing thin-film crystal layers in the manufacturing process, a light-emitting-element separation-trench 13 is formed by removing the thin-film crystal layers to a predetermined depth as described later for separating elements to separate the elements in the separation trench. FIG. 1-1A shows an example in which the thin-film crystal layers have been removal to the level of the substrate, which is one of preferred embodiments of the present invention. In the present invention, the elements are separated without exposing the thin-film crystal layers, particularly a first-conductivity-type semiconductor layer, an active layer structure and a second-conductivity-type semiconductor layer which are parts involved in essential functions such as current injection and light emitting, to the processes generally used for element separation such as scribing and breaking, so that the thin-film crystal layers involved in element performance is not directly damage. Thus, there is provided an element exhibiting good performance such as tolerance and reliability, particularly in a large current injection.

The sidewall surface exposed after removing the thin-film crystal layers is covered by the insulating layer 30. Furthermore, before separating elements, the insulating layer 30 does not cover the whole trench bottom surface of the light-emitting-element separation-trench 13 and a scribe region 14 where the insulating layer 30 is not formed in the substrate surface (that is, the trench bottom surface), as shown in FIG. 1-3A. Since only the substrate has to be scribed or broken in the element separation such as scribing and breaking in the manufacturing process, the thin-film crystal layers are never directly damaged. Furthermore, since detachment of the insulating layer does not occur, insulation is ensured and the thin-film crystal layers are not damaged due to tension generated during detachment of the insulating layer.

In a resultant light-emitting-element after separation, as shown in part A (dotted line circle) in FIGs. 1-1A and 1-1B, the sidewall surface of the thin-film crystal layer has receded and the insulating layer does not cover the whole exposed substrate surface, but covers the substrate surface inside from the position distant from the edge of the substrate 21 by $L_{ws}$. In the case that the division is performed from the middle of the width of the scribe region 14, a distance $L_{ws}$ without covering by the insulating layer corresponds to about 1/2 of the width of the scribe region 14 within the range of production fluctuation. In other words, formation of this configuration ensures that detachment of the insulating layer in the side of the thin-film crystal layer is avoided, so that in this light-emitting-element, unintended short circuit is prevented even if running around of a solder occurs and furthermore, the thin-film crystal layer is not damaged, so that the functions of the light-emitting-element are not deteriorated, resulting in a highly reliable element.

$L_{ws}$ has to be larger than 0 in a completed element and is generally 10 $\mu$m or more, preferably 15 $\mu$m or more. As a designed value, when the width of the scribe region 14 is $2L_{ws}$, $2L_{ws}$ is preferably 30 $\mu$m or more. Since an excessively large value is unnecessary, $2L_{ws}$ is generally 300 $\mu$m or less, preferably 200 $\mu$m or less.

In another preferred embodiment, the light-emitting-element separation-trench may be formed to the intermediate portion of the light-uniforming layer or the buffer layer. As a result, in a completed device, at least the first-conductivity-type semiconductor layer, the active layer structure and the second-conductivity-type semiconductor layer have receded inside from the edge (substrate edge) of the device to form a setback-sidewall-surface and there is formed an edge-step-face based on the trench bottom surface in the edge of the light-emitting-element. In FIG. 1-1A, the substrate surface itself corresponds to the step face.

FIG. 1-1C shows an example of a light-emitting-element in which a light-emitting-element separation-trench is formed to the intermediate portion of the light-uniforming layer 23. As shown in part A (dotted line circle in FIG), to the light-emitting-element edge, there are a buffer layer 22 and a part of the light-uniforming layer 23 as a non-setback-sidewall-surface and from the intermediate portion of the light-uniforming layer 23, the wall surface has receded from the element edge and forms a setback-sidewall-surface (the sidewall of the light-emitting-element separation-trench) in combination with the sidewall surface of the second-conductivity-type semiconductor layer. There is an edge-step-face 55 based on the bottom surface of the light-emitting-element separation-trench between the non-setback-sidewall-surface and the setback-sidewall-surface. The whole wall surface of the buffer layer is exposed. On the other hand, as shown in part A (dotted line circle) in FIG. 1-1C, the non-setback-sidewall-surface in the sidewall of the light-uniforming layer 23 is exposed and the setback-sidewall-surface is covered by the insulating layer 30, which continuously covers from the position distant from the edge (the position corresponding to $L_{ws}$ in FIG. 1-1B) in the edge-step-face 55 inwardly to the setback-sidewall-surface. This corresponds to a configuration where the light-emitting-element separation-trench is stopped in the intermediate portion of the light-uniforming layer 23 in FIG. 1-1A(FIG. 1-1B).

FIG. 1-1D shows an example of a light-emitting-element where a light-emitting-element separation-trench is formed to the intermediate portion of the buffer layer 22. As shown in part A (dotted line circle), there is the buffer layer to the light-emitting-element edge. There is an edge-step-face, based on the bottom surface of the light-emitting-element separation-trench, in the buffer layer, which includes the non-setback-sidewall-surface (the element edge) and the part of the setback-sidewall-surface (the sidewall of the light-emitting-element separation-trench) inside from the light-emitting-element edge, in the sidewall of the buffer layer. As shown in part A (dotted line circle) in FIG. 1-1D, in the sidewall of the buffer layer 22, the non-setback-sidewall-surface is exposed without being covered by the insulating layer while the part of the setback-sidewall-surface is covered by the insulating layer 30, which continuously covers from a position distant from the edge (the position corresponding to $L_{ws}$ in FIG. 1-1B) inwardly to the setback-sidewall-surface, in the edge-step-face 55. This corresponds to a configuration where the light-emitting-element separation-trench is stopped in the intermediate portion of the buffer layer 22 in FIG. 1-1A (FIG. 1-1B).

As illustrated in these examples, even when the light-emitting-element separation-trench is formed to the intermediate portion of the layer of the combination of the light-uniforming layer and the buffer layer, prevention of detachment of the insulating layer is ensured in a device having a configuration that the insulating layer covering the sidewall does not reach the edge of the light-emitting-element, and like the light-emitting-element of the configuration shown in FIG. 1-1A, a highly reliable device can be provided by forming the exposed layer using a high insulative material.

Second aspect

Embodiments belonging to the second aspect are shown in FIGs. 1-2A to 1-2E. In the second aspect, a layer configuration and so on are the same as described for the first aspect, but (II) the shape of the insulating film in the light-emitting-element edge is different.

First, as shown in FIG. 1-2A, at least sidewall surfaces of the first-conductivity-type semiconductor layer, the active layer structure and the second-conductivity-type semiconductor layer among the thin-film crystal layers have receded from the edge of the substrate, to form a setback-sidewall-surface. This shape is seen in all the embodiments of the present invention. It is because, as shown in FIG. 1-3B, after depositing thin-film crystal layers in the manufacturing process, a light-emitting-element separation-trench 13 is formed by removing the thin-film crystal layers as described later for separating elements to separate the elements in the separation trench. As in the other aspects of the invention disclosed in this Section, the insulating layer 30 covers the sidewall surfaces of at least a first-conductivity-type semiconductor layer (a first-conductivity-type cladding layer 24 in the figure), an active layer structure 25 and a second-conductivity-type semiconductor layer (a second-conductivity-type cladding layer 26 in the figure) among the sidewall surfaces exposed after removing the thin-film crystal layers.

In the second aspect, the insulating layer 30 is not present even in the part corresponding to the light-emitting-element separation-trench bottom surface in the surface of the substrate 21. In the setback-sidewall-surface of the thin-film crystal layer, a part without an insulating layer 15 uncovered by an insulating layer is present at least in the main light-extraction direction side of the sidewall surface of the buffer layer 22, and may extend to the whole sidewall surface of the buffer layer 22. Furthermore, it may extend to a part or the whole of the sidewall surface of the light-uniforming layer 23. When etching proceeds into a part of the substrate to form the light-emitting-element separation-trench, only the substrate part may be exposed in the wall surface of the trench while the buffer layer is covered.

In such cases, the buffer layer in the part without an insulating layer 15 which is not covered by the insulating layer is preferably an undoped layer which is not doped. When the part without an insulating layer 15 extends to the light-uniforming layer 23, layers to that portion is preferably an undoped layer which is not doped. When the exposed part is made of a high insulative material, defects such as short circuit due to running around of a solder do not occur, resulting in a highly reliable element.

This structure corresponds to a configuration before element separation in the course of the manufacturing process as shown in FIG. 1-3B, and the insulating layer 30 is removed from the substrate surface within the trench of the light-emitting-element separation-trench 13 and from the part without an insulating layer 15 in the trench sidewall surface near the substrate surface.

The insulating layer 30 is not formed in the part in contact with the substrate and therefore, only the substrate has to be scribed or broken in the element separation such as scribing and breaking in the manufacturing process. Therefore, the thin-film crystal layers are never directly damaged. Furthermore, since detachment of the insulating layer does not occur, insulation is ensured and the thin-film crystal layers are not damaged due to tension generated during detachment of the insulating layer.

In a resultant light-emitting-element after separation, as shown in part A (dotted line circle) in FIGs. 1-2A and 1-2B, the insulating layer does not cover the whole exposed substrate surface which has been formed by recession of the sidewall surface in the thin-film crystal layer. Formation of this configuration ensures elimination of detachment of the insulating layer in the side of the thin-film crystal layer, so that in this light-emitting-element, unintended short circuit is prevented even if running around of a solder occurs and furthermore, the thin-film crystal layer is not damaged, so that the functions of the light-emitting-element are not deteriorated, resulting in a highly reliable element.

In the second aspect, it is also a preferable embodiment that the light-emitting-element separation-trench is formed to the intermediate portion of the light-uniforming layer or the buffer layer. As a result, in a completed device, at least the first-conductivity-type semiconductor layer, the active layer structure and the second-conductivity-type semiconductor layer recede inside from the edge (substrate edge) of the device and there is formed an edge-step-face based on the trench bottom surface in the edge of the light-emitting-element.

FIG. 1-2C shows an example of a light-emitting-element in which a light-emitting-element separation-trench is formed to the intermediate portion of the light-uniforming layer 23. As shown in part A (dotted line circle in FIG), to the light-emitting-element edge, there are a buffer layer 22 and a part of the light-uniforming layer 23 as a non-setback-sidewall-surface and from the intermediate portion of the light-uniforming layer 23, the wall surface has receded from the element edge and forms a setback-sidewall-surface (the sidewall of the light-emitting-element separation-trench) in combination with the sidewall surface of the second-conductivity-type semiconductor layer. There is an edge-step-face 55 based on the bottom surface of the light-emitting-element separation-trench between the non-setback-sidewall-surface and the setback-sidewall-surface. The whole wall surface of the buffer layer is exposed. The edge-step-face of the light-uniforming layer is also not covered by the insulating layer, and there is a part without an insulating layer 15 which is not covered by the insulating layer in the main light-extraction direction side in the setback-sidewall-surface. This corresponds to a configuration that the light-emitting-element separation-trench is stopped in the intermediate portion of the light-uniforming layer 23 in FIG. 1-2A (1-2B).

FIGs. 1-2D and 1-2E show an example of a light-emitting-element where a light-emitting-element separation-trench is formed to the intermediate portion of the buffer layer 22. As shown in part A (dotted line circle in FIGs), a part of the buffer layer 22 is present as a non-setback-sidewall-surface to the light-emitting-element edge, and from the intermediate portion of the buffer layer 22, the wall surface recesses from the element edge and forms a setback-sidewall-surface (the sidewall of the light-emitting-element separation-trench) in combination with the sidewall surface of the second-conductivity-type semiconductor layer. There is an edge-step-face 55 based on the bottom surface between the non-setback-sidewall-surface and the setback-sidewall-surface. The non-setback-sidewall-surface (the sidewall part of the element edge) and the edge-step-face are not covered by the insulating layer. And in the setback-sidewall-surface (the sidewall of the light-emitting-element separation-trench), there is a part without an insulating layer 15 which is not covered by the insulating layer in the main light-extraction direction side. This corresponds to a configuration that in FIG. 1-2A (1-2B), the light-emitting-element separation-trench is stopped in the intermediate portion of the buffer layer 22. The part without an insulating layer 15 may extend to the whole sidewall surface of the buffer layer 22. Furthermore, it may extend to a part or the whole of the sidewall surface of the light-uniforming layer 23 as shown in FIG. 1-2E.

As illustrated in these examples, even when the light-emitting-element separation-trench is formed to the intermediate portion of the layer as a combination of the light-uniforming layer and the buffer layer, prevention of detachment of the insulating layer is ensured in the device having a configuration that the insulating layer covering the sidewall does not reach the edge of the light-emitting-element. Also by forming the exposed layer using a high insulative material, a highly reliable device can be provided, similarly to the light-emitting-element of the configuration shown in FIG. 1-2A.

In common to the first and the second aspects, the insulating layer 30 is in contact with a part of the first-conductivity-type-side electrode 28 at the side of the substrate (at the side of the main light-extraction direction) in the present invention as shown in part B (dotted line circle) in FIGs. 1-1B and 1-2B. In other words, the insulating layer intervenes partly between the first-conductivity-type-side electrode 28 and the first-conductivity-type semiconductor layer (in this embodiment, the first-conductivity-type cladding layer 24). As a result, an area of the first-conductivity-type-side electrode 28 is larger than an area of the first current injection region 36. As shown in FIGs. 1-1B and 1-2B, when $L_{1w}$ is the narrowest width in the part of the first-conductivity-type-side electrode in contact with the insulating layer, $L_{1w}$ is preferably 7 $\mu$m or more, particularly preferably 9 $\mu$m or more. Furthermore, $L_{1w}$ is generally 500 $\mu$m or less, preferably 100 $\mu$m or less. In general, when it is 5 $\mu$m or more, a process margin by a photolithography process and a liftoff procedure can be ensured.

Furthermore, as shown in part C (dotted line circle) in FIGs. 1-1B and 1-2B, the insulating layer 30 cover a part of the second-conductivity-type-side electrode 27 on the submount side (i.e. the opposite side to the main light-extraction direction). In other words, an area of the exposed part 37 in the second-conductivity-type-side electrode 27 is smaller than an area of the second-conductivity-type-side electrode 27, and an area of the second current injection region 35 is equal to an area of the second-conductivity-type-side electrode 27. As shown in FIGs. 1-1B and 1-2B, when $L_{2W}$ is the narrowest width in the part covered by the insulating layer around the second-conductivity-type-side electrode, $L_{2W}$ is preferably 15 $\mu$m or more. It is further preferably 30 $\mu$m or more, particularly preferably 100 $\mu$m or more. Covering many of the area of the second-conductivity-type-side electrode by the insulating layer particularly allows for reducing unintended short circuit with another part such as the first-conductivity-type-side electrode via a metal solder material. $L_{2w}$ is generally 2000 $\mu$m or less, preferably 750 $\mu$m or less.

Furthermore, the insulating layer 30 generally also covers the exposed part of the surface of the submount side (the opposite side to the main light-extraction direction) in the first-conductivity-type semiconductor layer (the first-conductivity-type cladding layer 24 in this embodiment) and the second-conductivity-type semiconductor layer (the second-conductivity-type cladding layer 26 in this embodiment) for preventing short circuit as shown in the figure.

Such a positional relationship between the insulating layer and each electrode means that an element can be manufactured by a process with less process damage.

In the present invention, as described above, the insulating layer is disposed, based on comprehensive consideration of factors such as process damage, and heat dissipation properties and insulation properties when flip-chip mount is employed.

Furthermore, the element of the invention disclosed in this Section has the light-uniforming layer 23 in a light-extraction direction in relation to the first-conductivity-type semiconductor layer (in this embodiment, the first-conductivity-type cladding layer 24). The light-uniforming layer, as detailed later, has an appropriate optical confinement effect, so that a light emitted from the active layer structure 25 is distributed over the whole light-uniforming layer without being localized. Thus, looking from the light-extraction-face 50a of the substrate, the light is also distributed in a region corresponding to a non-emitting portion where an active layer is not present for the formation of the first-conductivity-type-side electrode 28. And even when an emitted light is uneven in the active layer, the light is distributed to improve uniformity. Furthermore, since the periphery of the light-uniforming layer 23 is covered by the insulating film 30, a reflectance of the insulating layer 30 to an emission wavelength can be increased to improve an optical confinement effect within the light-uniforming layer, resulting in further improvement in in-plane uniformity.

There will be further detailed the materials and the structures constituting a device.

<u>Substrate</u>

There are no particular restrictions to a material for the substrate 21 as long as it is substantially optically transparent to an emission wavelength of the element. The term "substantially transparent" means that the substrate does not absorb the light in the emission wavelength or if any, a light output is not decreased by 50 % or more by absorption by the substrate.

The substrate is preferably an electrically insulative substrate. It is because even if a solder material adheres to the periphery of the substrate during flip-chip mounting, it does not affect current injection into a light-emitting-element. Specific examples of such a material is preferably selected from sapphire, SiC, GaN, $LiGaO_2$, ZnO, $ScAlMgO_4$, $NdGaO_3$ and MgO, particularly preferably sapphire, GaN and ZnO substrates for growing a thin-film crystal of an InAlGaN light-emitting material or an InAlBGaN material on the substrate. In particular, when a GaN substrate is used, its Si doping concentration is preferably a Si concentration of $3 \times 10^{17}$ cm$^{-3}$ or less for an undoped substrate, more preferably $1 \times 10^{17}$ cm$^{-3}$ or less in the light of electric resistance and crystallinity.

A substrate used in the invention disclosed in this Section may be, in addition to a just-substrate completely defined by a so-called plane index, a so-called off-substrate (miss oriented substrate) in the light of controlling crystallinity during thin-film crystal growth. An off-substrate is widely used as a substrate because it is effective for promoting favorable crystal growth in a step flow mode and thus effective for improving element morphology. For example, when a c+ plane substrate of sapphire is used as a substrate for crystal growth of an InAlGaN material, it is preferable to use a plane inclined to an m+ direction by about 0.2 °. An off-substrate having a small inclination of about 0.1 to 0.2 ° is generally used, but in an InAlGaN material formed on sapphire, a relatively larger off-angle is possible for canceling an electric field due to piezoelectric effect to a quantum well layer as a light-emitting point within an active layer structure.

A substrate may be pretreated by chemical etching or heating for manufacturing a compound semiconductor light-emitting-element utilizing crystal growth technique such as MOCVD and MBE. Alternatively, a substrate may be deliberately processed to have irregularity in relation to a buffer layer described later to prevent penetrating dislocation generated in an interface between a thin-film crystal layer and the substrate from being introduced near an active layer of a light-emitting-element.

In the invention disclosed in this Section, for confining a light in a light-uniforming layer described later and guiding it to distribute within the layer, it is desirable that the substrate has a refractive index ($n_{sb}$) at an emission wavelength of a compound semiconductor light-emitting-element which is relatively smaller than an average refractive index ($n_{oc}$) of a light-uniforming layer.

In one embodiment of the present invention, a thickness of the substrate is generally about 250 to 700 $\mu$m in an initial stage of element preparation so as to ensure mechanical strength during crystal growth in a semiconductor light-emitting-element and an element manufacturing process. After growing a thin-film crystal layer, it is desirable that for facilitating separation into individual elements, the substrate is appropriately thinned by a polishing step in the course of the process and finally has a thickness of about 100 $\mu$m or less in a device. The thickness is generally 30 $\mu$m or more.

In another embodiment of the present invention, a thickness of the substrate may be larger than a conventional thickness, and may be about 350 $\mu$m, furthermore about 400 $\mu$m or 500 $\mu$m.

In order to confine and wave-guide a light in the light-uniforming layer described later, the substrate may be selected so as to be a lower-refractive-index layer relative to the waveguide; and in this case, a physical thickness of the substrate is preferably more than $4\lambda/n_{sb}$ wherein an emission wavelength of a light-emitting-element is $\lambda$ (nm) and an average refractive index of a substrate is $n_{sb}$.

It is further desirable that a so-called low reflecting coating layer or low-reflecting optical film is formed on a plane in a main light-extraction direction of the substrate. It lowers reflection due to a refractive index difference in a substrate-air interface and output and element efficiency can be improved. Here, when R3 is a reflectance of reflection by the substrate, of a light having an emission wavelength of the light-emitting-element vertically incoming from the light-uniforming layer (if a buffer layer is present, from the buffer layer) to the substrate side and R4 is a reflectance of reflection by an interface with a space, of a light having an emission wavelength of the light-emitting-element vertically incoming from the substrate to the space of the light-extraction side, it is preferable that a low-reflecting optical film is formed in the light-extraction side of the substrate such that the relation:

R4 < R3

is satisfied. For example, when the substrate is sapphire, the low reflecting coating film is preferably, for example, $MgF_2$. It is because a refractive index of the low reflecting coating film is preferably near $\sqrt{n_s}$ in relation to a refractive index $n_s$ of the substrate at an emission wavelength, and because $MgF_2$ has a refractive index near a square root of a refractive index of sapphire.

In the invention disclosed in this Section, it is also preferable that a plane in a main light-extraction direction of the substrate is an irregular or crude surface. It allows for extracting light generated within a quantum well layer with a high efficiency, which is desirable in the light of improving an element output and efficiency. When an emission wavelength of an element is $\lambda$ (nm), its surface crudeness is preferably such that an average roughness Ra (nm) satisfy the relation:

$$\lambda/5 \; (\text{nm}) < \text{Ra} \; (\text{nm}) < 10 \times \lambda \; (\text{nm})$$

more preferably, the relation:

$$\lambda/2 \; (\text{nm}) < \text{Ra} \; (\text{nm}) < 2 \times \lambda \; (\text{nm}).$$

Buffer layer

A buffer layer 22 is formed mainly for facilitating thin-film crystal growth, for example, for preventing dislocation, alleviating imperfection in a substrate crystal and reducing various mutual mismatches between a substrate crystal and a desired thin-film crystal growth layer in growing a thin-film crystal on a substrate.

A buffer layer is deposited by thin-film crystal growth, and a buffer layer is particularly important since when a material such as an InAlGaN material, an InAlBGaN material, an InGaN material, an AlGaN material, an AlN material and a GaN material is grown on a foreign substrate by thin-film crystal growth, which is a desirable embodiment in the present invention, matching of a lattice constant with a substrate is not necessarily ensured. For example, when a thin-film crystal growth layer is grown by organic metal vapor deposition (MOVPE), a low temperature growth AlN layer at about 600 °C may be used as a buffer layer, or a low temperature growth GaN layer formed at about 500 °C may be used. A material such as AlN, GaN, AlGaN, InAlGaN and InAlBGaN grown at a high temperature of about 800 °C to 1000 °C may be used. These layers are generally as thin as about 5 to 40 nm.

A buffer layer 22 needs not necessarily to be a single layer, and on a GaN buffer layer grown at a low temperature, a GaN layer may be grown at a temperature of about 1000 °C to several $\mu$m without doping for further improving crystallinity. In practice, it is common to form such a thick film buffer layer with a thickness of about 0.5 to 7 $\mu$m. The buffer layer may be doped with, for example, Si, or it may be formed of stacked layers including therein a doped layer and an undoped layer.

A typical embodiment is a two-layer structure of a low temperature buffer layer formed by thin-film crystal growth at a low temperature of about 350 °C to less than 650 °C in contact with a substrate and a high temperature buffer layer formed by thin-film crystal growth at a high temperature of about 650 °C to 1100 °C. When the substrate is GaN, all the whole buffer layer can be GaN formed at a high temperature of 900 °C or higher.

A buffer layer may be formed by epitaxial lateral overgrowth (ELO) as a kind of so-called microchannel epitaxy, which may allow for significant reduction of penetrating dislocation generated between a substrate such as sapphire and an InAlGaN material. Furthermore, when a processed substrate whose surface is made irregular, dislocation can be partly diminished during epitaxial lateral overgrowth, and it is preferable to apply such a combination of a substrate and a buffer layer to the invention disclosed in this Section. Furthermore, such a configuration is preferable because the irregularity formed in the surface of the substrate improves a light-extraction efficiency.

In the invention disclosed in this Section, a buffer layer may be integrated with a light-uniforming layer described later to confine light for improving uniformity in light intensity in a light-extraction-face. Alternatively, a part or the whole of the buffer layer may also act as a light-uniforming layer.

In some embodiments, a buffer layer may be an exposed part of a light-emitting-element separation-trench; the exposed part is preferably an undoped part. Thus, insulation failure due to, for example, solder during device assembly can be prevented.

Light-uniforming layer

A light-uniforming layer in the invention disclosed in this Section is a layer to improve uniformity of a light-emitting-element in a light-extraction-face, wherein by confining and distributing a light emitted from an active layer structure within the layer, it leaks a part of the light while moderately guiding, and in some case it effects scattering, multiple reflection and thin-film interfering of the light.

The light-uniforming layer 23 is preferably formed in a compound semiconductor layer and as shown in the drawings such as FIGs. 1-1A, 1-2A and others, it is formed between a buffer layer (which is preferably present) and a first-conductivity-type semiconductor layer (a first-conductivity-type cladding layer). There are no particular restrictions to a deposition method, but the layer is preferably preferably formed by thin-film crystal growth together with the other thin-film crystal layers for conveniently preparing a semiconductor light-emitting-element.

In the invention disclosed in this Section, a refractive index of the light-uniforming layer is selected such that at least, light is confined within the layer, that is, the distribution density of the light is high. Thus, an average refractive index of light-uniforming layer ($n_{oc}$) is larger than an average refractive index of a first-conductivity-type cladding layer, and, in an aspect having a substrate, is larger than an average refractive index of the substrate ($n_{sb}$). Particularly preferably, it is larger than an average refractive index of the first-conductivity-type semiconductor layer ($n_1$) present between the light-uniforming layer and an active layer structure. It is equal to or larger than an average refractive index of a buffer layer ($n_{bf}$), particularly preferably more than an average refractive index of a buffer layer. It is particularly preferable that a material constituting the light-uniforming layer is transparent to a light emitted from a quantum well layer. When a light-emitting-element is based on an InAlGaN type Group III- V nitride, it is also desirable that it contains In or Al in such an amount that a light emitted from the active layer structure is not absorbed, and particularly preferably, In is contained in consideration of improving a refractive index.

A light-uniforming layer does not have to be a single layer, but may have a multilayer configuration. For a multilayer configuration, it may be a plurality of layers such as AlGaN, InGaN, InAlGaN, AlN and GaN or a superlattice structure. It may internally have a structure such as quantum dot, which may induce light scattering when it has a size near an emission wavelength of an element. Furthermore, it may be possible that a light-uniforming layer is formed by thin-film crystal growth, the crystal growth is discontinued once, the surface is appropriately processed to be irregular, and thin-film crystal growth is further conducted. This causes light scattering, multiple reflection and thin-film interference.

Here, an average refractive index (nav) of each layer is a quotient of the sum of products of a refractive index (nx) of each of n materials constituting the layer and a physical thickness (tx) of the material by the whole thickness, which is calculated by the following equation:

$$\text{nav} = (\text{n1}\times\text{t1}+\text{n2}\times\text{t2}+\cdots+\text{nn}\times\text{tn})/(\text{t1}+\text{t2}+\cdots+\text{tn}).$$

As an example of a light-uniforming layer, for example, a single layer of undoped GaN may be used as the light-uniforming layer when an active layer structure has a quantum well layer with a composition of $In_aGa_{1-a}N$ and an emission wavelength of 460 nm, a first-conductivity-type cladding layer is n-GaN, a buffer layer is undoped GaN and a substrate is sapphire. Generally, there is a tendency that the higher a carrier concentration is, the smaller a refractive index of a semiconductor material at a transparent wavelength to the material is.

Further, a single layer of undoped GaN may be used as the light-uniforming layer when an active layer structure has a quantum well layer with a composition of $In_aGa_{1-a}N$ and an emission wavelength of 460 nm, a first-conductivity-type cladding layer consists of an n-GaN and an n-AlGaN layers, a buffer layer is a stacked structure of an undoped GaN and a Si-doped GaN and a substrate is sapphire. Generally, there is a tendency that the higher a carrier concentration is, the smaller a refractive index of a semiconductor material at a transparent wavelength to the material is.

Further, a light-uniforming layer may be a multilayer structure having a thick film of undoped GaN which contains $InbGa_{1-b}N$ having a composition transparent to an emission wavelength and having a desired thickness in a desired number when an active layer structure has a quantum well layer having a composition of $In_aGa_{1-a}N$ and an emission wavelength of 460 nm, a first-conductivity-type cladding layer consists of an n-GaN and an n-AlGaN layers, a buffer layer is a stacked structure of undoped GaN and Si-doped GaN and a substrate is Si-doped GaN. Generally, there is a tendency that the higher a carrier concentration is, the smaller a refractive index of a semiconductor material at a transparent wavelength to the material is.

In these structures, it may be also desirable that a light-uniforming layer contains a material such as $In_bGa_{1-b}N$ and $In_cAl_dGa_{1-c-d}N$. The appropriate selection of the composition parameters b, c and d, thickness and so on provides a layer which is transparent at a wavelength of 460 nm and has a refractive index larger than that of n-GaN which may be contained in a first-conductivity-type semiconductor layer, of undoped GaN which may be contained in a buffer layer, of sapphire or GaN which may be contained in a substrate, so that it may be used as a light-uniforming layer. These materials can be used in the form of single layer or in multiple layers formed of these materials and undoped GaN layers.

Furthermore, it is also preferable that the light-uniforming layer has a superlattice quantum well structure consisting of an InGaN layer and a GaN layer in which an In composition and a InGaN layer thickness are adjusted so as not to absorb the emission wavelength of a compound semiconductor light-emitting-element.

It is also important that a thickness of the light-uniforming layer is selected such that it acts as a multimode optical waveguide receiving part of a light emitted from the quantum well layer and distributing the light within the layer.

When a physical thickness of the light-uniforming layer is $t_{oc}$ (nm), an emission wavelength of the light-emitting-element is $\lambda$ (nm), an average refractive index of the light-uniforming layer is $n_{oc}$, an average refractive index of the first-conductivity-type semiconductor layer is $n_1$, and an average refractive index of the substrate is $n_{sb}$, a relative refractive index difference $\Delta_{(oc-1)}$ between the light-uniforming layer and the first-conductivity-type semiconductor layer is defined as:

$$\Delta_{(oc-1)} \equiv ((n_{oc})^2-(n_1)^2)/(2\times(n_{oc})^2).$$

A relative refractive index difference $\Delta_{(oc-sb)}$ between the light-uniforming layer and the substrate is defined as:

$$\Delta_{(oc-sb)} \equiv ((n_{oc})^2-(n_{sb})^2)/(2\times(n_{oc})^2).$$

Regarding the light-uniforming layer as a symmetric slab waveguide sandwiched by average refractive indices of the first-conductivity-type semiconductor layer, the condition for the waveguide to be a multimode is that a normalized frequency is $\pi/2$ or more, and thus it is desirable that $t_{oc}$ is selected such that the relationship:

$$(\sqrt{(2\times\Delta_{(oc-1)})} \times n_{oc}\times\pi\times t_{oc})/ \lambda\geq\pi/2$$

is satisfied. At the same time, assuming that the light-uniforming layer is a symmetric slab waveguide sandwiched by average refractive indices of the substrate, the condition for the waveguide to be a multimode is that a normalized frequency is $\pi/2$ or more, and thus it is desirable that $t_{oc}$ is selected such that the relationship:

$$(\sqrt{(2\times\Delta_{(oc-sb)})} \times n_{oc}\times\pi\times t_{oc})/ \lambda\geq\pi/2$$

is also satisfied.

Specifically, for example, assuming that an average refractive index of the light-uniforming layer is 2.50 and an average refractive index of the substrate is 1.70, each at a wavelength of 460 nm, the above relationship is satisfied when a thickness of the light-uniforming layer is about 0.13 $\mu$m or more. Furthermore, for example, assuming that an average refractive index of the light-uniforming layer is 2.50 and an average refractive index of the first-conductivity-type semiconductor layer is 2.499, each at a wavelength of 460 nm, the above relationship is satisfied when a thickness of the light-uniforming layer is about 3.3 $\mu$m or more. Thus, a thickness of the light-uniforming layer can be appropriately selected, depending on an average refractive index of a substrate when a substrate is used, an average refractive index of the light-uniforming layer and an average refractive index of the first-conductivity-type semiconductor layer, but in general, it is preferably 1 to 7 $\mu$m, more preferably 3 to 5 $\mu$m.

As described above, there can be provided a multimode waveguide allowing for confinement and moderate leak of light and, depending on a structure, producing effects such as scattering, multiple reflection and thin-film interference of light, which facilitates uniform luminescence in the light-extraction-face of the light-emitting-element.

If a light is extremely confined in the light-uniforming layer, luminescence uniformity in a light-emitting-element is improved but light-extraction becomes difficult, and it is, therefore, preferrable that a thickness, a material, a structure, a configuration, a refractive index and so on of the light-uniforming layer are appropriately selected such that wave guide is attained while it is leaky to some extent. Particularly, in terms of its thickness, it is not desirable that a thickness of the light-uniforming layer is extremely large, leading to excessive light confinement in the waveguide; for example, its upper limit is preferably 30 $\mu$m or less, more preferably 10 $\mu$m or less, most preferably 5 $\mu$m or less.

The light-uniforming layer in the invention disclosed in this Section may be either conductive or insulative, but in the light of further ensuring prevention of short circuit due to, for example, a solder, it is preferably insulative. For example, a specific resistance $\rho_{oc}$ ($\Omega \cdot$cm) of the whole layer is preferably 0.5 ($\Omega\cdot$cm) or higher. It is more preferably 1.0 ($\Omega \cdot$cm) or higher, further preferably 1.5 ($\Omega \cdot$cm) or higher, most preferably 5 ($\Omega\cdot$cm) or higher. For a higher specific resistance, the light-uniforming layer is preferably undoped. In addition, for example, when the light-uniforming layer consists of multiple layers, a doped layer may be contained without problems if it is sandwiched between undoped layers. In this case, it is required that a layer adjacent to the first-conductivity-type semiconductor layer (for example, a first-conductivity-type cladding layer) has the above specific resistance. Since generally in a wavelength region transparent to the material in a semiconductor, an undoped layer has a higher refractive index than that of a layer having many carriers deliberately doped even for the same material, an undoped layer is preferable in view of not only optical properties but also electric properties. In particular, when a light-uniforming layer is an exposed part in a device edge, the exposed part is preferably undoped. Thus, insulation failure by, for example, a solder during device assembly can be inhibited.

In the invention disclosed in this Section, while the light-uniforming layer distribute and spreads light, the above buffer layer is for reduce various mismatches in crystal growth on a substrate, so that their functions are different. However, the single layer may have two functions at the same time. When the light-uniforming layer or the buffer layer consists of multiple layers, some layers may have two functions. Furthermore, when a growing method or conditions are different even in the same composition, the layer may have only one function.

In the invention disclosed in this Section, the lateral side of the exposed light-uniforming layer is covered by an insulating layer. Thus, in flip-chip mounting the light-emitting-element on, for example, a submount, short circuit due to a solder can be prevented in the sidewall of a thin-film crystal layer.

First-conductivity-type semiconductor layer and first-conductivity-type cladding layer

In a typical embodiment of the invention disclosed in this Section, a first-conductivity-type cladding layer 24 is present in contact with a light-uniforming layer 23 as shown in FIG. 1-1A. The first-conductivity-type cladding layer 24 cooperates with a second-conductivity-type cladding layer 26 described later to efficiently inject carriers into an active layer structure 25 described later and to prevent overflow from the active layer structure, for light emission in a quantum well layer with a high efficiency. It also contributes to confinement of light near the active layer structure, for light emission in a quantum well layer with a high efficiency. The first-conductivity-type semiconductor layer includes, in addition to the layer having the above cladding function, a first-conductivity-type doped layer for improving the performance of the element such as a contact layer, or because of manufacturing process. In the broad sense, the whole first-conductivity-type semiconductor layer may be regarded as a first-conductivity-type cladding layer, where a contact layer and so on can be regarded as a part of the first-conductivity-type cladding layer.

Generally, it is preferable that the first-conductivity-type cladding layer is made of a material having a smaller refractive index than an average refractive index of an active layer structure described later and having a larger band gap than an average band gap of the active layer structure described later. Furthermore, the first-conductivity-type cladding layer is generally made of a material belonging to a type I band lineup in the relation of the active layer structure, particularly a barrier layer. Based on such a guideline, the first-conductivity-type cladding layer material can be appropriately selected, considering a substrate, a buffer layer, an active layer structure and so on provided or prepared for achieving a desired emission wavelength.

For example, when a substrate is C+ plane sapphire and a buffer layer is a stacked structure of GaN grown at a low temperature and GaN grown at a high temperature, the first-conductivity-type cladding layer may be made of a GaN material, an AlGaN material, an AlGaInN material, an InAlBGaN material or a multilayer structure of these.

A carrier concentration of the first-conductivity-type cladding layer is, as a lower limit, preferably $1\times10^{17}$ cm$^{-3}$ or more, more preferably $5\times10^{17}$ cm$^{-3}$ or more, most preferably $1\times10^{18}$ cm$^{-3}$ or more. It is, as an upper limit, preferably $5\times10^{19}$ cm$^{-3}$ or less, more preferably $1\times10^{19}$ cm$^{-3}$ or less, most preferably $7\times10^{18}$ cm$^{-3}$ or less. Here, when the first-conductivity-type is n-type, a dopant is most preferably Si.

A structure of the first-conductivity-type cladding layer is shown as a single-layered first-conductivity-type cladding layer in the example of FIG. 1-1A, but the first-conductivity-type cladding layer may consist of two or more layers. Here, it may be made of, for example a GaN material and an AlGaN material, an InAlGaN material, an InAlBGaN material or an AlN material. The whole first-conductivity-type cladding layer may be a superlattice structure as a stacked structure of different materials. Furthermore, within the first-conductivity-type cladding layer, the above carrier concentration may be varied.

In the part contacting with the first-conductivity-type-side electrode in the first-conductivity-type cladding layer, the carrier concentration may be deliberately increased to reduce a contact resistance with the electrode.

In a preferred structure, a part of the first-conductivity-type cladding layer is etched, and the exposed sidewall and the etched part in the first-conductivity-type cladding layer are completely covered by an insulating layer, except a first current injection region for contact with a first-conductivity-type-side electrode described later.

In addition to the first-conductivity-type cladding layer, a further different layer may be, if necessary, present as a first-conductivity-type semiconductor layer. For example, there may be formed a contact layer for facilitating injection of carriers into a junction with an electrode. Alternatively, these layers may be formed as multiple layers different in a composition and formation conditions.

Active layer structure

There is formed the active layer structure 25 on the first-conductivity-type cladding layer 24. An active layer structure means a structure which contains a quantum well layer where the recombination of electrons and holes (or holes and electrons) injected from the above first-conductivity-type cladding layer and a second-conductivity-type cladding layer described later, respectively takes place to emit a light and a barrier layer adjacent to the quantum well layer or between the quantum well layer and a cladding layer. Here, for achieving improvement in an output and efficiency as the objectives of the present invention, it is desirable that the equation $B = W+1$ is satisfied where $W$ is the number of quantum well layers in the active layer structure and $B$ is the number of barrier layers. That is, it is desirable for improving an output that the overall layer relationship between the cladding layer and the active layer structure is "the first-conductivity-type cladding layer, the active layer structure, second-conductivity-type cladding layer" and an active layer structure is configured such as "a barrier layer, a quantum well layer and a barrier layer" or "a barrier layer, a quantum well layer, a barrier layer, a quantum well layer and a barrier layer". FIG. 1-4 schematically shows a stacked structure of five quantum well layers and six barrier layers.

Here, the quantum well layer has a film thickness as small as about a de Broglie wavelength for inducing a quantum size effect to improve a luminous efficiency. Thus, for improving an output, it is desirable to form, instead of forming a single quantum well layer, a plurality of quantum well layers, which are separated to form an active layer structure. Here, a layer controlling binding between the quantum well layers and separating them is a barrier layer. Furthermore, it is desirable that a barrier layer is present for separation between a cladding layer and a quantum well layer. For example, when a cladding layer is made of AlGaN and a quantum well layer is made of InGaN, there is preferably formed a barrier layer made of GaN between them. This is also desirable in terms of thin-film crystal growth because adjustment becomes easier when an optimal temperature for crystal growth is different. When a cladding layer is made of InAlGaN having the largest band gap and a quantum well layer is made of InAlGaN having the smallest band gap, a barrier layer may be made of InAlGaN having an intermediate band gap. Furthermore, a band gap difference between a cladding layer and a quantum well layer is generally larger than a band gap difference between a barrier layer and a quantum well layer; and considering an efficiency of injection of carriers into a quantum well layer, it is desirable that the quantum well layer is not directly adjacent to the cladding layer.

It is preferable that a quantum well layer is not deliberately doped. On the other hand, it is desirable that a barrier layer is doped to reduce a resistance of the overall system. In particular, it is desirable that a barrier layer is doped with an n-type dopant, particularly Si. Mg as a p-type dopant easily diffuses in a device and it is thus important to minimize Mg diffusion during high output operation. Thus, Si is effective and it is desirable that the barrier layer is Si-doped. It is, however, desirable that the interface between the quantum well layer and the barrier layer is undoped.

It is preferable that an active layer structure sidewall in one element is covered by an insulating layer 30 as shown in FIG. 1-1A. It is advantageous in that in flip-bonding of an element manufactured according to the invention disclosed in this Section, short circuit due to a solder in a sidewall in an active layer structure is avoided.

Second-conductivity-type semiconductor layer and second-conductivity-type cladding layer

The second-conductivity-type cladding layer 26 cooperates with the first-conductivity-type cladding layer 24 described above to efficiently inject carriers into the active layer structure 25 described above and to prevent overflow from the active layer structure, for light emission in a quantum well layer with a high efficiency. It also contributes to confinement of light near the active layer structure, for light emission in a quantum well layer with a high efficiency. The second-conductivity-type semiconductor layer includes, in addition to the layer having the above cladding function, a second-conductivity-type doped layer for improving the performance of the element such as a contact layer or because of manufacturing process. In the broad sense, the whole second-conductivity-type semiconductor layer may be regarded as a second-conductivity-type cladding layer, where a contact layer and so on can be regarded as a part of the second-conductivity-type cladding layer.

Generally, it is preferable that the second-conductivity-type cladding layer is made of a material having a smaller refractive index than an average refractive index of an active layer structure described above and having a larger band gap than an average band gap of the active layer structure described above. Furthermore, the second-conductivity-type cladding layer is generally made of a material belonging to a type I band lineup in relation to the active layer structure, particularly a barrier layer. Based on such a guideline, the second-conductivity-type cladding layer material can be appropriately selected, considering a substrate, a buffer layer, an active layer structure and so on provided or prepared for achieving a desired emission wavelength. For example, when a substrate is C+ plane sapphire and a buffer layer is made of GaN, the second-conductivity-type cladding layer may be made of a GaN material, an AlN material, an AlGaN material, an AlGaInN material, an AlGaBInN material or the like. It may be a stacked structure of the above materials. Furthermore, the first-conductivity-type cladding layer and the second-conductivity-type cladding layer may be made of the same material.

A carrier concentration of the second-conductivity-type cladding layer is, as a lower limit of, preferably $1\times10^{17}$ cm$^{-3}$ or more, more preferably $4\times10^{17}$ cm$^{-3}$ or more, further preferably $5\times10^{17}$ cm$^{-3}$ or more, most preferably $7\times10^{17}$ cm$^{-3}$ or more. It is, as an upper limit, preferably $7\times10^{18}$ cm$^{-3}$ or less, more preferably $3\times10^{18}$ cm$^{-3}$ or less, most preferably $2\times10^{18}$ cm$^{-3}$ or less. Here, when the second-conductivity-type is p-type, a dopant is most preferably Mg.

A structure of the second-conductivity-type cladding layer is shown as a single layer in the example of FIG. 1-1A, but the second-conductivity-type cladding layer may consist of two or more layers. Here, it may be made of, for example, a GaN material and an AlGaN material. The whole second-conductivity-type cladding layer may be a superlattice structure as a stacked structure of different materials. Furthermore, within the second-conductivity-type cladding layer, the above carrier concentration may be varied.

Generally, in a GaN material, when an n-type dopant is Si and a p-type dopant is Mg, p-type GaN, p-type AlGaN and p-type AlInGaN are inferior to n-type GaN, n-type AlGaN and n-type AlInGaN, respectively, in crystallinity. Thus, in manufacturing an element, it is desirable that a p-type cladding layer with inferior crystallinity is formed after crystal growth of an active layer structure, and in this regard, it is desirable that the first-conductivity-type is n-type while the second-conductivity-type is p-type.

A thickness of the p-type cladding layer with inferior crystallinity (this corresponds to a second-conductivity-type cladding layer in an preferred embodiment) is preferably thinner to some extent. In the invention disclosed in this Section where flip chip bonding is conducted, a substrate side becomes a main light-extraction direction, so that it is not necessary to consider light collection from the side of a second-conductivity-type-side electrode described later, allowing a thick film electrode with a large area to be formed. Thus, unlike in conducting face-up mounting, it is not necessary to expect current diffusion in a lateral direction in the second-conductivity-type-side cladding layer, and it is thus also advantageous in the light of an element structure that the second-conductivity-type-side cladding layer is thinner to some extent. However, since an extremely thin layer lead to reduction in a carrier injection efficiency, there is an optimal value. A thickness of the second-conductivity-type-side cladding layer can be appropriately selected, but is preferably 0.05 $\mu$m to 0.3 $\mu$m, most preferably 0.1 $\mu$m to 0.2 $\mu$m.

In the part contacting with the second-conductivity-type-side electrode in the second-conductivity-type cladding layer, its carrier concentration may be deliberately increased to reduce a contact resistance with the electrode.

It is desirable that the exposed sidewall in the second-conductivity-type cladding layer is completely covered by an insulating layer, except a second current injection region for contact with a second-conductivity-type-side electrode described later.

Furthermore, in addition to the second-conductivity-type cladding layer, a further different layer may be, if necessary, present as a second-conductivity-type semiconductor layer. For example, there may be formed a contact layer for facilitating injection of carriers into a part contacting with an electrode. Alternatively, these layers may be formed as multiple layers different in a composition and preparation conditions.

Without departing from the scope of the present invention, a layer which does not belong to the above category may be, if necessary, formed as a thin-film crystal layer.

Second-conductivity-type -side electrode

A second-conductivity-type-side electrode achieves good ohmic contact with a second-conductivity-type nitride compound semiconductor, acts as a good reflection mirror in an emission wavelength band in flip-chip mounting, and has good adhesion to a submount by a solder material in flip-chip mounting. For this end, a material can be appropriately selected and the second-conductivity-type-side electrode may be either single-layered or multi-layered. Generally, for achieving a plurality of required purposes to an electrode, a plurality of layer configurations are preferred.

When the second-conductivity-type is p-type and a portion of the second-conductivity-type-side cladding layer that faces to the second-conductivity-type-side electrode is formed of GaN, a material for the second-conductivity-type-side electrode is preferably a material comprising Ni, Pt, Pd, Mo, Au or two or more elements of these. This electrode may be of a multilayer structure, where at least one layer is made of a material comprising the above element, and preferably each layer is made of a material comprising the above element and having a different constituting component (type and/or ratio). A constituent material for the electrode is preferably an elemental metal or an alloy.

In a particularly preferable embodiment, the first layer, which faces to the p-side cladding layer, of the second-conductivity-type-side electrode is Ni and the surface of the opposite side to the p-side cladding layer side of the second-conductivity-type-side electrode is Au. This is because Ni has a work function with a large absolute value which is favorable for a p-type material and Au is preferable as the outermost surface material in the light of tolerance to process damage described later and a mounting sequence.

The second-conductivity-type-side electrode can contact with any of the thin-film crystal layers as long as second-conductivity-type carriers can be injected, and for example, when a second-conductivity-type-side contact layer is formed, the electrode is formed in contact with the layer.

First-conductivity-type-side electrode

A first-conductivity-type-side electrode achieves good ohmic contact with a first-conductivity-type nitride compound semiconductor, acts as a good reflection mirror in an emission wavelength band in flip-chip mounting and has good adhesion to a submount by a solder material in flip-chip mounting, and for this end, a material can be appropriately selected. The first-conductivity-type-side electrode may be either single-layered or multi-layered. Generally, for achieving a plurality of required purposes to an electrode, a plurality of layer configurations are preferred.

When the first-conductivity-type is n-type, an n-side electrode is preferably made of a material comprising any of Ti, Al, Ag and Mo or two or more of these. This electrode may be in the form of a multilayer structure, where at least one layer is made of a material comprising the above element, and preferably each layer is made of a material comprising the above element and having a different constituting component (type and/or ratio). A constituent material for the electrode is preferably an elemental metal or an alloy. This is because these metals have a work function with a small absolute value. In the opposite side of the main light-extraction direction of n-side electrode, Al is generally exposed.

In the present invention, it is preferred that the first-conductivity-type-side electrode is formed so as to have the larger area than the first current injection region, and that the first-conductivity-type-side electrode and the second-conductivity-type-side electrode do not spatially overlap at all. This is important for ensuring an adequate area to ensure adequate adhesiveness to a submount during flip-chip mounting a light-emitting-element by soldering while ensuring an adequate distance for preventing unintended short circuit due to, for example, a solder material between the second-conductivity-type-side electrode and first-conductivity-type-side electrode.

Here, it is desirable that the narrowest width of a part where the first-conductivity-type-side electrode is in contact with an insulating layer is 15 $\mu$m or more. This is because a margin is needed in a process for forming the first-conductivity-type-side electrode preferably by a photolithographic process and a lift-off process.

The first-conductivity-type-side electrode can contact with any of the thin-film crystal layers as long as first-conductivity-type carriers can be injected, and for example, when a first-conductivity-type-side contact layer is formed, the electrode is formed in contact with this layer.

Insulating layer

An insulating layer 30 is formed for preventing unintended short circuit due to running around of material for mounting, such as solder or conductive paste, "between the second-conductivity-type-side electrode and the first-conductivity-type-side electrode" and "to the sidewall of a thin-film crystal layer such as an active layer structure" during flip-chip mounting. Its structure and shape are as described above.

A material for an insulating layer may be appropriately selected as long as it ensures electric insulation. The material is, for example, preferably selected from single layer oxides, nitrides and fluorides; specifically, $SiO_x$, $AlO_x$, $TiO_x$, $TaO_x$, $HfO_x$, $ZrO_x$, $SiN_x$, $AlN_x$, $AlF_x$, $BaF_x$, $CaF_x$, $SrF_x$, $MgF_x$ and so on. These can stably ensure insulation for a long period.

The insulating layer 30 can be a multilayer film of insulating materials. This is a dielectric multilayer film, so that it can also act as a so-called highly reflective coating having a relatively higher optical reflectance to a light generated within a light-emitting-element by appropriately adjusting a refractive index of the dielectric material in the insulating layer. For example, when a center value of an element emission wavelength is $\lambda$, higher reflectiveness can be achieved by, for example, stacking $SiO_x$ and $TiO_x$ with each optical thickness of $\lambda/4n$ (here, n is a refractive index of each material at a wavelength $\lambda$). Such a configuration is very desirable because when flip chip bonding of an element is conducted, a light-extraction efficiency to a main extraction direction side can be improved and improvement in an element output and efficiency and prevention of unintended short circuit due to, for example, a solder material can be achieved at the same time.

Specifically, when R2 is a reflectance of reflection by a buffer layer, of a light having an emission wavelength of the light-emitting-element vertically incoming from the first-conductivity-type semiconductor layer side containing the first-conductivity-type cladding layer to the buffer layer, R12 is a reflectance of reflection by the insulating layer, of a light having an emission wavelength of the light-emitting-element vertically incoming from the second-conductivity-type semiconductor layer side containing the second-conductivity-type cladding layer to the insulating layer, R11 is a reflectance of reflection by the insulating layer, of a light having an emission wavelength of the light-emitting-element vertically incoming from the first-conductivity-type semiconductor layer side containing the first-conductivity-type cladding layer to the insulating layer and R1q is a reflectance of reflection by the insulating layer, of a light having an emission wavelength $h$ of the light-emitting-element vertically incoming from the active layer structure side containing a quantum well layer to the insulating layer, it is preferable that the insulating layer is configured such that at least one, particularly all of the conditions:

(Relation 1) R2 < R12
(Relation 2) R2 < R11
(Relation 3) R2 < R1q

are satisfied.

These are desirable ranges for allowing an insulating layer formed by a dielectric multilayer film to efficiently function as an optical reflection mirror. It is desirable in the light of stability of the materials and refractive index ranges that the dielectric film contains a fluoride; specifically, containing any of $AlF_x$, $BaF_x$, $CaF_x$, $SrF_x$ and $MgF_x$.

Submount

A submount 40 has a metal layer and performs functions of current injection into a flip-chip mounted element and heat dissipation. A base material of the submount is preferably a metal, AlN, SiC, diamond, BN or CuW. These materials are desirable because they exhibit good heat dissipation properties and can efficiently prevent the problem of heat generation which is inevitable in a high-output light-emitting-element. Furthermore, $Al_2O_3$, Si, glasses and so on are also preferable because they are inexpensive and can be used as a base material for a submount in a wide variety of applications. when a base material for the submount is selected from metals, its periphery is preferably covered by, for example, a dielectric material which is etching resistant. A metal base material is preferably a material having a higher reflectance at an emission wavelength of the light-emitting-element, preferably Al, Ag and so on. When it is covered by a dielectric material, $SiN_x$, $SiO_2$ and so on formed by any of various CVD processes are preferred.

A light-emitting-element is bonded to a metal layer on a submount via any of various solder materials and paste materials. For adequately ensuring heat dissipation properties for high output operation and highly efficient light emission, bonding via a metal solder is particularly preferable. Examples of a metal solder include In, InAg, PbSn, SnAg, AuSn, AuGe and AuSi. These solders are stable and can be appropriately selected in the light of the environmental conditions such as a working temperature.

A plurality of compound semiconductor light-emitting-elements of the invention disclosed in this Section can be mounted on one submount, and by varying metal wiring on the submount, the light-emitting-elements on one submount can be connected in parallel, in series or in combination of these.

Manufacturing process for a light-emitting-element disclosed in Section A

Next, there will be described a process for manufacturing a semiconductor light-emitting-element according to the invention disclosed in this Section. There will be described manufacturing processes according to typical embodiments.

Embodiment 1 of a manufacturing process

In Embodiment 1 of a manufacturing process, there will be described mainly a process for manufacturing a light-emitting-element shown in FIG. 1-1A and furthermore those for light-emitting-elements shown in FIG. 1-1C and FIG. 1-1D. As shown in FIG. 1-5, first a substrate 21 is provided and over the surface are sequentially deposited a buffer layer 22, a light-uniforming layer 23, a first-conductivity-type cladding layer 24, an active layer structure 25 and a second-conductivity-type cladding layer 26 by thin-film crystal growth. For formation of these thin-film crystal layers, MOCVD is preferably employed. However, it is possible to use MBE, PLD, PED, VPE and LPE processes for forming all or some of the thin-film crystal layers. A configuration of these layers can be appropriately changed, depending on, for example, an application of the element. After forming thin-film crystal layers, a variety of processings are allowed. As used herein, the term "thin-film crystal growth" includes heat-treatment after growing a thin-film crystal layer.

For providing the configuration shown in FIGs. 1-1A, 1-1B and 1-3A after growing thin-film crystal layers in the present invention, it is preferable that a second-conductivity-type-side electrode 27 is formed as shown in FIG. 1-5. That is, it is preferable that scheduled formation of the second-conductivity-type-side electrode 27 in the second current injection region 35 is conducted before formation of an insulating layer 30, formation of a first current injection region 36 and formation of a first-conductivity-type-side electrode 28. This is because when the second-conductivity-type is p-type as a desirable embodiment, formation of a p-side electrode after processing the exposed surface of the p-type cladding layer by various processes leads to reduction of a hole concentration in the p-GaN cladding layer with a relatively lower activation rate among GaN materials, due to process damage. For example, if the step of forming an insulating layer by p-CVD is conducted before forming the second-conductivity-type-side electrode, plasma damage remains in its surface. Thus, in the present invention, it is desirable that after thin-film crystal growth, formation of the second-conductivity-type-side electrode is conducted before any of the other process steps (for example, a first etching step, a second etching step or the step of forming an insulating layer, the step of forming an exposed part in a second-conductivity-type-side electrode, the step of forming a first current injection region and the step of forming a first-conductivity-type-side electrode as described later).

In the present invention, when the second-conductivity-type is p-type and when the exposed surface is a relatively stable metal such as Au (in a typical example, the surface of the second-conductivity-type-side electrode is expected to be Au as described above), the surface is not likely process-damaged through the subsequent processes. In this respect, it is again desirable in the present invention that after thin-film crystal growth, formation of the second-conductivity-type-side electrode is conducted before any other process step.

In the present invention, when a layer in which the second-conductivity-type-side electrode is formed is the second-conductivity-type contact layer, process damage to the second-conductivity-type semiconductor layer can be reduced in the same manner.

The second-conductivity-type-side electrode 27 can be formed by applying a variety of deposition processes such as sputtering, vacuum evaporation and plating, and a desired shape can be obtained by appropriately applying, for example, a lift-off process using photolithography technique or site-selective evaporation using, for example, a metal mask.

After forming the second-conductivity-type-side electrode 27, a part of the first-conductivity-type cladding layer 24 is exposed as shown in FIG. 1-6. In this step, it is preferable to remove the second-conductivity-type cladding layer 26, the active layer structure 25 and further a part of the first-conductivity-type cladding layer 24 by etching (a first etching step). The first etching step is conducted for the purpose of exposing a semiconductor layer into which a first-conductivity-type-side electrode described later injects first-conductivity-type carriers, and therefore, when a thin-film crystal layer contains another layer, for example, a cladding layer consists of two layers or contains a contact layer, the layer including the additional layer may be etched.

The first etching step does not require very high etching precision and thus can be a known dry etching technique by plasma etching using, for example, $Cl_2$ and using a etching mask of a nitride such as $SiN_x$ or an oxide such as $SiO_x$. It is, however, also preferable that dry etching can be conducted using a metal fluoride mask as detailed in a second etching step described later. It is particularly preferable to conduct etching by plasma excited dry etching using a gas such as $Cl_2$, $SiCl_4$, $BCl_3$ and $SiCl_4$ and using an etching mask containing a metal-fluoride layer selected from the group consisting of $SrF_2$, $AlF_3$, $MgF_2$, $BaF_2$, $CaF_2$ and combinations of these. Furthermore, the optimal dry etching is ICP type dry etching capable of generating high density plasma.

Here, the second-conductivity-type-side electrode 27 receives process history of the formation of a $SiN_x$ mask formed by, for example, plasma CVD or the step of removing the $SiN_x$ mask after the first etching step. However, when a stable metal such as Au is formed over the surface, the second-conductivity-type-side electrode is less process-damaged.

Then, as shown in FIG. 1-7, a light-emitting-element separation-trench 13 is formed by a second etching step. In the present invention, it is necessary that the light-emitting-element separation-trench is formed such that it interrupts at least the first-conductivity-type cladding layer, and in this embodiment, the light-emitting-element separation-trench 13 is formed such that it reaches the substrate 21. Here, when diamond scribing is conducted from the side where the thin-film crystal layers have been formed in the steps of scribing and breaking for device separation, detachment of a GaN material on the sapphire substrate can be inhibited. Furthermore, it is advantageous that when laser scribing is conducted, thin-film crystal layers are not damaged. Furthermore, it is also preferable that the light-emitting-element separation-trench is formed by conducting etching into a part of the sapphire substrate (same for other substrates such as GaN).

Alternatively, a configuration where the light-emitting-element separation-trench does not reach the substrate is also preferable. For example, when the light-emitting-element separation-trench is formed to the intermediate portion of the combination of the light-uniforming layer and the buffer layer, an insulating layer can be formed on the sidewall of the first-conductivity-type cladding layer, to maintain insulation to a running-around solder (see FIGs. 1-1C and 1-1D for a configuration after completion of the light-emitting-element). Here, a trench bottom surface is formed in the intermediate portion of the combination of the light-uniforming layer and the buffer layer and becomes an edge-step-face at the end of the light-emitting-element. The trench bottom surface is a plane having irregularity which can be formed by etching. Since the trench bottom surface is subjected to processing such as scribing during element separation, an edge-step-face after element separation is often relatively lower in flatness as a plane and parallelity to a layer direction. Furthermore, a layer exposed from the sidewall without being covered by the insulating layer is preferably highly insulative.

In the second etching step, the GaN material must be etched to more depth compared with the first etching step. The sum of a layer depth etched by the first etching step is generally about 0.5 $\mu$m while in the second etching step, the depth is sometimes 3 to 7 $\mu$m, 3 to 10 $\mu$m or more than 10 $\mu$m because the whole first-conductivity-type cladding layer 24 and at least a part or sometimes the whole of the light-uniforming layer 23 and the buffer layer 22 must be etched.

Generally, a metal mask, a nitride mask such as $SiN_x$ and an oxide mask such as $SiO_x$ have a selectivity ratio to a GaN material, in terms of tolerance to etching by $Cl_2$ plasma, of about 5. In conducting the second etching step where a GaN material with a large film thickness must be etched, a relatively thicker $SiN_x$ film is necessary. For example, etching a GaN material with a thickness of 10 $\mu$m by a second dry-etching process requires a $SiN_x$ mask with a thickness of 2 $\mu$m. However, with a $SiN_x$ mask with such a thickness, the $SiN_x$ mask is also etched during the dry etching, and not only its thickness in a longitudinal direction but also its shape in a horizontal direction are changed, so that a desired GaN material part cannot be selectively etched.

Thus, when forming the light-emitting-element separation-trench in the second etching step, dry etching using a mask including a metal-fluoride layer is preferred. A material constituting the metal-fluoride layer is preferably $MgF_2$, $CaF_2$, $SrF_2$, $BaF_2$ or $AlF_3$, most preferably $SrF_2$ in the light of balance between dry etching tolerance and wet-etching properties.

A metal fluoride film must be sufficiently tolerant to dry etching in the first and the second etching steps while being easily etched by etching for patterning (preferably, wet etching) to give a patterning shape with good linearity particularly in the sidewall. Deposition of a metal-fluoride layer at a temperature of 150 °C or higher gives a dense film having good adhesiveness to a base layer, and the film after patterned by etching shows good linearity in a mask sidewall. A deposition temperature is preferably 250 ° C or higher, further preferably 300 ° C or higher, most preferably 350 ° C or higher. Particularly, a metal-fluoride layer deposited at 350 ° C or higher exhibits good adhesiveness to any type of base layer and gives a fine film which is highly tolerant to dry etching and exhibits quite higher linearity in its sidewall in terms of a patterning shape, ensuring controllability to a width of the opening, and thus it is the most preferable as an etching mask.

Thus, although deposition at a high temperature is preferable for providing an etching mask exhibiting good adhesiveness to a base layer, giving a fine film, being highly tolerant to dry etching and exhibiting very high linearity in its sidewall and very high controllability of a width of the opening in terms of a patterning shape, a too high deposition temperature gives a film having excessive tolerance to wet etching using, for example, hydrochloric acid preferably used for patterning a metal fluoride, and thus the film cannot be easily removed. Particularly, when a mask such as $SrF_2$ is exposed to plasma such as chlorine plasma during dry etching of a semiconductor layer, an etching rate in a later process for removing the mask layer tends to be reduced in comparison with that before exposure to plasma such as chlorine plasma. Therefore, deposition of a metal fluoride at an excessively higher temperature is undesirable in the light of its patterning and final removal.

First, in a metal fluoride before being exposed to plasma in dry etching of a semiconductor layer, a layer deposited at a lower temperature has a larger etching rate to an etchant such as hydrochloric acid, resulting in a higher etching rate and a layer deposited at a higher temperature has a smaller etching rate, resulting in a lower etching rate. When deposition temperature becomes 300 ° C or higher, the etching rate decreases noticeably in comparison with a film deposited at a temperature of about 250 ° C, and a temperature of about 350 ° C to 450 ° C is within a very favorable etching rate range. A deposition temperature of higher than 480 ° C, however, leads to an excessively smaller absolute etching rate value, so that patterning of the metal fluoride takes a too longer time and patterning may be difficult under the conditions where a resist mask layer and so on are not detached. Furthermore, in a metal fluoride after being exposed to plasma in dry etching of a semiconductor layer, a wet-etching rate by, for example, hydrochloric acid in a removal step tends to decrease and growth at an excessively high temperature makes it difficult to remove the metal fluoride.

From such a viewpoint, a deposition temperature of a metal-fluoride layer is preferably 480 °C or lower, further preferably 470 ° C or lower, particularly preferably 460 ° C or lower.

Using a mask patterned considering the above (the mask may be a multilayer with $SiN_x$ or $SiO_2$ such that the metal-fluoride layer becomes a surface layer), dry etching is conducted. A gas species for the dry etching may be preferably selected from $Cl_2$, $BCl_3$, $SiCl_4$, $CCl_4$ and combinations of these. In the dry etching, a selectivity ratio of the $SrF_2$ mask to a GaN material is over 100, so that a thick GaN film can be easily and precisely etched. Furthermore, the optimal dry etching technique is ICP type dry etching capable of generating high-density plasma.

After the above etching, when the used unnecessary metal-fluoride layer mask is removed by an etchant such as hydrochloric acid, a multilayer mask with $SiN_x$, $SiO_2$ or the like may be formed such that the metal-fluoride layer becomes a surface layer if a material susceptible to an acid is present under the metal fluoride mask, for example, if an electrode material is susceptible to an acid. In such a case, $SiN_x$ or $SiO_2$ may be present in the whole region under the metal fluoride mask or alternatively, as shown, for example, in FIG. 1-16, a mask 51 such as $SiN_x$ and $SiO_2$ is not necessarily present in the whole region of the metal fluoride mask layer 52 but can be at least formed over a material susceptible to an acid.

By such a second etching step, the light-emitting-element separation-trench 13 is formed as shown in FIG. 1-7.

Regarding the first etching step and the second etching step, either step can be carried out before or after another step. It is also preferable for simplifying a process that the first etching step is first conducted and then without removing the etching mask, the second etching step is conducted. As shown in FIG. 1-16, first, a first etching mask 51 is formed from a material resistant to an acid such as $SiN_x$ and $SiO_2$ (preferably $SiN_x$) and etching is conducted such that a first-conductivity-type cladding layer 24 appears, and without removing the mask 51, a metal-fluoride layer is formed as a second etching mask 52. Then, preferably, after conducting the second etching step, the mask 52 is removed by an acid and then the mask 51 is removed as appropriate.

When the narrowest width between the light-emitting-element separation-trenches formed is $2L_{WSPT1}$, $L_{WSPT1}$ is preferably 20 $\mu$m or more, for example 30 $\mu$m or more for element separation by breaking. For separation by dicing, $L_{WSPT1}$ is preferably 300 $\mu$m or more. Since an excessively large width is not correspondingly effective, $L_{WSPT1}$ is generally 2000 $\mu$m or less. These are needed for ensuring a margin for an element manufacturing process and a scribe region.

A "setback-sidewall-surface" as defined in the present invention is a sidewall surface appearing as a sidewall in the second etching step, that is, during forming the light-emitting-element separation-trench, but not a wall surface appearing after the first etching alone.

After the second etching step, an insulating layer 30 is formed as shown in FIG. 1-8. The insulating layer may be appropriately made of any material as long as electric insulation can be ensured, as detailed above. Deposition can be conducted by any known method such as plasma CVD.

Next, as shown in FIG. 1-9A, a predetermined part in the insulating layer 30 is removed, to form a second-conductivity-type-side electrode exposed part 37 where the insulating layer on the second-conductivity-type-side electrode 27 is removed, a first current injection region 36 where the insulating layer on the first-conductivity-type cladding layer is removed, and a scribe region 14 where the insulating layer within the light-emitting-element separation-trench 13 is removed. Removal of the insulating layer 30 on the second-conductivity-type-side electrode 27 is conducted such that the periphery of the second-conductivity-type-side electrode is covered by the insulating layer. That is, the surface area of the second-conductivity-type-side electrode exposed part is smaller than the area of the second current injection region. Here, for ensuring a margin for an element manufacturing process, particularly a photolithography step or preventing unintended short circuit from occurring due to a solder material, the narrowest width ($L_{2w}$) in the part where the second-conductivity-type-side electrode is partly covered by the insulating layer is preferably 15 $\mu$m or more as described above. More preferably, it is 100 $\mu$m or more. In particular, covering the wide area of the second-conductivity-type-side electrode by the insulating layer allows for reducing unintended short circuit due to a metal solder material, with an another part such as the first-conductivity-type-side electrode.

For removing the insulating layer, an etching procedure such as dry etching and wet etching may be selected, depending on a material selected. For example, when the insulating layer is a single layer of $SiN_x$, dry etching using a gas such as $SF_6$ or wet etching using a hydrofluoric acid etchant can be employed. When the insulating layer is a dielectric multilayer film made of $SiO_x$ and $TiO_x$, the multilayer film in a desired part can be removed by Ar-ion milling.

A width of the scribe region 14 can be selected such that a predetermined $L_{ws}$ can be obtained as described above.

The second-conductivity-type-side electrode exposed part 37, the first current injection region 36 and the scribe region 14 can be separately formed. But they are, in general, simultaneously formed by etching. When the light-emitting-element separation-trench is formed to the intermediate portion of the combination of the light-uniforming layer and the buffer layer, the same process can be employed, except the insulating film is deposited not on the substrate surface but on the trench bottom surface in the above process.

Then, a first-conductivity-type-side electrode 28 is formed as shown in FIG. 1-10. The present invention is characterized in that the first-conductivity-type-side electrode is formed to have the larger area than the first current injection region and that the first-conductivity-type-side electrode and the second-conductivity-type-side electrode do not spatially overlap at all. This is important for ensuring an adequate area to ensure adequate bonding to a submount during flip-chip mounting of this element by soldering, and for ensuring an adequate distance for preventing unintended short circuit due to, for example, a solder material between the second-conductivity-type-side electrode and first-conductivity-type-side electrode. The narrowest width ($L_{1w}$) of the part where the first-conductivity-type-side electrode is in contact with the insulating layer is established within the above-mentioned range. In general, the width of 5 $\mu$m or more can ensure a process margin for a photolithography process and a liftoff method.

An electrode material preferably comprises, as described above, a material selected from Ti, Al, Ag and Mo or all of them as a constituent element when the first-conductivity-type is n-type. Generally, Al is exposed in a direction opposing to a main light-extraction direction of the n-side electrode.

The electrode material can be deposited by applying a variety of deposition processes such as sputtering, vacuum evaporation and plating, and an electrode shape can be obtained by appropriately applying, for example, a lift-off process using photolithography technique or site-selective evaporation using, for example, a metal mask.

The first-conductivity-type-side electrode is formed in this example such that a part thereof contacts with the first-conductivity-type cladding layer, but can be formed to contact with, in case formed, a first-conductivity-type-side contact layer.

In a manufacturing process according to the present invention, the first-conductivity-type-side electrode is formed in the final step of forming a stacked structure, which is advantageous in the light of reducing process damage. When the first-conductivity-type is n-type, Al is formed on the surface of the electrode material of the n-side electrode in a preferred embodiment. Here, if the n-side electrode is formed before formation of an insulating layer as the second-conductivity-type-side electrode, the n-side electrode surface, that is, Al metal receives a history of the etching process of the insulating layer. Etching of the insulating layer is conveniently conducted by wet etching using a hydrofluoric acid etchant as described above, but Al is less tolerant to various etchants including hydrofluoric acid, so that when effectively conducting such a process, the electrode itself is damaged. Furthermore, even if dry etching is employed, Al is relatively reactive, so that damages including oxidation may be introduced. Therefore, in the present invention, it is effective in reducing damage to the electrode that the first-conductivity-type-side electrode is formed after forming the insulating layer and after removing a predetermined unnecessary part in the insulating layer.

Thus, after forming the structure shown in FIG. 1-10, the substrate is scratched by diamond scribing or the substrate material is partly ablated by laser scribing using the light-emitting-element separation-trench for separating individual compound semiconductor light-emitting-elements.

In some embodiments, the light-emitting-element separation-trench is formed to the intermediate portion of the combination of the light-uniforming layer and the buffer layer, and in such a case, again, the substrate is scratched by diamond scribing or the substrate material is partly ablated by laser scribing using the light-emitting-element separation-trench.

In the present invention , there are no thin-film crystal layers which have influence on device performance, in the light-emitting-element separation-trench during the inter-element separation step, and therefore, process damage is not introduced into the thin-film crystal layer. Furthermore, since there are no insulating layers in the scribe region, for example, detachment of an insulating layer does not occur during scribing at all.

After finishing scratching (scribing), the compound semiconductor light-emitting-elements are divided in the braking step into the individual devices, each of which is mounted on a submount preferably by, for example, a solder material.

As described above, there is manufactured the light-emitting-element as shown in FIG. 1-1A. Likewise, light-emitting-elements shown in FIGs. 1-1C and 1-1D can be also manufactured.

In this manufacturing process, it is preferable as described above to conduct formation of the thin-film crystal layer, formation of the second-conductivity-type-side electrode, the etching steps (the first etching step and the second etching step), formation of the insulating layer, removal of the insulating layer (formation of the second-conductivity-type-side electrode exposed part, formation of the first current injection region and formation of the scribe region) and formation of the first-conductivity-type-side electrode, in this sequence. Such a process sequence allows for providing a light-emitting-element without damage in the thin-film crystal layer immediately below the second-conductivity-type-side electrode or damage in the first-conductivity-type-side electrode. Furthermore, the device shape reflects the process flow. In other words, this light-emitting-element internally has a structure where there are deposited the second-conductivity-type-side electrode, the insulating layer and the first-conductivity-type-side electrode in this sequence. That is, the second-conductivity-type-side electrode is in contact with the second-conductivity-type cladding layer (or another second-conductivity-type thin-film crystal layer) without an intervening insulating layer; there is a part of the upper periphery of the second-conductivity-type-side electrode which is covered by an insulating layer; and there is an area where an electrode periphery is intervened by an insulating layer between the first-conductivity-type-side electrode and the first-conductivity-type-side cladding layer (or another first-conductivity-type thin-film crystal layer).

Embodiment 2 of a manufacturing process

In Embodiment 2 of a manufacturing process, there will be described mainly a process for manufacturing a light-emitting-element shown in FIG. 1-2A and furthermore those for light-emitting-elements shown in FIG. 1-2C, FIG. 1-2D and FIG. 1-2E. Embodiment 2 is conducted as described in Embodiment 1 until the step of forming an insulating layer 30 (FIG. 1-5 to FIG. 1-8). Then, in Embodiment 1, only a region including the center of a light-emitting-element separation-trench of the substrate surface (a trench bottom surface) while in Embodiment 2, as shown in FIG. 1-9B, all the insulating layer 30 over the substrate 21 (that is, the trench bottom surface) within the light-emitting-element separation-trench 13 is removed and the substrate-side (that is, the trench bottom surface side) insulating layer formed on the sidewall within the trench is removed to form a part without an insulating layer 15. The following process may be used as a formation process. First, a resist mask having an opening whose area is equal to or slightly smaller than the area of the light-emitting-element separation-trench 13 is formed by photolithography, and then, wet etching is conducted using an etchant capable of etching an insulating layer, to initiate removal of the insulating layer on the substrate surface within the light-emitting-element separation-trench. If the etching is further continued, side etching proceeds to remove the insulating layer covering the substrate side of the trench sidewall by the wet etchant and thus to give a shape as shown in FIG. 1-9B

wherein an insulating layer of the sidewall is not present in the portion of the substrate side.

The sidewall exposed by the removal of the insulating layer is at least a part of the substrate side of the sidewall of the buffer layer, and depending on an embodiment, all the sidewall of the buffer layer 22 may be exposed or at least a part of the sidewall of the light-uniforming layer 23 may be exposed. When a part of the sidewall of the light-uniforming layer 23 is exposed, the sidewall of the buffer layer is exposed in FIG. 1-2A and the part without an insulating layer in FIG. 1-2A reaches the sidewall of the light-uniforming layer 23. The exposed sidewall without an insulating layer is preferably sidewall of undoped layer. This is because it prevents unintended electric short circuit from occurring even if a solder for bonding to a submount attaches to the sidewall during flip-chip mounting. The shape of the removed insulating layer of this type is advantageous for the process particularly when the substrate is removed in the manufacturing process for a light-emitting-element, because unintended defects such as detachment of an insulating layer with the substrate is prevented. Furthermore, when the light-emitting-element separation-trench is formed by partly etching the substrate, only a portion of the substrate may be exposed among the trench wall surface while the wall of the buffer layer may be covered by an insulating layer.

As in Embodiment 1, the second-conductivity-type-side electrode exposed part 37, the first current injection region 36 the and the part without an insulating layer 15 may be separately formed, but generally they are simultaneously formed by etching.

After the above, manufacturing of the light-emitting-element shown in FIG. 1-2A can be completed as described for Embodiment 1.

In Embodiment 2 of a manufacturing process, as in Embodiment 1, a configuration where the light-emitting-element separation-trench does not reach the substrate is also preferable. For example, when the light-emitting-element separation-trench is formed to the intermediate portion of the combination of the light-uniforming layer and the buffer layer, an insulating layer can be formed on the sidewall of the first-conductivity-type cladding layer, to maintain insulation to a running-around solder (see FIGs. 1-2C, 1-2D and 1-2E for a configuration after completion of the light-emitting-element). Here, a trench bottom surface is formed in the intermediate portion of the combination of the light-uniforming layer and the buffer layer and becomes an edge-step-face at the end of the light-emitting-element. The trench bottom surface is a plane having irregularity which can be formed by etching. Furthermore, a layer exposed from the sidewall without being covered by the insulating layer is preferably highly insulative. Then, when the insulating film 30 is deposited, the same process can be employed, except the insulating film is deposited in the above process not on the substrate surface but on the trench bottom surface. Otherwise, as described for Embodiment 2, the light-emitting-elements shown in FIGs. 1-2C, 1-2D and 1-2E can be also manufactured. The difference in a shape between FIGs. 1-2D and 1-2E is controlled by adjusting, for example, a side-etching period.

The light-emitting-element manufactured by the process of Embodiment 2 (and its variation) is also a device where the insulating layer covering the sidewall does not reach the end of the light-emitting-element, ensuring elimination of detachment of the insulating layer. In addition, by forming the exposed layer using a highly insulative material, a highly reliable device is obtained, similarly to the light-emitting-element according to the embodiment of FIG. 1-1A.

«Section B»

The invention disclosed in Section B relates to the followings.
[1] A compound semiconductor light-emitting-element comprising a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer in this order; a second-conductivity-type-side electrode; and a first-conductivity-type-side electrode, in which a main light-extraction direction is a buffer layer side in relation to the active layer structure,
wherein:

the first-conductivity-type-side electrode and the second-conductivity-type-side electrode are not spatially overlapped and are formed on the opposite side to the main light-extraction direction;
the light-emitting-element comprises a light-uniforming layer, for improving uniformity of a light outgoing from a light-extraction-face, between the buffer layer and the first-conductivity-type semiconductor layer;
at the edge of the light-emitting-element, sidewalls of at least the first-conductivity-type semiconductor layer, the active layer structure and the second-conductivity-type semiconductor layer form a setback-sidewall-surface, which has receded when forming a light-emitting-element separation-trench in a manufacturing process, on a sidewall surfaces of the thin-film crystal layers;

the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) in relation to the setback-sidewall-surface of the thin-film crystal layer,

(i) if a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer,

at least, the insulating layer being formed from a position distant from the light-emitting-element edge, or

(ii) if the light-uniforming layer and the buffer layer form a setback-sidewall-surface in combination and an edge-step-face is not present,

the insulating layer being not formed at least on the part of the buffer layer at the side of main light-extraction direction but covering the setback-sidewall-surface from the intermediate portion of the buffer layer or the light-uniforming layer; and

the light-emitting-element further comprises a support supporting the light-emitting-element, to which the first-conductivity-type-side electrode and the second-conductivity-type-side electrode are connected.

[2] The light-emitting-element as described in [1], having, in relation to the setback-sidewall-surface of the thin-film crystal layer, a configuration

(ii) where the light-uniforming layer and the buffer layer form a setback-sidewall-surface in combination and an edge-step-face is not present, the insulating layer being not formed at least on the part of the buffer layer at the side of main light-extraction direction but covering the setback-sidewall-surface from the intermediate portion of the buffer layer or the light-uniforming layer.

[3] The light-emitting-element as described in [1], having, in relation to the setback-sidewall-surface of the thin-film crystal layer, a configuration

(i) where a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer,

the insulating layer being formed from a position distant from the light-emitting-element edge, and wherein the insulating film covers at least a part of the setback-sidewall-surface of the light-uniforming layer and the buffer layer and does not cover the edge-step-face.

[4] The light-emitting-element as described in [1], having, in relation to the setback-sidewall-surface of the thin-film crystal layer, a configuration

(i) where a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer,

the insulating layer being formed from a position distant from the light-emitting-element edge, and wherein the insulating film covers the edge-step-face from a position distant from the light-emitting-element edge, and the surface in line with the setback-sidewall-surface in the first-conductivity-type semiconductor layer.

[5] The light-emitting-element as described in [4], wherein of the buffer layer, the layer constituting the part where the sidewall surface is not covered by the insulating layer is of an undoped type.

[6] The light-emitting-element as described in any of [1] to [5], wherein the light-uniforming layer is a layer formed between the substrate and the first-conductivity-type cladding layer as a part of the thin-film crystal layer.

[7] The light-emitting-element as described in any of [1] to [5], wherein when an average refractive index of the light-uniforming layer is $n_{oc}$, an average refractive index of the first-conductivity-type semiconductor layer is $n_1$ and an average refractive index of the buffer layer is $n_{bf}$, the relations:

$$n_1 < n_{oc} \text{ and } n_{bf} \leq n_{oc}$$

are satisfied.

[8] The light-emitting-element as described in any of [1] to [7], wherein when an emission wavelength of the light-emitting-element is $\lambda$ (nm), an average refractive index of the light-uniforming layer at an emission wavelength is $n_{oc}$, an average refractive index of the first-conductivity-type semiconductor layer at an emission wavelength is $n_1$ and a physical thickness of the light-uniforming layer is $t_{oc}$ (nm) and a relative refractive index difference $\lambda_{(oc-1)}$ between the light-uniforming layer and the first-conductivity-type semiconductor layer is defined as

$$\Delta_{(oc-1)}\equiv((n_{oc})^2-(n_1)^2)/(2\times(n_{oc})^2),$$

$t_{oc}$ is selected such that the relation:

$$(\sqrt{(2\times\Delta_{(oc-1)})}\times n_{oc}\times\pi\times t_{oc})/\lambda\geq\pi/2$$

is satisfied.

[9] The light-emitting-element as described in [8], wherein the relation:

$$(\sqrt{(2\times\Delta_{(oc-1)})}\times n_{oc}\times\pi\times t_{oc})/\lambda\geq 2\times\pi$$

is satisfied.

[10] The light-emitting-element as described in any of [1] to [9],

$$0.5\leq\rho_{oc}\quad .$$

[11] The light-emitting-element as described in any of [1] to [10], wherein the light-uniforming layer has a stacked structure consisting of multiple layers.

[12] The light-emitting-element as described in any of [1] to [11], wherein the narrowest width $L_w$ of a part where the first-conductivity-type-side electrode is contacting the insulating layer is 5 $\mu$m or more.

[13] The light-emitting-element as described in any of [1] to [12], wherein the narrowest width $L_{2w}$ of a part where the second-conductivity-type-side electrode is covered by the insulating layer is 15 $\mu$m or more.

[14] The light-emitting-element as described in [13], wherein the $L_{2w}$ is 100 $\mu$m or more.

[15] The light-emitting-element as described in any of [1] to [14], wherein the first-conductivity-type-side electrode comprises a layer made of material containing an element selected from the group consisting of Ti, Al, Ag, Mo and a combination of two or more of these.

[16] The light-emitting-element as described in any of [1] to [15], wherein the second-conductivity-type-side electrode comprises a layer made of material containing an element selected from the group consisting of Ni, Pt, Pd, Mo, Au and a combination of two or more of these.

[17] The light-emitting-element as described in any of [1] to [16], wherein the insulating layer is a single layer of material selected from the group consisting of $SiO_x$, $AlO_x$, $TiO_x$, $TaO_x$, $HfO_x$, $ZrO_x$, SiNx, $AlN_x$, $AlF_x$, $BaF_x$, $CaF_x$, $SrF_x$ and $MgF_x$.

[18] The light-emitting-element as described in any of [1] to [17], wherein the insulating layer is a dielectric multilayer film consisting of multiple layers.

[19] The light-emitting-element as described in [18], wherein at least one of the layers constituting the insulating layer is made of material containing fluoride.

[20] The light-emitting-element as described in [19], wherein the fluoride is selected from the group consisting of $AlF_x$, $BaF_x$, $CaF_x$, $SrF_x$ and $MgF_x$.

[21] The light-emitting-element as described in any of [1] to [20], wherein when R2 is a reflectance of reflection by the light-uniforming layer, of a light having an emission wavelength of the light-emitting-element vertically incoming from the first-conductivity-type semiconductor layer side to the light-uniforming layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

(Relation 1) R2 < R12
(Relation 2) R2 < R11
(Relation 3) R2 < R1q

are satisfied.

[22] The light-emitting-element as described in any of [1] to [21], wherein the thin-film crystal layer is formed by deposition on a substrate selected from the group consisting of sapphire, SiC, GaN, $LiGaO_2$, ZnO, $ScAlMgO_4$, $NdGaO_3$ and MgO.

[23] The light-emitting-element as described in any of [1] to [22], wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

[24] The light-emitting-element as described in any of [1] to [23], wherein the active layer structure consists of quantum well layer and barrier layer and when B is the number of the barrier layer and W is the number of the quantum well layer, B and W satisfy the relation:

$$B = W+1.$$

[25] The light-emitting-element as described in any of [1] to [24], wherein the first-conductivity-type is n-type and the second-conductivity-type is p-type.

[26] The light-emitting-element as described in any of [1] to [25], wherein the first-conductivity-type-side electrode and the second-conductivity-type-side electrode are bonded to the support having a metal layer via a solder.

[27] The light-emitting-element as described in [26], wherein bonding between each of the first-conductivity-type-side electrode and the second-conductivity-type-side electrode and the metal layer on the support is formed by a metal solder alone, or a metal solder and a metal bump.

[28] The light-emitting-element as described in [26] or [27], wherein the base material of the support is selected from the group consisting of AIN, $Al_2O_3$, Si, glass, SiC, diamond, BN and CuW.

[29] The light-emitting-element as described in any of [26] to [28], wherein the metal layer is not formed in a device-separating region in the support.

[30] The light-emitting-element as described in [2], wherein the surface of the light-extraction side of the substrate is not flat.

[31] The light-emitting-element as described in [3], wherein the surface of the light-extraction side of the buffer layer is not flat.

[32] The light-emitting-element as described in any of [2], wherein when R3 is a reflectance of reflection by the substrate, of a light having an emission wavelength of the light-emitting-element vertically incoming from the buffer layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

R4 < R3

is satisfied.

[33] The light-emitting-element as described in any of [3], wherein when R3 is a reflectance of reflection by the buffer layer, of a light having an emission wavelength of the light-emitting-element vertically incoming from the light-uniforming layer to the buffer layer side and R4 is a reflectance of reflection by an interface with a space, of a light having an emission wavelength of the light-emitting-element vertically incoming from the buffer layer to the space of the light-extraction side, a low-reflecting optical film is formed in the light-extraction side of the buffer layer such that the relation:

R4 < R3

is satisfied.

According to the invention disclosed in this Section, there can be provided a flip-chip mount type semiconductor light-emitting-element capable of emitting blue or ultraviolet light with higher output and higher efficiency and with higher uniformity in brightness in a light-extraction-face.

In the structure of the invention disclosed in this Section, process damage in each step in the manufacturing process is eliminated, so that a highly reliable element is provided without deterioration in the functions of the light-emitting-element.

<Explanation of Embodiments of the invention in Section B>

The invention relating to this Section is further explained in details, as below.

FIGs. 2-1A, 2-2A and 2-3A show a typical example of a compound semiconductor light-emitting-element according to the invention disclosed in this Section (hereinafter, simply referred to as "light-emitting-element"). FIGs. 2-1B and 2-3B are figures in which some portions of FIGs. 2-1A and 2-3A are omitted, respectively for explanation and FIGs. 2-4A and 2-4B are figures showing structures in the course of the manufacturing process for detailing the structure of the light-emitting-element. The present invention will be described with reference to FIGs. 2-1A to 2-4B.

A light-emitting-element according to the invention disclosed in this Section has, as shown in FIGs. 2-1A, 2-2A and 2-3A, on a substrate 21, a compound semiconductor thin-film crystal layer having a buffer layer 22, a light-uniforming layer 23, a first-conductivity-type semiconductor layer containing a first-conductivity-type cladding layer 24, a second-conductivity-type semiconductor layer containing a second-conductivity-type cladding layer 26, and an active layer structure 25 sandwiched between the first and the second-conductivity-type semiconductor layers; a second-conductivity-type-side electrode 27; and a first-conductivity-type-side electrode 28.

On a part of the second-conductivity-type cladding layer 26, the second-conductivity-type-side electrode 27 is disposed and the part where the second-conductivity-type cladding layer 26 and the second-conductivity-type-side electrode 27 are in contact with each other is a second current injection region 35. In this configuration, parts of the second-conductivity-type cladding layer and the active layer structure, and a part of the first-conductivity-type cladding layer are removed. The first-conductivity-type-side electrode 28 is disposed in contact with the first-conductivity-type cladding layer 24 exposed in the removed part, so that the second-conductivity-type-side electrode 27 and the first-conductivity-type-side electrode 28 are disposed on the same side in relation to the substrate. The second-conductivity-type-side electrode 27 and the first-conductivity-type-side electrode 28, each, is connected to metal layer 41 on a support 40 via metal solder 42.

In the present invention, the first-conductivity-type-side electrode and the second-conductivity-type-side electrode are not spatially overlapped. This means that as shown in FIGs. 2-1A, 2-2A and 2-3A, when the first-conductivity-type-side electrode 28 and the second-conductivity-type-side electrode 27 are projected to the substrate surface, their shadows are not overlapped.

An insulating layer 30 is formed for preventing unintended short circuit due to a solder or a conductive paste material for mounting entering/going around, for example, "between the second-conductivity-type-side electrode and the first-conductivity-type-side electrode" or "a sidewall of a thin-film crystal layer such as an active layer structure" during flip-chip mounting. At the same time, in the present invention, an insulating layer is disposed at the optimal position for avoiding influence of damage on element performance or on an yield.

The light-emitting-element according to the invention disclosed in this part may have a different configuration in two portions, that is, (I) a step shape of an edge in a light-emitting-element and (II) a shape of an insulating film in a light-emitting-element edge. In terms of (I) the step shape of the edge in a light-emitting-element, there are generally three options, depending on an etching depth when forming a light-emitting-element separation-trench for element separation in the manufacturing process, i.e. (i) the depth to the intermediate portion of the light-uniforming layer, (ii) the depth to the intermediate portion of the buffer layer and (iii) the depth to the substrate surface (or deeper). Furthermore, the wall surface of the light-emitting-element separation-trench recedes from the element edge after element separation. In the present invention, the surface that has been appeared as sidewall surface after forming the light-emitting-element separation-trench is, therefore, referred as a "setback-sidewall-surface" in the element after element separation. The sidewall surface appearing in the element edge by the element separation is called a "non-setback-sidewall-surface". Then, in the edge of the light-emitting-element, a step face is formed between the setback-sidewall-surface and the non-setback-sidewall-surface, which is called an "edge-step-face".

Depending on the depth (i) to (iii) in the light-emitting-element separation-trench, in the case of (i), a part of the light-uniforming layer forms a setback-sidewall-surface in combination with a thin-film crystal layer while the remaining (in the main light-extraction direction side) sidewall of the light-uniforming layer forms a non-setback-sidewall-surface, and there is an edge-step-face on the edge of the light-uniforming layer. Similarly, in the case of (ii), there is an edge-step-face on the edge of the buffer layer. In the case of (iii), an edge-step-face does not exist because both sidewalls of the light-uniforming layer and the buffer layer form setback-sidewall-surface (because they are a sidewall surface of the light-emitting-element separation-trench) and a substrate is not present in the manufactured element in the invention disclosed in this Section. Even in the case of (iii), since the sidewall of light-emitting-element separation-trench is considered to have receded from the element edge face which is separated without forming a light-emitting-element separation-trench, it is referred as "setback-sidewall" to keep consistency in the present invention.

The shape corresponding to (i) is shown in FIGs. 2-2A and 2-3A (FIG 2-3B). The shape corresponding to (ii) is shown in FIGs. 2-2B, 2-2C and 2-3C. The shape corresponding to (iii) is shown in FIGs. 2-1A (2-1B).

In terms of (II) the shape of the insulating film in the light-emitting-element edge, there are options, in the manufacturing process, (i) removing only the insulating layer in the region including the middle part over the trench bottom surface while leaving the insulating layer formed in the sidewall of the light-emitting-element separation-trench and (ii) removing a part of the insulating layer on the sidewall within the trench, in addition to the whole insulating layer formed in the trench bottom surface. In a light-emitting-element thus manufactured, there are provided two shapes, that is, (i) a shape where the insulating film is in contact with the trench bottom surface and (ii) a shape where the insulating film is present apart from the trench bottom surface. The shape corresponding to (i) is shown in FIGs. 2-3A (2-3B) and 2-3C. The shape corresponding to (ii) is shown in FIGs. 2-1A (2-1B), 2-2A(2-2B) and 2-2C.

Since a growth substrate is removed during the manufacturing process in the invention disclosed in this Section, a configuration is not preferable, in which the insulating film is in contact with the substrate when the substrate is removed. The invention disclosed in this Section does not, therefore, comprise a configuration where in the above combination, (I) the step shape in the edge of the light-emitting-element is a shape where (iii) neither the light-uniforming layer nor the buffer layer has a step and (II) the shape of the insulating film of the light-emitting-element edge is a shape where (i) the insulating film is in contact with the trench bottom surface.

There will be described configurations of the light-emitting-element according to the invention disclosed in this Section, as a first aspect: (ii) a shape where the insulating film is separated from the trench bottom surface and a second aspect: (i) a shape where the insulating film is in contact with the trench bottom surface in sequence, depending on (II) the shape of the insulating film in the light-emitting-element edge.

However, in common to the light-emitting-elements of the invention disclosed in this Section, the insulating film does not reach the end of the buffer layer in a main light-extraction direction.

First aspect

FIGs. 2-1A to 2-2C show embodiments belonging to the first aspect. First, there will be described a typical embodiment using FIG. 2-1A. A light-emitting-element of the invention disclosed in this Section does not have a substrate in a main light-extraction direction as shown in FIG. 2-1A. The insulating layer 30 covers at least the sidewall surfaces of a first-conductivity-type semiconductor layer (a first-conductivity-type cladding layer 24 in the figure), an active layer structure 25, and a second-conductivity-type semiconductor layer (a second-conductivity-type cladding layer 26 in the figure) of the sidewall surfaces exposed after removing the thin-film crystal layer. There is present a part without an insulating layer 15 which is not covered by an insulating layer at least in a main light-extraction direction side of the sidewall surface of the buffer layer 22, which optionally extends over the whole sidewall surface of the buffer layer 22. Furthermore, it may extend to a part or the whole of the sidewall surface of the light-uniforming layer 23. Thus, in the light-emitting-element of the invention disclosed in this Section, an insulating layer is not present in the element edge in a main light-extraction direction side of the buffer layer. This is also applied to other embodiments where a buffer layer or a light-uniforming layer has an edge-step-face.

It is preferable that the buffer layer of the part without an insulating layer 15 which is not covered by an insulating layer is an undoped layer which is not doped. When the part without an insulating layer 15 extends to the light-uniforming layer 23, layers to that portion is preferably an undoped layer which is not doped to the part. When the exposed part is made of a highly insulative material, no defects such as short circuit due to running around of a solder occur, resulting in a highly reliable element.

This structure has an intermediate configuration shown in FIG. 2-4A before element separation in the course of the manufacturing process. In the course of the manufacturing process, the insulating layer 30 is removed from the in-trench substrate surface (the trench bottom surface) in the light-emitting-element separation-trench 13 and the part without an insulating layer 15 of the trench sidewall surface near the substrate surface (the trench bottom surface). In the invention disclosed in this Section, the substrate 21 is removed in the course of the manufacturing process. Here, since the insulating layer 30 is not in contact with the substrate 21, detachment of the insulating layer does not occur during removal of the substrate. Therefore, insulation can be ensured and furthermore, tension generated during delamination of the insulating layer does not cause damage in the thin-film crystal layer.

The light-emitting-element thus obtained after separation has a part without an insulating layer 15 which is not covered by an insulating layer in a main light-extraction direction side of the wall surface of the buffer layer 22 as shown in area A in FIG. 2-1A. That is, this shape ensures elimination of detachment of the insulating layer in the side surface of the thin-film crystal layer. As a result, in this light-emitting-element, unintended short circuit is prevented even if running around of a solder occurs and furthermore, the thin-film crystal layer is not damaged, so that the functions of the light-emitting-element are not deteriorated, resulting in a highly reliable element.

In addition, the insulating layer 30 is in contact with a part of the first-conductivity-type-side electrode 28 at the side of the substrate (at the side of the main light-extraction direction) in the present invention as shown in part B (dotted line circle) in FIG. 2-1B. In other words, the insulating layer intervenes partly between the first-conductivity-type-side electrode 28 and the first-conductivity-type semiconductor layer (in this embodiment, the first-conductivity-type cladding layer 24). As a result, an area of the first-conductivity-type-side electrode 28 is larger than an area of the first current injection region 36. As shown in FIG. 2-1B, when $L_{1w}$ is the narrowest width in the part of the first-conductivity-type-side electrode in contact with the insulating layer, $L_{1w}$ is preferably 7 $\mu$m or more, particularly preferably 9 $\mu$m or more. Furthermore, $L_{1w}$ is generally 500 $\mu$m or less, preferably 100 $\mu$m or less. In general, when it is 5 $\mu$m or more, a process margin by a photolithography process and a liftoff procedure can be ensured.

Furthermore, as shown in part C (dotted line circle) in FIG. 2-1B, the insulating layer 30 cover a part of the second-conductivity-type-side electrode 27 on the support side (i.e. the opposite side to the main light-extraction direction). In other words, an area of the exposed part 37 in the second-conductivity-type-side electrode 27 is smaller than an area of the second-conductivity-type-side electrode 27, and an area of the second current injection region 35 is equal to an area of the second-conductivity-type-side electrode 27. As shown in FIG. 2-3, when $L_{2W}$ is the narrowest width in the part covered by the insulating layer around the second-conductivity-type-side electrode, $L_{2W}$ is preferably 15 $\mu$m or more. It is further preferably 30 $\mu$m or more, particularly preferably 100 $\mu$m or more. Covering many of the area of the second-conductivity-type-side electrode by the insulating layer particularly allows for reducing unintended short circuit with another part such as the first-conductivity-type-side electrode via a metal solder material. $L_{2w}$ is generally 2000 $\mu$m or less, preferably 750 $\mu$m or less.

Furthermore, the insulating layer 30 generally also covers the exposed part of the surface of the support side (the opposite side to the main light-extraction direction) in the first-conductivity-type semiconductor layer (the first-conductivity-type cladding layer 24 in this embodiment) and the second-conductivity-type semiconductor layer (the second-conductivity-type cladding layer 26 in this embodiment) for preventing short circuit as shown in the figure.

Such a positional relationship between the insulating layer and each electrode means that an element can be manufactured by a process with less process damage.

Furthermore, the element of the invention disclosed in this Section has the light-uniforming layer 23 in a light-extraction direction in relation to the first-conductivity-type semiconductor layer (in this embodiment, the first-conductivity-type cladding layer 24). The light-uniforming layer, as detailed later, has a appropriate optical confinement effect, so that a light emitted from the active layer structure 25 is distributed over the whole light-uniforming layer without being localized. Thus, looking from the light-extraction-face 50b of the substrate, the light is also distributed in a region corresponding to a non-emitting portion where an active layer is not present for the formation of the first-conductivity-type-side electrode 28. And even when an emitted light is uneven in the active layer, the light is distributed to improve uniformity. Furthermore, since the periphery of the light-uniforming layer 23 is covered by the insulating film 30, a reflectance of the insulating layer 30 to an emission wavelength can be increased to improve an optical confinement effect within the light-uniforming layer, resulting in further improvement in in-plane uniformity.

<u>First aspect -2</u>

There will be described other embodiments belonging to the first aspect with reference to FIGs. 2-2A to FIG. 2-2C. In terms of a difference from the embodiment in FIG. 2-1A, the light-emitting-element of FIG. 2-1A has a configuration where (I) the step shape in the edge of the light-emitting-element is a shape where (iii) neither the light-uniforming layer nor the buffer layer has a step, while the light-emitting-elements shown in FIGs. 2-2A to 2-2C have a configuration having (i) an edge-step-face based on the light-emitting-element separation-trench at the end of the light-uniforming layer or having (ii) an edge-step-face based on the light-emitting-element separation-trench at the end of the buffer layer.

This configuration is manufactured such that the light-emitting-element separation-trench is formed to the intermediate portion of the light-uniforming layer or the buffer layer, and as a result, in a completed device, at least the first-conductivity-type semiconductor layer, the active layer structure and the second-conductivity-type semiconductor layer has receded inside from the edge of the device to form a setback-sidewall-surface and there is an edge-step-face between setback-sidewall-surface and an element edge wall surface (a non-setback-sidewall-surface).

FIG. 2-2A shows an example of a light-emitting-element where a light-emitting-element separation-trench is formed to the intermediate portion of the light-uniforming layer 23. As shown in part A (dotted line circle in FIG), to the light-emitting-element edge, there are a buffer layer 22 and a part of the light-uniforming layer 23 as a non-setback-sidewall-surface and from the intermediate portion of the light-uniforming layer 23, the wall surface has receded from the element edge and forms a setback-sidewall-surface (the sidewall of the light-emitting-element separation-trench) in combination with the sidewall surface of the second-conductivity-type semiconductor layer. There is an edge-step-face 55 based on the bottom surface of the light-emitting-element separation-trench between the non-setback-sidewall-surface and the setback-sidewall-surface. The whole wall surface of the buffer layer is exposed. The edge-step-face of the light-uniforming layer is also not covered by the insulating layer, and there is a part without an insulating layer 15 which is not covered by the insulating layer in the main light-extraction direction side in the setback-sidewall-surface.

FIG. 2-2B shows an example of a light-emitting-element where a light-emitting-element separation-trench is formed to the intermediate portion of the buffer layer 22. As shown in part A (dotted line circle in FIG), a part of the buffer layer 22 is present as a non-setback-sidewall-surface to the light-emitting-element edge, and from the intermediate portion of the buffer layer 22, the wall surface recesses from the element edge and forms a setback-sidewall-surface (the sidewall of the light-emitting-element separation-trench) in combination with the sidewall surface of the second-conductivity-type semiconductor layer. There is an edge-step-face 55 based on the bottom surface between the non-setback-sidewall-surface and the setback-sidewall-surface. The non-setback-sidewall-surface (the sidewall part of the element edge) and the edge-step-face are not covered by the insulating layer. And in the setback-sidewall-surface (the sidewall of the light-emitting-element separation-trench), there is a part without an insulating layer 15 which is not covered by the insulating layer in the main light-extraction direction side. In this example, the part without an insulating layer 15 is present only in the buffer layer, and the light-uniforming layer 23 is covered by the insulating film 30. FIG. 2-2C also shows an example of a light-emitting-element manufactured such that the light-emitting-element separation-trench is formed in the intermediate portion of the buffer layer 22. As shown in this figure, the part without an insulating layer 15 extends from the buffer layer 22 to the light-uniforming layer 23 and the whole sidewall of the buffer layer is exposed.

As illustrated in these examples, even when the light-emitting-element separation-trench is formed to the intermediate portion of the layer as a combination of the light-uniforming layer and the buffer layer, prevention of detachment of the insulating layer is ensured in the device having a configuration that the insulating layer covering the sidewall does not reach the edge of the light-emitting-element. Also by forming the exposed layer using a high insulative material, a highly reliable device can be provided, similarly to the light-emitting-element of the configuration shown in FIG. 2-1A.

Second aspect

The second aspect has (II) a shape of the insulating film in the light-emitting-element edge where (i) the insulating film is in contact with the trench bottom surface. In the light-emitting-element of FIG. 2-3A, the light-emitting-element separation-trench is formed to the intermediate portion of the light-uniforming layer 23 before element separation as shown in FIG. 2-4B, and the insulating layer 30 does not cover the whole trench bottom surface of the light-emitting-element separation-trench 13 and a scribe region 14 without the insulating layer 30 is formed in the trench bottom surface. Therefore, in the element separation such as scribing and breaking in the manufacturing process, only the buffer layer and the light-uniforming layer can be broken and layers involved in device performance in the thin-film crystal layers, that is, the first-conductivity-type semiconductor layer, the active layer structure and the second-conductivity-type semiconductor layer are not directly damaged. Furthermore, since separation is initiated from the scribe region without an insulating layer in the trench bottom surface, detachment of the insulating layer does not occur, ensuring insulation and prevention of damage to a thin-film crystal layer due to tension generated during detachment of an insulating layer.

In a resultant light-emitting-element after separation, as shown in part A (dotted line circle) in FIGs. 2-3A and 2-3B, the insulating layer does not cover the whole edge step surface (trench bottom surface) formed in the light-uniforming layer, but covers the substrate surface inside from the position distant from the edge of the substrate 21 by $L_{ws}$. In the case that the division is performed from the middle of the width of the scribe region 14, a distance $L_{ws}$ without covering by the insulating layer corresponds to about 1/2 of the width of the scribe region 14 within the range of production fluctuation. In other words, formation of this configuration ensures that detachment of the insulating layer in the side of the thin-film crystal layer is avoided, so that in this light-emitting-element, unintended short circuit is prevented even if running around of a solder occurs and furthermore, the thin-film crystal layer is not damaged, so that the functions of the light-emitting-element are not deteriorated, resulting in a highly reliable element.

$L_{ws}$ has to be larger than 0 in a completed element and is generally 10 $\mu$m or more, preferably 15 $\mu$m or more. As a designed value, when the width of the scribe region 14 is $2L_{ws}$, $2L_{ws}$ is preferably 30 $\mu$m or more. Since an excessively large value is unnecessary, $2L_{ws}$ is generally 300 $\mu$m or less, preferably 200 $\mu$m or less.

The light-emitting-element shown in FIG. 2-3C has a configuration where the light-emitting-element separation-trench is formed to the intermediate portion of the buffer layer 22 and the insulating film formed in the trench bottom surface is removed in the scribe region 14 including the trench center region as shown in FIG. 2-4C.

In the light-emitting-element of the second aspect, by forming the exposed layer using a high insulative material, a highly reliable device can be provided, similarly to the light-emitting device of the embodiment of FIG. 2-1A. Furthermore, the configuration of the other parts of the second aspect is as described for the first aspect.

There will be further detailed the members and the structure constituting a device.

Substrate

In the invention disclosed in Section B, the completed light-emitting-element does not have a substrate. A substrate is selected, on which a semiconductor layer can be grown and which can be finally removed. The substrate does not have to be transparent, but when the substrate is delaminated by laser debonding described later in the manufacturing process, it preferably allows a laser beam at the particular wavelength for penetrating. Preferably, it is electrically an insulating substrate. This is because when a substrate is delaminated by a laser debonding method in the manufacturing process, free electrons in a conductive substrate makes it difficult to employ the above substrate delaminating method.

The substrate materials described in Section A can be used in the invention of Section B. Specific examples of such a material is preferably selected from sapphire, SiC, GaN, $LiGaO_2$, ZnO, $ScAlMgO_4$, $NdGaO_3$ and MgO, particularly preferably sapphire, GaN and ZnO substrates for growing a thin-film crystal of an InAlGaN light-emitting material or an InAlBGaN material over the substrate. In particular, when a GaN substrate is used, its Si doping concentration is preferably a Si concentration of $3 \times 10^{17}$ $cm^{-3}$ or less for an undoped substrate, more preferably $1 \times 10^{17}$ $cm^{-3}$ or less in the light of electric resistance and crystallinity. When the substrate is removed based on chemical etching, ZnO which can be easily removed using, for example, hydrochloric acid is preferable.

As described in Section A, again, an off substrate can be used; a substrate can be pre-treated by chemical etching, heating and so on; and a substrate may be deliberately made irregular.

In one of the embodiments, a thickness of the substrate is generally about 250 to 700 $\mu$m in an initial stage of device preparation for ensuring mechanical strength during semiconductor crystal growth and an element manufacturing process. After required growth of a semiconductor layer using a substrate, the substrate is removed by, for example, polishing, etching, laser debonding or the like. Particularly, when it is delaminated by an optical procedure such as laser debonding, it is preferable to use a two-side polished substrate in thin-film crystal growth. This is because if a one-side polished substrate is used, a laser incident from a surface without thin-film crystal growth is incident from a crude surface, leading to an undue large laser output during laser debonding.

Buffer layer

In terms of a buffer layer, all the descriptions in Section A can be applied to the invention of Section B. Since a substrate does not remain in the invention according to this Section, preferred embodiments will be further described.

In a completed element, as described above, at least an area near a light-extraction direction of the sidewall surface of a buffer layer (a substrate side in buffer layer deposition) is not covered by an insulating layer.

For confining a light in the light-uniforming layer described later for wave guiding, a refractive index of the buffer layer at an emission wavelength of the light-emitting-element is equal to or less than an average refractive index of the light-uniforming layer, preferably less than an average refractive index of the light-uniforming layer. A physical thickness of the buffer layer is preferably more than $4\lambda/n_{bf}$ wherein an emission wavelength of a light-emitting-element is $\lambda$ (nm) and an average refractive index of the buffer layer is $n_{bf}$.

Since the substrate is removed in the course of the manufacturing process, the buffer layer constitutes a main light-extraction-face. As described above, one of the methods of removing the substrate includes a process where a part of the buffer layer is optically decomposed using a light which is transparent to the substrate and can be absorbed by the buffer layer, to remove the substrate. When employing such a method, a material suitable for the process is selected. For example, when the substrate is sapphire and the buffer layer is GaN, a laser debonding can be conduced, where an excimer laser having an oscillation wavelength of 248 nm is irradiated from the substrate side where the thin-film crystal has not been grown, to decompose GaN in the buffer layer into metal Ga and nitrogen and thus to delaminate the substrate.

Since there is not a substrate in a main light-extraction direction in the configuration disclosed in this Section, it is desirable that a so-called low reflecting coating layer or low-reflecting optical film is formed on a plane in a main light-extraction direction of the buffer layer. It may lead to inhibiting reflection due to a refractive index difference in a buffer layer-air interface and an output and element efficiency can be improved. Here, when R3 is a reflectance of reflection by the buffer layer, of a light having an emission wavelength of the light-emitting-element vertically incoming from the light-uniforming layer described later to the buffer layer side and R4 is a reflectance of reflection by an interface with a space, of a light having an emission wavelength of the light-emitting-element vertically incoming from the buffer layer to the space of the light-extraction side, it is preferable that a low-reflecting optical film is formed in the light-extraction side of the buffer layer such that the relation:

R4<R3

is satisfied. For example, when the buffer layer is GaN, the low reflecting coating film is preferably, for example, $Al_2O_3$.

This is because since a refractive index of the low reflecting coating film is preferably near $\sqrt{n_{bf}}$ in relation to a refractive index $n_{bf}$ of the buffer layer at an emission wavelength of the element, and because $Al_2O_3$ has a refractive index near a square root of a refractive index of GaN.

It is also preferable that a plane in a main light-extraction direction of the buffer layer is an irregular or crude surface. It allows for extracting light generated within quantum well layer(s) with a high efficiency, which is desirable in the light of improving an element output and an efficiency. When an emission wavelength of an element is λ (nm), a surface crudeness of the buffer layer is preferably such that an average roughness Ra (nm) satisfy the relation:

$$\lambda/5 \text{ (nm)} < \text{Ra (nm)} < 10 \times \lambda \text{ (nm)}$$

more preferably, the relation:

$$\lambda/2 \text{ (nm)} < \text{Ra (nm)} < 2 \times \lambda \text{ (nm)}.$$

In this configuration, at least a part of the buffer layer is exposed at a device edge. Therefore, it is preferable that at least the exposed part is made undoped because insufficient insulation which may occur by soldering during device assembly can be prevented.

Light-uniforming layer

A light-uniforming layer employed in the invention according to this Section is as described in Section A.

First-conductivity-type semiconductor layer and first-conductivity-type cladding layer

A first-conductivity-type semiconductor layer and a first-conductivity-type cladding layer employed in the invention according to this Section are as described in Section A.

Active layer structure

An active layer structure employed in the invention according to this Section is as described in Section A.

Second-conductivity-type semiconductor layer and second-conductivity-type cladding layer

A second-conductivity-type semiconductor layer and a second-conductivity-type cladding layer employed in the invention according to this Section are as described in Section A.

Second-conductivity-type-side electrode

A second-conductivity-type-side electrode employed in the invention according to this Section is as described in Section A.

First-conductivity-type-side electrode

A first-conductivity-type-side electrode employed in the invention according to this Section is as described in Section A.

Insulating layer

An insulating layer employed in the invention according to this Section is as described in Section A.

Support

Since the light-emitting-element of this Section does not have a substrate, functions required to a support are more or less different from those described in Section A.

Although it is essential that a support 40 plays a role as a support for a thin-film crystal layer during substrate removal, the support after the element manufacturing is completed very preferably has functions of current input and heat dissipation simultaneously. In this view, a base material of the support is preferably selected from the group consisting of a metal, AlN, SiC, diamond, BN and CuW. These materials are preferred because they exhibit good heat dissipation properties and can efficiently prevent the problem of heat generation which is inevitable in a high-output light-emitting-element. Furthermore, $Al_2O_3$, Si, glasses and so on are also preferable because they are inexpensive and can be used as a support in a wide variety of applications. It is desirable to conduct wet etching for removing metal Ga after decomposing a part of the thin-film crystal layer into metal Ga and nitrogen by laser irradiation in substrate removal described later, and in such a case, the support is preferably made of a material resistant to etching. It is desirable that when selecting a base material for a support from metals, its periphery is covered by, for example, a dielectric material which is etching resistant. A metal base material is preferably a material having a higher reflectance at an emission wavelength of the light-emitting-element, preferably Al, Ag and so on. When it is covered by a dielectric material, SiNx, $SiO_2$ and so on formed by any of various CVD processes are desirable.

In view of having both functions of current introduction and of heat dissipation after completion of an element, the support preferably has an electrode interconnection for current input on a base material, and the part on the electrode interconnection where a device is mounted preferably has an adhesion layer for bonding of the support to a device as appropriate. Here, the adhesion layer may be formed using an Ag-containing paste, a metal bump or the like, and it is very preferably made of a metal solder in the light of heat dissipating properties. A metal solder can allow for flip-chip mounting with significantly excellent heat dissipating properties in comparison with an Ag-containing paste or a metal bump. Here, a metal solder may be a material such as In, InAg, InSn, SnAg, PbSn, AuSn, AuGe and AuSi. A high-melting solder such as AuSn, AuSi and AuGe is more preferred. This is because a temperature of an area near the solder material is increased to about 200 °C when introducing a large current for ultrahigh power driving of a light-emitting-element, and thus as a solder material, preferred is a metal solder having a melting point higher than an element temperature during driving. In some cases, it is preferable that bonding is formed using a bump whose periphery is filled with a metal solder material for canceling height difference in an element during flip-chip mount mounting.

Generally, an element is separated by dividing the support as described later and thus, it is preferable that in a completed light-emitting-element, there is a separation region without a metal interconnection at the periphery of the support 40. As shown in FIG. 2-5, when a width of a region without a metal interconnection is $L_{WSPT2}$ (in FIG. 2-5, those in the left and the right sides are represented by $L_{WSPT2(left)}$ and $L_{WSPT2(right)}$, respectively), $L_{WSPT2}$ may be more than 0 in a completed element, but as described below, a preferable range varies depending on a method employed for a separation process.

For separation by scribing, it is generally 10 $\mu$m or more, preferably 15 $\mu$m or more. In a separation region 47, $2L_{WSPT2}$ is, therefore, preferably 30 $\mu$m or more. Since an excessively large value is not meaningful, $2L_{WSPT2}$ is generally 300 $\mu$m or less, preferably 200 $\mu$m or less.

For separation by dicing, $L_{WSPT2}$ is generally 100 $\mu$m or more, preferably 500 $\mu$m or more. As a separation region 47, $2L_{WSPT2}$ is, therefore, preferably 1000 $\mu$m or more. Since an excessively large value is not meaningful, $2L_{WSPT2}$ is generally 2000 $\mu$m or less, preferably 1500 $\mu$m or less.

An embodiment where a support is not divided may be feasible; for example, a plurality of light-emitting-elements may be mounted on one support. By deliberately varying metal interconnections over the support, the light-emitting-elements on one support can be connected in parallel, in series or in combination of these.

Manufacturing process for a light-emitting-element disclosed in Section B

Next, there will be described a process for manufacturing a semiconductor light-emitting-element according to the invention disclosed in this Section.

Manufacturing process for the light-emitting-element of the first aspect

In a example of a manufacturing process, as shown in FIG. 2-7, first a substrate 21 is provided and over the surface are sequentially deposited a buffer layer 22, a light-uniforming layer 23, a first-conductivity-type cladding layer 24, an active layer structure 25 and a second-conductivity-type cladding layer 26 by thin-film crystal growth. MOCVD is preferably employed. However, it is possible to use MBE, PLD and the like for forming all or some of the thin-film crystal layers. A configuration of these layers can be appropriately changed, depending on, for example, an application of the element. After forming thin-film crystal layers, a variety of processings are allowed. As used herein, the term "thin-film crystal growth" includes heat-treatment after growing a thin-film crystal layer.

For providing the configuration shown in FIGs. 2-1A to 2-2C after growing thin-film crystal layers in the invention disclosed in this Section, it is preferable that a second-conductivity-type-side electrode 27 is formed as shown in FIG. 2-7. That is, it is preferable that scheduled formation of the second-conductivity-type-side electrode 27 in the second current injection region 35 is conducted before formation of an insulating layer 30, formation of a first current injection region 36 and formation of a first-conductivity-type-side electrode 28. This is because when the second-conductivity-type is p-type as a desirable embodiment, formation of a p-side electrode after processing the exposed surface of the p-type cladding layer by various processes leads to reduction of a hole concentration in the p-GaN cladding layer with a relatively lower activation rate among GaN materials, due to process damage. For example, if the step of forming an insulating layer by p-CVD is conducted before forming the second-conductivity-type-side electrode, plasma damage remains in its surface. Thus, in the present invention, it is desirable that after thin-film crystal growth, formation of the second-conductivity-type-side electrode is conducted before any of the other process steps (for example, a first etching step, a second etching step or the step of forming an insulating layer, the step of forming an exposed part in a second-conductivity-type-side electrode, the step of forming a first current injection region and the step of forming a first-conductivity-type-side electrode as described later).

In the present invention, when the second-conductivity-type is p-type and when the exposed surface is a relatively stable metal such as Au (in a typical example, the surface of the second-conductivity-type-side electrode is expected to be Au as described above), the surface is not likely process-damaged through the subsequent processes. In this respect, it is again desirable in the present invention that after thin-film crystal growth, formation of the second-conductivity-type-side electrode is conducted before any other process step.

In the present invention, when a layer in which the second-conductivity-type-side electrode is formed is the second-conductivity-type contact layer, process damage to the second-conductivity-type semiconductor layer can be reduced in the same manner.

The second-conductivity-type-side electrode 27 can be formed by applying a variety of deposition processes such as sputtering, vacuum evaporation and plating, and a desired shape can be obtained by appropriately applying, for example, a lift-off process using photolithography technique or site-selective evaporation using, for example, a metal mask.

After forming the second-conductivity-type-side electrode 27, a part of the first-conductivity-type cladding layer 24 is exposed as shown in FIG. 2-8. In this step, it is preferable to remove the second-conductivity-type cladding layer 26, the active layer structure 25 and further a part of the first-conductivity-type cladding layer 24 by etching (a first etching step). The first etching step is conducted for the purpose of exposing a semiconductor layer into which a first-conductivity-type-side electrode described later injects first-conductivity-type carriers, and therefore, when a thin-film crystal layer contains another layer, for example, a cladding layer consists of two layers or contains a contact layer, the layer including the additional layer may be etched.

The first etching step does not require very high etching precision and thus can be a known dry etching technique by plasma etching using, for example, $Cl_2$ and using a etching mask of a nitride such as $SiN_x$ or an oxide such as $SiO_x$. It is, however, also preferable that dry etching can be conducted using a metal fluoride mask as detailed in a second etching step described later. It is particularly preferable to conduct etching by plasma excited dry etching using a gas such as $Cl_2$, $SiCl_4$, $BCl_3$ and $SiCl_4$ and using an etching mask containing a metal-fluoride layer selected from the group consisting of $SrF_2$, $AlF_3$, $MgF_2$, $BaF_2$, $CaF_2$ and combinations of these. Furthermore, the optimal dry etching is ICP type dry etching capable of generating high density plasma.

Here, the second-conductivity-type-side electrode 27 receives process history of the formation of a $SiN_x$ mask formed by, for example, plasma CVD or the step of removing the $SiN_x$ mask after the first etching step. However, when a stable metal such as Au is formed over the surface, the second-conductivity-type-side electrode is less process-damaged.

Then, as shown in FIG. 2-9, a light-emitting-element separation-trench 13 is formed by a second etching step. In the present invention, it is necessary that the light-emitting-element separation-trench is formed such that it interrupts at least the first-conductivity-type cladding layer, and in this embodiment, the light-emitting-element separation-trench 13 is formed such that it reaches the substrate 21. Here, when diamond scribing is conducted from the side where the thin-film crystal layers have been formed in the steps of scribing and breaking for device separation, detachment of a GaN material on the sapphire substrate can be inhibited. Furthermore, it is advantageous that when laser scribing is conducted, thin-film crystal layers are not damaged. Furthermore, it is also preferable that the light-emitting-element separation-trench is formed by conducting etching into a part of the sapphire substrate (same for other substrates such as GaN).

Alternatively, a configuration where the light-emitting-element separation-trench does not reach the substrate is also preferable. For example, when the light-emitting-element separation-trench is formed to the intermediate portion of the combination of the light-uniforming layer and the buffer layer, an insulating layer can be formed on the sidewall of the first-conductivity-type cladding layer, to maintain insulation to a running-around solder (see FIGs. 2-2A to 2-2C for a configuration after completion of the light-emitting-element). Here, a trench bottom surface is formed in the intermediate portion of the combination of the light-uniforming layer and the buffer layer and becomes an edge-step-face at the end of the light-emitting-element. The trench bottom surface is a plane having irregularity which can be formed by etching. Since the trench bottom surface is subjected to processing such as scribing during element separation, an edge-step-face after element separation is often relatively lower in flatness as a plane and parallelity to a layer direction. Furthermore, a layer exposed from the sidewall without being covered by the insulating layer is preferably highly insulative.

In the second etching step, the GaN material must be etched to more depth compared with the first etching step. The sum of a layer depth etched by the first etching step is generally about 0.5 $\mu$m while in the second etching step, the depth is sometimes 3 to 7 $\mu$m, 3 to 10 $\mu$m or more than 10 $\mu$m because the whole first-conductivity-type cladding layer 24 and at least a part or sometimes the whole of the light-uniforming layer 23 and the buffer layer 22 must be etched.

Generally, a metal mask, a nitride mask such as $SiN_x$ and an oxide mask such as $SiO_x$ have a selectivity ratio to a GaN material, in terms of tolerance to etching by $Cl_2$ plasma, of about 5. In conducting the second etching step where a GaN material with a large film thickness must be etched, a relatively thicker $SiN_x$ film is necessary. For example, etching a GaN material with a thickness of 10 $\mu$m by a second dry-etching process requires a $SiN_x$ mask with a thickness of 2 $\mu$m. However, with a $SiN_x$ mask with such a thickness, the $SiN_x$ mask is also etched during the dry etching, and not only its thickness in a longitudinal direction but also its shape in a horizontal direction are changed, so that a desired GaN material part cannot be selectively etched.

Thus, when forming the light-emitting-element separation-trench in the second etching step, dry etching using a mask including a metal-fluoride layer is preferred. A material constituting the metal-fluoride layer is preferably $MgF_2$, $CaF_2$, $SrF_2$, $BaF_2$ or $AlF_3$, most preferably $SrF_2$ in the light of balance between dry etching tolerance and wet-etching properties.

A metal fluoride film must be sufficiently tolerant to dry etching in the first and the second etching steps while being easily etched by etching for patterning (preferably, wet etching) to give a patterning shape with good linearity particularly in the sidewall. Deposition of a metal-fluoride layer at a temperature of 150 °C or higher gives a dense film having good adhesiveness to a base layer, and the film after patterned by etching shows good linearity in a mask sidewall. A deposition temperature is preferably 250 °C or higher, further preferably 300 °C or higher, most preferably 350 ° C or higher. Particularly, a metal-fluoride layer deposited at 350 °C or higher exhibits good adhesiveness to any type of base layer and gives a fine film which is highly tolerant to dry etching and exhibits quite higher linearity in its sidewall in terms of a patterning shape, ensuring controllability to a width of the opening, and thus it is the most preferable as an etching mask.

Thus, although deposition at a high temperature is preferable for providing an etching mask exhibiting good adhesiveness to a base layer, giving a fine film, being highly tolerant to dry etching and exhibiting very high linearity in its sidewall and very high controllability of a width of the opening in terms of a patterning shape, a too high deposition temperature gives a film having excessive tolerance to wet etching using, for example, hydrochloric acid preferably used for patterning a metal fluoride, and thus the film cannot be easily removed. Particularly, when a mask such as $SrF_2$ is exposed to plasma such as chlorine plasma during dry etching of a semiconductor layer, an etching rate in a later process for removing the mask layer tends to be reduced in comparison with that before exposure to plasma such as chlorine plasma. Therefore, deposition of a metal fluoride at an excessively higher temperature is undesirable in the light of its patterning and final removal.

First, in a metal fluoride before being exposed to plasma in dry etching of a semiconductor layer, a layer deposited at a lower temperature has a larger etching rate to an etchant such as hydrochloric acid, resulting in a higher etching rate and a layer deposited at a higher temperature has a smaller etching rate, resulting in a lower etching rate. When deposition temperature becomes 300 °C or higher, the etching rate decreases noticeably in comparison with a film deposited at a temperature of about 250 °C, and a temperature of about 350 ° C to 450 °C is within a very favorable etching rate range. A deposition temperature of higher than 480 ° C, however, leads to an excessively smaller absolute etching rate value, so that patterning of the metal fluoride takes a too longer time and patterning may be difficult under the conditions where a resist mask layer and so on are not detached. Furthermore, in a metal fluoride after being exposed to plasma in dry etching of a semiconductor layer, a wet-etching rate by, for example, hydrochloric acid in a removal step tends to decrease and growth at an excessively high temperature makes it difficult to remove the metal fluoride.

From such a viewpoint, a deposition temperature of a metal-fluoride layer is preferably 480 ° C or lower, further preferably 470 ° C or lower, particularly preferably 460 ° C or lower.

Using a mask patterned considering the above (the mask may be a multilayer with $SiN_x$ or $SiO_2$ such that the metal-fluoride layer becomes a surface layer), dry etching is conducted. A gas species for the dry etching may be preferably selected from $Cl_2$, $BCl_3$, $SiCl_4$, $CCl_4$ and combinations of these. In the dry etching, a selectivity ratio of the $SrF_2$ mask to a GaN material is over 100, so that a thick GaN film can be easily and precisely etched. Furthermore, the optimal dry etching technique is ICP type dry etching capable of generating high-density plasma.

After the above etching, when the used unnecessary metal-fluoride layer mask is removed by an etchant such as hydrochloric acid, a multilayer mask with $SiN_x$, $SiO_2$ or the like may be formed such that the metal-fluoride layer becomes a surface layer if a material susceptible to an acid is present under the metal fluoride mask, for example, if an electrode material is susceptible to an acid. In such a case, $SiN_x$ or $SiO_2$ may be present in the whole region under the metal fluoride mask or alternatively, as shown, for example, in FIG. 2-19, a mask 51 such as $SiN_x$ and $SiO_2$ is not

necessarily present in the whole region of the metal fluoride mask layer 52 but can be at least formed over a material susceptible to an acid.

By such a second etching step, the light-emitting-element separation-trench 13 is formed as shown in FIG. 2-9.

Regarding the first etching step and the second etching step, either step can be carried out before or after another step. It is also preferable for simplifying a process that the first etching step is first conducted and then without removing the etching mask, the second etching step is conducted. As shown in FIG. 2-19, first, a first etching mask 51 is formed from a material resistant to an acid such as $SiN_x$ and $SiO_2$ (preferably $SiN_x$) and etching is conducted such that a first-conductivity-type cladding layer 24 appears, and without removing the mask 51, a metal-fluoride layer is formed as a second etching mask 52. Then, preferably, after conducting the second etching step, the mask 52 is removed by an acid and then the mask 51 is removed as appropriate.

When the narrowest width between the light-emitting-element separation-trenches formed is $2L_{WSPT1}$, $L_{WSPT1}$ is preferably 20 $\mu m$ or more, for example 30 $\mu m$ or more for element separation by breaking. For separation by dicing, $L_{WSPT1}$ is preferably 300 $\mu m$ or more. Since an excessively large width is not correspondingly effective, $L_{WSPT1}$ is generally 2000 $\mu m$ or less. These are needed for ensuring a margin for an element manufacturing process and a scribe region.

A "setback-sidewall-surface" as defined in the present invention is a sidewall surface appearing as a sidewall in the second etching step, that is, during forming the light-emitting-element separation-trench, but not a wall surface appearing after the first etching alone.

After the second etching step, an insulating layer 30 is formed as shown in FIG. 2-10. The insulating layer may be appropriately made of any material as long as electric insulation can be ensured, as detailed above. Deposition can be conducted by any known method such as plasma CVD.

Next, as shown in FIG. 2-11, a predetermined part in the insulating layer 30 is removed, to form a second-conductivity-type-side electrode exposed part 37 where the insulating layer on the second-conductivity-type-side electrode 27 is removed, a first current injection region 36 where the insulating layer on the first-conductivity-type cladding layer is removed, and a region without an insulating layer 15 where the insulating layer on the substrate and the sidewall within the light-emitting-element separation-trench 13 is removed.

Removal of the insulating layer 30 on the second-conductivity-type-side electrode 27 is conducted such that the periphery of the second-conductivity-type-side electrode is covered by the insulating layer. That is, the surface area of the second-conductivity-type-side electrode exposed part is smaller than the area of the second current injection region. Here, for ensuring a margin for an element manufacturing process, particularly a photolithography step or preventing unintended short circuit from occurring due to a solder material, the narrowest width ($L_{2w}$) in the part where the second-conductivity-type-side electrode is partly covered by the insulating layer is preferably 15 $\mu m$ or more as described above. More preferably, it is 100 $\mu m$ or more. In particular, covering the wide area of the second-conductivity-type-side electrode by the insulating layer allows for reducing unintended short circuit due to a metal solder material, with an another part such as the first-conductivity-type-side electrode.

For removing the insulating layer, an etching procedure such as dry etching and wet etching may be selected, depending on a material selected. For example, when the insulating layer is a single layer of $SiN_x$, dry etching using a gas such as $SF_6$ or wet etching using a hydrofluoric acid etchant can be employed. When the insulating layer is a dielectric multilayer film made of $SiO_x$ and $TiO_x$, the multilayer film in a desired part can be removed by Ar-ion milling.

The second-conductivity-type-side electrode exposed part 37, the first current injection region 36 and the part without an insulating layer 15 can be separately formed. But they are, in general, simultaneously formed by etching.

In order to form the part without an insulating layer 15 by etching the insulating film on the sidewall near the substrate in the light-emitting-element separation-trench, the following process may be used as a formation process. First, a resist mask having an opening whose area is equal to or slightly smaller than the area of the light-emitting-element separation-trench 13 is formed by photolithography, and then, wet etching is conducted using an etchant capable of etching an insulating layer, to initiate removal of the insulating layer on the substrate surface within the light-emitting-element separation-trench. If the etching is further continued, side etching proceeds to remove the insulating layer covering the substrate side of the trench sidewall by the wet etchant and thus to give a shape as shown in FIG. 2-11 wherein an insulating layer of the sidewall is not present in the portion of the substrate side. In the case that the insulating layer is removed as this case, the exposed sidewall without an insulating layer is preferably sidewall of undoped layer. This is because it prevents unintended electric short circuit from occurring even if a solder for bonding to a support attaches to the sidewall during flip-chip mounting. The shape of the removed insulating layer of this type is advantageous for the process particularly when the substrate is removed in the manufacturing process for a light-emitting-element, because unintended defects such as detachment of an insulating layer with the substrate is prevented

Then, a first-conductivity-type-side electrode 28 is formed as shown in FIG. 2-12. The present invention is characterized in that the first-conductivity-type-side electrode is formed to have the larger area than the first current injection region and that the first-conductivity-type-side electrode and the second-conductivity-type-side electrode do not spatially overlap at all. This is important for ensuring an adequate area to ensure adequate bonding to a support during flip-chip mounting of this element by soldering, and for ensuring an adequate distance for preventing unintended short circuit due to, for example, a solder material between the second-conductivity-type-side electrode and first-conductivity-type-side electrode. The narrowest width ($L_{1w}$) of the part where the first-conductivity-type-side electrode is in contact with the insulating layer is established within the above-mentioned range. In general, the width of $5\mu$ m or more can ensure a process margin for a photolithography process and a liftoff method.

An electrode material preferably comprises, as described above, a material selected from Ti, Al, Ag and Mo or all of them as a constituent element when the first-conductivity-type is n-type. Generally, Al is exposed in a direction opposing to a main light-extraction direction of the n-side electrode.

The electrode material can be deposited by applying a variety of deposition processes such as sputtering, vacuum evaporation and plating, and an electrode shape can be obtained by appropriately applying, for example, a lift-off process using photolithography technique or site-selective evaporation using, for example, a metal mask.

The first-conductivity-type-side electrode is formed in this example such that a part thereof contacts with the first-conductivity-type cladding layer, but can be formed to contact with, in case formed, a first-conductivity-type-side contact layer.

In this manufacturing process, the first-conductivity-type-side electrode is formed in the final step of forming a stacked structure, which is advantageous in the light of reducing process damage. When the first-conductivity-type is n-type, Al is formed on the surface of the electrode material of the n-side electrode in a preferred embodiment. Here, if the n-side electrode is formed before formation of an insulating layer as the second-conductivity-type-side electrode, the n-side electrode surface, that is, Al metal receives a history of the etching process of the insulating layer. Etching of the insulating layer is conveniently conducted by wet etching using a hydrofluoric acid etchant as described above, but Al is less tolerant to various etchants including hydrofluoric acid, so that when effectively conducting such a process, the electrode itself is damaged. Furthermore, even if dry etching is employed, Al is relatively reactive, so that damages including oxidation may be introduced. Therefore, in the present invention, it is effective in reducing damage to the electrode that the first-conductivity-type-side electrode is formed after forming the insulating layer and after removing a predetermined unnecessary part in the insulating layer.

Thus, after forming the structure of FIG. 2-12, there is carried out a preparation for substrate removal. Generally, the structure shown in FIG. 2-12 is first bonded to the support 40 as the whole or a part of the wafer. This is because since even the thin-film crystal layers as a whole has at most a thickness of about 15 $\mu$m, once the substrate is removed mechanical strength is insufficient, resulting that it cannot tolerate the later processes by itself. A material for the support is as described above.

As shown in FIG. 2-13, the structure is mounted on a metal layer 41 (for example, an electrode interconnection) on a support 40, for example, via connection with a metal solder 42.

Here, in the light-emitting-element of the present invention, the second-conductivity-type-side electrode 27 and the first-conductivity-type-side electrode 28 are disposed such that they are not spatially overlapped at all and the first-conductivity-type-side electrode is larger than the first current injection region and preferably has an adequate area to ensure both prevention of unintended short circuit and improved heat dissipating properties. Furthermore, since the sidewalls of the other thin-film crystal layers are covered by an insulating film except at least a part of the buffer layer, particularly the undoped part, running out of a solder does not cause a problem such as short circuit in an active layer structure sidewall within the thin-film crystal layer.

Subsequently, the element is bonded to the support and then the substrate is removed. Removal of the substrate can be conducted by any method such as polishing, etching and laser debonding. When polishing a sapphire substrate, the substrate can be removed using a polishing material such as diamond. A substrate can be removed by dry etching. Furthermore, for example, when the substrate is sapphire and a thin-film crystal growth part is made of an InAlGaN material, laser debonding can be employed by using a KrF excimer laser from the sapphire substrate side at 248 nm which penetrates the sapphire substrate and is absorbed by, for example, GaN used for a buffer layer, to decompose GaN in a part of the buffer layer into metal Ga and nitrogen and delaminate the substrate. FIG. 2-14 schematically shows the stage when the substrate 21 has been delaminated by laser debonding.

When using ZnO, $ScAlMgO_4$ or the like as a substrate, an etchant such as HCl can be used in wet etching to remove the substrate.

Since the substrate is not in contact with the insulating layer at all in the invention disclosed in this Section, removal of the substrate does not secondarily cause a problem such as detachment of the insulating layer.

Then, as shown in FIG. 2-14, in a separation region 47 corresponding to the area where the light-emitting-element separation-trench is present, the light-emitting-element is separated together with the support to provide a single light-emitting-element. Here, it is preferable that a metal interconnection is not present in the separation region of the support. This is because a metal interconnection in the region makes inter-device separation difficult.

Cutting of the separation region in the support can be conducted by an appropriate process such as dicing, scribing and breaking depending on a base material. When the light-emitting-element separation-trench is formed to the intermediate portion of the combination of the light-uniforming layer and the buffer layer, scratching by diamond scribing or partial ablation of the light-uniforming layer and/or the buffer layer by laser scribing can be conducted using the light-emitting-element separation-trench to easily separate between light-emitting-elements in the thin-film crystal growth layer. Then, the support can be separated into individual light-emitting-elements by dicing. Optionally, separation between light-emitting-elements can be conducted by simultaneous separation of the thin-film crystal growth layer and the support by dicing.

As described above, the light-emitting-elements of the first aspect shown in FIGs. 2-1A to 2-2C are provided.

Manufacturing process for the light-emitting-element of the second aspect

For manufacturing the light-emitting-elements shown in FIGs. 2-3A to 2-3C, etching is stopped in the intermediate portion of the light-uniforming layer or the buffer layer during forming the light-emitting-element separation-trench in the description of the manufacturing process according to the first aspect. Likewise, an insulating layer 30 is formed and when the insulating layer is etched, the insulating layer is removed from a region including the center of the light-emitting-element separation-trench to form a scribe region as shown in FIGs. 2-4B and 2-4C. In the first aspect, the whole insulating layer over the trench bottom surface is removed, while in this aspect, the layer remains in the trench bottom surface and side etching is not conducted deliberately. A width of the scribe region 14 can be selected to give a predetermined $L_{ws}$ as described above. The subsequent process is conducted as described in the first aspect, to provide the light-emitting-elements shown in FIGs. 2-3A to 2-3C.

Commonly to the first and the second aspects, in this manufacturing process, it is preferable as described above to conduct formation of the thin-film crystal layer, formation of the second-conductivity-type-side electrode, the etching steps (the first etching step and the second etching step), formation of the insulating layer, removal of the insulating layer (formation of the second-conductivity-type-side electrode exposed part, formation of the first current injection region and formation of the scribe region) and formation of the first-conductivity-type-side electrode, in this sequence. Such a process sequence allows for providing a light-emitting-element without damage in the thin-film crystal layer immediately below the second-conductivity-type-side electrode or damage in the first-conductivity-type-side electrode. Furthermore, the device shape reflects the process flow. In other words, the light-emitting-element internally has a structure where there are deposited the second-conductivity-type-side electrode, the insulating layer and the first-conductivity-type-side electrode in this sequence. That is, the second-conductivity-type-side electrode is in contact with the second-conductivity-type cladding layer (or another second-conductivity-type thin-film crystal layer) without an intervening insulating layer; there is a part of the upper periphery of the second-conductivity-type-side electrode which is covered by an insulating layer; and there is an area where an electrode periphery is intervened by an insulating layer between the first-conductivity-type-side electrode and the first-conductivity-type-side cladding layer (or another first-conductivity-type thin-film crystal layer).

«Section C»

The invention disclosed in Section C relates to the followings.
[1] A process for manufacturing a light-emitting-element, comprising
step (a): depositing a buffer layer and a light-uniforming layer on a substrate in this order;
step (b): depositing a thin-film crystal layer having at least a first-conductivity-type semiconductor layer containing a first-conductivity-type cladding layer, an active layer structure and a second-conductivity-type semiconductor layer containing a second-conductivity-type cladding layer, in this order from the side of the substrate;
step (c): forming a second-conductivity-type-side electrode on the surface of the second-conductivity-type semiconductor layer;
first etching step (d): etching a part of the region where the second-conductivity-type-side electrode is not formed, to expose a part of the first-conductivity-type semiconductor layer;
second etching step (e): for forming a light-emitting-element separation-trench separating adjacent light-emitting-elements, etching a part of the region where the second-conductivity-type-side electrode is not formed, from its surface, to such a depth (i) that at least a part of the light-uniforming layer is removed, (ii) that at least a part of the buffer layer is removed, or (iii) that the etching reaches at least the substrate, whereby forming the light-emitting-element separation-trench;
step (f): forming an insulating layer on the whole surface including the second-conductivity-type-side electrode, the first-conductivity-type semiconductor layer exposed by the first etching step and the inside of the light-emitting-element separation-trench;
step (g): removing the insulating layer in a region including at least the trench center of the trench bottom surface in the light-emitting-element separation-trench,

step (h): removing a part of the insulating layer formed on the first-conductivity-type semiconductor layer to form an opening to be a first current injection region,

step (i): removing a part of the insulating layer formed on the surface of the second-conductivity-type-side electrode to expose a part of the second-conductivity-type-side electrode, and

step (j): forming a first-conductivity-type-side electrode in contact with the first current injection region opened in step (h).

[2] The process as described in [1], wherein step (g) comprises removing the insulating layer in the region including only the trench center on the trench bottom surface in the light-emitting-element separation-trench, while leaving the insulating layer formed in the sidewall of the light-emitting-element separation-trench.

[3] The process as described in [1], wherein step (g) comprises removing the whole insulating layer formed on the trench bottom surface within the light-emitting-element separation-trench and at least a portion near the trench bottom surface, of the insulating layer formed on the sidewall within the light-emitting-element separation-trench.

[4] The process as described in any of [1] to [3], wherein a layer constituting the plane exposed after removing the insulating layer is of an undoped type.

[5] The process as described in any of [1] to [4], after step (j), further comprising steps of:

separating the substrate into elements along the light-emitting-element separation-trench; and

bonding the first-conductivity-type-side electrode and the second-conductivity-type-side electrode to a metal layer on the submount.

[6] The process as described in any of [1] to [4], after step (j), further comprising steps of:

bonding the first-conductivity-type-side electrode and the second-conductivity-type-side electrode to a metal layer on the support for their mounting on the support;

removing the substrate; and

dividing the support for element separation.

[7] The process as described in any of [1] to [6], wherein the buffer layer and the light-uniforming layer are formed as a part of the thin-film crystal layer before forming the first-conductivity-type semiconductor layer.

[8] The process as described in any of [1] to [7], wherein when an average refractive index of the substrate is $n_{sb}$ and an average refractive index of the light-uniforming layer is $n_{oc}$ and an average refractive index of the first-conductivity-type semiconductor layer is $n_1$, each at an emission wavelength, the relation:

$$n_{sb} < n_{oc} \text{ and } n_1 < n_{oc}$$

is satisfied.

[9] The process as described in any of [1] to [8], wherein when an emission wavelength of the light-emitting-element is $\lambda$ (nm), an average refractive index of the substrate is $n_{sb}$ and an average refractive index of the light-uniforming layer is $n_{oc}$, each at an emission wavelength, and a physical thickness of the light-uniforming layer is $t_{oc}$ (nm) and where a relative refractive index difference $\Delta_{(oc-sb)}$ between the light-uniforming layer and the substrate is defined as:

$$\Delta_{(oc-sb)} \equiv ((n_{oc})^2 - (n_{sb})^2)/(2 \times (n_{oc})^2),$$

$t_{oc}$ is selected such that the relation:

$$(\sqrt{(2 \times \Delta_{(oc-sb)})} \times n_{oc} \times \pi \times t_{oc})/\lambda \geq \pi/2$$

is satisfied.

[10] The process as described in any of [1] to [9], wherein when an emission wavelength of the light-emitting-element is $\lambda$ (nm), an average refractive index of the light-uniforming layer at an emission wavelength is $n_{oc}$, an average refractive index of the first-conductivity-type semiconductor layer at an emission wavelength is $n_1$ and a physical thickness of the light-uniforming layer is $t_{oc}$ (nm) and a relative refractive index difference $\Delta_{(oc-1)}$ between the light-uniforming layer and the first-conductivity-type semiconductor layer is defined as

$$\Delta_{(oc-1)} \equiv ((n_{oc})^2 - (n_1)^2)/(2 \times (n_{oc})^2),$$

$t_{oc}$ is selected such that the relation:

$$(\sqrt{(2 \times \Delta_{(oc-1)})} \times n_{oc} \times \pi \times t_{oc})/\lambda \geq \pi/2$$

is satisfied.

[11] The process as described in any of [1] to [10], wherein an overall specific resistance of the light-uniforming layer $\rho_{oc}(\Omega \cdot cm)$ satisfies the relation:

$$0.5 \leq \rho_{oc} \quad .$$

[12] The process as described in any of [1] to [11], wherein the light-uniforming layer is formed as a stacked structure consisting of multiple layers.

[13] The process as described in any of [1] to [12], wherein, in the step (j), the first-conductivity-type-side electrode is formed so that the narrowest width $L_{1w}$ of a part where the first-conductivity-type-side electrode is contacting the insulating layer is 5 $\mu$m or more.

[14] The process as described in any of [1] to [13], wherein, in the step (i), a part of the second-conductivity-type-side electrode is exposed so that the narrowest width $L_{2w}$ of a part where the second-conductivity-type-side electrode is covered by the insulating layer is 15 $\mu$m or more.

[15] The process as described in [14], wherein the $L_{2w}$ is 30 $\mu$m or more.

[16] The process as described in any of [1] to [15], wherein the first-conductivity-type-side electrode comprises a layer made of material containing an element selected from the group consisting of Ti, Al, Ag, Mo and a combination of two or more of these.

[17] The process as described in any of [1] to [16], wherein the second-conductivity-type-side electrode comprises a layer made of material containing an element selected from the group consisting of Ni, Pt, Pd, Mo, Au and a combination of two or more of these.

[18] The process as described in any of [1] to [17], wherein the insulating layer is a single layer of material selected from the group consisting of $SiO_x$, $AlO_x$, $TiO_x$, $TaO_x$, $HfO_x$, $ZrO_x$, $SiN_x$, $AlN_x$, $AlF_x$, $BaF_x$, $CaF_x$, $SrF_x$ and $MgF_x$.

[19] The process as described in any of [1] to [18], wherein the insulating layer is a dielectric multilayer film consisting of multiple layers.

[20] The process as described in [19], wherein at least one of the layers constituting the insulating layer is made of material containing fluoride.

[21] The process as described in [20], wherein the fluoride is selected from the group consisting of $AlF_x$, $BaF_x$, $CaF_x$, $SrF_x$ and $MgF_x$.

[22] The process as described in any of [1] to [21], wherein when R2 is a reflectance of reflection by the light-uniforming layer, of a light having an emission wavelength of the light-emitting-element vertically incoming from the first-conductivity-type semiconductor layer side to the light-uniforming layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

(Relation 1) R2 < R12
(Relation 2) R2 < R11
(Relation 3) R2 < R1q

are satisfied.

[23] The process as described in any of [1] to [22], wherein the thin-film crystal layer is formed on the substrate selected from the group consisting of sapphire, SiC, GaN, LiGaO$_2$, ZnO, ScAlMgO$_4$, NdGaO$_3$ and MgO.

[24] The process as described in any of [1] to [23], wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

[25] The process as described in any of [1] to [24], wherein the active layer structure consists of quantum well layer and barrier layer and when B is the number of the barrier layer and W is the number of the quantum well layer, B and W satisfy the relation:

$$B=W+1.$$

[26] The process as described in any of [1] to [25], wherein the first-conductivity-type is n-type and the second-conductivity-type is p-type.

[27] The process as described in [5], wherein the first-conductivity-type-side electrode and the second-conductivity-type-side electrode are bonded to the submount having a metal layer via a solder.

[28] The process as described in [6], wherein the first-conductivity-type-side electrode and the second-conductivity-type-side electrode are bonded to the support having a metal layer via a solder.

[29] The process as described in [27] or [28], wherein bonding between each of the first-conductivity-type-side electrode and the second-conductivity-type-side electrode and the metal layer on the support is formed by a metal solder alone, or a metal solder and a metal bump.

[30] The process as described in any of [27] to [29], wherein the base material of the support is selected from the group consisting of AlN, Al$_2$O$_3$, Si, glass, SiC, diamond, BN and CuW.

[31] The process as described in any of [27] to [30], wherein the metal layer is not formed in a device-separating part in the support.

[32] The process as described in [5], wherein the surface of the light-extraction side of the substrate is not flat.

[33] The process as described in [6], wherein the surface of the light-extraction side of the buffer layer is not flat.

[34] The process as described in any of [5], wherein when R3 is a reflectance of reflection by the substrate, of a light having an emission wavelength of the light-emitting-element vertically incoming from the buffer layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

$$R4 < R3$$

is satisfied.

[35] The process as described in any of [6], wherein when R3 is a reflectance of reflection by the buffer layer, of a light having an emission wavelength of the light-emitting-element vertically incoming from the light-uniforming layer to the buffer layer side and R4 is a reflectance of reflection by an interface with a space, of a light having an emission wavelength of the light-emitting-element vertically incoming from the buffer layer to the space of the light-extraction side, a low-reflecting optical film is formed in the light-extraction side of the buffer layer such that the relation:

$$R4 < R3$$

is satisfied.

[36] The process as described in any of [1] to [35], wherein the substrate is GaN and the whole buffer layer is formed from GaN at a temperature of 900 °C or higher.

According to the invention disclosed in this Section, there can be provided process for manufacturing a flip-chip mount type semiconductor light-emitting-element capable of emitting blue or ultraviolet light with higher output and higher efficiency and with higher uniformity in brightness in a light-extraction-face.

In the process of the present invention disclosed in this Section, process damage in each step in the manufacturing process is eliminated, so that a highly reliable element can be manufactured without deterioration in the functions of the light-emitting-element.

Description of embodiments of the invention of Section C

According to the manufacturing process of Section C, the light-emitting-elements disclosed in Sections A and B can be manufactured. This manufacturing process has steps (a) to (j), whose order is shown in the flow chart of FIG. 3-4. In the invention disclosed in this Section, steps (a), (b) and (c) are conducted in this sequence. Steps (d) and (e) are conducted after step (c), but steps (d) and (e) can be conducted in any order. Then, after step (f), steps (g), (h) and (i) can be conducted in any order. Alternatively, steps (g), (h) and (i) may be conducted simultaneously.

In case that the substrate used for thin-film crystal growth is removed, this step is conduced after step (j).

The specific contents of each step are as described in Sections A and B, and Section C encompasses the whole contents. However, in the light-emitting-element disclosed in Section A, the buffer layer has an arbitrary configuration and, therefore, the step of buffer layer deposition is omitted when a light-emitting-element without a buffer layer is prepared.

Furthermore, because of difference in steps (e) and (g), shape of the element edge and shapes of insulating film at trench bottom surface and sidewall surface are different.

«Section D»

The invention disclosed in Section D relates to the followings.

[1] A compound semiconductor light-emitting-element comprising, on a substrate transparent to an emission wavelength, a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer; a second-conductivity-type-side electrode; and a first-conductivity-type-side electrode, in which a main light-extraction direction is the side of the substrate, wherein:

the first-conductivity-type-side electrode and the second-conductivity-type-side electrode are not spatially overlapped and are formed on the opposite side to the main light-extraction direction;

at the edge of the light-emitting-element, sidewalls of at least the first-conductivity-type semiconductor layer, the active layer structure and the second-conductivity-type semiconductor layer form a setback-sidewall-surface which recedes from the edge of the substrate on a sidewall surface of the thin-film crystal layers; and

the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) at least, covering the setback-sidewall-surface at a position distant from the light-emitting-element edge.

[2] The light-emitting-element as described in [1], having, in relation to the setback-sidewall-surface of the thin-film crystal layer, a configuration

(i) where a part of the buffer layer form a setback-sidewall-surface in combination and forms an edge-step-face with a non-setback-sidewall-surface which has not receded in the buffer layer, or

(ii) where the whole of the buffer layer have receded and the exposed part of the substrate forms an edge-step-face; and

wherein the insulating film covers the edge-step-face from a position distant from the light-emitting-element edge, and the surface in line with the setback-sidewall-surface in the first-conductivity-type semiconductor layer.

[3] The light-emitting-element as described in [1], having, in relation to the setback-sidewall-surface of the thin-film crystal layer, a configuration

(i) where a part of the buffer layer form a setback-sidewall-surface in combination and forms an edge-step-face with a non-setback-sidewall-surface which has not receded in the buffer layer, or

(ii) where the whole of the buffer layer have receded and the exposed part of the substrate forms an edge-step-face; and

wherein the insulating film covers at least a part of the setback-sidewall-surface of the buffer layer and does not cover the edge-step-face.

[4] The light-emitting-element as described in any of [1] to [3], wherein the narrowest width $L_{1w}$ of a part where the first-conductivity-type-side electrode is contacting the insulating layer is 5 $\mu$m or more.

[5] The light-emitting-element as described in any of [1] to [3], wherein the narrowest width $L_{2w}$ of a part where the second-conductivity-type-side electrode is covered by the insulating layer is 15 $\mu$m or more.

[6] The light-emitting-element as described in [5], wherein the $L_{2w}$ is 100 $\mu$m or more.

[7] The light-emitting-element as described in any of [1] to [6], wherein the narrowest width $L_{ws}$ of an end-face-part on the substrate surface exposed by recession of the sidewall surface of the thin-film crystal layer and uncovered by the insulating layer is 15 $\mu$m or more.

[8] The light-emitting-element as described in any of [1] to [7], wherein the first-conductivity-type-side electrode comprises a layer made of material containing an element selected from the group consisting of Ti, Al, Ag, Mo and a combination of two or more of these.

[9] The light-emitting-element as described in any of [1] to [8], wherein the second-conductivity-type-side electrode comprises a layer made of material containing an element selected from the group consisting of Ni, Pt, Pd, Mo, Au and a combination of two or more of these.

[10] The light-emitting-element as described in any of [1] to [9], wherein the insulating layer is a single layer of material selected from the group consisting of $SiO_x$, $AlO_x$, $TiO_x$, $TaO_x$, $HfO_x$, $ZrO_x$, $SiN_x$, $AlN_x$, $AlF_x$, $BaF_x$, $CaF_x$, $SrF_x$ and $MgF_x$.

[11] The light-emitting-element as described in any of [1] to [9], wherein the insulating layer is a dielectric multilayer film consisting of multiple layers.

[12] The light-emitting-element as described in [11], wherein at least one of the layers constituting the insulating layer is made of material containing fluoride.

[13] The light-emitting-element as described in [12], wherein the fluoride is selected from the group consisting of $AlF_x$, $BaF_x$, $CaF_x$, $SrF_x$ and $MgF_x$.

[14] The light-emitting-element as described in any of [1] to [13], wherein when R2 is a reflectance of reflection by the buffer layer, of a light having an emission wavelength of the light-emitting-element vertically incoming from the first-conductivity-type semiconductor layer side to the buffer layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

(Relation 1) R2 < R12
(Relation 2) R2 < R11
(Relation 3) R2 < R1q

are satisfied.

[15] The light-emitting-element as described in any of [1] to [14], wherein the substrate is selected from the group consisting of sapphire, SiC, GaN, $LiGaO_2$, ZnO, $ScAlMgO_4$, $NdGaO_3$ and MgO.

[16] The light-emitting-element as described in any of [1] to [15], wherein the surface of the light-extraction side of the substrate is not flat.

[17] The light-emitting-element as described in any of [1] to [16], wherein when R3 is a reflectance of reflection by the substrate, of a light having an emission wavelength of the light-emitting-element vertically incoming from the buffer layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

R4 < R3

is satisfied.

[18] The light-emitting-element as described in any of [1] to [17], wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

[19] The light-emitting-element as described in any of [1] to [18], wherein the active layer structure consists of quantum well layer and barrier layer and when B is the number of the barrier layer and W is the number of the quantum well layer, B and W satisfy the relation:

$$B = W+1.$$

[20] The light-emitting-element as described in any of [1] to [19], wherein the first-conductivity-type is n-type and the second-conductivity-type is p-type.

[21] The light-emitting-element as described in any of [1] to [20], wherein the first-conductivity-type-side electrode and the second-conductivity-type-side electrode are bonded to a submount having a metal layer via a solder.

According to the invention disclosed in this Section, there can be provided a flip-chip mount type semiconductor light-emitting-element capable of emitting blue or ultraviolet light with higher output and higher efficiency.

In the structure of the invention disclosed in this Section, process damage in each step in the manufacturing process is eliminated, so that a highly reliable element is provided without deterioration in the functions of the light-emitting-element.

<Explanation of Embodiments of the invention in Section D>

FIGs. 4-1A and 4-2A show a typical example of a compound semiconductor light-emitting-element according to the invention disclosed in this Section (hereinafter, simply referred to as "light-emitting-element"). FIGs. 4-1B and 4-2B are figures in which some portions of FIGs. 4-1A and 4-2A are omitted, respectively for explanation and FIGs. 4-3A and 4-3B are figures showing structures in the course of the manufacturing process for detailing the structure of the light-emitting-element. The present invention will be described with reference to FIGs. 4-1A to 4-3B.

A light-emitting-element according to the invention disclosed in this Section has, as shown in FIGs. 4-1A and 4-2A, on a substrate 21, a compound semiconductor thin-film crystal layer having a buffer layer 22, a first-conductivity-type semiconductor layer containing a first-conductivity-type cladding layer 24, a second-conductivity-type semiconductor layer containing a second-conductivity-type cladding layer 26, and an active layer structure 25 sandwiched between the first and the second-conductivity-type semiconductor layers; a second-conductivity-type-side electrode 27; and a first-conductivity-type-side electrode 28.

On a part of the second-conductivity-type cladding layer 26, the second-conductivity-type-side electrode 27 is disposed and the part where the second-conductivity-type cladding layer 26 and the second-conductivity-type-side electrode 27 are in contact with each other is a second current injection region 35. In this configuration, parts of the second-conductivity-type cladding layer and the active layer structure, and a part of the first-conductivity-type cladding layer are removed. The first-conductivity-type-side electrode 28 is disposed in contact with the first-conductivity-type cladding layer 24 exposed in the removed part, so that the second-conductivity-type-side electrode 27 and the first-conductivity-type-side electrode 28 are disposed on the same side in relation to the substrate. The second-conductivity-type-side electrode 27 and the first-conductivity-type-side electrode 28, each, is connected to metal layer 41 on a submount 40 via metal solder 42.

In the present invention, the first-conductivity-type-side electrode and the second-conductivity-type-side electrode are not spatially overlapped. This means that as shown in FIG. 4-1A, when the first-conductivity-type-side electrode 28 and the second-conductivity-type-side electrode 27 are projected to the substrate surface, their shadows are not overlapped.

An insulating layer 30 is formed for preventing unintended short circuit due to a solder or a conductive paste material for mounting entering/going around, for example, "between the second-conductivity-type-side electrode and the first-conductivity-type-side electrode" or "a sidewall of a thin-film crystal layer such as an active layer structure" during flip-chip mounting. At the same time, in the present invention, an insulating layer is disposed at the optimal position for avoiding influence of damage on element performance or on an yield.

The light-emitting-element according to the invention disclosed in this Section may have a different configuration in two portions, that is, (I) a step shape of an edge in a light-emitting-element and (II) a shape of an insulating film in a light-emitting-element edge. In terms of (I) the step shape of the edge in a light-emitting-element, there are generally three options, depending on an etching depth when forming a light-emitting-element separation-trench for element separation in the manufacturing process, i.e. (i) the depth to the intermediate portion of the buffer layer and (ii) the depth to the substrate surface (or deeper). Furthermore, the wall surface of the light-emitting-element separation-trench recedes from the element edge after element separation. In the present invention, the surface that has been appeared as sidewall surface after forming the light-emitting-element separation-trench is, therefore, referred as a "setback-sidewall-surface" in the element after element separation. The sidewall surface appearing in the element edge by the element separation is called a "non-setback-sidewall-surface". Then, in the edge of the light-emitting-element, a step face is formed between the setback-sidewall-surface and the non-setback-sidewall-surface, which is called an "edge-step-face".

Depending on the depth (i) to (ii) in the light-emitting-element separation-trench, in the case of (i), a part of the buffer layer forms a setback-sidewall-surface in combination with a thin-film crystal layer while the remaining (in the main light-extraction direction side) sidewall of the buffer layer forms a non-setback-sidewall-surface, and there is an edge-step-face on the edge of the buffer layer. In the case of (ii), sidewall of the buffer layer forms setback-sidewall-surface (because it is a sidewall surface of the light-emitting-element separation-trench), so that the exposed part of the substrate is an edge-step-face.

The shape corresponding to (i) is shown in FIGs. 4-1C and 4-2C. The shape corresponding to (ii) is shown in FIGs. 4-1A (4-1B) and 4-2A (4-2B).

In terms of (II) the shape of the insulating film in the light-emitting-element edge, there are options, in the manufacturing process,

(i) removing only the insulating layer in the region including the intermediate portion part over the trench bottom surface while leaving the insulating layer formed in the sidewall of the light-emitting-element separation-trench and (ii) removing a part of the insulating layer on the sidewall within the trench, in addition to the whole insulating layer formed in the trench bottom surface. In a light-emitting-element thus manufactured, there are provided two shapes, that is, (i) a shape where the insulating film is in contact with the trench bottom surface and (ii) a shape where the insulating film is present apart from the trench bottom surface. The shape corresponding to (i) is shown in FIGs. 4-1A (4-1B) and 4-1C. The shape corresponding to (ii) is shown in FIGs. 4-2A (4-2B) and 4-2C.

A shape of the light-emitting-element of the invention disclosed in this Section will be described, dividing it into (i) a first aspect and (ii) a second aspect, depending on (II) the shape of the insulating film of the light-emitting-element edge.

First aspect

A configuration belonging to the first aspect is shown in FIGs. 4-1A to 4-1C. First, there will be described a typical embodiment using FIG. 4-1A. At least the sidewall surfaces of the first-conductivity-type semiconductor layer, the active layer structure and the second-conductivity-type semiconductor layer among the thin-film crystal layers have receded from the edge of the substrate. This shape is seen in all the embodiments of the present invention. It is because, as shown in FIG. 4-3A, after depositing thin-film crystal layers in the manufacturing process, a light-emitting-element separation-trench 13 is formed by removing the thin-film crystal layers to a predetermined depth as described later for separating elements to separate the elements in the separation trench. FIG. 4-1A shows an example in which the thin-film crystal layer has been removal to the level of the substrate, which is one of preferred embodiments of the present invention. In the present invention, the elements are separated without exposing the thin-film crystal layers, particularly a first-conductivity-type semiconductor layer, an active layer structure and a second-conductivity-type semiconductor layer which are parts involved in essential functions such as current injection and light emitting, to the processes generally used for element separation such as scribing and breaking, so that the thin-film crystal layers involved in element performance is not directly damage. Thus, there is provided an element exhibiting good performance such as tolerance and reliability, particularly in a large current injection.

The sidewall surface exposed after removing the thin-film crystal layers is covered by the insulating layer 30.

Furthermore, before separating elements, the insulating layer 30 does not cover the whole trench bottom surface of the light-emitting-element separation-trench 13 and a scribe region 14 where the insulating layer 30 is not formed in the substrate surface (that is, the trench bottom surface), as shown in FIG. 4-3A. Since only the substrate has to be scribed or broken in the element separation such as scribing and breaking in the manufacturing process, the thin-film crystal layers are never directly damaged. Furthermore, since detachment of the insulating layer does not occur, insulation is ensured and the thin-film crystal layers are not damaged due to tension generated during detachment of the insulating layer.

In a resultant light-emitting-element after separation, as shown in part A (dotted line circle) in FIGs. 4-1A and 4-1B, the sidewall surface of the thin-film crystal layer has receded and the insulating layer does not cover the whole exposed substrate surface, but covers the substrate surface inside from the position distant from the edge of the substrate 21 by $L_{ws}$. In the case that the division is performed from the middle of the width of the scribe region 14, a distance $L_{ws}$ without covering by the insulating layer corresponds to about 1/2 of the width of the scribe region 14 within the range of production fluctuation. In other words, formation of this configuration ensures that detachment of the insulating layer in the side of the thin-film crystal layer is avoided, so that in this light-emitting-element, unintended short circuit is prevented even if running around of a solder occurs and furthermore, the thin-film crystal layer is not damaged, so that the functions of the light-emitting-element are not deteriorated, resulting in a highly reliable element.

$L_{ws}$ has to be larger than 0 in a completed element and is generally 10 $\mu$m or more, preferably 15 $\mu$m or more. As a designed value, when the width of the scribe region 14 is $2L_{ws}$, $2L_{ws}$ is preferably 30 $\mu$m or more. Since an excessively large value is unnecessary, $2L_{ws}$ is generally 300 $\mu$m or less, preferably 200 $\mu$m or less.

In another preferred embodiment, the light-emitting-element separation-trench may be formed to the intermediate portion of the light-uniforming layer or the buffer layer. As a result, in a completed device, at least the first-conductivity-type semiconductor layer, the active layer structure and the second-conductivity-type semiconductor layer have receded inside from the edge (substrate edge) of the device to form a setback-sidewall-surface and there is formed a face parallel to the substrate (an edge parallel face, i.e. an edge-step-face) based on the trench bottom surface in the edge of the light-emitting-element. In FIG. 4-1A, the substrate surface itself corresponds to the face parallel to the substrate.

FIG. 4-1C shows an example of a light-emitting-element in which a light-emitting-element separation-trench is formed to the intermediate portion of the buffer layer 22. As shown in part A (dotted line circle in FIG), to the light-emitting-element edge, there are a buffer layer 22 as a non-setback-sidewall-surface and from the intermediate portion of the buffer layer 22, the wall surface has receded from the element edge and forms a setback-sidewall-surface (the sidewall of the light-emitting-element separation-trench) in combination with the sidewall surface of the second-conductivity-type semiconductor layer. There is an edge-step-face 55 based on the bottom surface of the light-emitting-element separation-trench between the non-setback-sidewall-surface and the setback-sidewall-surface. The non-setback-sidewall-surface in the sidewall of the buffer layer 22 is exposed and the setback-sidewall-surface is covered by the insulating layer 30, which continuously covers from the position distant from the edge (the position corresponding to $L_{ws}$ in FIG. 4-1B) in the edge-step-face 55 inwardly to the setback-sidewall-surface. This corresponds to a configuration where the light-emitting-element separation-trench is stopped in the intermediate portion of the buffer layer 22 in FIG. 4-1A(FIG. 4-1B).

As illustrated in these examples, even when the light-emitting-element separation-trench is formed to the intermediate portion of the buffer layer, prevention of detachment of the insulating layer is ensured in a device having a configuration that the insulating layer covering the sidewall does not reach the edge of the light-emitting-element, and like the light-emitting-element of the configuration shown in FIG. 4-1A, a highly reliable device can be provided by forming the exposed layer using a high insulative material.

Second aspect

Embodiments belonging to the second aspect are shown in FIGs. 4-2A to 4-2C. In the second aspect, a layer configuration and so on are the same as described for the first aspect, but (II) the shape of the insulating film in the light-emitting-element edge is different.

First, as shown in FIG. 4-2A, at least sidewall surfaces of the first-conductivity-type semiconductor layer, the active layer structure and the second-conductivity-type semiconductor layer among the thin-film crystal layers have receded from the edge of the substrate, to form a setback-sidewall-surface. This shape is seen in all the embodiments of the present invention. It is because, as shown in FIG. 4-3B, after depositing thin-film crystal layers in the manufacturing process, a light-emitting-element separation-trench 13 is formed by removing the thin-film crystal layers as described later for separating elements to separate the elements in the separation trench. As in the other aspects of the preset invention, the insulating layer 30 covers the sidewall surfaces of at least a first-conductivity-type semiconductor layer (a first-conductivity-type cladding layer 24 in the figure), an active layer structure 25 and a second-conductivity-type semiconductor layer (a second-conductivity-type cladding layer 26 in the figure) among the sidewall surfaces exposed after removing the thin-film crystal layers.

In the second aspect, the insulating layer 30 is not present even on the surface of the substrate 21 (on the light-emitting-element separation-trench bottom surface). In the setback-sidewall-surface of the thin-film crystal layer, a part without an insulating layer 15 uncovered by an insulating layer is present at least in the main light-extraction direction side of the sidewall surface of the buffer layer 22, and may extend to the whole sidewall surface of the buffer layer 22. When etching proceeds into a part of the substrate to form the light-emitting-element separation-trench, only the substrate part may be exposed in the wall surface of the trench while the buffer layer is covered.

In such cases, the buffer layer in the part without an insulating layer 15 which is not covered by the insulating layer is preferably an undoped layer which is not doped. When the exposed part is made of a high insulative material, defects such as short circuit due to running around of a solder do not occur, resulting in a highly reliable element.

This structure corresponds to a configuration before element separation in the course of the manufacturing process as shown in FIG. 1-3B, and the insulating layer 30 is removed from the substrate surface within the trench of the light-emitting-element separation-trench 13 and from the part without an insulating layer 15 in the trench sidewall surface near the substrate surface.

The insulating layer 30 is not formed in the part in contact with the substrate and therefore, only the substrate has to be scribed or broken in the element separation such as scribing and breaking in the manufacturing process. Therefore, the thin-film crystal layers are never directly damaged. Furthermore, since detachment of the insulating layer does not occur, insulation is ensured and the thin-film crystal layers are not damaged due to tension generated during detachment of the insulating layer.

In a resultant light-emitting-element after separation, as shown in part A (dotted line circle) in FIGs. 4-2A and 4-2B, the insulating layer does not cover the whole exposed substrate surface which has been formed by recession of the sidewall surface in the thin-film crystal layer. Formation of this configuration ensures elimination of detachment of the insulating layer in the side of the thin-film crystal layer, so that in this light-emitting-element, unintended short circuit is prevented even if running around of a solder occurs and furthermore, the thin-film crystal layer is not damaged, so that the functions of the light-emitting-element are not deteriorated, resulting in a highly reliable element.

In the second aspect, it is also a preferable embodiment that the light-emitting-element separation-trench is formed to the intermediate portion of the buffer layer. As a result, in a completed device, at least the first-conductivity-type semiconductor layer, the active layer structure and the second-conductivity-type semiconductor layer recede inside from the edge (substrate edge) of the device and there is formed a face parallel to the substrate (an edge parallel face, i.e. an edge-step-face) based on the trench bottom surface in the edge of the light-emitting-element.

FIG. 4-2C shows an example of a light-emitting-element where a light-emitting-element separation-trench is formed to the intermediate portion of the buffer layer 22. As shown in part A (dotted line circle in FIGs), a part of the buffer layer 22 is present as a non-setback-sidewall-surface to the light-emitting-element edge, and from the intermediate portion of the buffer layer 22, the wall surface recesses from the element edge and forms a setback-sidewall-surface (the sidewall of the light-emitting-element separation-trench) in combination with the sidewall surface of the second-conductivity-type semiconductor layer. There is an edge-step-face 55 based on the bottom surface between the non-setback-sidewall-surface and the setback-sidewall-surface. The non-setback-sidewall-surface (the sidewall part of the element edge) and the edge-step-face are not covered by the insulating layer. And in the setback-sidewall-surface (the sidewall of the light-emitting-element separation-trench), there is a part without an insulating layer 15 which is not covered by the insulating layer in the main light-extraction direction side. The part without an insulating layer 15 may extend to the whole sidewall surface of the buffer layer 22.

As illustrated in these examples, even when the light-emitting-element separation-trench is formed to the intermediate portion of the buffer layer, prevention of detachment of the insulating layer is ensured in the device having a configuration that the insulating layer covering the sidewall does not reach the edge of the light-emitting-element. Also by forming the exposed layer using a high insulative material, a highly reliable device can be provided, similarly to the light-emitting-element of the configuration shown in FIG. 4-2A.

In common to the first and the second aspects, the insulating layer 30 is in contact with a part of the first-conductivity-type-side electrode 28 at the side of the substrate (at the side of the main light-extraction direction) in the present invention as shown in part B (dotted line circle) in FIGs. 4-1B and 4-2B. In other words, the insulating layer intervenes partly between the first-conductivity-type-side electrode 28 and the first-conductivity-type semiconductor layer (in this embodiment, the first-conductivity-type cladding layer 24). As a result, an area of the first-conductivity-type-side electrode 28 is larger than an area of the first current injection region 36. As shown in FIGs. 4-1B and 4-2B, when $L_{1w}$ is the narrowest width in the part of the first-conductivity-type-side electrode in contact with the insulating layer, $L_{1w}$ is preferably 7 $\mu$m or more, particularly preferably 9 $\mu$m or more. Furthermore, $L_{1w}$ is generally 500 $\mu$m or less, preferably 100 $\mu$m or less. In general, when it is 5 $\mu$m or more, a process margin by a photolithography process and a liftoff procedure can be ensured.

Furthermore, as shown in part C (dotted line circle) in FIGs. 4-1B and 4-2B, the insulating layer 30 cover a part of the second-conductivity-type-side electrode 27 on the submount side (i.e. the opposite side to the main light-extraction direction). In other words, an area of the exposed part 37 in the second-conductivity-type-side electrode 27 is smaller than an area of the second-conductivity-type-side electrode 27, and an area of the second current injection region 35 is equal to an area of the second-conductivity-type-side electrode 27. As shown in FIGs. 4-1B and 4-2B, when $L_{2W}$ is the narrowest width in the part covered by the insulating layer around the second-conductivity-type-side electrode, $L_{2W}$ is preferably 15 $\mu$m or more. It is further preferably 30 $\mu$m or more, particularly preferably 100 $\mu$m or more. Covering many of the area of the second-conductivity-type-side electrode by the insulating layer particularly allows for reducing unintended short circuit with another part such as the first-conductivity-type-side electrode via a metal solder material. $L_{2w}$ is generally 2000 $\mu$m or less, preferably 750 $\mu$m or less.

Furthermore, the insulating layer 30 generally also covers the exposed part of the surface of the submount side (the opposite side to the main light-extraction direction) in the first-conductivity-type semiconductor layer (the first-conductivity-type cladding layer 24 in this embodiment) and the second-conductivity-type semiconductor layer (the second-conductivity-type cladding layer 26 in this embodiment) for preventing short circuit as shown in the figure.

Such a positional relationship between the insulating layer and each electrode means that an element can be manufactured by a process with less process damage.

In the present invention, as described above, the insulating layer is disposed, based on comprehensive consideration of factors such as process damage, and heat dissipation properties and insulation properties when flip-chip mount is employed.

There will be further detailed the materials and the structures constituting a device.

Substrate

There are no particular restrictions to a material for the substrate 21 as long as it is substantially optically transparent to an emission wavelength of the element. The term "substantially transparent" means that the substrate does not absorb the light in the emission wavelength or if any, a light output is not decreased by 50 % or more by absorption by the substrate.

The substrate is preferably an electrically insulative substrate. It is because even if a solder material adheres to the periphery of the substrate during flip-chip mounting, it does not affect current injection into a light-emitting-element. Specific examples of such a material is preferably selected from sapphire, SiC, GaN, LiGaO$_2$, ZnO, ScAlMgO$_4$, NdGaO$_3$

and MgO, particularly preferably sapphire, GaN and ZnO substrates for growing a thin-film crystal of an InAlGaN light-emitting material or an InAlBGaN material over the substrate. In particular, when a GaN substrate is used, its Si doping concentration is preferably a Si concentration of $3 \times 10^{17}$ cm$^{-3}$ or less for an undoped substrate, more preferably $1 \times 10^{17}$ cm$^{-3}$ or less in the light of electric resistance and crystallinity.

A substrate used in the invention disclosed in this Section may be, in addition to a just-substrate completely defined by a so-called plane index, a so-called off-substrate (miss oriented substrate) in the light of controlling crystallinity during thin-film crystal growth. An off-substrate is widely used as a substrate because it is effective for promoting favorable crystal growth in a step flow mode and thus effective for improving element morphology. For example, when a c+ plane substrate of sapphire is used as a substrate for crystal growth of an InAlGaN material, it is preferable to use a plane inclined to an m+ direction by about 0.2 °. An off-substrate having a small inclination of about 0.1 to 0.2 ° is generally used, but in an InAlGaN material formed on sapphire, a relatively larger off-angle is possible for canceling an electric field due to piezoelectric effect to a quantum well layer as a light-emitting point within an active layer structure.

A substrate may be pretreated by chemical etching or heating for manufacturing a compound semiconductor light-emitting-element utilizing crystal growth technique such as MOCVD and MBE. Alternatively, a substrate may be deliberately processed to have irregularity in relation to a buffer layer described later to prevent penetrating dislocation generated in an interface between a thin-film crystal layer and the substrate from being introduced near an active layer of a light-emitting-element.

In one embodiment of the invention disclosed in this Section, a thickness of the substrate is generally about 250 to 700 $\mu$m in an initial stage of element preparation so as to ensure mechanical strength during crystal growth in a semiconductor light-emitting-element and an element manufacturing process. After growing a thin-film crystal layer, it is desirable that for facilitating separation into individual elements, the substrate is appropriately thinned by a polishing step in the course of the process and finally has a thickness of about 100 $\mu$m or less in a device. The thickness is generally 30 $\mu$m or more.

In another embodiment of the invention disclosed in this Section, a thickness of the substrate may be larger than a conventional thickness, and may be about 350 $\mu$m, furthermore about 400 $\mu$m or 500 $\mu$m.

It is further desirable that a so-called low reflecting coating layer or low-reflecting optical film is formed on a plane in a main light-extraction direction of the substrate. It lowers reflection due to a refractive index difference in a substrate-air interface and an output and element efficiency can be improved. Here, when R3 is a reflectance of reflection by the substrate, of a light having an emission wavelength of the light-emitting-element vertically incoming from the buffer layer to the substrate side and R4 is a reflectance of reflection by an interface with a space, of a light having an emission wavelength of the light-emitting-element vertically incoming from the substrate to the space of the light-extraction side, it is preferable that a low-reflecting optical film is formed in the light-extraction side of the substrate such that the relation:

$$R4 < R3$$

is satisfied. For example, when the substrate is sapphire, the low reflecting coating film is preferably, for example, MgF$_2$. It is because a refractive index of the low reflecting coating film is preferably near $\sqrt{n_s}$ in relation to a refractive index $n_s$ of the substrate at an emission wavelength, and because MgF$_2$ has a refractive index near a square root of a refractive index of sapphire.

In the invention disclosed in this Section, it is also preferable that a plane in a main light-extraction direction of the substrate is an irregular or crude surface. It allows for extracting light generated within a quantum well layer with a high efficiency, which is desirable in the light of improving an element output and an efficiency. When an emission wavelength of an element is $\lambda$ (nm), its surface crudeness is preferably such that an average roughness Ra (nm) satisfy the relation:

$$\lambda/5 \text{ (nm)} < Ra \text{ (nm)} < 10 \times \lambda \text{ (nm)}$$

more preferably, the relation:

$$\lambda/2 \text{ (nm)} < Ra \text{ (nm)} < 2 \times \lambda \text{ (nm)}.$$

Buffer layer

A buffer layer 22 is formed mainly for facilitating thin-film crystal growth, for example, for preventing dislocation, alleviating imperfection in a substrate crystal and reducing various mutual mismatches between a substrate crystal and a desired thin-film crystal growth layer in growing a thin-film crystal on a substrate.

A buffer layer is deposited by thin-film crystal growth, and a buffer layer is particularly important since when a material such as an InAlGaN material, an InAlBGaN material, an InGaN material, an AlGaN material and a GaN material is grown on a foreign substrate by thin-film crystal growth, which is a desirable embodiment in the present invention, matching of a lattice constant with a substrate is not necessarily ensured. For example, when a thin-film crystal growth layer is grown by organic metal vapor deposition (MOVPE), a low temperature growth AlN layer at about 600 °C may be used as a buffer layer, or a low temperature growth GaN layer formed at about 500 ° C may be used. A material such as AlN, GaN, AlGaN, InAlGaN and InAlBGaN grown at a high temperature of about 800 ° C to 1000 ° C may be used. These layers are generally as thin as about 5 to 40 nm.

A buffer layer 22 needs not necessarily to be a single layer, and on a GaN buffer layer grown at a low temperature, a GaN layer may be grown at a temperature of about 1000 °C to several $\mu$m without doping for further improving crystallinity. In practice, it is common to form such a thick film buffer layer with a thickness of about 0.5 to 7 $\mu$m. The buffer layer may be doped with, for example, Si, or it may be formed of stacked layers including therein a doped layer and an undoped layer.

A typical embodiment is a two-layer structure of a low temperature buffer layer formed by thin-film crystal growth at a low temperature of about 350 °C to less than 650 °C in contact with a substrate and a high temperature buffer layer formed by thin-film crystal growth at a high temperature of about 650 °C to 1100 °C. When the substrate is GaN, all the whole buffer layer can be GaN formed at a high temperature of 900 ° C or higher.

A buffer layer may be formed by epitaxial lateral overgrowth (ELO) as a kind of so-called microchannel epitaxy, which may allow for significant reduction of penetrating dislocation generated between a substrate such as sapphire and an InAlGaN material. Furthermore, when a processed substrate whose surface is made irregular, dislocation can be partly diminished during epitaxial lateral overgrowth, and it is preferable to apply such a combination of a substrate and a buffer layer to the invention disclosed in this Section. Furthermore, such a configuration is preferable because the irregularity formed in the surface of the substrate improves a light-extraction efficiency.

In some embodiments, a buffer layer may be an exposed part of a light-emitting-element separation-trench; the exposed part is preferably an undoped part. Thus, insulation failure due to, for example, solder during device assembly can be prevented.

First-conductivity-type semiconductor layer and first-conductivity-type cladding layer

A first-conductivity-type semiconductor layer and a first-conductivity-type cladding layer employed in the invention according to this Section D are as described in Section A except that the first-conductivity-type semiconductor layer including the first-conductivity-type cladding layer is present in contact with the buffer layer because there is no light-uniforming layer in this Section.

Active layer structure

An active layer structure employed in the invention according to this Section is as described in Section A.

Second-conductivity-type semiconductor layer and second-conductivity-type cladding layer

A second-conductivity-type semiconductor layer and a second-conductivity-type cladding layer employed in the invention according to this Section are as described in Section A.

Second-conductivity-type-side electrode

A second-conductivity-type-side electrode employed in the invention according to this Section is as described in Section A.

First-conductivity-type-side electrode

A first-conductivity-type-side electrode employed in the invention according to this Section is as described in Section A.

Insulating layer

An insulating layer employed in the invention according to this Section is as described in Section A.

Submount

A submount employed in the invention according to this Section is as described in Section A.

Manufacturing process for a light-emitting-element disclosed in Section D

Next, there will be described a process for manufacturing a semiconductor light-emitting-element according to the invention disclosed in this Section.

Embodiment 1 of a manufacturing process

In Embodiment 1 of a manufacturing process, there will be described mainly a process for manufacturing a light-emitting-element shown in FIG. 4-1A and furthermore those for light-emitting-elements shown in FIG. 4-1C. As shown in FIG. 4-5, first a substrate 21 is provided and over the surface are sequentially deposited a buffer layer 22, a first-conductivity-type cladding layer 24, an active layer structure 25 and a second-conductivity-type cladding layer 26 by thin-film crystal growth. For formation of these thin-film crystal layers, MOCVD is preferably employed. However, it is possible to use MBE, PLD, PED, VPE and LPE processes for forming all or some of the thin-film crystal layers. A configuration of these layers can be appropriately changed, depending on, for example, an application of the element. After forming thin-film crystal layers, a variety of processings are allowed. As used herein, the term "thin-film crystal growth" includes heat-treatment after growing a thin-film crystal layer.

For providing the configuration shown in FIGs. 4-1A, 4-1B and 4-3A after growing thin-film crystal layers in the present invention, it is preferable that a second-conductivity-type-side electrode 27 is formed as shown in FIG. 4-5. That is, it is preferable that scheduled formation of the second-conductivity-type-side electrode 27 in the second current injection region 35 is conducted before formation of an insulating layer 30, formation of a first current injection region 36 and formation of a first-conductivity-type-side electrode 28. This is because when the second-conductivity-type is p-type as a desirable embodiment, formation of a p-side electrode after processing the exposed surface of the p-type cladding layer by various processes leads to reduction of a hole concentration in the p-GaN cladding layer with a relatively lower activation rate among GaN materials, due to process damage. For example, if the step of forming an insulating layer by p-CVD is conducted before forming the second-conductivity-type-side electrode, plasma damage remains in its surface. Thus, in the present invention, it is desirable that after thin-film crystal growth, formation of the second-conductivity-type-side electrode is conducted before any of the other process steps (for example, a first etching step, a second etching step or the step of forming an insulating layer, the step of forming an exposed part in a second-conductivity-type-side electrode, the step of forming a first current injection region and the step of forming a first-conductivity-type-side electrode as described later).

In the present invention, when the second-conductivity-type is p-type and when the exposed surface is a relatively stable metal such as Au (in a typical example, the surface of the second-conductivity-type-side electrode is expected to be Au as described above), the surface is not likely process-damaged through the subsequent processes. In this respect, it is again desirable in the present invention that after thin-film crystal growth, formation of the second-conductivity-type-side electrode is conducted before any other process step.

In the present invention, when a layer in which the second-conductivity-type-side electrode is formed is the second-conductivity-type contact layer, process damage to the second-conductivity-type semiconductor layer can be reduced in the same manner.

The second-conductivity-type-side electrode 27 can be formed by applying a variety of deposition processes such as sputtering, vacuum evaporation and plating, and a desired shape can be obtained by appropriately applying, for example, a lift-off process using photolithography technique or site-selective evaporation using, for example, a metal mask.

After forming the second-conductivity-type-side electrode 27, a part of the first-conductivity-type cladding layer 24 is exposed as shown in FIG. 4-6. In this step, it is preferable to remove the second-conductivity-type cladding layer 26, the active layer structure 25 and further a part of the first-conductivity-type cladding layer 24 by etching (a first etching step). The first etching step is conducted for the purpose of exposing a semiconductor layer into which a first-conductivity-type-side electrode described later injects first-conductivity-type carriers, and therefore, when a thin-film crystal layer contains another layer, for example, a cladding layer consists of two layers or contains a contact layer, the layer including the additional layer may be etched.

The first etching step does not require very high etching precision and thus can be a known dry etching technique by plasma etching using, for example, $Cl_2$ and using a etching mask of a nitride such as $SiN_x$ or an oxide such as $SiO_x$. It is, however, also preferable that dry etching can be conducted using a metal fluoride mask as detailed in a second etching step described later. It is particularly preferable to conduct etching by plasma excited dry etching using a gas such as $Cl_2$, $SiCl_4$, $BCl_3$ and $SiCl_4$ and using an etching mask containing a metal-fluoride layer selected from the group consisting of $SrF_2$, $AlF_3$, $MgF_2$, $BaF_2$, $CaF_2$ and combinations of these. Furthermore, the optimal dry etching is ICP type dry etching capable of generating high density plasma.

Here, the second-conductivity-type-side electrode 27 receives process history of the formation of a $SiN_x$ mask formed by, for example, plasma CVD or the step of removing the $SiN_x$ mask after the first etching step. However, when a stable metal such as Au is formed over the surface, the second-conductivity-type-side electrode is less process-damaged.

Then, as shown in FIG. 4-7, a light-emitting-element separation-trench 13 is formed by a second etching step. In the present invention, it is necessary that the light-emitting-element separation-trench is formed such that it interrupts at least the first-conductivity-type cladding layer, and in this embodiment, the light-emitting-element separation-trench 13 is formed such that it reaches the substrate 21. Here, when diamond scribing is conducted from the side where the thin-film crystal layers have been formed in the steps of scribing and breaking for device separation, detachment of a GaN material on the sapphire substrate can be inhibited. Furthermore, it is advantageous that when laser scribing is conducted, thin-film crystal layers are not damaged. Furthermore, it is also preferable that the light-emitting-element separation-trench is formed by conducting etching into a part of the sapphire substrate (same for other substrates such as GaN).

Alternatively, a configuration where the light-emitting-element separation-trench does not reach the substrate is also preferable. For example, when the light-emitting-element separation-trench is formed to the intermediate portion of the buffer layer, an insulating layer can be formed on the sidewall of the first-conductivity-type cladding layer, to maintain insulation to a running-around solder (see FIG. 4-1C for a configuration after completion of the light-emitting-element). Here, a trench bottom surface is formed in the intermediate portion of the buffer layer and becomes an edge-step-face at the end of the light-emitting-element. The trench bottom surface is a plane having irregularity which can be formed by etching. Since the trench bottom surface is subjected to processing such as scribing during element separation, an edge-step-face after element separation is often relatively lower in flatness as a plane and parallelity to a layer direction. Furthermore, a layer exposed from the sidewall without being covered by the insulating layer is preferably highly insulative.

In the second etching step, the GaN material must be etched to more depth compared with the first etching step. The sum of a layer depth etched by the first etching step is generally about 0.5 $\mu$m while in the second etching step, the depth is sometimes 3 to 7 $\mu$m, 3 to 10 $\mu$m or more than 10 $\mu$m because the whole first-conductivity-type cladding layer 24 and at least a part or sometimes the whole of the buffer layer 22 must be etched.

Generally, a metal mask, a nitride mask such as $SiN_x$ and an oxide mask such as $SiO_x$ have a selectivity ratio to a GaN material, in terms of tolerance to etching by $Cl_2$ plasma, of about 5. In conducting the second etching step where a GaN material with a large film thickness must be etched, a relatively thicker $SiN_x$ film is necessary. For example, etching a GaN material with a thickness of 10 $\mu$m by a second dry-etching process requires a $SiN_x$ mask with a thickness of 2 $\mu$m. However, with a $SiN_x$ mask with such a thickness, the $SiN_x$ mask is also etched during the dry etching, and not only its thickness in a longitudinal direction but also its shape in a horizontal direction are changed, so that a desired GaN material part cannot be selectively etched.

Thus, when forming the light-emitting-element separation-trench in the second etching step, dry etching using a mask including a metal-fluoride layer is preferred. A material constituting the metal-fluoride layer is preferably $MgF_2$, $CaF_2$, $SrF_2$, $BaF_2$ or $AlF_3$, most preferably $SrF_2$ in the light of balance between dry etching tolerance and wet-etching properties.

A metal fluoride film must be sufficiently tolerant to dry etching in the first and the second etching steps while being easily etched by etching for patterning (preferably, wet etching) to give a patterning shape with good linearity particularly in the sidewall. Deposition of a metal-fluoride layer at a temperature of 150 °C or higher gives a dense film having good adhesiveness to a base layer, and the film after patterned by etching shows good linearity in a mask sidewall. A deposition temperature is preferably 250 °C or higher, further preferably 300 °C or higher, most preferably 350 °C or higher. Particularly, a metal-fluoride layer deposited at 350 °C or higher exhibits good adhesiveness to any type of base layer and gives a fine film which is highly tolerant to dry etching and exhibits quite higher linearity in its sidewall in terms of a patterning shape, ensuring controllability to a width of the opening, and thus it is the most preferable as an etching mask.

Thus, although deposition at a high temperature is preferable for providing an etching mask exhibiting good adhesiveness to a base layer, giving a fine film, being highly tolerant to dry etching and exhibiting very high linearity in its sidewall and very high controllability of a width of the opening in terms of a patterning shape, a too high deposition temperature gives a film having excessive tolerance to wet etching using, for example, hydrochloric acid preferably used for patterning a metal fluoride, and thus the film cannot be easily removed. Particularly, when a mask such as $SrF_2$ is

exposed to plasma such as chlorine plasma during dry etching of a semiconductor layer, an etching rate in a later process for removing the mask layer tends to be reduced in comparison with that before exposure to plasma such as chlorine plasma. Therefore, deposition of a metal fluoride at an excessively higher temperature is undesirable in the light of its patterning and final removal.

First, in a metal fluoride before being exposed to plasma in dry etching of a semiconductor layer, a layer deposited at a lower temperature has a larger etching rate to an etchant such as hydrochloric acid, resulting in a higher etching rate and a layer deposited at a higher temperature has a smaller etching rate, resulting in a lower etching rate. When deposition temperature becomes 300 ° C or higher, the etching rate decreases noticeably in comparison with a film deposited at a temperature of about 250 ° C, and a temperature of about 350 ° C to 450 ° C is within a very favorable etching rate range. A deposition temperature of higher than 480 ° C, however, leads to an excessively smaller absolute etching rate value, so that patterning of the metal fluoride takes a too longer time and patterning may be difficult under the conditions where a resist mask layer and so on are not detached. Furthermore, in a metal fluoride after being exposed to plasma in dry etching of a semiconductor layer, a wet-etching rate by, for example, hydrochloric acid in a removal step tends to decrease and growth at an excessively high temperature makes it difficult to remove the metal fluoride.

From such a viewpoint, a deposition temperature of a metal-fluoride layer is preferably 480 ° C or lower, further preferably 470 ° C or lower, particularly preferably 460 ° C or lower.

Using a mask patterned considering the above (the mask may be a multilayer with $SiN_x$ or $SiO_2$ such that the metal-fluoride layer becomes a surface layer), dry etching is conducted. A gas species for the dry etching may be preferably selected from $Cl_2$, $BCl_3$, $SiCl_4$, $CCl_4$ and combinations of these. In the dry etching, a selectivity ratio of the $SrF_2$ mask to a GaN material is over 100, so that a thick GaN film can be easily and precisely etched. Furthermore, the optimal dry etching technique is ICP type dry etching capable of generating high-density plasma.

After the above etching, when the used unnecessary metal-fluoride layer mask is removed by an etchant such as hydrochloric acid, a multilayer mask with $SiN_x$, $SiO_2$ or the like may be formed such that the metal-fluoride layer becomes a surface layer if a material susceptible to an acid is present under the metal fluoride mask, for example, if an electrode material is susceptible to an acid. In such a case, $SiN_x$ or $SiO_2$ may be present in the whole region under the metal fluoride mask or alternatively, as shown, for example, in FIG. 4-16, a mask 51 such as $SiN_x$ and $SiO_2$ is not necessarily present in the whole region of the metal fluoride mask layer 52 but can be at least formed over a material susceptible to an acid.

By such a second etching step, the light-emitting-element separation-trench 13 is formed as shown in FIG. 4-7.

Regarding the first etching step and the second etching step, either step can be carried out before or after another step. It is also preferable for simplifying a process that the first etching step is first conducted and then without removing the etching mask, the second etching step is conducted. As shown in FIG. 4-16, first, a first etching mask 51 is formed from a material resistant to an acid such as $SiN_x$ and $SiO_2$ (preferably $SiN_x$) and etching is conducted such that a first-conductivity-type cladding layer 24 appears, and without removing the mask 51, a metal-fluoride layer is formed as a second etching mask 52. Then, preferably, after conducting the second etching step, the mask 52 is removed by an acid and then the mask 51 is removed as appropriate.

When the narrowest width between the light-emitting-element separation-trenches formed is $2L_{WSPT1}$, $L_{WSPT1}$ is preferably 20 $\mu$m or more, for example 30 $\mu$m or more for element separation by breaking. For separation by dicing, $L_{WSPT1}$ is preferably 300 $\mu$m or more. Since an excessively large width is not correspondingly effective, $L_{WSPT1}$ is generally 2000 $\mu$m or less. These are needed for ensuring a margin for an element manufacturing process and a scribe region.

A "setback-sidewall-surface" as defined in the present invention is a sidewall surface appearing as a sidewall in the second etching step, that is, during forming the light-emitting-element separation-trench, but not a wall surface appearing after the first etching alone.

After the second etching step, an insulating layer 30 is formed as shown in FIG. 4-8. The insulating layer may be appropriately made of any material as long as electric insulation can be ensured, as detailed above. Deposition can be conducted by any known method such as plasma CVD.

Next, as shown in FIG. 4-9A, a predetermined part in the insulating layer 30 is removed, to form a second-conductivity-type-side electrode exposed part 37 where the insulating layer on the second-conductivity-type-side electrode 27 is removed, a first current injection region 36 where the insulating layer on the first-conductivity-type cladding layer is removed, and a scribe region 14 where the insulating layer within the light-emitting-element separation-trench 13 is removed. Removal of the insulating layer 30 on the second-conductivity-type-side electrode 27 is conducted such that the periphery of the second-conductivity-type-side electrode is covered by the insulating layer. That is, the surface area of the second-conductivity-type-side electrode exposed part is smaller than the area of the second current injection region. Here, for ensuring a margin for an element manufacturing process, particularly a photolithography step or preventing unintended short circuit from occurring due to a solder material, the narrowest width ($L_{2w}$) in the part where the second-conductivity-type-side electrode is partly covered by the insulating layer is preferably 15 $\mu$m or more as described above. More preferably, it is 100 $\mu$m or more. In particular, covering the wide area of the second-conductivity-type-side electrode by the insulating layer allows for reducing unintended short circuit due to a metal solder material, with an another part such as the first-conductivity-type-side electrode.

For removing the insulating layer, an etching procedure such as dry etching and wet etching may be selected, depending on a material selected. For example, when the insulating layer is a single layer of $SiN_x$, dry etching using a gas such as $SF_6$ or wet etching using a hydrofluoric acid etchant can be employed. When the insulating layer is a dielectric multilayer film made of $SiO_x$ and $TiO_x$, the multilayer film in a desired part can be removed by Ar-ion milling.

A width of the scribe region 14 can be selected such that a predetermined $L_{ws}$ can be obtained as described above.

The second-conductivity-type-side electrode exposed part 37, the first current injection region 36 and the scribe region 14 can be separately formed. But they are, in general, simultaneously formed by etching. When the light-emitting-element separation-trench is formed to the intermediate portion of the buffer layer, the same process can be employed, except the insulating film is deposited not on the substrate surface but on the trench bottom surface in the above process.

Then, a first-conductivity-type-side electrode 28 is formed as shown in FIG. 4-10. The present invention is characterized in that the first-conductivity-type-side electrode is formed to have the larger area than the first current injection region and that the first-conductivity-type-side electrode and the second-conductivity-type-side electrode do not spatially overlap at all. This is important for ensuring an adequate area to ensure adequate bonding to a submount during flip-chip mounting of this element by soldering, and for ensuring an adequate distance for preventing unintended short circuit due to, for example, a solder material between the second-conductivity-type-side electrode and first-conductivity-type-side electrode. The narrowest width ($L_{1w}$) of the part where the first-conductivity-type-side electrode is in contact with the insulating layer is established within the above-mentioned range. In general, the width of 5 μm or more can ensure a process margin for a photolithography process and a liftoff method.

An electrode material preferably comprises, as described above, a material selected from Ti, Al, Ag and Mo or all of them as a constituent element when the first-conductivity-type is n-type. Generally, Al is exposed in a direction opposing to a main light-extraction direction of the n-side electrode.

The electrode material can be deposited by applying a variety of deposition processes such as sputtering, vacuum evaporation and plating, and an electrode shape can be obtained by appropriately applying, for example, a lift-off process using photolithography technique or site-selective evaporation using, for example, a metal mask.

The first-conductivity-type-side electrode is formed in this example such that a part thereof contacts with the first-conductivity-type cladding layer, but can be formed to contact with, in case formed, a first-conductivity-type-side contact layer.

In a manufacturing process according to the present invention, the first-conductivity-type-side electrode is formed in the final step of forming a stacked structure, which is advantageous in the light of reducing process damage. When the first-conductivity-type is n-type, Al is formed on the surface of the electrode material of the n-side electrode in a preferred embodiment. Here, if the n-side electrode is formed before formation of an insulating layer as the second-conductivity-type-side electrode, the n-side electrode surface, that is, Al metal receives a history of the etching process of the insulating layer. Etching of the insulating layer is conveniently conducted by wet etching using a hydrofluoric acid etchant as described above, but Al is less tolerant to various etchants including hydrofluoric acid, so that when effectively conducting such a process, the electrode itself is damaged. Furthermore, even if dry etching is employed, Al is relatively reactive, so that damages including oxidation may be introduced. Therefore, in the present invention, it is effective in reducing damage to the electrode that the first-conductivity-type-side electrode is formed after forming the insulating layer and after removing a predetermined unnecessary part in the insulating layer.

Thus, after forming the structure shown in FIG. 4-10, the substrate is scratched by diamond scribing or the substrate material is partly ablated by laser scribing using the light-emitting-element separation-trench for separating individual compound semiconductor light-emitting-elements.

In some embodiments, the light-emitting-element separation-trench is formed to the intermediate portion of the buffer layer, and in such a case, again, the substrate is scratched by diamond scribing or the substrate material is partly ablated by laser scribing using the light-emitting-element separation-trench.

In the present invention , there are no thin-film crystal layers which have influence on device performance, in the light-emitting-element separation-trench during the inter-element separation step, and therefore, process damage is not introduced into the thin-film crystal layer. Furthermore, since there are no insulating layers in the scribe region, for example, detachment of an insulating layer does not occur during scribing at all.

After finishing scratching (scribing), the compound semiconductor light-emitting-elements are divided in the braking step into the individual devices, each of which is mounted on a submount preferably by, for example, a solder material.

As described above, there is manufactured the light-emitting-element as shown in FIG. 4-1A. Likewise, light-emitting-elements shown in FIG. 4-1C can be also manufactured.

In this manufacturing process, it is preferable as described above to conduct formation of the thin-film crystal layer, formation of the second-conductivity-type-side electrode, the etching steps (the first etching step and the second etching step), formation of the insulating layer, removal of the insulating layer (formation of the second-conductivity-type-side electrode exposed part, formation of the first current injection region and formation of the scribe region) and formation of the first-conductivity-type-side electrode, in this sequence. Such a process sequence allows for providing a light-emitting-element without damage in the thin-film crystal layer immediately below the second-conductivity-type-side electrode or damage in the first-conductivity-type-side electrode. Furthermore, the device shape reflects the process flow. In other words, this light-emitting-element internally has a structure where there are deposited the second-conductivity-type-side electrode, the insulating layer and the first-conductivity-type-side electrode in this sequence. That is, the second-conductivity-type-side electrode is in contact with the second-conductivity-type cladding layer (or another second-conductivity-type thin-film crystal layer) without an intervening insulating layer; there is a part of the upper periphery of the second-conductivity-type-side electrode which is covered by an insulating layer; and there is an area where an electrode periphery is intervened by an insulating layer between the first-conductivity-type-side electrode and the first-conductivity-type-side cladding layer (or another first-conductivity-type thin-film crystal layer).

Embodiment 2 of a manufacturing process

In Embodiment 2 of a manufacturing process, there will be described mainly a process for manufacturing a light-emitting-element shown in FIG. 4-2A and furthermore those for light-emitting-elements shown in FIG. 4-2C. Embodiment 2 is conducted as described in Embodiment 1 until the step of forming an insulating layer 30 (FIG. 4-5 to FIG. 4-8). Then, in Embodiment 1, only a region including the center of a light-emitting-element separation-trench of the substrate surface (a trench bottom surface) while in Embodiment 2, as shown in FIG. 4-9B, all the insulating layer 30 over the substrate 21 (that is, the trench bottom surface) within the light-emitting-element separation-trench 13 is removed and the substrate-side (that is, the trench bottom surface side) insulating layer formed on the sidewall within the trench is removed to form a part without an insulating layer 15. The following process may be used as a formation process. First, a resist mask having an opening whose area is equal to or slightly smaller than the area of the light-emitting-element separation-trench 13 is formed by photolithography, and then, wet etching is conducted using an etchant capable of etching an insulating layer, to initiate removal of the insulating layer on the substrate surface within the light-emitting-element separation-trench. If the etching is further continued, side etching proceeds to remove the insulating layer covering the substrate side of the trench sidewall by the wet etchant and thus to give a shape as shown in FIG. 4-9B wherein an insulating layer of the sidewall is not present in the portion of the substrate side.

The sidewall exposed by the removal of the insulating layer is at least a part of the substrate side of the sidewall of the buffer layer, and depending on an embodiment, all the sidewall of the buffer layer 22 may be exposed The exposed sidewall without an insulating layer is preferably sidewall of undoped layer. This is because it prevents unintended electric short circuit from occurring even if a solder for bonding to a submount attaches to the sidewall during flip-chip mounting. Furthermore, when the light-emitting-element separation-trench is formed by partly etching the substrate, only a portion of the substrate may be exposed among the trench wall surface while the wall of the buffer layer may be covered by an insulating layer.

As in Embodiment 1, the second-conductivity-type-side electrode exposed part 37, the first current injection region 36 the and the part without an insulating layer 15 may be separately formed, but generally they are simultaneously formed by etching.

After the above, manufacturing of the light-emitting-element shown in FIG. 4-2A can be completed as described for Embodiment 1.

In Embodiment 2 of a manufacturing process, as in Embodiment 1, a configuration where the light-emitting-element separation-trench does not reach the substrate is also preferable. For example, when the light-emitting-element separation-trench is formed to the intermediate portion of the buffer layer, an insulating layer can be formed on the sidewall of the first-conductivity-type cladding layer, to maintain insulation to a running-around solder (see FIG. 4-2C for a configuration after completion of the light-emitting-element). Here, a trench bottom surface is formed in the intermediate portion of the buffer layer and becomes an edge-step-face at the end of the light-emitting-element. The trench bottom surface is a plane having irregularity which can be formed by etching. Furthermore, a layer exposed from the sidewall without being covered by the insulating layer is preferably highly insulative. Then, when the insulating film 30 is deposited, the same process can be employed, except the insulating film is deposited in the above process not on the substrate surface but on the trench bottom surface. Otherwise, as described for Embodiment 2, the light-emitting-elements shown in FIG. 4-2C can be also manufactured.

The light-emitting-element manufactured by the process of Embodiment 2 (and its variation) is also a device where the insulating layer covering the sidewall does not reach the end of the light-emitting-element, ensuring elimination of detachment of the insulating layer. In addition, by forming the exposed layer using a highly insulative material, a highly reliable device is obtained, similarly to the light-emitting-element according to the embodiment of FIG. 4-1A.

«Section E»

The invention disclosed in Section E relates to the followings.
[1] A compound semiconductor light-emitting-element comprising a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer in this order; a second-conductivity-type-side electrode; and a first-conductivity-type-side electrode, in which a main light-extraction direction is a buffer layer side in relation to the active layer structure, wherein:

the first-conductivity-type-side electrode and the second-conductivity-type-side electrode are not spatially overlapped and are formed on the opposite side to the main light-extraction direction;
the light-emitting-element comprises a support supporting the light-emitting-element, to which the first-conductivity-type-side electrode and the second-conductivity-type-side electrode are connected;
at the edge of the light-emitting-element, sidewalls of at least the first-conductivity-type semiconductor layer, the active layer structure and the second-conductivity-type semiconductor layer form a setback-sidewall-surface, which has receded when forming a light-emitting-element separation-trench in a manufacturing process, on a sidewall surfaces of the thin-film crystal layers;
the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) in relation to the setback-sidewall-surface of the thin-film crystal layer,

(i) if a part of the buffer layer form a setback-sidewall-surface in combination and forms an edge-step-face with the non-setback-sidewall-surface which has not receded in the buffer layer,
at least, the insulating layer being formed from a position distant from the light-emitting-element edge, or
(ii) if the buffer layer form a setback-sidewall-surface in combination and an edge-step-face is not formed, the insulating layer being not formed at least on the part of the buffer layer at the side of main light-extraction direction but covering the setback-sidewall-surface from the intermediate portion of the buffer layer or the light-uniforming layer,

[2] The light-emitting-element as described in [1], having, in relation to the setback-sidewall-surface of the thin-film crystal layer, a configuration

(ii) where the buffer layer form a setback-sidewall-surface in combination and an edge-step-face is not present, the insulating layer being not formed at least on the part of the buffer layer at the side of main light-extraction direction but covering the setback-sidewall-surface from the intermediate portion of the buffer layer.

[3] The light-emitting-element as described in [1], having, in relation to the setback-sidewall-surface of the thin-film crystal layer, a configuration

(i) where a part of the buffer layer forms a setback-sidewall-surface in combination and forms an edge-step-face with the non-setback-sidewall-surface which has not receded in the buffer layer, the insulating layer being formed from a position distant from the light-emitting-element edge, and
wherein the insulating film covers at least a part of the setback-sidewall-surface of the buffer layer and does not cover the edge-step-face.

[4] The light-emitting-element as described in [1], having, in relation to the setback-sidewall-surface of the thin-film crystal layer, a configuration

(i) where a part of the buffer layer forms a setback-sidewall-surface in combination and forms an edge-step-face with the non-setback-sidewall-surface which has not receded in the buffer layer,
the insulating layer being formed from a position distant from the light-emitting-element edge, and
wherein the insulating film covers the edge-step-face from a position distant from the light-emitting-element edge, and the surface in line with the setback-sidewall-surface in the first-conductivity-type semiconductor layer.

[5] The light-emitting-element as described in [4], wherein of the buffer layer, the layer constituting the part where the sidewall surface is not covered by the insulating layer is of an undoped type.

[6] The light-emitting-element as described in any of [1] to [5], wherein the narrowest width $L_{1w}$ of a part where the first-conductivity-type-side electrode is contacting the insulating layer is 5 $\mu$m or more.

[7] The light-emitting-element as described in any of [1] to [6], wherein the narrowest width $L_{2w}$ of a part where the second-conductivity-type-side electrode is covered by the insulating layer is 15 $\mu$m or more.

[8] The light-emitting-element as described in [7], wherein the $L_{2w}$ is 100 $\mu$m or more.

[9] The light-emitting-element as described in any of [1] to [8], wherein the first-conductivity-type-side electrode comprises a layer made of material containing an element selected from the group consisting of Ti, Al, Ag, Mo and a combination of two or more of these.

[10] The light-emitting-element as described in any of [1] to [9], wherein the second-conductivity-type-side electrode comprises a layer made of material containing an element selected from the group consisting of Ni, Pt, Pd, Mo, Au and a combination of two or more of these.

[11] The light-emitting-element as described in any of [1] to [10], wherein the insulating layer is a single layer of material selected from the group consisting of $SiO_x$, $AlO_x$, $TiO_x$, $TaO_x$, $HfO_x$, $ZrO_x$, $SiN_x$, $AlN_x$, $AlF_x$, $BaF_x$, $CaF_x$, $SrF_x$ and $MgF_x$.

[12] The light-emitting-element as described in any of [1] to [11], wherein the insulating layer is a dielectric multilayer film consisting of multiple layers.

[13] The light-emitting-element as described in [12], wherein at least one of the layers constituting the insulating layer is made of material containing fluoride.

[14] The light-emitting-element as described in [13], wherein the fluoride is selected from the group consisting of $AlF_x$, $BaF_x$, $CaF_x$, $SrF_x$ and $MgF_x$.

[15] The light-emitting-element as described in any of [1] to [14], wherein when R2 is a reflectance of reflection by the buffer layer, of a light having an emission wavelength of the light-emitting-element vertically incoming from the first-conductivity-type semiconductor layer side to the buffer layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

(Relation 1) R2 < R12
(Relation 2) R2 < R11
(Relation 3) R2 < R1q

are satisfied.

[16] The light-emitting-element as described in any of [1] to [15], wherein the thin-film crystal layer is formed by deposition on a substrate selected from the group consisting of sapphire, SiC, GaN, $LiGaO_2$, ZnO, $ScAlMgO_4$, $NdGaO_3$ and MgO.

[17] The light-emitting-element as described in any of [1] to [16], wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

[18] The light-emitting-element as described in any of [1] to [17], wherein the active layer structure consists of quantum well layer and barrier layer and when B is the number of the barrier layer and W is the number of the quantum well layer, B and W satisfy the relation:

$$B = W+1.$$

[19] The light-emitting-element as described in any of [1] to [18], wherein the first-conductivity-type is n-type and the second-conductivity-type is p-type.

[20] The light-emitting-element as described in any of [1] to [19], wherein the first-conductivity-type-side electrode and the second-conductivity-type-side electrode are bonded to the support having a metal layer via a solder.

[21] The light-emitting-element as described in [20], wherein bonding between each of the first-conductivity-type-side electrode and the second-conductivity-type-side electrode and the metal layer on the support is formed by a metal solder alone, or a metal solder and a metal bump.

[22] The light-emitting-element as described in [20] or [21], wherein the base material of the support is selected from the group consisting of AlN, $Al_2O_3$, Si, glass, SiC, diamond, BN and CuW.

[23] The light-emitting-element as described in any of [20] to [22], wherein the metal layer is not formed in a device-separating region in the support.

[24] The light-emitting-element as described in [2], wherein the surface of the light-extraction side of the substrate is not flat.

[25] The light-emitting-element as described in [3], wherein the surface of the light-extraction side of the buffer layer is not flat.

[26] The light-emitting-element as described in [2], wherein when R3 is a reflectance of reflection by the substrate, of a light having an emission wavelength of the light-emitting-element vertically incoming from the buffer layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

$$R4 < R3$$

is satisfied.

[27] The light-emitting-element as described in [3], wherein when R3 is a reflectance of reflection by the buffer layer, of a light having an emission wavelength of the light-emitting-element vertically incoming from the first-conductivity-type semiconductor layer to the buffer layer side and R4 is a reflectance of reflection by an interface with a space, of a light having an emission wavelength of the light-emitting-element vertically incoming from the buffer layer to the space of the light-extraction side, a low-reflecting optical film is formed in the light-extraction side of the buffer layer such that the relation:

$$R4 < R3$$

is satisfied.

According to the invention disclosed in this Section, there can be provided a flip-chip mount type semiconductor light-emitting-element capable of emitting blue or ultraviolet light with higher output and higher efficiency.

In the structure of the invention disclosed in this Section, process damage in each step in the manufacturing process is eliminated, so that a highly reliable element is provided without deterioration in the functions of the light-emitting-element.

<Explanation of Embodiments of the invention in Section E>

FIGs. 5-1A, 5-2A and 5-3A show a typical example of a compound semiconductor light-emitting-element according to the invention disclosed in this Section (hereinafter, simply referred to as "light-emitting-element"). FIGs. 5-1B and 5-3B are figures in which some portions of FIGs. 5-1A and 5-3A are omitted, respectively for explanation and FIGs. 5-4A and 5-4B are figures showing structures in the course of the manufacturing process for detailing the structure of the light-emitting-element. The present invention will be described with reference to FIGs. 5-1A to 5-4B.

A light-emitting-element according to the invention disclosed in this Section has, as shown in FIGs. 5-1A, 5-2A and 5-3A, a compound semiconductor thin-film crystal layer having a buffer layer 22, a first-conductivity-type semiconductor layer containing a first-conductivity-type cladding layer 24, a second-conductivity-type semiconductor layer containing a second-conductivity-type cladding layer 26, and an active layer structure 25 sandwiched between the first and the second-conductivity-type semiconductor layers; a second-conductivity-type-side electrode 27; and a first-conductivity-type-side electrode 28.

On a part of the second-conductivity-type cladding layer 26, the second-conductivity-type-side electrode 27 is disposed and the part where the second-conductivity-type cladding layer 26 and the second-conductivity-type-side electrode 27 are in contact with each other is a second current injection region 35. In this configuration, parts of the second-conductivity-type cladding layer and the active layer structure, and a part of the first-conductivity-type cladding layer are removed. The first-conductivity-type-side electrode 28 is disposed in contact with the first-conductivity-type cladding layer 24 exposed in the removed part, so that the second-conductivity-type-side electrode 27 and the first-conductivity-type-side electrode 28 are disposed on the same side in relation to the substrate. The second-conductivity-type-side electrode 27 and the first-conductivity-type-side electrode 28, each, is connected to metal layer 41 on a support 40 via metal solder 42.

In the present invention, the first-conductivity-type-side electrode and the second-conductivity-type-side electrode are not spatially overlapped. This means that as shown in FIGs. 5-1A, 5-2A and 5-3A, when the first-conductivity-type-side electrode 28 and the second-conductivity-type-side electrode 27 are projected to the substrate surface, their shadows are not overlapped.

An insulating layer 30 is formed for preventing unintended short circuit due to a solder or a conductive paste material for mounting entering/going around, for example, "between the second-conductivity-type-side electrode and the first-conductivity-type-side electrode" or "a sidewall of a thin-film crystal layer such as an active layer structure" during flip-chip mounting. At the same time, in the present invention, an insulating layer is disposed at the optimal position for avoiding influence of damage on element performance or on an yield.

The light-emitting-element according to the invention disclosed in this Section may have a different configuration in two portions, that is, (I) a step shape of an edge in a light-emitting-element and (II) a shape of an insulating film in a light-emitting-element edge. In terms of (I) the step shape of the edge in a light-emitting-element, there are generally three options, depending on an etching depth when forming a light-emitting-element separation-trench for element separation in the manufacturing process, i.e. (i) the depth to the intermediate portion of the buffer layer and (ii) the depth to the substrate surface (or deeper). Furthermore, the wall surface of the light-emitting-element separation-trench recedes from the element edge after element separation. In the present invention, the surface that has been appeared as sidewall surface after forming the light-emitting-element separation-trench is, therefore, referred as a "setback-sidewall-surface" in the element after element separation. The sidewall surface appearing in the element edge by the element separation is called a "non-setback-sidewall-surface". Then, in the edge of the light-emitting-element, a step face is formed between the setback-sidewall-surface and the non-setback-sidewall-surface, which is called an "edge-step-face".

Depending on the depth (i) to (ii) in the light-emitting-element separation-trench, in the case of (i), a part of the buffer layer forms a setback-sidewall-surface in combination with a thin-film crystal layer while the remaining (in the main light-extraction direction side) sidewall of the buffer layer forms a non-setback-sidewall-surface, and there is an edge-step-face on the edge of the buffer layer. In the case of (ii), an edge-step-face does not exist because both sidewalls of the buffer layer form setback-sidewall-surface (because it is a sidewall surface of the light-emitting-element separation-trench) and a substrate is not present in the manufactured element in the invention disclosed in this Section. Even in the case of (ii), since the sidewall of light-emitting-element separation-trench is considered to have receded from the element edge face which is separated without forming a light-emitting-element separation-trench, it is referred as "setback-sidewall" to keep consistency in the present invention.

The shape corresponding to (i) is shown in FIGs. 5-2A and 5-3A (FIG 5-3B). The shape corresponding to (ii) is shown in FIGs. 5-1A (5-1B).

In terms of (II) the shape of the insulating film in the light-emitting-element edge, there are options, in the manufacturing process, (i) removing only the insulating layer in the region including the intermediate portion part over the trench bottom surface while leaving the insulating layer formed in the sidewall of the light-emitting-element separation-trench and (ii) removing a part of the insulating layer on the sidewall within the trench, in addition to the whole insulating layer formed in the trench bottom surface. In a light-emitting-element thus manufactured, there are provided two shapes, that is, (i) a shape where the insulating film is in contact with the trench bottom surface and (ii) a shape where the insulating film is present apart from the trench bottom surface. The shape corresponding to (i) is shown in FIG. 5-3A (5-3B). The shape corresponding to (ii) is shown in FIGs. 5-1A (5-1B), and 5-2.

Since a growth substrate is removed during the manufacturing process in the invention disclosed in this Section, a configuration is not preferable, in which the insulating film is in contact with the substrate when the substrate is removed. The invention disclosed in this Section does not, therefore, comprise a configuration where in the above combination, (I) the step shape in the edge of the light-emitting-element is a shape where (ii) the buffer layer does not have a step and (II) the shape of the insulating film of the light-emitting-element edge is a shape where (i) the insulating film is in contact with the trench bottom surface.

There will be described configurations of the light-emitting-element according to the invention disclosed in this Section, as a first aspect: (ii) a shape where the insulating film is separated from the trench bottom surface and a second aspect: (i) a shape where the insulating film is in contact with the trench bottom surface in sequence, depending on (II) the shape of the insulating film in the light-emitting-element edge.

However, in common to the light-emitting-elements of the invention disclosed in this Section, the insulating film does not reach the end of the buffer layer in a main light-extraction direction.

First aspect

FIGs. 5-1A to 5-2 show embodiments belonging to the first aspect. First, there will be described a typical embodiment using FIG. 5-1A. A light-emitting-element of the invention disclosed in this Section does not have a substrate in a main light-extraction direction as shown in FIG. 5-1A. The insulating layer 30 covers at least the sidewall surfaces of a first-conductivity-type semiconductor layer (a first-conductivity-type cladding layer 24 in the figure), an active layer structure 25, and a second-conductivity-type semiconductor layer (a second-conductivity-type cladding layer 26 in the figure) of the sidewall surfaces exposed after removing the thin-film crystal layer. There is present a part without an insulating layer 15 which is not covered by an insulating layer at least in a main light-extraction direction side of the sidewall surface of the buffer layer 22, which optionally extends over the whole sidewall surface of the buffer layer 22. Thus, in the light-emitting-element of the invention disclosed in this Section, an insulating layer is not present in the element edge in a main light-extraction direction side of the buffer layer. This is also applied to other embodiments where a buffer layer has an edge-step-face.

It is preferable that the buffer layer of the part without an insulating layer 15 which is not covered by an insulating layer is an undoped layer which is not doped. When the exposed part is made of a highly insulative material, no defects such as short circuit due to running around of a solder occur, resulting in a highly reliable element.

This structure has an intermediate configuration shown in FIG. 5-4A before element separation in the course of the manufacturing process. In the course of the manufacturing process, the insulating layer 30 is removed from the in-trench substrate surface (the trench bottom surface) in the light-emitting-element separation-trench 13 and the part without an insulating layer 15 of the trench sidewall surface near the substrate surface (the trench bottom surface). In the invention disclosed in this Section, the substrate 21 is removed in the course of the manufacturing process. Here, since the insulating layer 30 is not in contact with the substrate 21, detachment of the insulating layer does not occur during removal of the substrate. Therefore, insulation can be ensured and furthermore, tension generated during delamination of the insulating layer does not cause damage in the thin-film crystal layer.

The light-emitting-element thus obtained after separation has a part without an insulating layer 15 which is not covered by an insulating layer in a main light-extraction direction side of the wall surface of the buffer layer 22 as shown in area A in FIG. 5-1A. That is, this shape ensures elimination of detachment of the insulating layer in the side surface of the thin-film crystal layer. As a result, in this light-emitting-element, unintended short circuit is prevented even if running around of a solder occurs and furthermore, the thin-film crystal layer is not damaged, so that the functions of the light-emitting-element are not deteriorated, resulting in a highly reliable element.

In addition, the insulating layer 30 is in contact with a part of the first-conductivity-type-side electrode 28 at the side of the substrate (at the side of the main light-extraction direction) in the present invention as shown in part B (dotted line circle) in FIG. 5-1B. In other words, the insulating layer intervenes partly between the first-conductivity-type-side electrode 28 and the first-conductivity-type semiconductor layer (in this embodiment, the first-conductivity-type cladding layer 24). As a result, an area of the first-conductivity-type-side electrode 28 is larger than an area of the first current injection region 36. As shown in FIG. 5-1B, when $L_{1w}$ is the narrowest width in the part of the first-conductivity-type-side electrode in contact with the insulating layer, $L_{1w}$ is preferably 7 $\mu$m or more, particularly preferably 9 $\mu$m or more. Furthermore, $L_{1w}$ is generally 500 $\mu$m or less, preferably 100 $\mu$m or less. In general, when it is 5 $\mu$m or more, a process margin by a photolithography process and a liftoff procedure can be ensured.

Furthermore, as shown in part C (dotted line circle) in FIG. 5-1B, the insulating layer 30 cover a part of the second-conductivity-type-side electrode 27 on the support side (i.e. the opposite side to the main light-extraction direction). In other words, an area of the exposed part 37 in the second-conductivity-type-side electrode 27 is smaller than an area of the second-conductivity-type-side electrode 27, and an area of the second current injection region 35 is equal to an area of the second-conductivity-type-side electrode 27. As shown in FIG. 5-3, when $L_{2W}$ is the narrowest width in the part covered by the insulating layer around the second-conductivity-type-side electrode, $L_{2W}$ is preferably 15 $\mu$m or more. It is further preferably 30 $\mu$m or more, particularly preferably 100 $\mu$m or more. Covering many of the area of the second-conductivity-type-side electrode by the insulating layer particularly allows for reducing unintended short circuit with another part such as the first-conductivity-type-side electrode via a metal solder material. $L_{2w}$ is generally 2000 $\mu$m or less, preferably 750 $\mu$m or less.

Furthermore, the insulating layer 30 generally also covers the exposed part of the surface of the support side (the opposite side to the main light-extraction direction) in the first-conductivity-type semiconductor layer (the first-conductivity-type cladding layer 24 in this embodiment) and the second-conductivity-type semiconductor layer (the second-conductivity-type cladding layer 26 in this embodiment) for preventing short circuit as shown in the figure.

Such a positional relationship between the insulating layer and each electrode means that an element can be manufactured by a process with less process damage.

First aspect -2

There will be described other embodiments belonging to the first aspect with reference to FIG. 5-2. In terms of a difference from the embodiment in FIG. 5-1A, the light-emitting-element of FIG. 5-1A has a configuration where (I) the step shape in the edge of the light-emitting-element is a shape where (ii) the buffer layer does not have a step, while the light-emitting-elements shown in FIGs. 5-2 has a configuration having (i) an edge-step-face based on the light-emitting-element separation-trench at the end of the buffer layer.

This configuration is manufactured such that the light-emitting-element separation-trench is formed to the intermediate portion of the buffer layer, and as a result, in a completed device, at least the first-conductivity-type semiconductor layer, the active layer structure and the second-conductivity-type semiconductor layer has receded inside from the edge of the device to form a setback-sidewall-surface and there is an edge-step-face between setback-sidewall-surface and an element edge wall surface (a non-setback-sidewall-surface).

FIG. 5-2 shows an example of a light-emitting-element where a light-emitting-element separation-trench is formed to the intermediate portion of the buffer layer 22. As shown in part A (dotted line circle in FIG), a part of the buffer layer 22 is present as a non-setback-sidewall-surface to the light-emitting-element edge, and from the intermediate portion of the buffer layer 22, the wall surface recesses from the element edge and forms a setback-sidewall-surface (the sidewall of the light-emitting-element separation-trench) in combination with the sidewall surface of the second-conductivity-type semiconductor layer. There is an edge-step-face 55 based on the bottom surface between the non-setback-sidewall-surface and the setback-sidewall-surface. The non-setback-sidewall-surface (the sidewall part of the element edge) and the edge-step-face are not covered by the insulating layer. And in the setback-sidewall-surface (the sidewall of the light-emitting-element separation-trench), there is a part without an insulating layer 15 which is not covered by the insulating layer in the main light-extraction direction side. The part without an insulating layer 15, in some cases, may extend to the whole of the sidewall of the buffer layer 22.

As illustrated in these examples, even when the light-emitting-element separation-trench is formed to the intermediate portion of the layer of the buffer layer, prevention of detachment of the insulating layer is ensured in the device having a configuration that the insulating layer covering the sidewall does not reach the edge of the light-emitting-element. Also by forming the exposed layer using a high insulative material, a highly reliable device can be provided, similarly to the light-emitting-element of the configuration shown in FIG. 5-1A.

Second aspect

The second aspect has (II) a shape of the insulating film in the light-emitting-element edge where (i) the insulating film is in contact with the trench bottom surface. In the light-emitting-element of FIG. 5-3A, the light-emitting-element separation-trench is formed to the intermediate portion of the buffer layer 22 before element separation as shown in FIG. 5-4B, and the insulating layer 30 does not cover the whole trench bottom surface of the light-emitting-element separation-trench 13 and a scribe region 14 without the insulating layer 30 is formed in the trench bottom surface. Therefore, in the element separation such as scribing and breaking in the manufacturing process, only the buffer layer can be broken and layers involved in device performance in the thin-film crystal layers, that is, the first-conductivity-type semiconductor layer, the active layer structure and the second-conductivity-type semiconductor layer are not directly damaged. Furthermore, since separation is initiated from the scribe region without an insulating layer in the trench bottom surface, detachment of the insulating layer does not occur, ensuring insulation and prevention of damage to a thin-film crystal layer due to tension generated during detachment of an insulating layer.

In a resultant light-emitting-element after separation, as shown in part A (dotted line circle) in FIGs. 5-3A and 5-3B, the insulating layer does not cover the whole edge step surface (trench bottom surface) formed in the buffer layer, but covers the substrate surface inside from the position distant from the edge of the substrate 21 by $L_{ws}$. In the case that the division is performed from the middle of the width of the scribe region 14, a distance $L_{ws}$ without covering by the insulating layer corresponds to about 1/2 of the width of the scribe region 14 within the range of production fluctuation. In other words, formation of this configuration ensures that detachment of the insulating layer in the side of the thin-film crystal layer is avoided, so that in this light-emitting-element, unintended short circuit is prevented even if running around of a solder occurs and furthermore, the thin-film crystal layer is not damaged, so that the functions of the light-emitting-element are not deteriorated, resulting in a highly reliable element.

$L_{ws}$ has to be larger than 0 in a completed element and is generally 10 $\mu$m or more, preferably 15 $\mu$m or more. As a designed value, when the width of the scribe region 14 is $2L_{ws}$, $2L_{ws}$ is preferably 30 $\mu$m or more. Since an excessively large value is unnecessary, $2L_{ws}$ is generally 300 $\mu$m or less, preferably 200 $\mu$m or less.

In the light-emitting-element of the second aspect, by forming the exposed layer using a high insulative material, a highly reliable device can be provided, similarly to the light-emitting device of the embodiment of FIG. 5-1A. Furthermore, the configuration of the other parts of the second aspect is as described for the first aspect.

There will be further detailed the members and the structure constituting a device.

Substrate

In the invention disclosed in Section E, the completed light-emitting-element does not have a substrate. A substrate is selected, on which a semiconductor layer can be grown and which can be finally removed. The substrate does not have to be transparent, but when the substrate is delaminated by laser debonding described later in the manufacturing process, it preferably allows a laser beam at the particular wavelength for penetrating. Preferably, it is electrically an insulating substrate. This is because when a substrate is delaminated by a laser debonding method in the manufacturing process, free electrons in a conductive substrate makes it difficult to employ the above substrate delaminating method.

The substrate materials described in Section D can be used in the invention of Section E. Specific examples of such a material is preferably selected from sapphire, SiC, GaN, $LiGaO_2$, ZnO, $ScAlMgO_4$, $NdGaO_3$ and MgO, particularly preferably sapphire, GaN and ZnO substrates for growing a thin-film crystal of an InAlGaN light-emitting material or an InAlBGaN material over the substrate. In particular, when a GaN substrate is used, its Si doping concentration is preferably a Si concentration of $3 \times 10^{17}$ cm$^{-3}$ or less for an undoped substrate, more preferably $1 \times 10^{17}$ cm$^{-3}$ or less in the light of electric resistance and crystallinity. When the substrate is removed based on chemical etching, ZnO which can be easily removed using, for example, hydrochloric acid is preferable.

A substrate used in the invention disclosed in this Section may be, in addition to a just-substrate completely defined by a so-called plane index, a so-called off-substrate (miss oriented substrate) in the light of controlling crystallinity during thin-film crystal growth. An off-substrate is widely used as a substrate because it is effective for promoting favorable crystal growth in a step flow mode and thus effective for improving element morphology. For example, when a c+ plane substrate of sapphire is used as a substrate for crystal growth of an InAlGaN material, it is preferable to use a plane inclined to an m+ direction by about 0.2 °. An off-substrate having a small inclination of about 0.1 to 0.2 ° is generally used, but in an InAlGaN material formed on sapphire, a relatively larger off-angle is possible for canceling an electric field due to piezoelectric effect to a quantum well layer as a light-emitting point within an active layer structure.

A substrate may be pretreated by chemical etching or heating for manufacturing a compound semiconductor light-emitting-element utilizing crystal growth technique such as MOCVD and MBE. Alternatively, a substrate may be deliberately processed to have irregularity in relation to a buffer layer described later to prevent penetrating dislocation generated in an interface between a thin-film crystal layer and the substrate from being introduced near an active layer of a light-emitting-element.

In one of the embodiments, a thickness of the substrate is generally about 250 to 700 $\mu$m in an initial stage of device preparation for ensuring mechanical strength during semiconductor crystal growth and an element manufacturing process. After required growth of a semiconductor layer using a substrate, the substrate is removed by, for example, polishing, etching, laser debonding or the like. Particularly, when it is delaminated by an optical procedure such as laser debonding, it is preferable to use a two-side polished substrate in thin-film crystal growth. This is because if a one-side polished substrate is used, a laser incident from a surface without thin-film crystal growth is incident from a crude surface, leading to an undue large laser output during laser debonding.

Buffer layer

In terms of a buffer layer, all the descriptions in Section D can be applied to the invention of Section E. Since a substrate does not remain in the invention according to this Section, preferred embodiments will be further described.

In the invention disclosed in this Section, since the substrate is removed in the course of the manufacturing process, the buffer layer constitutes a main light-extraction-face in an embodiment of the present aspect. As described later, one of the methods of removing the substrate includes a process where a part of the buffer layer is optically decomposed using a light which is transparent to the substrate and can be absorbed by the buffer layer, to remove the substrate. When employing such a method, a material suitable for the process is selected. For example, when the substrate is sapphire and the buffer layer is GaN, a laser debonding can be conduced, where an excimer laser having an oscillation wavelength of 248 nm is irradiated from the substrate side where the thin-film crystal has not been grown, to decompose GaN in the buffer layer into metal Ga and nitrogen and thus to delaminate the substrate. Since there is not a substrate in a main light-extraction direction in the configuration disclosed in this Section, it is desirable that a so-called low reflecting coating layer or low-reflecting optical film is formed on a plane in a main light-extraction direction of the buffer layer. It may lead to inhibiting reflection due to a refractive index difference in a buffer layer-air interface and an output and element efficiency can be improved. Here, when R3 is a reflectance of reflection by the buffer layer, of a light having an emission wavelength of the light-emitting-element vertically incoming from the first-conductivity-type semiconductor layer described later to the buffer layer side and R4 is a reflectance of reflection by an interface with a space, of a light having an emission wavelength of the light-emitting-element vertically incoming from the buffer layer to the space of the light-extraction side, it is preferable that a low-reflecting optical film is formed in the light-extraction side of the buffer layer such that the relation:

R4 < R3

is satisfied. For example, when the buffer layer is GaN, the low reflecting coating film is preferably, for example, $Al_2O_3$. This is because since a refractive index of the low reflecting coating film is preferably near $\sqrt{n_{bf}}$ in relation to a refractive index $n_{bf}$ of the buffer layer at an emission wavelength of the element, and because $Al_2O_3$ has a refractive index near a square root of a refractive index of GaN.

It is also preferable that a plane in a main light-extraction direction of the buffer layer is an irregular or crude surface. It allows for extracting light generated within a quantum well layer with a high efficiency, which is desirable in the light of improving an element output and an efficiency. When an emission wavelength of an element is λ (nm), a surface crudeness of the buffer layer is preferably such that an average roughness Ra (nm) satisfy the relation:

$$\lambda/5 \text{ (nm)} < Ra \text{ (nm)} < 10 \times \lambda \text{ (nm)}$$

more preferably, the relation:

$$\lambda/2 \text{ (nm)} < Ra \text{ (nm)} < 2 \times \lambda \text{ (nm)}.$$

In this configuration, at least a part of the buffer layer is exposed at a device edge. Therefore, it is preferable that at least the exposed part is made undoped because insufficient insulation which may occur by soldering during device assembly can be prevented.

First-conductivity-type semiconductor layer and first-conductivily-type cladding layer

A first-conductivity-type semiconductor layer and a first-conductivity-type cladding layer employed in the invention according to this Section are as described in Section D.

Active layer structure

An active layer structure employed in the invention according to this Section is as described in Section D.

Second-conductivity-type semiconductor layer and second-conductivity-type cladding layer

A second-conductivity-type semiconductor layer and a second-conductivity-type cladding layer employed in the invention according to this Section are as described in Section D.

Second-conductivity-type-side electrode

A second-conductivity-type-side electrode employed in the invention according to this Section is as described in Section D.

First-conductivity-type-side electrode

A first-conductivity-type-side electrode employed in the invention according to this Section is as described in Section D.

Insulating layer

An insulating layer employed in the invention according to this Section is as described in Section D.

Support

Although it is essential that a support 40 plays a role as a support for a thin-film crystal layer during substrate peeling, the support after the element manufacturing is completed very preferably has functions of current input and heat dissipation simultaneously. In this view, a base material of the support is preferably selected from the group consisting of a metal, AlN, SiC, diamond, BN and CuW. These materials are preferred because they exhibit good heat dissipation properties and can efficiently prevent the problem of heat generation which is inevitable in a high-output light-emitting-element. Furthermore, $Al_2O_3$, Si, glasses and so on are also preferable because they are inexpensive and can be used as a support in a wide variety of applications. It is desirable to conduct wet etching for removing metal Ga after decomposing a part of the thin-film crystal layer into metal Ga and nitrogen by laser irradiation in substrate removal described later, and in such a case, the support is preferably made of a material resistant to etching. It is desirable that when selecting a base material for a support from metals, its periphery is covered by, for example, a dielectric material which is etching resistant. A metal base material is preferably a material having a higher reflectance at an emission wavelength of the light-emitting-element, preferably Al, Ag and so on. When it is covered by a dielectric material, SiNx, SiO$_2$ and so on formed by any of various CVD processes are desirable.

In view of having both functions of current introduction and of heat dissipation after completion of an element, the support preferably has an electrode interconnection for current input on a base material, and the part on the electrode interconnection where a device is mounted preferably has an adhesion layer for bonding of the support to a device as appropriate. Here, the adhesion layer may be formed using an Ag-containing paste, a metal bump or the like, and it is very preferably made of a metal solder in the light of heat dissipating properties. A metal solder can allow for flip-chip mounting with significantly excellent heat dissipating properties in comparison with an Ag-containing paste or a metal bump. Here, a metal solder may be a material such as In, InAg, InSn, SnAg, PbSn, AuSn, AuGe and AuSi. A high-melting solder such as AuSn, AuSi and AuGe is more preferred. This is because a temperature of an area near the solder material is increased to about 200 °C when introducing a large current for ultrahigh power driving of a light-emitting-element, and thus as a solder material, preferred is a metal solder having a melting point higher than an element temperature during driving. In some cases, it is preferable that bonding is formed using a bump whose periphery is filled with a metal solder material for canceling height difference in an element during flip-chip mount mounting.

Generally, an element is separated by dividing the support as described later and thus, it is preferable that in a completed light-emitting-element, there is a separation region without a metal interconnection at the periphery of the support 40. As shown in FIG. 5-5, when a width of a region without a metal interconnection is $L_{WSPT2}$ (in FIG. 5-5, those in the left and the right sides are represented by $L_{WSPT2(left)}$ and $L_{WSPT2(right)}$, respectively), $L_{WSPT2}$ may be more than 0 in a completed element, but as described below, a preferable range varies depending on a method employed for a separation process.

For separation by scribing, it is generally 10 $\mu$m or more, preferably 15 $\mu$m or more. In a separation region 47, $2L_{WSPT2}$ is, therefore, preferably 30 $\mu$m or more. Since an excessively large value is not meaningful, $2L_{WSPT2}$ is generally 300 $\mu$m or less, preferably 200 $\mu$m or less.

For separation by dicing, $L_{WSPT2}$ is generally 100 $\mu$m or more, preferably 500 $\mu$m or more. As a separation region 47, $2L_{WSPT2}$ is, therefore, preferably 1000 $\mu$m or more. Since an excessively large value is not meaningful, $2L_{WSPT2}$ is generally 2000 $\mu$m or less, preferably 1500 $\mu$m or less.

An embodiment where a support is not divided may be feasible; for example, a plurality of light-emitting-elements may be mounted on one support. By deliberately varying metal interconnections over the support, the light-emitting-elements on one support can be connected in parallel, in series or in combination of these.

Manufacturing process for a light-emitting-element disclosed in Section E

Next, there will be described a process for manufacturing a semiconductor light-emitting-element according to the invention disclosed in this Section.

Manufacturing process for the light-emitting-element of the first aspect

In a example of a manufacturing process, as shown in FIG. 5-7, first a substrate 21 is provided and over the surface are sequentially deposited a buffer layer 22, a first-conductivity-type cladding layer 24, an active layer structure 25 and a second-conductivity-type cladding layer 26 by thin-film crystal growth. MOCVD is preferably employed. However, it is possible to use MBE, PLD, PED, VPE, LPE and the like for forming all or some of the thin-film crystal layers. A configuration of these layers can be appropriately changed, depending on, for example, an application of the element. After forming thin-film crystal layers, a variety of processings are allowed. As used herein, the term "thin-film crystal growth" includes heat-treatment after growing a thin-film crystal layer.

For providing the configuration shown in FIGs. 5-1A to 5-2 after growing thin-film crystal layers in the present invention, it is preferable that a second-conductivity-type-side electrode 27 is formed as shown in FIG. 5-7. That is, it is preferable that scheduled formation of the second-conductivity-type-side electrode 27 in the second current injection region 35 is conducted before formation of an insulating layer 30, formation of a first current injection region 36 and formation of a first-conductivity-type-side electrode 28. This is because when the second-conductivity-type is p-type as a desirable embodiment, formation of a p-side electrode after processing the exposed surface of the p-type cladding layer by various processes leads to reduction of a hole concentration in the p-GaN cladding layer with a relatively lower activation rate among GaN materials, due to process damage. For example, if the step of forming an insulating layer by p-CVD is conducted before forming the second-conductivity-type-side electrode, plasma damage remains in its surface. Thus, in the present invention, it is desirable that after thin-film crystal growth, formation of the second-conductivity-type-side electrode is conducted before any of the other process steps (for example, a first etching step, a second etching step or the step of forming an insulating layer, the step of forming an exposed part in a second-conductivity-type-side electrode, the step of forming a first current injection region and the step of forming a first-conductivity-type-side electrode as described later).

In the present invention, when the second-conductivity-type is p-type and when the exposed surface is a relatively stable metal such as Au (in a typical example, the surface of the second-conductivity-type-side electrode is expected to be Au as described above), the surface is not likely process-damaged through the subsequent processes. In this respect, it is again desirable in the present invention that after thin-film crystal growth, formation of the second-conductivity-type-side electrode is conducted before any other process step.

In the present invention, when a layer in which the second-conductivity-type-side electrode is formed is the second-conductivity-type contact layer, process damage to the second-conductivity-type semiconductor layer can be reduced in the same manner.

The second-conductivity-type-side electrode 27 can be formed by applying a variety of deposition processes such as sputtering, vacuum evaporation and plating, and a desired shape can be obtained by appropriately applying, for example, a lift-off process using photolithography technique or site-selective evaporation using, for example, a metal mask.

After forming the second-conductivity-type-side electrode 27, a part of the first-conductivity-type cladding layer 24 is exposed as shown in FIG. 5-8. In this step, it is preferable to remove the second-conductivity-type cladding layer 26, the active layer structure 25 and further a part of the first-conductivity-type cladding layer 24 by etching (a first etching step). The first etching step is conducted for the purpose of exposing a semiconductor layer into which a first-conductivity-type-side electrode described later injects first-conductivity-type carriers, and therefore, when a thin-film crystal layer contains another layer, for example, a cladding layer consists of two layers or contains a contact layer, the layer including the additional layer may be etched.

The first etching step does not require very high etching precision and thus can be a known dry etching technique by plasma etching using, for example, $Cl_2$ and using a etching mask of a nitride such as $SiN_x$ or an oxide such as $SiO_x$. It is, however, also preferable that dry etching can be conducted using a metal fluoride mask as detailed in a second etching step described later. It is particularly preferable to conduct etching by plasma excited dry etching using a gas such as $Cl_2$, $SiCl_4$, $BCl_3$ and $SiCl_4$ and using an etching mask containing a metal-fluoride layer selected from the group consisting of $SrF_2$, $AlF_3$, $MgF_2$, $BaF_2$, $CaF_2$ and combinations of these. Furthermore, the optimal dry etching is ICP type dry etching capable of generating high density plasma.

Here, the second-conductivity-type-side electrode 27 receives process history of the formation of a $SiN_x$ mask formed by, for example, plasma CVD or the step of removing the $SiN_x$ mask after the first etching step. However, when a stable metal such as Au is formed over the surface, the second-conductivity-type-side electrode is less process-damaged.

Then, as shown in FIG. 5-9, a light-emitting-element separation-trench 13 is formed by a second etching step. In the present invention, it is necessary that the light-emitting-element separation-trench is formed such that it interrupts at least the first-conductivity-type cladding layer, and in this embodiment, the light-emitting-element separation-trench 13 is formed such that it reaches the substrate 21. Here, when diamond scribing is conducted from the side where the thin-film crystal layers have been formed in the steps of scribing and breaking for device separation, detachment of a GaN material on the sapphire substrate can be inhibited. Furthermore, it is advantageous that when laser scribing is conducted, thin-film crystal layers are not damaged. Furthermore, it is also preferable that the light-emitting-element separation-trench is formed by conducting etching into a part of the sapphire substrate (same for other substrates such as GaN).

Alternatively, a configuration where the light-emitting-element separation-trench does not reach the substrate is also preferable. For example, when the light-emitting-element separation-trench is formed to the intermediate portion of the buffer layer, an insulating layer can be formed on the sidewall of the first-conductivity-type cladding layer, to maintain insulation to a running-around solder (see FIG. 5-2 for a configuration after completion of the light-emitting-element). Here, a trench bottom surface is formed in the intermediate portion of the buffer layer and becomes an edge-step-face at the end of the light-emitting-element. The trench bottom surface is a plane having irregularity which can be formed by etching. Since the trench bottom surface is subjected to processing such as scribing during element separation, an edge-step-face after element separation is often relatively lower in flatness as a plane and parallelity to a layer direction. Furthermore, a layer exposed from the sidewall without being covered by the insulating layer is preferably highly insulative.

In the second etching step, the GaN material must be etched to more depth compared with the first etching step. The sum of a layer depth etched by the first etching step is generally about 0.5 $\mu$m while in the second etching step, the depth is sometimes 3 to 7 $\mu$m, 3 to 10 $\mu$m or more than 10 $\mu$m because the whole first-conductivity-type cladding layer 24 and at least a part or sometimes the whole of the buffer layer 22 must be etched.

Generally, a metal mask, a nitride mask such as $SiN_x$ and an oxide mask such as $SiO_x$ have a selectivity ratio to a GaN material, in terms of tolerance to etching by $Cl_2$ plasma, of about 5. In conducting the second etching step where a GaN material with a large film thickness must be etched, a relatively thicker $SiN_x$ film is necessary. For example, etching a GaN material with a thickness of 10 $\mu$m by a second dry-etching process requires a $SiN_x$ mask with a thickness of 2 $\mu$m. However, with a $SiN_x$ mask with such a thickness, the $SiN_x$ mask is also etched during the dry etching, and not only its thickness in a longitudinal direction but also its shape in a horizontal direction are changed, so that a desired GaN material part cannot be selectively etched.

Thus, when forming the light-emitting-element separation-trench in the second etching step, dry etching using a mask including a metal-fluoride layer is preferred. A material constituting the metal-fluoride layer is preferably $MgF_2$, $CaF_2$, $SrF_2$, $BaF_2$ or $AlF_3$, most preferably $SrF_2$ in the light of balance between dry etching tolerance and wet-etching properties.

A metal fluoride film must be sufficiently tolerant to dry etching in the first and the second etching steps while being easily etched by etching for patterning (preferably, wet etching) to give a patterning shape with good linearity particularly in the sidewall. Deposition of a metal-fluoride layer at a temperature of 150 ° C or higher gives a dense film having good adhesiveness to a base layer, and the film after patterned by etching shows good linearity in a mask sidewall. A deposition temperature is preferably 250 °C or higher, further preferably 300 °C or higher, most preferably 350 ° C or higher. Particularly, a metal-fluoride layer deposited at 350 °C or higher exhibits good adhesiveness to any type of base layer and gives a fine film which is highly tolerant to dry etching and exhibits quite higher linearity in its sidewall in terms of a patterning shape, ensuring controllability to a width of the opening, and thus it is the most preferable as an etching mask.

Thus, although deposition at a high temperature is preferable for providing an etching mask exhibiting good adhesiveness to a base layer, giving a fine film, being highly tolerant to dry etching and exhibiting very high linearity in its sidewall and very high controllability of a width of the opening in terms of a patterning shape, a too high deposition temperature gives a film having excessive tolerance to wet etching using, for example, hydrochloric acid preferably used for patterning a metal fluoride, and thus the film cannot be easily removed. Particularly, when a mask such as $SrF_2$ is exposed to plasma such as chlorine plasma during dry etching of a semiconductor layer, an etching rate in a later process for removing the mask layer tends to be reduced in comparison with that before exposure to plasma such as chlorine plasma. Therefore, deposition of a metal fluoride at an excessively higher temperature is undesirable in the light of its patterning and final removal.

First, in a metal fluoride before being exposed to plasma in dry etching of a semiconductor layer, a layer deposited at a lower temperature has a larger etching rate to an etchant such as hydrochloric acid, resulting in a higher etching rate and a layer deposited at a higher temperature has a smaller etching rate, resulting in a lower etching rate. When deposition temperature becomes 300 °C or higher, the etching rate decreases noticeably in comparison with a film deposited at a temperature of about 250 °C, and a temperature of about 350 ° C to 450 ° C is within a very favorable etching rate range. A deposition temperature of higher than 480 ° C, however, leads to an excessively smaller absolute etching rate value, so that patterning of the metal fluoride takes a too longer time and patterning may be difficult under the conditions where a resist mask layer and so on are not detached. Furthermore, in a metal fluoride after being exposed to plasma in dry etching of a semiconductor layer, a wet-etching rate by, for example, hydrochloric acid in a removal step tends to decrease and growth at an excessively high temperature makes it difficult to remove the metal fluoride.

From such a viewpoint, a deposition temperature of a metal-fluoride layer is preferably 480 °C or lower, further preferably 470 °C or lower, particularly preferably 460 ° C or lower.

Using a mask patterned considering the above (the mask may be a multilayer with $SiN_x$ or $SiO_2$ such that the metal-fluoride layer becomes a surface layer), dry etching is conducted. A gas species for the dry etching may be preferably selected from $Cl_2$, $BCl_3$, $SiCl_4$, $CCl_4$ and combinations of these. In the dry etching, a selectivity ratio of the $SrF_2$ mask to a GaN material is over 100, so that a thick GaN film can be easily and precisely etched. Furthermore, the optimal dry etching technique is ICP type dry etching capable of generating high-density plasma.

After the above etching, when the used unnecessary metal-fluoride layer mask is removed by an etchant such as hydrochloric acid, a multilayer mask with $SiN_x$, $SiO_2$ or the like may be formed such that the metal-fluoride layer becomes a surface layer if a material susceptible to an acid is present under the metal fluoride mask, for example, if an electrode material is susceptible to an acid. In such a case, $SiN_x$ or $SiO_2$ may be present in the whole region under the metal fluoride mask or alternatively, as shown, for example, in FIG. 5-19, a mask 51 such as $SiN_x$ and $SiO_2$ is not necessarily present in the whole region of the metal fluoride mask layer 52 but can be at least formed over a material susceptible to an acid.

By such a second etching step, the light-emitting-element separation-trench 13 is formed as shown in FIG. 5-9.

Regarding the first etching step and the second etching step, either step can be carried out before or after another step. It is also preferable for simplifying a process that the first etching step is first conducted and then without removing the etching mask, the second etching step is conducted. As shown in FIG. 5-19, first, a first etching mask 51 is formed from a material resistant to an acid such as $SiN_x$ and $SiO_2$ (preferably $SiN_x$) and etching is conducted such that a first-conductivity-type cladding layer 24 appears, and without removing the mask 51, a metal-fluoride layer is formed as a second etching mask 52. Then, preferably, after conducting the second etching step, the mask 52 is removed by an acid and then the mask 51 is removed as appropriate.

When the narrowest width between the light-emitting-element separation-trenches formed is $2L_{WSPT1}$, $L_{WSPT1}$ is preferably 20 $\mu$m or more, for example 30 $\mu$m or more for element separation by breaking. For separation by dicing,

$L_{WSPT1}$ is preferably 300 $\mu$m or more. Since an excessively large width is not correspondingly effective, $L_{WSPT1}$ is generally 2000 $\mu$m or less. These are needed for ensuring a margin for an element manufacturing process and a scribe region.

A "setback-sidewall-surface" as defined in the present invention is a sidewall surface appearing as a sidewall in the second etching step, that is, during forming the light-emitting-element separation-trench, but not a wall surface appearing after the first etching alone.

After the second etching step, an insulating layer 30 is formed as shown in FIG. 5-10. The insulating layer may be appropriately made of any material as long as electric insulation can be ensured, as detailed above. Deposition can be conducted by any known method such as plasma CVD.

Next, as shown in FIG. 5-11, a predetermined part in the insulating layer 30 is removed, to form a second-conductivity-type-side electrode exposed part 37 where the insulating layer on the second-conductivity-type-side electrode 27 is removed, a first current injection region 36 where the insulating layer on the first-conductivity-type cladding layer is removed, and a region without an insulating layer 15 where the insulating layer on the substrate and the sidewall within the light-emitting-element separation-trench 13 is removed.

Removal of the insulating layer 30 on the second-conductivity-type-side electrode 27 is conducted such that the periphery of the second-conductivity-type-side electrode is covered by the insulating layer. That is, the surface area of the second-conductivity-type-side electrode exposed part is smaller than the area of the second current injection region. Here, for ensuring a margin for an element manufacturing process, particularly a photolithography step or preventing unintended short circuit from occurring due to a solder material, the narrowest width ($L_{2w}$) in the part where the second-conductivity-type-side electrode is partly covered by the insulating layer is preferably 15 $\mu$m or more as described above. More preferably, it is 100 $\mu$m or more. In particular, covering the wide area of the second-conductivity-type-side electrode by the insulating layer allows for reducing unintended short circuit due to a metal solder material, with an another part such as the first-conductivity-type-side electrode.

For removing the insulating layer, an etching procedure such as dry etching and wet etching may be selected, depending on a material selected. For example, when the insulating layer is a single layer of $SiN_x$, dry etching using a gas such as $SF_6$ or wet etching using a hydrofluoric acid etchant can be employed. When the insulating layer is a dielectric multilayer film made of $SiO_x$ and $TiO_x$, the multilayer film in a desired part can be removed by Ar-ion milling.

The second-conductivity-type-side electrode exposed part 37, the first current injection region 36 and the part without an insulating layer 15 can be separately formed. But they are, in general, simultaneously formed by etching.

In order to form the part without an insulating layer 15 by etching the insulating film on the sidewall near the substrate in the light-emitting-element separation-trench, the following process may be used as a formation process. First, a resist mask having an opening whose area is equal to or slightly smaller than the area of the light-emitting-element separation-trench 13 is formed by photolithography, and then, wet etching is conducted using an etchant capable of etching an insulating layer, to initiate removal of the insulating layer on the substrate surface within the light-emitting-element separation-trench. If the etching is further continued, side etching proceeds to remove the insulating layer covering the substrate side of the trench sidewall by the wet etchant and thus to give a shape as shown in FIG. 5-11 wherein an insulating layer of the sidewall is not present in the portion of the substrate side. In the case that the insulating layer is removed as this case, the exposed sidewall without an insulating layer is preferably sidewall of undoped layer. This is because it prevents unintended electric short circuit from occurring even if a solder for bonding to a support attaches to the sidewall during flip-chip mounting. The shape of the removed insulating layer of this type is advantageous for the process particularly when the substrate is removed in the manufacturing process for a light-emitting-element, because unintended defects such as detachment of an insulating layer with the substrate is prevented

Then, a first-conductivity-type-side electrode 28 is formed as shown in FIG. 5-12. The present invention is characterized in that the first-conductivity-type-side electrode is formed to have the larger area than the first current injection region and that the first-conductivity-type-side electrode and the second-conductivity-type-side electrode do not spatially overlap at all. This is important for ensuring an adequate area to ensure adequate bonding to a support during flip-chip mounting of this element by soldering, and for ensuring an adequate distance for preventing unintended short circuit due to, for example, a solder material between the second-conductivity-type-side electrode and first-conductivity-type-side electrode. The narrowest width ($L_{1w}$) of the part where the first-conductivity-type-side electrode is in contact with the insulating layer is established within the above-mentioned range. In general, the width of 5 $\mu$m or more can ensure a process margin for a photolithography process and a liftoff method.

An electrode material preferably comprises, as described above, a material selected from Ti, Al, Ag and Mo or all of them as a constituent element when the first-conductivity-type is n-type. Generally, Al is exposed in a direction opposing to a main light-extraction direction of the n-side electrode.

The electrode material can be deposited by applying a variety of deposition processes such as sputtering, vacuum evaporation and plating, and an electrode shape can be obtained by appropriately applying, for example, a lift-off process using photolithography technique or site-selective evaporation using, for example, a metal mask.

The first-conductivity-type-side electrode is formed in this example such that a part thereof contacts with the first-conductivity-type cladding layer, but can be formed to contact with, in case formed, a first-conductivity-type-side contact layer.

In this manufacturing process, the first-conductivity-type-side electrode is formed in the final step of forming a stacked structure, which is advantageous in the light of reducing process damage. When the first-conductivity-type is n-type, Al is formed on the surface of the electrode material of the n-side electrode in a preferred embodiment. Here, if the n-side electrode is formed before formation of an insulating layer as the second-conductivity-type-side electrode, the n-side electrode surface, that is, Al metal receives a history of the etching process of the insulating layer. Etching of the insulating layer is conveniently conducted by wet etching using a hydrofluoric acid etchant as described above, but Al is less tolerant to various etchants including hydrofluoric acid, so that when effectively conducting such a process, the electrode itself is damaged. Furthermore, even if dry etching is employed, Al is relatively reactive, so that damages including oxidation may be introduced. Therefore, in the present invention, it is effective in reducing damage to the electrode that the first-conductivity-type-side electrode is formed after forming the insulating layer and after removing a predetermined unnecessary part in the insulating layer.

Thus, after forming the structure of FIG. 5-12, there is carried out a preparation for substrate removal. Generally, the structure shown in FIG. 5-12 is first bonded to the support 40 as the whole or a part of the wafer. This is because since even the thin-film crystal layers as a whole has at most a thickness of about 15 μm, once the substrate is removed mechanical strength is insufficient, resulting that it cannot tolerate the later processes by itself. A material for the support is as described above.

As shown in FIG. 5-13, the structure is mounted on a metal layer 41 (for example, an electrode interconnection) on a support 40, for example, via connection with a metal solder 42.

Here, in the light-emitting-element of the present invention, the second-conductivity-type-side electrode 27 and the first-conductivity-type-side electrode 28 are disposed such that they are not spatially overlapped at all and the first-conductivity-type-side electrode is larger than the first current injection region and preferably has an adequate area to ensure both prevention of unintended short circuit and improved heat dissipating properties. Furthermore, since the sidewalls of the other thin-film crystal layers are covered by an insulating film except a part of the buffer layer, particularly the undoped part, running out of a solder does not cause a problem such as short circuit in an active layer structure sidewall within the thin-film crystal layer.

Subsequently, the element is bonded to the support and then the substrate is removed. Removal of the substrate can be conducted by any method such as polishing, etching and laser debonding. When polishing a sapphire substrate, the substrate can be removed using a polishing material such as diamond. A substrate can be removed by dry etching. Furthermore, for example, when the substrate is sapphire and a thin-film crystal growth part is made of an InAlGaN material, laser debonding can be employed by using a KrF excimer laser from the sapphire substrate side at 248 nm which penetrates the sapphire substrate and is absorbed by, for example, GaN used for a buffer layer, to decompose GaN in a part of the buffer layer into metal Ga and nitrogen and delaminate the substrate. FIG. 5-14 schematically shows the stage when the substrate 21 has been delaminated by laser debonding.

When using ZnO, ScAlMgO$_4$ or the like as a substrate, an etchant such as HCl can be used in wet etching to remove the substrate.

Since the substrate is not in contact with the insulating layer at all in the invention disclosed in this Section, removal of the substrate does not secondarily cause a problem such as detachment of the insulating layer.

Then, as shown in FIG. 5-14, in a separation region 47 corresponding to the area where the light-emitting-element separation-trench is present, the light-emitting-element is separated together with the support to provide a single light-emitting-element. Here, it is preferable that a metal interconnection is not present in the separation region of the support. This is because a metal interconnection in the region makes inter-device separation difficult.

Cutting of the separation region in the support can be conducted by an appropriate process such as dicing, scribing and breaking depending on a base material. When the light-emitting-element separation-trench is formed to the intermediate portion of the buffer layer, scratching by diamond scribing or partial ablation of the buffer layer by laser scribing can be conducted using the light-emitting-element separation-trench to easily separate between light-emitting-elements in the thin-film crystal growth layer. Then, the support can be separated into individual light-emitting-elements by dicing. Optionally, separation between light-emitting-elements can be conducted by simultaneous separation of the thin-film crystal growth layer and the support by dicing.

As described above, the light-emitting-elements of the first aspect shown in FIGs. 5-1A to 5-2 are provided.

Manufacturing process for the light - emitting- element of the second aspect

For manufacturing the light-emitting-element shown in FIG. 5-3A, etching is stopped in the intermediate portion of the buffer layer during forming the light-emitting-element separation-trench in the description of the manufacturing process according to the first aspect. Likewise, an insulating layer 30 is formed and when the insulating layer is etched, the insulating layer is removed from a region including the center of the light-emitting-element separation-trench to form a scribe region as shown in FIGs. 5-4B. In the first aspect, the whole insulating layer over the trench bottom surface is removed, while in this aspect, the layer remains in the trench bottom surface and side etching is not conducted deliberately. A width of the scribe region 14 can be selected to give a predetermined $L_{ws}$ as described above. The subsequent process is conducted as described in the first aspect, to provide the light-emitting-element shown in FIG. 5-3A.

Commonly to the first and the second aspects, in this manufacturing process, it is preferable as described above to conduct formation of the thin-film crystal layer, formation of the second-conductivity-type-side electrode, the etching steps (the first etching step and the second etching step), formation of the insulating layer, removal of the insulating layer (formation of the second-conductivity-type-side electrode exposed part, formation of the first current injection region and formation of the scribe region) and formation of the first-conductivity-type-side electrode, in this sequence. Such a process sequence allows for providing a light-emitting-element without damage in the thin-film crystal layer immediately below the second-conductivity-type-side electrode or damage in the first-conductivity-type-side electrode. Furthermore, the device shape reflects the process flow. In other words, the light-emitting-element internally has a structure where there are deposited the second-conductivity-type-side electrode, the insulating layer and the first-conductivity-type-side electrode in this sequence. That is, the second-conductivity-type-side electrode is in contact with the second-conductivity-type cladding layer (or another second-conductivity-type thin-film crystal layer) without an intervening insulating layer; there is a part of the upper periphery of the second-conductivity-type-side electrode which is covered by an insulating layer; and there is an area where an electrode periphery is intervened by an insulating layer between the first-conductivity-type-side electrode and the first-conductivity-type-side cladding layer (or another first-conductivity-type thin-film crystal layer).

<u>\<\<Section F\>\></u>

The invention disclosed in Section F relates to the followings.
[1] A process for manufacturing a light-emitting-element, comprising
step (a): depositing a buffer layer on a substrate;
step (b): depositing a thin-film crystal layer having at least a first-conductivity-type semiconductor layer containing a first-conductivity-type cladding layer, an active layer structure and a second-conductivity-type semiconductor layer containing a second-conductivity-type cladding layer, in this order from the side of the substrate;
step (c): forming a second-conductivity-type-side electrode on the surface of the second-conductivity-type semiconductor layer;
first etching step (d): etching a part of the region where the second-conductivity-type-side electrode is not formed, to expose a part of the first-conductivity-type semiconductor layer;
second etching step (e): for forming a light-emitting-element separation-trench separating adjacent light-emitting-elements, etching a part of the region where the second-conductivity-type-side electrode is not formed, from its surface, to such a depth (i) that at least a part of the buffer layer is removed or (ii) that the etching reaches at least the substrate, whereby forming the light-emitting-element separation-trench;
step (f): forming an insulating layer on the whole surface including the second-conductivity-type-side electrode, a first-conductivity-type semiconductor layer exposed by the first etching step and the inside of the light-emitting-element separation-trench;
step (g): removing the insulating layer in a region including at least the trench center of the trench bottom surface in the light-emitting-element separation-trench,
step (h): removing a part of the insulating layer formed on the first-conductivity-type semiconductor layer to form an opening to be a first current injection region,
step (i): removing a part of the insulating layer formed on the surface of the second-conductivity-type-side electrode to expose a part of the second-conductivity-type-side electrode, and
step (j): forming a first-conductivity-type-side electrode in contact with the first current injection region opened in step (h).

[2] The process as described in [1], wherein step (g) comprises removing the insulating layer in the region including only the trench center on the trench bottom surface in the light-emitting-element separation-trench, while leaving the insulating layer formed in the sidewall of the light-emitting-element separation-trench.
[3] The process as described in [1], wherein step (g) comprises removing the whole insulating layer formed on the trench bottom surface within the light-emitting-element separation-trench and at least a portion near the trench bottom surface, of the insulating layer formed on the sidewall within the light-emitting-element separation-trench.
[4] The process as described in any of [1] to [3], wherein a layer constituting the plane exposed after removing the insulating layer is of an undoped type.

[5] The process as described in any of [1] to [4], after step (j), further comprising steps of:

separating the substrate into elements along the light-emitting-element separation-trench; and
bonding the first-conductivity-type-side electrode and the second-conductivity-type-side electrode to a metal layer on the submount.

[6] The process as described in any of [1] to [4], after step (j), further comprising steps of:

bonding the first-conductivity-type-side electrode and the second-conductivity-type-side electrode to a metal layer on the support for their mounting on the support;
removing the substrate; and
dividing the support for element separation,
with the proviso that the process does not include the case in which, in step (e), etching is carried our to reach the substrate and, in step (g), the insulating layer is removed in a region including only the trench center of the trench bottom surface in the light-emitting-element separation-trench.

[7] The process as described in any of [1] to [6], wherein the buffer layer is formed as a part of the thin-film crystal layer before forming the first-conductivity-type semiconductor layer.

[8] The process as described in any of [1] to [7], wherein, in the step (j), the first-conductivity-type-side electrode is formed so that the narrowest width $L_{1w}$ of a part where the first-conductivity-type-side electrode is contacting the insulating layer is 5 $\mu$m or more.

[9] The process as described in any of [1] to [8], wherein, in the step (i), a part of the second-conductivity-type-side electrode is exposed so that the narrowest width $L_{2w}$ of a part where the second-conductivity-type-side electrode is covered by the insulating layer is 15 $\mu$m or more.

[10] The process as described in [9], wherein the $L_{2w}$ is 30 $\mu$m or more.

[11] The process as described in any of [1] to [11], wherein the first-conductivity-type-side electrode comprises a layer made of material containing an element selected from the group consisting of Ti, Al, Ag, Mo and a combination of two or more of these.

[12] The process as described in any of [1] to [11], wherein the second-conductivity-type-side electrode comprises a layer made of material containing an element selected from the group consisting of Ni, Pt, Pd, Mo, Au and a combination of two or more of these.

[13] The process as described in any of [1] to [12], wherein the insulating layer is a single layer of material selected from the group consisting of $SiO_x$, $AlO_x$, $TiO_x$, $TaO_x$, $HfO_x$, $ZrO_x$, $SiN_x$, $AlN_x$, $AlF_x$, $BaF_x$, $CaF_x$, $SrF_x$ and $MgF_x$.

[14] The process as described in any of [1] to [13], wherein the insulating layer is a dielectric multilayer film consisting of multiple layers.

[15] The process as described in [14], wherein at least one of the layers constituting the insulating layer is made of material containing fluoride.

[16] The process as described in [15], wherein the fluoride is selected from the group consisting of $AlF_x$, $BaF_x$, $CaF_x$, $SrF_x$ and $MgF_x$.

[17] The process as described in any of [1] to [16], wherein when R2 is a reflectance of reflection by the buffer layer, of a light having an emission wavelength of the light-emitting-element vertically incoming from the first-conductivity-type semiconductor layer side to the buffer layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

(Relation 1) R2 < R12
(Relation 2) R2 < R11
(Relation 3) R2 < R1q

are satisfied.

[18] The process as described in any of [1] to [17], wherein the thin-film crystal layer is formed on the substrate selected from the group consisting of sapphire, SiC, GaN, $LiGaO_2$, ZnO, $ScAlMgO_4$, $NdGaO_3$ and MgO.

[19] The process as described in any of [1] to [18], wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

[20] The process as described in any of [1] to [19], wherein the active layer structure consists of quantum well layer and barrier layer and when B is the number of the barrier layer and W is the number of the quantum well layer, B and W satisfy the relation:

B = W+1.

[21] The process as described in any of [1] to [20], wherein the first-conductivity-type is n-type and the second-conductivity-type is p-type.

[22] The process as described in [5], wherein the first-conductivity-type-side electrode and the second-conductivity-type-side electrode are bonded to the submount having a metal layer via a solder.

[23] The process as described in [6], wherein the first-conductivity-type-side electrode and the second-conductivity-type-side electrode are bonded to the support having a metal layer via a solder.

[24] The process as described in [22] or [23], wherein bonding between each of the first-conductivity-type-side electrode and the second-conductivity-type-side electrode and the metal layer on the support is formed by a metal solder alone, or a metal solder and a metal bump.

[25] The process as described in any of [22] to [24], wherein the base material of the support is selected from the group consisting of AlN, $Al_2O_3$, Si, glass, SiC, diamond, BN and CuW.

[26] The process as described in any of [22] to [25], wherein the metal layer is not formed in a device-separating part in the support.

[27] The process as described in [5], wherein the surface of the light-extraction side of the substrate is not flat.

[28] The process as described in [6], wherein the surface of the light-extraction side of the buffer layer is not flat.

[29] The process as described in any of [5], wherein when R3 is a reflectance of reflection by the substrate, of a light having an emission wavelength of the light-emitting-element vertically incoming from the buffer layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

R4 < R3

is satisfied.

[30] The process as described in any of [6], wherein when R3 is a reflectance of reflection by the buffer layer, of a light having an emission wavelength of the light-emitting-element vertically incoming from the first-conductivity-type semiconductor layer to the buffer layer side and R4 is a reflectance of reflection by an interface with a space, of a light having an emission wavelength of the light-emitting-element vertically incoming from the buffer layer to the space of the light-extraction side, a low-reflecting optical film is formed in the light-extraction side of the buffer layer such that the relation:

R4 < R3

is satisfied.

[31] The process as described in any of [1] to [30], wherein the substrate is GaN and the whole buffer layer is formed from GaN at a temperature of 900 ° C or higher.

According to the invention disclosed in this Section, there can be provided process for manufacturing a flip-chip mount type semiconductor light-emitting-element capable of emitting blue or ultraviolet light with higher output and higher efficiency.

In the process of the present invention disclosed in this Section, process damage in each step in the manufacturing process is eliminated, so that a highly reliable element can be manufactured without deterioration in the functions of the light-emitting-element.

Description of embodiments of the invention of Section E

According to the manufacturing process of Section E, the light-emitting-elements disclosed in Sections D and E can be manufactured. This manufacturing process has steps (a) to (j), whose order is shown in the flow chart of FIG. 6-4. In the invention disclosed in this Section, steps (a), (b) and (c) are conducted in this sequence. Steps (d) and (e) are conducted after step (c), but steps (d) and (e) can be conducted in any order. Then, after step (f), steps (g), (h) and (i) can be conducted in any order. Alternatively, steps (g), (h) and (i) may be conducted simultaneously. Then, step (j) is conducted.

In case that the substrate used for thin-film crystal growth is removed, i.e. in the case the light-emitting-elements disclosed in Section E is manufactured, this step is conduced after step (j).

The specific contents of each step are as described in Sections D and E, and Section C encompasses the whole contents. However, in the light-emitting-element disclosed in Section D, the buffer layer has an arbitrary configuration and, therefore, the step of buffer layer deposition is omitted when a light-emitting-element without a buffer layer is prepared.

Furthermore, because of difference in steps (e) and (g), shape of the element edge and shapes of insulating film at trench bottom surface and sidewall surface are different.

Example

There will be described the present invention with reference to examples. Materials, amounts, proportions, specific processes and process orders in the following examples may be appropriately modified without departing from the scope of the invention. The scope of this invention should not be interpreted to be limited to the specific examples described below. Furthermore, in the drawings referred in the following examples, some sizes are deliberately changed to help understanding the structures, but practical dimensions are as indicated in the following description.

Examples of the invention in relation to Section A

Example A-1

The light-emitting-element shown in FIG. 1-11 was manufactured by the following procedure. FIGs. 1-5 to 10 will be referred to as a related process drawing.

First was prepared a c+ plane sapphire substrate 21 with a thickness of 430 $\mu$m, on which an undoped GaN layer with a thickness of 10 nm was formed by growing at a low temperature by MOCVD as a first buffer layer 22a; and then an undoped GaN layer with a thickness of 0.5 $\mu$m and a Si-doped (Si concentration: $7 \times 10^{17}$ cm$^{-3}$) GaN layer with a thickness of 0.5 $\mu$m were deposited at 1040 °C as a second buffer layer 22b with a thickness of 1 $\mu$m. Subsequently, an undoped GaN layer with a thickness of 3.5 $\mu$m was formed at 1035 °C as a light-uniforming layer 23.

Then, a Si-doped (Si concentration: $1 \times 10^{18}$ cm$^{-3}$) GaN layer was formed to 2 $\mu$m as a first-conductivity-type (n-type) second cladding layer 24b; a Si-doped (Si concentration: $2 \times 10^{18}$ cm$^{-3}$) GaN layer was formed to 0.5 $\mu$m as a first-conductivity-type (n-type) contact layer 24c; and then a Si-doped (Si concentration: $1.5 \times 10^{18}$ cm$^{-3}$) Al$_{0.15}$Ga$_{0.85}$N layer was formed to 0.1 $\mu$m as a first-conductivity-type (n-type) first cladding layer 24a. Then, an active layer structure 25 was formed by depositing alternately undoped GaN layer to a thickness of 13 nm at 850 °C as a barrier layer and undoped In$_{0.1}$Ga$_{0.9}$N layer to a thickness of 2 nm at 720 °C as a quantum well layer such that five quantum well layers were formed in total and both sides were the barrier layers. Then, after increasing a growth temperature to 1025 °C, a Mg-doped (Mg concentration $5 \times 10^{19}$ cm$^{-3}$) Al$_{0.15}$Ga$_{0.85}$N layer was formed to 0.1 $\mu$m as a second-conductivity-type (p-type) first cladding layer 26a. Subsequently, a Mg-doped (Mg concentration: $5 \times 10^{19}$ cm$^{-3}$) GaN layer was formed to 0.07 $\mu$m as a second-conductivity-type (p-type) second cladding layer 26b. Finally, a Mg-doped (Mg concentration: $1 \times 10^{20}$ cm$^{-3}$) GaN layer was formed to 0.03 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode in the wafer after the thin-film crystal growth, photolithography was used to prepare for patterning a p-side electrode 27 by lift-off technique and a resist pattern was formed. Here, Ni(thickness: 20 nm)/Au(thickness: 500 nm) was deposited by vacuum evaporation as a p-side electrode, and an unnecessary part was removed in acetone by lift-off technique. Then, after heating, a p-side electrode was prepared. The structure manufactured so far substantially corresponds to FIG. 1-5. So far, there was not a step causing a damage such as a plasma process in the p-side current injection region just under the p-side electrode.

Next, for conducting the first etching step, an etching mask was formed. Here, by p-CVD, SiN$_x$ was deposited to 0.4 $\mu$m over the whole wafer surface at a substrate temperature of 400 °C. Here, since Au was exposed in the p-side electrode surface, it was not deteriorated at all after the SiN$_x$ deposition process by p-CVD. Then, photolithography was again conducted for patterning the SiN$_x$ mask to prepare a SiN$_x$ etching mask. Here, the unnecessary part in the SiN$_x$ film was etched using SF$_6$ plasma by RIE, and the mask was left in a part where the thin-film crystal layer was not etched in the first etching step described later, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of InGaN quantum well layers and GaN barrier layers and the n-AlGaN first cladding layer 24a to the intermediate portion of the n-GaN contact layer 24c, to expose the n-type contact layer 24c which was to be an injection part for n-type carriers.

After the ICP plasma etching, the $SiN_x$ mask was completely removed using buffered hydrofluoric acid. Again, since Au was exposed in the p-side electrode surface, the p-side electrode was not deteriorated at all after the $SiN_x$ deposition process by p-CVD. The structure manufactured so far substantially corresponds to FIG. 1-6.

Next, for conducting the second etching step of forming a light-emitting-element separation-trench 13, a $SrF_2$ mask was formed over the whole wafer surface using vacuum evaporation. Then, the $SrF_2$ film in the region where a light-emitting-element separation-trench was to be formed was removed to form a mask for forming a light-emitting-element separation-trench on a thin-film crystal layer, that is, a $SrF_2$ mask for the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layers and the GaN barrier layers, the n-AlGaN first cladding layer 24a, the n-GaN contact layer 24c, the n-GaN second cladding layer 24b, the undoped GaN light-uniforming layer 23 and the undoped GaN buffer layer 22 in the part corresponding to the light-emitting-element separation-trench by ICP etching using $Cl_2$ gas. During this second etching step, the $SrF_2$ mask was substantially not etched. The light-emitting-element separation-trench 13 was formed to a width of 150 $\mu$m in good agreement with the width of the mask.

After forming the light-emitting-element separation-trench 13 by the second etching step, the used unnecessary $SrF_2$ mask was removed. Again, since Au was exposed in the p-side electrode surface, it was not deteriorated at all. The structure manufactured so far substantially corresponds to FIG. 1-7.

Next, over the whole wafer were sequentially formed $SiO_x$ and $SiN_x$ by p-CVD to form a dielectric multilayer film. Here, each of $SiN_x$ and $SiO_x$ was formed one by one to a thickness that is 1/4 as an optical wavelength to an emission wavelength of the element, so that it had a relatively higher reflectance to the emission wavelength. The structure manufactured so far substantially corresponds to FIG. 1-8.

Then, first, a resist mask was formed using photolithography technique for simultaneously forming a p-side electrode exposed part on the p-side electrode 27 made of Ni-Au, an n-side current injection region (36) on the n-side contact layer 24c and a scribe region 14 within the light-emitting-element separation-trench. Next, a hydrofluoric acid-containing etchant was used to remove the dielectric multilayer film (the insulating layer) in the part which was not covered by the resist mask. Here, the periphery of the p-side electrode 27 was covered by the insulating layer consisting of $SiO_x$ and $SiN_x$ to 150 $\mu$m. The scribe region was formed with a width of 100 $\mu$m (Lws in the element after separation was 50 $\mu$m).

Subsequently, the used unnecessary resist mask was removed by acetone and by ashing with oxygen plasma by RIE. Again, since Au was exposed in the p-side electrode surface, it was not deteriorated at all after the $SiN_x$ deposition process by p-CVD. The structure manufactured so far substantially corresponds to FIG. 1-9A.

Next, for forming an n-side electrode 28, photolithography was used to prepare for patterning an n-side electrode by lift-off technique and a resist pattern was formed. Here, Ti(thickness: 20 nm)/Al(thickness: 300 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its periphery contacted the insulating layer by 30 $\mu$m for having an area larger than the n-side current injection region and such that it did not overlap the p-side electrode 27, considering facilitation of flip chip bonding using a metal solder and heat dissipating properties. In another manufacturing example, it was formed so as to contact by 10 $\mu$m, and a light-emitting-element exhibiting performance comparable to this example was manufactured. An Al electrode tends to be deteriorated during, for example, a plasma process and is etched by, for example, hydrofluoric acid, but since the n-side electrode was formed in the final step of the element manufacturing process, it was not damaged at all. The structure manufactured so far substantially corresponds to FIG. 1-10.

Then, on the rear surface of the sapphire substrate was formed a low-reflecting optical film 45 made of $MgF_2$ by vacuum evaporation. Here, $MgF_2$ was deposited to 1/4 of an optical film thickness, giving a low-reflecting coating to an emission wavelength of the element.

Next, for dividing the individual light-emitting-elements formed over the wafer, a scribe line was formed from the thin-film crystal growth side in the inside of the light-emitting-element separation-trench 13 using a laser scriber. Then, along this scribe line, only the sapphire substrate and the $MgF_2$ low-reflecting optical film were broken to provide individual compound semiconductor light-emitting-elements. Here, no damages were introduced to the thin-film crystal layer and detachment of the dielectric film did not occur.

Then, this element was bonded to the metal layer 41 in the submount 40 using a metal solder 42, to provide the light-emitting-element shown in FIG. 1-11. Here, no defects such as unintended short circuit occurred in the element.

Example A-2

The light-emitting-element shown in FIG. 1-15 (similar to FIG. 1-2A) was manufactured as described below.

The process in Example A-1 was repeated to the stage where a dielectric multilayer film was formed over the whole wafer surface as an insulating layer (substantially corresponding to FIG. 1-8).

Then, a resist mask was formed using photolithography technique for simultaneously forming a p-side electrode exposed part on the p-side electrode 27 made of Ni-Au, forming an n-side current injection region 36 on the n-side contact layer 24c and removing portion of an insulating layer present near the substrate 21 on the sidewall of the undoped buffer layer within the light-emitting-element separation-trench. Next, a hydrofluoric acid containing etchant was used to remove the dielectric multilayer film (the insulating layer) which was not covered by the resist mask. Further, by the effect of side etching by hydrofluoric acid, the dielectric multilayer film (insulating layer) on the part of the sidewall of the undoped buffer layer 22 was also removed. Here, the periphery of the p-side electrode 27 was covered by the insulating layer consisting of $SiN_x$ and $SiO_x$ to 150 $\mu$m.

Subsequently, the unnecessary resist mask was removed by acetone and by ashing with oxygen plasma by RIE. Again, since Au was exposed in the p-side electrode surface, it was not deteriorated at all after the $SiN_x$ deposition process by p-CVD. The structure manufactured so far substantially corresponds to FIG. 1-9B.

Then, an n-side electrode 28 was formed as described in Example A-1. Then, on the rear surface of the sapphire substrate was formed a low-reflecting optical film 45 made of $MgF_2$ by vacuum evaporation. Here, $MgF_2$ was deposited to 1/4 of an optical film thickness, giving a low-reflecting coating to an emission wavelength of the element.

Next, for dividing the individual light-emitting-elements formed over the wafer, a scribe line was formed from the thin-film crystal growth side to the inside of the light-emitting-element separation-trench 13 using a laser scriber. Then, along this scribe line, only the sapphire substrate and the $MgF_2$ low-reflecting optical film were broken to provide individual light-emitting-elements. Here, no damages were introduced to the thin-film crystal layer and detachment of the dielectric film did not occur.

Then, this element was bonded to the metal layer 41 on the submount 40 using a metal solder 42, to provide the light-emitting-element shown in FIG. 1-15. Here, no defects such as unintended short circuit occurred in the element.

Examples A-3 and 4

The procedure in Examples A-1 and 2 was repeated, except that after depositing the light-uniforming layer 23, a thin-film crystal layer was deposited as described below. Specifically, an undoped GaN was formed at 1035 °C to a thickness of 3.5 $\mu$m as a light-uniforming layer 23 as described in Example A-1, and then a Si-doped (Si concentration: $5 \times 10^{18}$ cm$^{-3}$) GaN layer was formed to 4 $\mu$m as a first-conductivity-type (n-type) second cladding layer 24b; a Si-doped (Si concentration: $8 \times 10^{18}$ cm$^{-3}$) GaN layer was formed to 0.5 $\mu$m as a first-conductivity-type (n-type) contact layer 24c; and then a Si-doped (Si concentration: $5.0 \times 10^{18}$ cm$^{-3}$) $Al_{0.10}Ga_{0.90}N$ layer was formed to 0.1 $\mu$m as a first-conductivity-type (n-type) first cladding layer 24a. Then, an active layer structure 25 were formed by depositing alternately undoped GaN layer to a thickness of 13 nm at 850 °C as a barrier layer and undoped $In_{0.1}Ga_{0.9}N$ layer to a thickness of 2 nm at 720 °C as a quantum well layer such that eight quantum well layers were formed in total and both sides were the barrier layers. Then, after increasing a growth temperature to 1025 °C, a Mg-doped (Mg concentration $5 \times 10^{19}$ cm$^{-3}$) $Al_{0.10}Ga_{0.90}N$ was formed to 0.1 $\mu$m as a second-conductivity-type (p-type)first cladding layer 26a. Subsequently, a Mg-doped (Mg concentration: $5 \times 10^{19}$ cm$^{-3}$) GaN was formed to 0.07 $\mu$m as a second-conductivity-type (p-type) second cladding layer 26b. Finally, a Mg-doped (Mg concentration: $1 \times 10^{20}$ cm$^{-3}$) GaN was formed to 0.03 $\mu$m as a second-conductivity-type (p-type) contact layer 26c. The subsequent process was conducted as described in Examples A- 1 and 2, to provide the light-emitting-elements shown in FIGs. 1-11 and 1-15, respectively. Here, no defects such as unintended short circuit occurred in the elements.

In the processes in Examples A-1 to 4, the $SiN_x$ mask was removed after the first etching step, but the $SiN_x$ mask may not be removed and can be removed after the second etching step.

Furthermore, in Example A-1 (and Example A-3), the light-emitting-element shown in FIG. 1-1D can be manufactured (wherein the insulating film is a multilayer dielectric film) by stopping etching in the second etching step in the intermediate portion of the buffer layer. Furthermore, by stopping etching in the second etching step in the intermediate portion of the light-uniforming layer, the light-emitting-element shown in FIG. 1-1C can be manufactured. Similarly, in Example A-2 (and Example A-4), by stopping etching in the second etching step in the intermediate portion of the buffer layer, and by providing an appropriate etching mask shape using photolithography suitable for a predetermined shape and adjusting the side etching amount, the light-emitting-element shown in FIG. 1-2D or FIG. 1-2E can be manufactured (wherein the insulating film is a multilayer dielectric film). Furthermore, by stopping etching in the second etching step in the intermediate portion of the light-uniforming layer, the light-emitting-element shown in FIG. 1-2C can be manufactured.

Example A-5

The light-emitting-element shown in FIG. 1-12 was manufactured as follows. First was prepared a c+ plane sapphire substrate 21 with a thickness of 430 $\mu$m, on which an undoped GaN layer with a thickness of 20 nm was formed by growing at a low temperature by MOCVD as a first buffer layer 22a and then an undoped GaN layer with a thickness

of 1 $\mu$m was formed at 1040 °C as a second buffer layer 22b.

As the light-uniforming layer 23, an undoped GaN layer was formed to 2 $\mu$m, which, in its center, includes a stacked structure consisting of ten undoped $In_{0.05}Ga_{0.95}N$ layers each having a thickness of 3 nm and ten undoped GaN layers each having a thickness of 12 nm. Here, the undoped GaN layer and the undoped $In_{0.05}Ga_{0.95}N$ layer were grown at 850 °C and 730 °C, respectively.

Then, a Si-doped (Si concentration: $1 \times 10^{18}$ cm$^{-3}$) GaN layer was formed to 2 $\mu$m as a first-conductivity-type (n-type) second cladding layer 24b; a Si-doped (Si concentration: $2 \times 10^{18}$ cm$^{-3}$) GaN layer was formed to 0.5 $\mu$m as a first-conductivity-type (n-type) contact layer 24c; and then a Si-doped (Si concentration: $1.5 \times 10^{18}$ cm$^{-3}$) $Al_{0.15}Ga_{0.85}N$ layer was formed to 0.1 $\mu$m as a first-conductivity-type (n-type) first cladding layer 22a.

Then, an active layer structure 25 was formed by depositing alternately undoped GaN layer to a thickness of 13 nm at 850 °C as a barrier layer and undoped $In_{0.13}Ga_{0.87}N$ layer to a thickness of 2 nm at 715 °C as a quantum well layer such that three quantum well layers were formed in total and both sides were the barrier layers.

Then, after increasing a growth temperature to 1025 °C, a Mg-doped (Mg concentration $5 \times 10^{19}$ cm$^{-3}$) $Al_{0.15}Ga_{0.85}N$ layer was formed to 0.1 $\mu$m as a second-conductivity-type (p-type) first cladding layer 26a. Subsequently, a Mg-doped (Mg concentration: $5 \times 10^{19}$ cm$^{-3}$) GaN layer was formed to 0.05 $\mu$m as a second-conductivity-type (p-type) second cladding layer 26b. Finally, a Mg-doped (Mg concentration: $1 \times 10^{20}$ cm$^{-3}$) GaN layer was formed to 0.02 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode 27 in the wafer after the thin-film crystal growth, photolithography was used to prepare for patterning a p-side electrode by lift-off technique and a resist pattern was formed. Here, Pd(thickness: 20 nm)/Au(thickness: 1000 nm) was deposited by vacuum evaporation as a p-side electrode, and an unnecessary part was removed in acetone by lift-off technique. Then, after heating, a p-side electrode 27 was prepared. So far, there was not a step causing a damage such as a plasma process in the p-side current injection region just under the p-side electrode.

Next, for conducting a second etching step of forming a light-emitting-element separation-trench, a SrF$_2$ mask was formed over the whole wafer surface using vacuum evaporation. Then, the SrF$_2$ film in the region where a light-emitting-element separation-trench was to be formed was removed to form a separation etching mask, that is, an etching mask for conducting the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layer and the GaN barrier layer, the n-AlGaN first cladding layer 24a, the n-GaN contact layer 24c, the n-GaN second cladding layer 24b, the undoped InGaN/GaN light-uniforming layer 23 and the undoped GaN buffer layer 22 in the part corresponding to the light-emitting-element separation-trench by ICP etching using Cl$_2$ gas. During the second etching step, the SrF$_2$ mask was substantially not etched.

After forming the light-emitting-element separation-trench 13 by the second etching step, the used unnecessary SrF$_2$ mask was removed. Again, since Au was exposed in the p-side electrode surface, it was not deteriorated at all.

Subsequently, a mask for etching was formed to conduct a first etching step for exposing the first-conductivity-type contact layer as preparation before forming a first-conductivity-type-side electrode. Here, SiN$_x$ was deposited to 0.4 $\mu$m over the whole wafer surface at a substrate temperature of 400 °C by p-CVD. Here, since Au was exposed in the p-side electrode surface, it was not deteriorated at all after the SiN$_x$ deposition process by p-CVD. Then, a photolithography process was again conducted for patterning the SiN$_x$ layer to prepare a SiN$_x$ etching mask. Here, the unnecessary part in the SiN$_x$ film was etched using SF$_6$ plasma by RIE, and a part where the thin-film crystal layer was not etched in the first etching step described later was left, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of an InGaN quantum well layer and a GaN barrier layer and the n-AlGaN first cladding layer 24a to the intermediate portion of the n-GaN contact layer 24c, to expose the n-type contact layer which was to be an injection part for n-type carriers.

After the ICP plasma etching, the SiN$_x$ mask was completely removed by RIE using SF$_6$ gas. Again, since Au was exposed in the p-side electrode surface, it was not deteriorated at all after the process.

Then, SiN$_x$ was formed over the whole wafer surface to 125 nm thickness as an insulating layer 30 by p-CVD. Next, for simultaneously forming a p-side electrode exposed part on the p-side electrode 27 made of Pd-Au, an n-side current injection region on the n-side contact layer and a scribe region 14 in the light-emitting-element separation-trench, first, a resist mask was formed by photolithography, and then, the insulating layer in the part which was not covered by a resist mask was removed using RIE plasma of SF$_6$ gas. Here, the periphery of the p-side electrode was covered by the SiN$_x$ insulating layer. Furthermore, for example, the sidewall of the thin-film crystal layer was covered by an insulating layer, except the n-side current injection region.

Subsequently, the unnecessary resist mask was removed by acetone and by ashing with oxygen plasma by RIE. Again, since Au was exposed in the p-side electrode surface, it was not deteriorated at all.

Next, for forming an n-side electrode 28, photolithography was used to prepare for patterning an n-side electrode by lift-off technique and a resist pattern was formed. Here, Ti(thickness: 20 nm)/Al(thickness: 1500 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its area was larger than the n-side current injection region and such that it does not overlap the p-side electrode, considering facilitation of flip chip bonding using a metal solder and heat dissipating properties. An Al electrode tends to be deteriorated during, for example, a plasma process and is etched by, for example, hydrofluoric acid, but since the n-side electrode was formed in the final step of the element manufacturing process, it was not damaged at all.

Then, this element was bonded to the metal layer 41 in the submount 40 using a metal solder 42, to provide a light-emitting-element. Here, no defects such as unintended short circuit occurred in the element.

Example A-6

A light-emitting device was manufactured as described in Example A-5, except that the configurations of a substrate and thin-film crystal layers were modified as follows.

First, was prepared a c+ plane GaN substrate 21 (Si concentration: $1 \times 10^{17}$ cm$^{-3}$)) with a thickness of 330 $\mu$m, on which undoped GaN was first formed to 2 $\mu$m thickness at 1040 °C by MOCVD as a buffer layer 22.

As the light-uniforming layer 23, an undoped GaN layer was formed to 4 $\mu$m, which, in its center, includes a stacked structure consisting of twenty undoped $In_{0.05}Ga_{0.95}N$ layers each having a thickness of 3 nm and twenty undoped GaN layers each having a thickness of 12 nm. Here, the undoped $In_{0.05}Ga_{0.95}N$ layer, the adjacent undoped GaN layer and the other GaN layers were grown at 730 °C, 850 °C and 1035 ° C, respectively.

Then, a Si-doped (Si concentration: $5 \times 10^{18}$ cm$^{-3}$) GaN layer was formed to 4 $\mu$m as a first-conductivity-type (n-type) second cladding layer 24b; a Si-doped (Si concentration: $7 \times 10^{18}$ cm$^{-3}$) GaN layer was formed to 0.5 $\mu$m as a first-conductivity-type (n-type) contact layer 24c; and then a Si-doped (Si concentration: $5 \times 10^{18}$ cm$^{-3}$) $Al_{0.10}Ga_{0.90}N$ layer was formed to 0.1 $\mu$m as a first-conductivity-type (n-type) first cladding layer 24a.

Then, an active layer structure 25 was formed by depositing alternately undoped GaN layer to a thickness of 13nm at 850 °C as a barrier layer and undoped $In_{0.13}Ga_{0.87}N$ layer to a thickness of 2 nm at 715 °C as a quantum well layer such that eight quantum well layers were formed in total and both sides were the barrier layers.

Then, after increasing a growth temperature to 1025 °C, a Mg-doped (Mg concentration $5 \times 10^{19}$ cm$^{-3}$) $Al_{0.10}Ga_{0.90}N$ layer was formed to 0.1 $\mu$m as a second-conductivity-type (p-type) first cladding layer 26a. Subsequently, a Mg-doped (Mg concentration: $5 \times 10^{19}$ cm$^{-3}$) GaN was formed to 0.05 $\mu$m as a second-conductivity-type (p-type) second cladding layer 26b. Finally, a Mg-doped (Mg concentration: $1 \times 10^{20}$ cm$^{-3}$) GaN was formed to 0.02 $\mu$m as a second-conductivity-type (p-type) contact layer 26c.

Then, after gradually lowering the temperature of the MOCVD growth furnace, the wafer was removed and thus thin-film crystal growth was completed.

The subsequent process was conducted as described in Example A-5 to provide a light-emitting device. Here, no defects such as unintended short circuit occurred in the element.

In Examples A-5 and 6, the second etching step was conducted before the first etching step, but the first etching step may be conducted before the second etching step. It is also preferable that without removing the SiN mask used in the first etching step, the second etching step is conducted. Furthermore, in the etching of the insulating layer 30, by providing an appropriate etching mask shape using photolithography suitable for a predetermined shape and by allowing side etching to proceed, a light-emitting-element having a shape according to the second aspect is obtained.

Examples of the invention in relation to Section B

Example B-1

The light-emitting-element shown in FIG. 2-15 was manufactured by the following procedure. FIGs. 2-7 to 12 will be referred to as a related process drawing.

First was prepared a c+ plane sapphire substrate 21 with a thickness of 430 $\mu$m, on which an undoped GaN layer with a thickness of 10 nm was formed by growing at a low temperature by MOCVD as a first buffer layer 22a; and then an undoped GaN layer with a thickness of 0.5 $\mu$m and a Si-doped (Si concentration: $7 \times 10^{17}$ cm$^{-3}$) GaN layer with a thickness of 0.5 $\mu$m were deposited at 1040 °C as a second buffer layer 22b with a thickness of 1 $\mu$m. Subsequently, an undoped GaN layer with a thickness of 3.5 $\mu$m was formed at 1035 °C as a light-uniforming layer 23.

Then, a Si-doped (Si concentration: $1 \times 10^{18}$ cm$^{-3}$) GaN layer was formed to 2 $\mu$m as a first-conductivity-type (n-type) second cladding layer 24b; a Si-doped (Si concentration: $2 \times 10^{18}$ cm$^{-3}$) GaN layer was formed to 0.5 $\mu$m as a

first-conductivity-type (n-type) contact layer 24c; and then a Si-doped (Si concentration: $1.5\times10^{-8}$ cm$^{-3}$) Al$_{0.15}$Ga$_{0.85}$N layer was formed to 0.1 $\mu$m as a first-conductivity-type (n-type) first cladding layer 24a. Then, an active layer structure 25 was formed by depositing alternately undoped GaN layer to a thickness of 13 nm at 850 °C as a barrier layer and undoped In$_{0.1}$Ga$_{0.9}$N layer to a thickness of 2 nm at 720 °C as a quantum well layer such that five quantum well layers were formed in total and both sides were the barrier layers. Then, after increasing a growth temperature to 1025 °C, a Mg-doped (Mg concentration $5\times10^{19}$ cm$^{-3}$) Al$_{0.15}$Ga$_{0.85}$N layer was formed to 0.1 $\mu$m as a second-conductivity-type (p-type) first cladding layer 26a. Subsequently, a Mg-doped (Mg concentration: $5\times10^{19}$ cm$^{-3}$) GaN layer was formed to 0.07 $\mu$m as a second-conductivity-type (p-type) second cladding layer 26b. Finally, a Mg-doped (Mg concentration: $1\times10^{20}$ cm$^{-3}$) GaN layer was formed to 0.03 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode in the wafer after the thin-film crystal growth, photolithography was used to prepare for patterning a p-side electrode 27 by lift-off technique and a resist pattern was formed. Here, Ni(thickness: 20 nm)/Au(thickness: 500 nm) was deposited by vacuum evaporation as a p-side electrode, and an unnecessary part was removed in acetone by lift-off technique. Then, after heating, a p-side electrode was prepared. The structure manufactured so far substantially corresponds to FIG. 1-5. So far, there was not a step causing a damage such as a plasma process in the p-side current injection region just under the p-side electrode.

Next, for conducting the first etching step, an etching mask was formed. Here, by p-CVD, SiN$_x$ was deposited to 0.4 $\mu$m over the whole wafer surface at a substrate temperature of 400 °C. Here, since Au was exposed in the p-side electrode surface, it was not deteriorated at all after the SiN$_x$ deposition process by p-CVD. Then, photolithography was again conducted for patterning the SiN$_x$ mask to prepare a SiN$_x$ etching mask. Here, the unnecessary part in the SiN$_x$ film was etched using SF$_6$ plasma by RIE, and the mask was left in a part where the thin-film crystal layer was not etched in the first etching step described later, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of InGaN quantum well layers and GaN barrier layers and the n-AlGaN first cladding layer 24a to the intermediate portion of the n-GaN contact layer 24c, to expose the n-type contact layer 24c which was to be an injection part for n-type carriers.

After the ICP plasma etching, the SiN$_x$ mask was completely removed using buffered hydrofluoric acid. Again, since Au was exposed in the p-side electrode surface, the p-side electrode was not deteriorated at all after the SiN$_x$ deposition process by p-CVD. The structure manufactured so far substantially corresponds to FIG. 2-8.

Next, for conducting the second etching step of forming a light-emitting-element separation-trench 13, a SrF$_2$ mask was formed over the whole wafer surface using vacuum evaporation. Then, the SrF$_2$ film in the region where a light-emitting-element separation-trench was to be formed was removed to form a mask for forming a light-emitting-element separation-trench on a thin-film crystal layer, that is, a SrF$_2$ mask for the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layers and the GaN barrier layers, the n-AlGaN first cladding layer 24a, the n-GaN contact layer 24c, the n-GaN second cladding layer 24b, the undoped GaN light-uniforming layer 23 and the undoped GaN buffer layer 22 in the part corresponding to the light-emitting-element separation-trench by ICP etching using Cl$_2$ gas. During this second etching step, the SrF$_2$ mask was substantially not etched. The light-emitting-element separation-trench 13 was formed to a width of 150 $\mu$m in good agreement with the width of the mask.

After forming the light-emitting-element separation-trench 13 by the second etching step, the used unnecessary SrF$_2$ mask was removed. Again, since Au was exposed in the p-side electrode surface, it was not deteriorated at all. The structure manufactured so far substantially corresponds to FIG. 2-9.

Next, over the whole wafer were sequentially formed SiO$_x$ and SiN$_x$ by p-CVD to form a dielectric multilayer film. Here, each of SiN$_x$ and SiO$_x$ was formed one by one to a thickness that is 1/4 as an optical wavelength to an emission wavelength of the element, so that it had a relatively higher reflectance to the emission wavelength. The structure manufactured so far substantially corresponds to FIG. 2-10.

Then, a resist mask was formed using photolithography technique for simultaneously forming a p-side electrode exposed part on the p-side electrode 27 made of Ni-Au, forming an n-side current injection region (36) on the n-side contact layer 24c and removing portion of an insulating layer present near the substrate 21 on the sidewall of the undoped buffer layer within the light-emitting-element separation-trench. Next, a hydrofluoric acid containing etchant was used to remove the dielectric multilayer film (the insulating layer) which was not covered by the resist mask. Further, by the effect of side etching by hydrofluoric acid, the dielectric multilayer film (insulating layer) on the part of the sidewall of the undoped buffer layer 22 was also removed. Here, the periphery of the p-side electrode 27 was covered by the insulating layer consisting of SiN$_x$ and SiO$_x$ to 150 $\mu$m.

Subsequently, the used unnecessary resist mask was removed by acetone and by ashing with oxygen plasma by RIE. Again, since Au was exposed in the p-side electrode surface, it was not deteriorated at all after the $SiN_x$ deposition process by p-CVD. The structure manufactured so far substantially corresponds to FIG. 2-11.

Next, for forming an n-side electrode 28, photolithography was used to prepare for patterning an n-side electrode by lift-off technique and a resist pattern was formed. Here, Ti(thickness: 20 nm)/Al(thickness: 300 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its periphery contacted the insulating layer by 30 $\mu$m for having an area larger than the n-side current injection region and such that it did not overlap the p-side electrode 27, considering facilitation of flip chip bonding using a metal solder and heat dissipating properties. In another manufacturing example, it was formed so as to contact by 10 $\mu$m, and a light-emitting-element exhibiting performance comparable to this example was manufactured. An Al electrode tends to be deteriorated during, for example, a plasma process and is etched by, for example, hydrofluoric acid, but since the n-side electrode was formed in the final step of the element manufacturing process, it was not damaged at all. The structure manufactured so far substantially corresponds to FIG. 2-12.

As preparation for delaminating the substrate, an AlN substrate was prepared as a support 40, on the surface of which was formed a metal interconnection (a metal layer 41) having a stacked structure of Ti/Pt/Au. To the support was bonded the whole wafer (substrate 21) including so-far-manufactured light-emitting-element, using an AuSn solder. In the bonding, the support 40 and the wafer (the substrate 21) having light-emitting-elements were heated at 300 °C to fusion-bond a p-side electrode and an n-side electrode to designed metal interconnections on the support, respectively, using an AuSn solder. Here, no defects such as unintended short circuit occurred in the element.

Then, for delaminating the substrate, a laser beam outgoing from a KrF excimer laser (wavelength: 248 nm) was irradiated from the surface of the substrate 21 in which thin-film crystal growth had not been conducted, to delaminate the substrate (i.e. laser debonding). Then, Ga metal generated by decomposition of a part of the GaN buffer layer into nitrogen and metal Ga was removed by wet etching.

Finally, for dividing individual light-emitting-elements, the separation region within the support and the light-emitting-element separation-trench within the wafer were simultaneously cut using a dicing saw. Here, since, for example, a metal interconnection is not present in the element separation region within the support, no defects such as unintended interconnection peeling occurred. Thus, a compound semiconductor light-emitting-element shown in FIG. 2-15 was provided.

Examples B-2

The procedure in Examples B-1 was repeated, except that after depositing the light-uniforming layer 23, a thin-film crystal layer was deposited as described below. Specifically, an undoped GaN was formed at 1035 °C to a thickness of 3.5 $\mu$m as a light-uniforming layer 23 as described in Example B-1, and then a Si-doped (Si concentration: $5\times10^{18}$ $cm^{-3}$) GaN layer was formed to 4 $\mu$m as a first-conductivity-type (n-type) second cladding layer 24b; a Si-doped (Si concentration: $8\times10^{18}$ $cm^{-3}$) GaN layer was formed to 0.5 $\mu$m as a first-conductivity-type (n-type) contact layer 24c; and then a Si-doped (Si concentration: $5.0\times10^{18}$ $cm^{-3}$) $Al_{0.10}Ga_{0.90}N$ layer was formed to 0.1 $\mu$m as a first-conductivity-type (n-type) first cladding layer 24a. Then, an active layer structure 25 were formed by depositing alternately undoped GaN layer to a thickness of 13 nm at 850 °C as a barrier layer and undoped $In_{0.1}Ga_{0.90}N$ layer to a thickness of 2 nm at 720 °C as a quantum well layer such that eight quantum well layers were formed in total and both sides were the barrier layers. Then, after increasing a growth temperature to 1025 °C, a Mg-doped (Mg concentration $5\times10^{19}$ $cm^{-3}$) $Al_{0.10}Ga_{0.90}N$ was formed to 0.1 $\mu$m as a second-conductivity-type (p-type)first cladding layer 26a. Subsequently, a Mg-doped (Mg concentration: $5\times10^{19}$ $cm^{-3}$) GaN was formed to 0.07 $\mu$m as a second-conductivity-type (p-type) second cladding layer 26b. Finally, a Mg-doped (Mg concentration: $1\times10^{20}$ $cm^{-3}$) GaN was formed to 0.03 $\mu$m as a second-conductivity-type (p-type) contact layer 26c. The subsequent process was conducted as described in Examples B-1, to provide the light-emitting-element shown in FIG. 2-15. Here, no defects such as unintended short circuit occurred in the elements.

In the processes in Examples B-1 and 2, the $SiN_x$ mask was removed after the first etching step, but the $SiN_x$ mask may not be removed and can be removed after the second etching step.

Furthermore, in Examples B-1 and B-2, the etching in the second etching step can be stopped in the intermediate portion of the buffer layer, to provide the light-emitting-elements shown in FIGs. 2-2B and 2-2C (wherein the insulating film is a multilayer dielectric film). Furthermore, the etching in the second etching step can be stopped in the intermediate portion of the light-uniforming layer to provide the light-emitting-element shown in FIG. 2-2A. The elements can be separated by cutting the element separation region in the support, together with the light-uniforming layer and the buffer layer in the bottom of the light-emitting-element separation-trench.

Furthermore, the light-emitting-element shown in FIGs. 2-3A to 2-3C (wherein the insulating film was a multilayer dielectric film) can be provided by, in Examples B-1 and B-2, stopping the etching in the second etching step in the intermediate portion of the light-uniforming layer or the buffer layer and further preparing an appropriate etching mask shape by photolithography suitable for a predetermined shape and forming a scribe region without allowing side etching of the insulating film to proceed, for example, leaving a portion of the insulating layer in the trench bottom surface such that a width of the scribe region becomes 100 $\mu$m (Lws in the element is 50 $\mu$m after the separation).

<u>Example B-3</u>

The light-emitting-element shown in FIG. 2-16 was manufactured as follows. First was prepared a c+ plane sapphire substrate 21 with a thickness of 430 $\mu$m, on which an undoped GaN layer with a thickness of 20 nm was formed by growing at a low temperature by MOCVD as a first buffer layer 22a and then an undoped GaN layer with a thickness of 1 $\mu$m was formed at 1040 °C as a second buffer layer 22b.

As the light-uniforming layer 23, an undoped GaN layer was formed to 2 $\mu$m, which, in its center, includes a stacked structure consisting of ten undoped $In_{0.05}Ga_{0.95}N$ layers each having a thickness of 3 nm and ten undoped GaN layers each having a thickness of 12 nm. Here, the undoped GaN layer and the undoped $In_{0.05}Ga_{0.95}N$ layer were grown at 850 °C and 730 °C, respectively.

Then, a Si-doped (Si concentration: $1 \times 10^{18}$ cm$^{-3}$) GaN layer was formed to 2 $\mu$m as a first-conductivity-type (n-type) second cladding layer 24b; a Si-doped (Si concentration: $2 \times 10^{18}$ cm$^{-3}$) GaN layer was formed to 0.5 $\mu$m as a first-conductivity-type (n-type) contact layer 24c; and then a Si-doped (Si concentration: $1.5 \times 10^{18}$ cm$^{-3}$) $Al_{0.15}Ga_{0.85}N$ layer was formed to 0.1 $\mu$m as a first-conductivity-type (n-type) first cladding layer 24a.

Then, an active layer structure 25 was formed by depositing alternately undoped GaN layer to a thickness of 13 nm at 850 °C as a barrier layer and undoped $In_{0.13}Ga_{0.87}N$ layer to a thickness of 2 nm at 715 °C as a quantum well layer such that three quantum well layers were formed in total and both sides were the barrier layers.

Then, after increasing a growth temperature to 1025 °C, a Mg-doped (Mg concentration $5 \times 10^{19}$ cm$^{-3}$) $Al_{0.15}Ga_{0.85}N$ layer was formed to 0.1 $\mu$m as a second-conductivity-type (p-type) first cladding layer 26a. Subsequently, a Mg-doped (Mg concentration: $5 \times 10^{19}$ cm$^{-3}$) GaN layer was formed to 0.05 $\mu$m as a second-conductivity-type (p-type) second cladding layer 26b. Finally, a Mg-doped (Mg concentration: $1 \times 10^{20}$ cm$^{-3}$) GaN layer was formed to 0.02 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode 27 in the wafer after the thin-film crystal growth, photolithography was used to prepare for patterning a p-side electrode by lift-off technique and a resist pattern was formed. Here, Pd(thickness: 20 nm)/Au(thickness: 1000 nm) was deposited by vacuum evaporation as a p-side electrode, and an unnecessary part was removed in acetone by lift-off technique. Then, after heating, a p-side electrode 27 was prepared. So far, there was not a step causing a damage such as a plasma process in the p-side current injection region just under the p-side electrode.

Next, for conducting a second etching step of forming a light-emitting-element separation-trench, a SrF$_2$ mask was formed over the whole wafer surface using vacuum evaporation. Then, the SrF$_2$ film in the region where a light-emitting-element separation-trench was to be formed was removed to form a separation etching mask, that is, an etching mask for conducting the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layer and the GaN barrier layer, the n-AlGaN first cladding layer 24a, the n-GaN contact layer 24c, the n-GaN second cladding layer 24b, the undoped InGaN/GaN light-uniforming layer 23 and the undoped GaN buffer layer 22 in the part corresponding to the light-emitting-element separation-trench by ICP etching using Cl$_2$ gas. During the second etching step, the SrF$_2$ mask was substantially not etched.

After forming the light-emitting-element separation-trench 13 by the second etching step, the used unnecessary SrF$_2$ mask was removed. Again, since Au was exposed in the p-side electrode surface, it was not deteriorated at all.

Subsequently, a mask for etching was formed to conduct a first etching step for exposing the first-conductivity-type contact layer as preparation before forming a first-conductivity-type-side electrode. Here, SiN$_x$ was deposited to 0.4 $\mu$m over the whole wafer surface at a substrate temperature of 400 ° C by p-CVD. Here, since Au was exposed in the p-side electrode surface, it was not deteriorated at all after the SiN$_x$ deposition process by p-CVD. Then, a photolithography process was again conducted for patterning the SiN$_x$ layer to prepare a SiN$_x$ etching mask. Here, the unnecessary part in the SiN$_x$ film was etched using SF$_6$ plasma by RIE, and a part where the thin-film crystal layer was not etched in the first etching step described later was left, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of an InGaN quantum well layer and a GaN barrier layer and the n-AlGaN first cladding layer 24a to the intermediate portion of the n-GaN contact layer 24c, to expose the n-type contact layer which was to be an injection part for n-type carriers.

After the ICP plasma etching, the SiN$_x$ mask was completely removed by RIE using SF$_6$ gas. Again, since Au was exposed in the p-side electrode surface, it was not deteriorated at all after the process.

Then, SiN$_x$ was formed over the whole wafer surface to 125 nm thickness as an insulating layer 30 by p-CVD.

Then, a resist mask was formed using photolithography technique for simultaneously forming a p-side electrode exposed part on the p-side electrode 27 made of Pd-Au, forming an n-side current injection region (36) on the n-side contact layer 24c and removing portion of an insulating layer present near the substrate 21 on the sidewall of the undoped buffer layer within the light-emitting-element separation-trench. Next, a hydrofluoric acid containing etchant was used to remove the dielectric multilayer film (the insulating layer) which was not covered by the resist mask. Further, by the effect of side etching by hydrofluoric acid, the dielectric multilayer film (insulating layer) on the part of the sidewall of the undoped buffer layer 22 was also removed. Here, the periphery of the p-side electrode 27 was covered by the insulating layer consisting of SiN$_x$ and SiO$_x$ to 150 $\mu$m. Furthermore, the sidewall of the thin-film crystal layer and so on was covered by an insulating layer, except the n-side current injection region.

Subsequently, the unnecessary resist mask was removed by acetone and by ashing with oxygen plasma by RIE. Again, since Au was exposed in the p-side electrode surface, it was not deteriorated at all.

Next, for forming an n-side electrode 28, photolithography was used to prepare for patterning an n-side electrode by lift-off technique and a resist pattern was formed. Here, Ti(thickness: 20 nm)/Al(thickness: 1500 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its area was larger than the n-side current injection region and such that it does not overlap the p-side electrode, considering facilitation of flip chip bonding using a metal solder and heat dissipating properties. An Al electrode tends to be deteriorated during, for example, a plasma process and is etched by, for example, hydrofluoric acid, but since the n-side electrode was formed in the final step of the element manufacturing process, it was not damaged at all.

As preparation for delaminating the substrate, an AlN substrate was prepared as a support 40, on the surface of which was formed a metal interconnection (a metal layer 41) having a stacked structure of Ti/Pt/Au. To the support was bonded the whole wafer (substrate 21) including so-far-manufactured light-emitting-element, using an AuSn solder. In the bonding, the support 40 and the wafer (the substrate 21) having light-emitting-elements were heated at 300 °C to fusion-bond a p-side electrode and an n-side electrode to designed metal interconnections on the support, respectively, using an AuSn solder. Here, no defects such as unintended short circuit occurred in the element.

Then, for delaminating the substrate, a laser beam outgoing from a KrF excimer laser (wavelength: 248 nm) was irradiated from the surface of the substrate 21 in which thin-film crystal growth had not been conducted, to delaminate the substrate (i.e. laser debonding). Then, Ga metal generated by decomposition of a part of the GaN buffer layer into nitrogen and metal Ga was removed by wet etching.

Finally, for dividing individual light-emitting-elements, the separation region within the support and the light-emitting-element separation-trench within the wafer were simultaneously cut using a dicing saw. Here, since, for example, a metal interconnection is not present in the element separation region within the support, no defects such as unintended interconnection peeling occurred. Thus, a compound semiconductor light-emitting-element shown in FIG. 2-16 was provided.

Examples of the invention in relation to Section D

Example D-1

The light-emitting-element shown in FIG. 4-11 was manufactured by the following procedure. FIGs. 4-5 to 10 will be referred to as a related process drawing.

First was prepared a c+ plane sapphire substrate 21 with a thickness of 430 $\mu$m, on which an undoped GaN layer with a thickness of 10 nm was formed by growing at a low temperature by MOCVD as a first buffer layer 22a; and then an undoped GaN layer with a thickness of 4 $\mu$m was deposited at 1040 °C as a second buffer layer 22b.

Then, a Si-doped (Si concentration: $1 \times 10^{18}$ cm$^{-3}$) GaN layer was formed to 2 $\mu$m as a first-conductivity-type (n-type) second cladding layer 24b; a Si-doped (Si concentration: $2 \times 10^{18}$ cm$^{-3}$) GaN layer was formed to 0.5 $\mu$m as a first-conductivity-type (n-type) contact layer 24c; and then a Si-doped (Si concentration: $1.5 \times 10^{18}$ cm$^{-3}$) Al$_{0.15}$Ga$_{0.85}$N layer was formed to 0.1 $\mu$m as a first-conductivity-type (n-type) first cladding layer 24a. Then, an active layer structure 25 was formed by depositing alternately undoped GaN layer to a thickness of 13 nm at 850 °C as a barrier layer and undoped In$_{0.1}$Ga$_{0.9}$N layer to a thickness of 2 nm at 720 °C as a quantum well layer such that five quantum well layers were formed in total and both sides were the barrier layers. Then, after increasing a growth temperature to 1025 °C, a Mg-doped (Mg concentration $5 \times 10^{19}$ cm$^{-3}$) Al$_{0.15}$Ga$_{0.85}$N layer was formed to 0.1 $\mu$m as a second-conductivity-type (p-type) first cladding layer 26a. Subsequently, a Mg-doped (Mg concentration: $5 \times 10^{19}$ cm$^{-3}$) GaN layer was formed to 0.07 $\mu$m as a second-conductivity-type (p-type) second cladding layer 26b. Finally, a Mg-doped (Mg concentration:

$1 \times 10^{20}$ cm$^{-3}$) GaN layer was formed to 0.03 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode in the wafer after the thin-film crystal growth, photolithography was used to prepare for patterning a p-side electrode 27 by lift-off technique and a resist pattern was formed. Here, Ni(thickness: 20 nm)/Au(thickness: 500 nm) was deposited by vacuum evaporation as a p-side electrode, and an unnecessary part was removed in acetone by lift-off technique. Then, after heating, a p-side electrode was prepared. The structure manufactured so far substantially corresponds to FIG. 4-5. So far, there was not a step causing a damage such as a plasma process in the p-side current injection region just under the p-side electrode.

Next, for conducting the first etching step, an etching mask was formed. Here, by p-CVD, SiN$_x$ was deposited to 0.4 $\mu$m over the whole wafer surface at a substrate temperature of 400 °C. Here, since Au was exposed in the p-side electrode surface, it was not deteriorated at all after the SiN$_x$ deposition process by p-CVD. Then, photolithography was again conducted for patterning the SiN$_x$ mask to prepare a SiN$_x$ etching mask. Here, the unnecessary part in the SiN$_x$ film was etched using SF$_6$ plasma by RIE, and the mask was left in a part where the thin-film crystal layer was not etched in the first etching step described later, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of InGaN quantum well layers and GaN barrier layers and the n-AlGaN first cladding layer 24a to the intermediate portion of the n-GaN contact layer 24c, to expose the n-type contact layer 24c which was to be an injection part for n-type carriers.

After the ICP plasma etching, the SiN$_x$ mask was completely removed using buffered hydrofluoric acid. Again, since Au was exposed in the p-side electrode surface, the p-side electrode was not deteriorated at all after the SiN$_x$ deposition process by p-CVD. The structure manufactured so far substantially corresponds to FIG. 4-6.

Next, for conducting the second etching step of forming a light-emitting-element separation-trench 13, a SrF$_2$ mask was formed over the whole wafer surface using vacuum evaporation. Then, the SrF$_2$ film in the region where a light-emitting-element separation-trench was to be formed was removed to form a mask for forming a light-emitting-element separation-trench on a thin-film crystal layer, that is, a SrF$_2$ mask for the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layers and the GaN barrier layers, the n-AlGaN first cladding layer 24a, the n-GaN contact layer 24c, the n-GaN second cladding layer 24b and the undoped GaN buffer layer 22 in the part corresponding to the light-emitting-element separation-trench by ICP etching using Cl$_2$ gas. During this second etching step, the SrF$_2$ mask was substantially not etched. The light-emitting-element separation-trench 13 was formed to a width of 150 $\mu$m in good agreement with the width of the mask.

After forming the light-emitting-element separation-trench 13 by the second etching step, the used unnecessary SrF$_2$ mask was removed. Again, since Au was exposed in the p-side electrode surface, it was not deteriorated at all. The structure manufactured so far substantially corresponds to FIG. 4-7.

Next, over the whole wafer were sequentially formed SiO$_x$ and SiN$_x$ by p-CVD to form a dielectric multilayer film. Here, each of SiN$_x$ and SiO$_x$ was formed one by one to a thickness that is 1/4 as an optical wavelength to an emission wavelength of the element, so that it had a relatively higher reflectance to the emission wavelength. The structure manufactured so far substantially corresponds to FIG. 4-8.

Then, first, a resist mask was formed using photolithography technique for simultaneously forming a p-side electrode exposed part on the p-side electrode 27 made of Ni-Au, an n-side current injection region (36) on the n-side contact layer 24c and a scribe region 14 within the light-emitting-element separation-trench. Next, a hydrofluoric acid-containing etchant was used to remove the dielectric multilayer film (the insulating layer) in the part which was not covered by the resist mask. Here, the periphery of the p-side electrode 27 was covered by the insulating layer consisting of SiO$_x$ and SiN$_x$ to 150 $\mu$m. The scribe region was formed with a width of 100 $\mu$m (Lws in the element after separation was 50 $\mu$m).

Subsequently, the used unnecessary resist mask was removed by acetone and by ashing with oxygen plasma by RIE. Again, since Au was exposed in the p-side electrode surface, it was not deteriorated at all after the SiN$_x$ deposition process by p-CVD. The structure manufactured so far substantially corresponds to FIG. 4-9A.

Next, for forming an n-side electrode 28, photolithography was used to prepare for patterning an n-side electrode by lift-off technique and a resist pattern was formed. Here, Ti(thickness: 20 nm)/Al(thickness: 300 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its periphery contacted the insulating layer by 30 $\mu$m for having an area larger than the n-side current injection region and such that it did not overlap the p-side electrode 27, considering facilitation of flip chip bonding using a metal solder and heat dissipating properties. In another manufacturing example, it was formed so as to contact by 10 $\mu$m, and a light-emitting-element exhibiting performance comparable to this example was manufactured. An Al electrode tends to be deteriorated during, for example, a plasma process and is etched by, for example, hydrofluoric acid, but since the n-side electrode was formed in the final step of the element manufacturing process, it was not damaged at all. The structure manufactured so far substantially corresponds to FIG. 4-10.

Then, on the rear surface of the sapphire substrate was formed a low-reflecting optical film 45 made of MgF$_2$ by vacuum evaporation. Here, MgF$_2$ was deposited to 1/4 of an optical film thickness, giving a low-reflecting coating to an emission wavelength of the element.

Next, for dividing the individual light-emitting-elements formed over the wafer, a scribe line was formed from the thin-film crystal growth side in the inside of the light-emitting-element separation-trench 13 using a laser scriber. Then, along this scribe line, only the sapphire substrate and the MgF$_2$ low-reflecting optical film were broken to provide individual compound semiconductor light-emitting-elements. Here, no damages were introduced to the thin-film crystal layer and detachment of the dielectric film did not occur.

Then, this element was bonded to the metal layer 41 in the submount 40 using a metal solder 42, to provide the light-emitting-element shown in FIG. 4-11. Here, no defects such as unintended short circuit occurred in the element.

Example D-2

The light-emitting-element shown in FIG. 4-15 (similar to FIG. 4-2A) was manufactured as described below.

The process in Example D-1 was repeated to the stage where a dielectric multilayer film was formed over the whole wafer surface as an insulating layer (substantially corresponding to FIG. 4-8).

Then, a resist mask was formed using photolithography technique for simultaneously forming a p-side electrode exposed part on the p-side electrode 27 made of Ni-Au, forming an n-side current injection region 36 on the n-side contact layer 24c and removing portion of an insulating layer present near the substrate 21 on the sidewall of the undoped buffer layer within the light-emitting-element separation-trench. Next, a hydrofluoric acid containing etchant was used to remove the dielectric multilayer film (the insulating layer) which was not covered by the resist mask. Further, by the effect of side etching by hydrofluoric acid, the dielectric multilayer film (insulating layer) on the part of the sidewall of the undoped buffer layer 22 was also removed. Here, the periphery of the p-side electrode 27 was covered by the insulating layer consisting of SiN$_x$ and SiO$_x$ to 150 $\mu$m.

Subsequently, the unnecessary resist mask was removed by acetone and by ashing with oxygen plasma by RIE. Again, since Au was exposed in the p-side electrode surface, it was not deteriorated at all after the SiN$_x$ deposition process by p-CVD. The structure manufactured so far substantially corresponds to FIG. 4-9B.

Then, an n-side electrode 28 was formed as described in Example D-1. Then, on the rear surface of the sapphire substrate was formed a low-reflecting optical film 45 made of MgF$_2$ by vacuum evaporation. Here, MgF$_2$ was deposited to 1/4 of an optical film thickness, giving a low-reflecting coating to an emission wavelength of the element.

Next, for dividing the individual light-emitting-elements formed over the wafer, a scribe line was formed from the thin-film crystal growth side to the inside of the light-emitting-element separation-trench 13 using a laser scriber. Then, along this scribe line, only the sapphire substrate and the MgF$_2$ low-reflecting optical film were broken to provide individual light-emitting-elements. Here, no damages were introduced to the thin-film crystal layer and detachment of the dielectric film did not occur.

Then, this element was bonded to the metal layer 41 on the submount 40 using a metal solder 42, to provide the light-emitting-element shown in FIG. 4-15. Here, no defects such as unintended short circuit occurred in the element.

Examples D-3 and 4

The procedure in Examples D-1 and 2 was repeated, except that after depositing the buffer layer 22, a thin-film crystal layer was deposited as described below. Specifically, a buffer layer 22 was formed as described in Example D-1, and then a Si-doped (Si concentration: $5 \times 10^{18}$ cm$^{-3}$) GaN layer was formed to 4 $\mu$m as a first-conductivity-type (n-type) second cladding layer 24b; a Si-doped (Si concentration: $8 \times 10^{18}$ cm$^{-3}$) GaN layer was formed to 0.5 $\mu$m as a first-conductivity-type (n-type) contact layer 24c; and then a Si-doped (Si concentration: $5.0 \times 10^{18}$ cm$^{-3}$) Al$_{0.10}$Ga$_{0.90}$N layer was formed to 0.1 $\mu$m as a first-conductivity-type (n-type) first cladding layer 24a. Then, an active layer structure 25 were formed by depositing alternately undoped GaN layer to a thickness of 13 nm at 850 °C as a barrier layer and undoped In$_{0.1}$Ga$_{0.9}$N layer to a thickness of 2 nm at 720 °C as a quantum well layer such that eight quantum well layers were formed in total and both sides were the barrier layers. Then, after increasing a growth temperature to 1025 °C, a Mg-doped (Mg concentration $5 \times 10^{19}$ cm$^{-3}$) Al$_{0.10}$Ga$_{0.90}$N was formed to 0.1 $\mu$m as a second-conductivity-type (p-type) first cladding layer 26a. Subsequently, a Mg-doped (Mg concentration: $5 \times 10^{19}$ cm$^{-3}$) GaN was formed to 0.07 $\mu$m as a second-conductivity-type (p-type) second cladding layer 26b. Finally, a Mg-doped (Mg concentration: $1 \times 10^{20}$ cm$^{-3}$) GaN was formed to 0.03 $\mu$m as a second-conductivity-type (p-type) contact layer 26c. The subsequent process was conducted as described in Examples D-1 and 2, to provide the light-emitting-elements shown in FIGs. 4-11 and 4-15, respectively. Here, no defects such as unintended short circuit occurred in the elements.

In the processes in Examples D-1 to 4, the $SiN_x$ mask was removed after the first etching step, but the $SiN_x$ mask may not be removed and can be removed after the second etching step.

Furthermore, in Example D-1 (and Example D-3), the light-emitting-element shown in FIG. 4-1C can be manufactured (wherein the insulating film is a multilayer dielectric film) by stopping etching in the second etching step in the intermediate portion of the buffer layer. Similarly, in Example D-2 (and Example D-4), by stopping etching in the second etching step in the intermediate portion of the buffer layer, the light-emitting-element shown in FIG. 4-2C can be manufactured (wherein the insulating film is a multilayer dielectric film).

Example D-5

The light-emitting-element shown in FIG. 4-12 was manufactured as follows. First was prepared a c+ plane sapphire substrate 21 with a thickness of 430 $\mu$m, on which an undoped GaN layer with a thickness of 20 nm was formed by growing at a low temperature by MOCVD as a first buffer layer 22a and then an undoped GaN layer with a thickness of 2 $\mu$m was formed at 1040 °C as a second buffer layer 22b.

Then, a Si-doped (Si concentration: $1\times10^{18}$ cm$^{-3}$) GaN layer was formed to 2 $\mu$m as a first-conductivity-type (n-type) second cladding layer 24b; a Si-doped (Si concentration: $2\times10^{18}$ cm$^{-3}$) GaN layer was formed to 0.5 $\mu$m as a first-conductivity-type (n-type) contact layer 24c; and then a Si-doped (Si concentration: $1.5\times10^{18}$ cm$^{-3}$) $Al_{0.15}Ga_{0.85}N$ layer was formed to 0.1 $\mu$m as a first-conductivity-type (n-type) first cladding layer 24a.

Then, an active layer structure 25 was formed by depositing alternately undoped GaN layer to a thickness of 13 nm at 850 °C as a barrier layer and undoped $In_{0.13}Ga_{0.87}N$ layer to a thickness of 2 nm at 715 °C as a quantum well layer such that three quantum well layers were formed in total and both sides were the barrier layers.

Then, after increasing a growth temperature to 1025 °C, a Mg-doped (Mg concentration $5\times10^{19}$ cm$^{-3}$) $Al_{0.15}Ga_{0.85}N$ layer was formed to 0.1 $\mu$m as a second-conductivity-type (p-type) first cladding layer 26a. Subsequently, a Mg-doped (Mg concentration: $5\times10^{19}$ cm$^{-3}$) GaN layer was formed to 0.05 $\mu$m as a second-conductivity-type (p-type) second cladding layer 26b. Finally, a Mg-doped (Mg concentration: $1\times10^{20}$ cm$^{-3}$) GaN layer was formed to 0.02 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode 27 in the wafer after the thin-film crystal growth, photolithography was used to prepare for patterning a p-side electrode by lift-off technique and a resist pattern was formed. Here, Pd(thickness: 20 nm)/Au(thickness: 1000 nm) was deposited by vacuum evaporation as a p-side electrode, and an unnecessary part was removed in acetone by lift-off technique. Then, after heating, a p-side electrode 27 was prepared. So far, there was not a step causing a damage such as a plasma process in the p-side current injection region just under the p-side electrode.

Next, for conducting a second etching step of forming a light-emitting-element separation-trench, a $SrF_2$ mask was formed over the whole wafer surface using vacuum evaporation. Then, the $SrF_2$ film in the region where a light-emitting-element separation-trench was to be formed was removed to form a separation etching mask, that is, an etching mask for conducting the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layer and the GaN barrier layer, the n-AlGaN first cladding layer 24a, the n-GaN contact layer 24c, the n-GaN second cladding layer 24b and the undoped GaN buffer layer 22 in the part corresponding to the light-emitting-element separation-trench by ICP etching using $Cl_2$ gas. During the second etching step, the $SrF_2$ mask was substantially not etched.

After forming the light-emitting-element separation-trench 13 by the second etching step, the used unnecessary $SrF_2$ mask was removed. Again, since Au was exposed in the p-side electrode surface, it was not deteriorated at all.

Subsequently, a mask for etching was formed to conduct a first etching step for exposing the first-conductivity-type contact layer as preparation before forming a first-conductivity-type-side electrode. Here, $SiN_x$ was deposited to 0.4 $\mu$m over the whole wafer surface at a substrate temperature of 400 °C by p-CVD. Here, since Au was exposed in the p-side electrode surface, it was not deteriorated at all after the $SiN_x$ deposition process by p-CVD. Then, a photolithography process was again conducted for patterning the $SiN_x$ layer to prepare a $SiN_x$ etching mask. Here, the unnecessary part in the $SiN_x$ film was etched using $SF_6$ plasma by RIE, and a part where the thin-film crystal layer was not etched in the first etching step described later was left, while the $SiN_x$ film was removed in the part corresponding to the part of the thin-film crystal layer to be etched.

Next, as the first etching step, ICP plasma etching was conducted using $Cl_2$ gas for etching through the p-GaN contact layer 26c, the p-GaN second cladding layer 26b, the p-AlGaN first cladding layer 26a, the active layer structure 25 consisting of an InGaN quantum well layer and a GaN barrier layer and the n-AlGaN first cladding layer 24a to the intermediate portion of the n-GaN contact layer 24c, to expose the n-type contact layer which was to be an injection part for n-type carriers.

After the ICP plasma etching, the $SiN_x$ mask was completely removed by RIE using $SF_6$ gas. Again, since Au was exposed in the p-side electrode surface, it was not deteriorated at all after the process.

Then, $SiN_x$ was formed over the whole wafer surface to 125 nm thickness as an insulating layer 30 by p-CVD. Next, for simultaneously forming a p-side electrode exposed part on the p-side electrode 27 made of Pd-Au, an n-side current injection region on the n-side contact layer and a scribe region 14 in the light-emitting-element separation-trench, first, a resist mask was formed by photolithography, and then, the insulating layer in the part which was not covered by a resist mask was removed using RIE plasma of $SF_6$ gas. Here, the periphery of the p-side electrode was covered by the $SiN_x$ insulating layer. Furthermore, for example, the sidewall of the thin-film crystal layer was covered by an insulating layer, except the n-side current injection region.

Subsequently, the unnecessary resist mask was removed by acetone and by ashing with oxygen plasma by RIE. Again, since Au was exposed in the p-side electrode surface, it was not deteriorated at all.

Next, for forming an n-side electrode 28, photolithography was used to prepare for patterning an n-side electrode by lift-off technique and a resist pattern was formed. Here, Ti(thickness: 20 nm)/Al(thickness: 1500 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its area was larger than the n-side current injection region and such that it does not overlap the p-side electrode, considering facilitation of flip chip bonding using a metal solder and heat dissipating properties. An Al electrode tends to be deteriorated during, for example, a plasma process and is etched by, for example, hydrofluoric acid, but since the n-side electrode was formed in the final step of the element manufacturing process, it was not damaged at all.

Then, this element was bonded to the metal layer 41 in the submount 40 using a metal solder 42, to provide a light-emitting-element. Here, no defects such as unintended short circuit occurred in the element.

Example D-6

A light-emitting device was manufactured as described in Example D-5, except that the configurations of a substrate and thin-film crystal layers were modified as follows.

First, was prepared a c+ plane GaN substrate 21 (Si concentration: $1\times10^{17}$ cm$^{-3}$)) with a thickness of 330 $\mu$m, on which undoped GaN was first formed to 6 $\mu$m thickness at 1040 °C by MOCVD as a buffer layer 22.

Then, a Si-doped (Si concentration: $5\times10^{18}$ cm$^{-3}$) GaN layer was formed to 4 $\mu$m as a first-conductivity-type (n-type) second cladding layer 24b; a Si-doped (Si concentration: $7\times10^{18}$ cm$^{-3}$) GaN layer was formed to 0.5 $\mu$m as a first-conductivity-type (n-type) contact layer 24c; and then a Si-doped (Si concentration: $5\times10^{18}$ cm$^{-3}$) $Al_{0.10}Ga_{0.90}N$ layer was formed to 0.1 $\mu$m as a first-conductivity-type (n-type) first cladding layer 24a.

Then, an active layer structure 25 was formed by depositing alternately undoped GaN layer to a thickness of 13nm at 850 °C as a barrier layer and undoped $In_{0.13}Ga_{0.87}N$ layer to a thickness of 2 nm at 715 °C as a quantum well layer such that eight quantum well layers were formed in total and both sides were the barrier layers.

Then, after increasing a growth temperature to 1025 °C, a Mg-doped (Mg concentration $5\times10^{19}$ cm$^{-3}$) $Al_{0.10}Ga_{0.90}N$ layer was formed to 0.1 $\mu$m as a second-conductivity-type (p-type) first cladding layer 26a. Subsequently, a Mg-doped (Mg concentration: $5\times10^{19}$ cm$^{-3}$) GaN was formed to 0.05 $\mu$m as a second-conductivity-type (p-type) second cladding layer 26b. Finally, a Mg-doped (Mg concentration: $1\times10^{20}$ cm$^{-3}$) GaN was formed to 0.02 $\mu$m as a second-conductivity-type (p-type) contact layer 26c.

Then, after gradually lowering the temperature of the MOCVD growth furnace, the wafer was removed and thus thin-film crystal growth was completed.

The subsequent process was conducted as described in Example D-5 to provide a light-emitting device. Here, no defects such as unintended short circuit occurred in the element.

In Examples D-5 and 6, the second etching step was conducted before the first etching step, but the first etching step may be conducted before the second etching step. It is also preferable that without removing the SiN mask used in the first etching step, the second etching step is conducted. Furthermore, in the etching of the insulating layer 30, by providing an appropriate etching mask shape using photolithography suitable for a predetermined shape and by allowing side etching to proceed, a light-emitting-element having a shape according to the second aspect is obtained.

Examples of the invention in relation to Section E

Example E-1

The light-emitting-element shown in FIG. 5-15 was manufactured by the following procedure. FIGs. 5-7 to 12 will be referred to as a related process drawing.

First was prepared a c+ plane sapphire substrate 21 with a thickness of 430 $\mu$m, on which an undoped GaN layer with a thickness of 10 nm was formed by growing at a low temperature by MOCVD as a first buffer layer 22a; and then an undoped GaN layer with a thickness of 4 $\mu$m was deposited at 1040 °C as a second buffer layer 22b.

Then, a Si-doped (Si concentration: $1 \times 10^{18}$ cm$^{-3}$) GaN layer was formed to 2 $\mu$m as a first-conductivity-type (n-type) second cladding layer 24b; a Si-doped (Si concentration: $2 \times 10^{18}$ cm$^{-3}$) GaN layer was formed to 0.5 $\mu$m as a first-conductivity-type (n-type) contact layer 24c; and then a Si-doped (Si concentration: $1.5 \times 10^{18}$ cm$^{-3}$) Al$_{0.15}$Ga$_{0.85}$N layer was formed to 0.1 $\mu$m as a first-conductivity-type (n-type) first cladding layer 24a. Then, an active layer structure 25 was formed by depositing alternately undoped GaN layer to a thickness of 13 nm at 850 °C as a barrier layer and undoped In$_{0.1}$Ga$_{0.9}$N layer to a thickness of 2 nm at 720 °C as a quantum well layer such that five quantum well layers were formed in total and both sides were the barrier layers. Then, after increasing a growth temperature to 1025 °C, a Mg-doped (Mg concentration $5 \times 10^{19}$ cm$^{-3}$) Al$_{0.15}$Ga$_{0.85}$N layer was formed to 0.1 $\mu$m as a second-conductivity-type (p-type) first cladding layer 26a. Subsequently, a Mg-doped (Mg concentration: $5 \times 10^{19}$ cm$^{-3}$) GaN layer was formed to 0.07 $\mu$m as a second-conductivity-type (p-type) second cladding layer 26b. Finally, a Mg-doped (Mg concentration: $1 \times 10^{20}$ cm$^{-3}$) GaN layer was formed to 0.03 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode in the wafer after the thin-film crystal growth, photolithography was used to prepare for patterning a p-side electrode 27 by lift-off technique and a resist pattern was formed. Here, Ni(thickness: 20 nm)/Au(thickness: 500 nm) was deposited by vacuum evaporation as a p-side electrode, and an unnecessary part was removed in acetone by lift-off technique. Then, after heating, a p-side electrode was prepared. The structure manufactured so far substantially corresponds to FIG. 5-7. So far, there was not a step causing a damage such as a plasma process in the p-side current injection region just under the p-side electrode.

Next, for conducting the first etching step, an etching mask was formed. Here, by p-CVD, SiN$_x$ was deposited to 0.4 $\mu$m over the whole wafer surface at a substrate temperature of 400 °C. Here, since Au was exposed in the p-side electrode surface, it was not deteriorated at all after the SiN$_x$ deposition process by p-CVD. Then, photolithography was again conducted for patterning the SiN$_x$ mask to prepare a SiN$_x$ etching mask. Here, the unnecessary part in the SiN$_x$ film was etched using SF$_6$ plasma by RIE, and the mask was left in a part where the thin-film crystal layer was not etched in the first etching step described later, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of InGaN quantum well layers and GaN barrier layers and the n-AlGaN first cladding layer 24a to the intermediate portion of the n-GaN contact layer 24c, to expose the n-type contact layer 24c which was to be an injection part for n-type carriers.

After the ICP plasma etching, the SiN$_x$ mask was completely removed using buffered hydrofluoric acid. Again, since Au was exposed in the p-side electrode surface, the p-side electrode was not deteriorated at all after the SiN$_x$ deposition process by p-CVD. The structure manufactured so far substantially corresponds to FIG. 5-8.

Next, for conducting the second etching step of forming a light-emitting-element separation-trench 13, a SrF$_2$ mask was formed over the whole wafer surface using vacuum evaporation. Then, the SrF$_2$ film in the region where a light-emitting-element separation-trench was to be formed was removed to form a mask for forming a light-emitting-element separation-trench on a thin-film crystal layer, that is, a SrF$_2$ mask for the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layers and the GaN barrier layers, the n-AlGaN first cladding layer 24a, the n-GaN contact layer 24c, the n-GaN second cladding layer 24b and the undoped GaN buffer layer 22 in the part corresponding to the light-emitting-element separation-trench by ICP etching using Cl$_2$ gas. During this second etching step, the SrF$_2$ mask was substantially not etched. The light-emitting-element separation-trench 13 was formed to a width of 150 $\mu$m in good agreement with the width of the mask.

After forming the light-emitting-element separation-trench 13 by the second etching step, the used unnecessary SrF$_2$ mask was removed. Again, since Au was exposed in the p-side electrode surface, it was not deteriorated at all. The structure manufactured so far substantially corresponds to FIG. 5-9.

Next, over the whole wafer were sequentially formed SiO$_x$ and SiN$_x$ by p-CVD to form a dielectric multilayer film. Here, each of SiN$_x$ and SiO$_x$ was formed one by one to a thickness that is 1/4 as an optical wavelength to an emission wavelength of the element, so that it had a relatively higher reflectance to the emission wavelength. The structure manufactured so far substantially corresponds to FIG. 5-10.

Then, a resist mask was formed using photolithography technique for simultaneously forming a p-side electrode exposed part on the p-side electrode 27 made of Ni-Au, forming an n-side current injection region (36) on the n-side contact layer 24c and removing portion of an insulating layer present near the substrate 21 on the sidewall of the undoped buffer layer within the light-emitting-element separation-trench. Next, a hydrofluoric acid containing etchant was used to remove the dielectric multilayer film (the insulating layer) which was not covered by the resist mask. Further, by the effect of side etching by hydrofluoric acid, the dielectric multilayer film (insulating layer) on the part of the sidewall of the undoped buffer layer 22 was also removed. Here, the periphery of the p-side electrode 27 was covered by the insulating layer consisting of $SiN_x$ and $SiO_x$ to 150 $\mu$m.

Subsequently, the used unnecessary resist mask was removed by acetone and by ashing with oxygen plasma by RIE. Again, since Au was exposed in the p-side electrode surface, it was not deteriorated at all after the $SiN_x$ deposition process by p-CVD. The structure manufactured so far substantially corresponds to FIG. 5-11.

Next, for forming an n-side electrode 28, photolithography was used to prepare for patterning an n-side electrode by lift-off technique and a resist pattern was formed. Here, Ti(thickness: 20 nm)/Al(thickness: 300 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its periphery contacted the insulating layer by 30 $\mu$m for having an area larger than the n-side current injection region and such that it did not overlap the p-side electrode 27, considering facilitation of flip chip bonding using a metal solder and heat dissipating properties. In another manufacturing example, it was formed so as to contact by 10 $\mu$m, and a light-emitting-element exhibiting performance comparable to this example was manufactured. An Al electrode tends to be deteriorated during, for example, a plasma process and is etched by, for example, hydrofluoric acid, but since the n-side electrode was formed in the final step of the element manufacturing process, it was not damaged at all. The structure manufactured so far substantially corresponds to FIG. 5-12.

As preparation for delaminating the substrate, an AlN substrate was prepared as a support 40, on the surface of which was formed a metal interconnection (a metal layer 41) having a stacked structure of Ti/Pt/Au. To the support was bonded the whole wafer (substrate 21) including so-far-manufactured light-emitting-element, using an AuSn solder. In the bonding, the support 40 and the wafer (the substrate 21) having light-emitting-elements were heated at 300 °C to fusion-bond a p-side electrode and an n-side electrode to designed metal interconnections on the support, respectively, using an AuSn solder. Here, no defects such as unintended short circuit occurred in the element.

Then, for delaminating the substrate, a laser beam outgoing from a KrF excimer laser (wavelength: 248 nm) was irradiated from the surface of the substrate 21 in which thin-film crystal growth had not been conducted, to delaminate the substrate (i.e. laser debonding). Then, Ga metal generated by decomposition of a part of the GaN buffer layer into nitrogen and metal Ga was removed by wet etching.

Finally, for dividing individual light-emitting-elements, the separation region within the support and the light-emitting-element separation-trench within the wafer were simultaneously cut using a dicing saw. Here, since, for example, a metal interconnection is not present in the element separation region within the support, no defects such as unintended interconnection peeling occurred. Thus, a compound semiconductor light-emitting-element shown in FIG. 5-15 was provided.

Examples E-2

The procedure in Example E-1 was repeated, except that after depositing the buffer layer 22, a thin-film crystal layer was deposited as described below. Specifically, a buffer layer 22 was formed as described in Example E-1, and then a Si-doped (Si concentration: $5 \times 10^{18}$ cm$^{-3}$) GaN layer was formed to 4 $\mu$m as a first-conductivity-type (n-type) second cladding layer 24b; a Si-doped (Si concentration: $8 \times 10^{18}$ cm$^{-3}$) GaN layer was formed to 0.5 $\mu$m as a first-conductivity-type (n-type) contact layer 24c; and then a Si-doped (Si concentration: $5.0 \times 10^{18}$ cm$^{-3}$) $Al_{0.10}Ga_{0.90}N$ layer was formed to 0.1 $\mu$m as a first-conductivity-type (n-type) first cladding layer 24a. Then, an active layer structure 25 were formed by depositing alternately undoped GaN layer to a thickness of 13 nm at 850 °C as a barrier layer and undoped $In_{0.1}Ga_{0.9}N$ layer to a thickness of 2 nm at 720 °C as a quantum well layer such that eight quantum well layers were formed in total and both sides were the barrier layers. Then, after increasing a growth temperature to 1025 °C, a Mg-doped (Mg concentration $5 \times 10^{19}$ cm$^{-3}$) $Al_{0.10}Ga_{0.90}N$ was formed to 0.1 $\mu$m as a second-conductivity-type (p-type) first cladding layer 26a. Subsequently, a Mg-doped (Mg concentration: $5 \times 10^{19}$ cm$^{-3}$) GaN was formed to 0.07 $\mu$m as a second-conductivity-type (p-type) second cladding layer 26b. Finally, a Mg-doped (Mg concentration: $1 \times 10^{20}$ cm$^{-3}$) GaN was formed to 0.03 $\mu$m as a second-conductivity-type (p-type) contact layer 26c. The subsequent process was conducted as described in Example E-1, to provide the light-emitting-element shown in FIG. 5-15. Here, no defects such as unintended short circuit occurred in the elements.

In the processes in Examples E-1 and 2, the $SiN_x$ mask was removed after the first etching step, but the $SiN_x$ mask may not be removed and can be removed after the second etching step.

Furthermore, in Examples E-1 and E-2, the etching in the second etching step can be stopped in the intermediate portion of the buffer layer, to provide the light-emitting-element shown in FIG. 5-2 (wherein the insulating film is a multilayer dielectric film). The elements can be separated by cutting the element separation region in the support, together with the buffer layer in the bottom of the light-emitting-element separation-trench.

Furthermore, the light-emitting-element shown in FIG. 5-3A (wherein the insulating film was a multilayer dielectric film) can be provided by, in Examples E-1 and E-2, stopping the etching in the second etching step in the intermediate portion of the buffer layer and further preparing an appropriate etching mask shape by photolithography suitable for a predetermined shape and forming a scribe region without allowing side etching of the insulating film to proceed, for example, leaving a portion of the insulating layer in the trench bottom surface such that a width of the scribe region becomes 100 $\mu$m (Lws in the element is 50 $\mu$m after the separation).

Example E-3

The light-emitting-element shown in FIG. 5-16 was manufactured as follows. First was prepared a c+ plane sapphire substrate 21 with a thickness of 430 $\mu$m, on which an undoped GaN layer with a thickness of 20 nm was formed by growing at a low temperature by MOCVD as a first buffer layer 22a and then an undoped GaN layer with a thickness of 3 $\mu$m was formed at 1040 °C as a second buffer layer 22b.

Then, a Si-doped (Si concentration: $1\times10^{18}$ cm$^{-3}$) GaN layer was formed to 2 $\mu$m as a first-conductivity-type (n-type) second cladding layer 24b; a Si-doped (Si concentration: $2\times10^{18}$ cm$^{-3}$) GaN layer was formed to 0.5 $\mu$m as a first-conductivity-type (n-type) contact layer 24c; and then a Si-doped (Si concentration: $1.5\times10^{18}$ cm$^{-3}$) Al$_{0.15}$Ga$_{0.85}$N layer was formed to 0.1 $\mu$m as a first-conductivity-type (n-type) first cladding layer 24a.

Then, an active layer structure 25 was formed by depositing alternately undoped GaN layer to a thickness of 13 nm at 850 °C as a barrier layer and undoped In$_{0.13}$Ga$_{0.87}$N layer to a thickness of 2 nm at 715 °C as a quantum well layer such that three quantum well layers were formed in total and both sides were the barrier layers.

Then, after increasing a growth temperature to 1025 °C, a Mg-doped (Mg concentration $5\times10^{19}$ cm$^{-3}$) Al$_{0.15}$Ga$_{0.85}$N layer was formed to 0.1 $\mu$m as a second-conductivity-type (p-type) first cladding layer 26a. Subsequently, a Mg-doped (Mg concentration: $5\times10^{19}$ cm$^{-3}$) GaN layer was formed to 0.05 $\mu$m as a second-conductivity-type (p-type) second cladding layer 26b. Finally, a Mg-doped (Mg concentration: $1\times10^{20}$ cm$^{-3}$) GaN layer was formed to 0.02 $\mu$m as a second-conductivity-type (p-type) contact layer 26c.

Then, after gradually lowering the temperature of the MOCVD growth furnace, the wafer was taken out and thus thin-film crystal growth was completed.

For forming a p-side electrode 27 in the wafer after the thin-film crystal growth, photolithography was used to prepare for patterning a p-side electrode by lift-off technique and a resist pattern was formed. Here, Pd(thickness: 20 nm)/Au(thickness: 1000 nm) was deposited by vacuum evaporation as a p-side electrode, and an unnecessary part was removed in acetone by lift-off technique. Then, after heating, a p-side electrode 27 was prepared. So far, there was not a step causing a damage such as a plasma process in the p-side current injection region just under the p-side electrode.

Next, for conducting a second etching step of forming a light-emitting-element separation-trench, a SrF$_2$ mask was formed over the whole wafer surface using vacuum evaporation. Then, the SrF$_2$ film in the region where a light-emitting-element separation-trench was to be formed was removed to form a separation etching mask, that is, an etching mask for conducting the second etching step.

Then, as the second etching step, were etched all the thin-film crystal layers, that is, the p-GaN contact layer 26c, the p-GaN second cladding layer 26b, the p-AlGaN first cladding layer 26a, the active layer structure 25 consisting of the InGaN quantum well layer and the GaN barrier layer, the n-AlGaN first cladding layer 24a, the n-GaN contact layer 24c, the n-GaN second cladding layer 24b and the undoped GaN buffer layer 22 in the part corresponding to the light-emitting-element separation-trench by ICP etching using Cl$_2$ gas. During the second etching step, the SrF$_2$ mask was substantially not etched.

After forming the light-emitting-element separation-trench 13 by the second etching step, the used unnecessary SrF$_2$ mask was removed. Again, since Au was exposed in the p-side electrode surface, it was not deteriorated at all.

Subsequently, a mask for etching was formed to conduct a first etching step for exposing the first-conductivity-type contact layer as preparation before forming a first-conductivity-type-side electrode. Here, SiN$_x$ was deposited to 0.4 $\mu$m over the whole wafer surface at a substrate temperature of 400 ° C by p-CVD. Here, since Au was exposed in the p-side electrode surface, it was not deteriorated at all after the SiN$_x$ deposition process by p-CVD. Then, a photolithography process was again conducted for patterning the SiN$_x$ layer to prepare a SiN$_x$ etching mask. Here, the unnecessary part in the SiN$_x$ film was etched using SF$_6$ plasma by RIE, and a part where the thin-film crystal layer was not etched in the first etching step described later was left, while the SiN$_x$ film was removed in the part corresponding to the part of the thin-film crystal layer to be etched.

Next, as the first etching step, ICP plasma etching was conducted using Cl$_2$ gas for etching through the p-GaN contact layer 26c, the p-GaN second cladding layer 26b, the p-AlGaN first cladding layer 26a, the active layer structure 25 consisting of an InGaN quantum well layer and a GaN barrier layer and the n-AlGaN first cladding layer 24a to the intermediate portion of the n-GaN contact layer 24c, to expose the n-type contact layer which was to be an injection part for n-type carriers.

After the ICP plasma etching, the SiN$_x$ mask was completely removed by RIE using SF$_6$ gas. Again, since Au was exposed in the p-side electrode surface, it was not deteriorated at all after the process.

Then, SiN$_x$ was formed over the whole wafer surface to 125 nm thickness as an insulating layer 30 by p-CVD.

Then, a resist mask was formed using photolithography technique for simultaneously forming a p-side electrode exposed part on the p-side electrode 27 made of Pd-Au, forming an n-side current injection region (36) on the n-side contact layer 24c and removing portion of an insulating layer present near the substrate 21 on the sidewall of the undoped buffer layer within the light-emitting-element separation-trench. Next, a hydrofluoric acid containing etchant was used to remove the dielectric multilayer film (the insulating layer) which was not covered by the resist mask. Further, by the effect of side etching by hydrofluoric acid, the dielectric multilayer film (insulating layer) on the part of the sidewall of the undoped buffer layer 22 was also removed. Here, the periphery of the p-side electrode 27 was covered by the insulating layer consisting of SiN$_x$ and SiO$_x$ to 150 μm. Furthermore, the sidewall of the thin-film crystal layer and so on was covered by an insulating layer, except the n-side current injection region.

Subsequently, the unnecessary resist mask was removed by acetone and by ashing with oxygen plasma by RIE. Again, since Au was exposed in the p-side electrode surface, it was not deteriorated at all.

Next, for forming an n-side electrode 28, photolithography was used to prepare for patterning an n-side electrode by lift-off technique and a resist pattern was formed. Here, Ti(thickness: 20 nm)/Al(thickness: 1500 nm) was deposited over the whole wafer surface by vacuum evaporation as an n-side electrode, and an unnecessary part was removed in acetone by lift-off technique. Then, after heating, an n-side electrode was prepared. The n-side electrode was formed such that its area was larger than the n-side current injection region and such that it does not overlap the p-side electrode, considering facilitation of flip chip bonding using a metal solder and heat dissipating properties. An Al electrode tends to be deteriorated during, for example, a plasma process and is etched by, for example, hydrofluoric acid, but since the n-side electrode was formed in the final step of the element manufacturing process, it was not damaged at all.

As preparation for delaminating the substrate, an AlN substrate was prepared as a support 40, on the surface of which was formed a metal interconnection (a metal layer 41) having a stacked structure of Ti/Pt/Au. To the support was bonded the whole wafer (substrate 21) including so-far-manufactured light-emitting-element, using an AuSn solder. In the bonding, the support 40 and the wafer (the substrate 21) having light-emitting-elements were heated at 300 °C to fusion-bond a p-side electrode and an n-side electrode to designed metal interconnections on the support, respectively, using an AuSn solder. Here, no defects such as unintended short circuit occurred in the element.

Then, for delaminating the substrate, a laser beam outgoing from a KrF excimer laser (wavelength: 248 nm) was irradiated from the surface of the substrate 21 in which thin-film crystal growth had not been conducted, to delaminate the substrate (i.e. laser debonding). Then, Ga metal generated by decomposition of a part of the GaN buffer layer into nitrogen and metal Ga was removed by wet etching.

Finally, for dividing individual light-emitting-elements, the separation region within the support and the light-emitting-element separation-trench within the wafer were simultaneously cut using a dicing saw. Here, since, for example, a metal interconnection is not present in the element separation region within the support, no defects such as unintended interconnection peeling occurred. Thus, a compound semiconductor light-emitting-element shown in FIG. 5-16 was provided.

<u>Industrial Applicability</u>

According to the present invention, there is provided a flip-chip mount type semiconductor light-emitting-element capable of emitting blue or ultraviolet light with higher output and higher efficiency.

**Claims**

1. A compound semiconductor light-emitting-element comprising, on a substrate transparent to an emission wavelength, a compound semiconductor thin-film crystal layer having a first-conductivity-type semiconductor layer containing a first-conductivity-type cladding layer, an active layer structure and a second-conductivity-type semiconductor layer containing a second-conductivity-type cladding layer; a second-conductivity-type-side electrode; and a first-conductivity-type-side electrode, in which a main light-extraction direction is the side of the substrate, wherein:

   the first-conductivity-type-side electrode and the second-conductivity-type-side electrode are not spatially overlapped and are formed on the opposite side to the main light-extraction direction;
   the light-emitting-element comprises a light-uniforming layer, for improving uniformity of a light outgoing from a light-extraction-face, between the substrate and the first-conductivity-type semiconductor layer, and optionally a buffer layer between the substrate and the light-uniforming layer;
   at the edge of the light-emitting-element, sidewalls of at least the first-conductivity-type semiconductor layer, the active layer structure and the second-conductivity-type semiconductor layer form a setback-sidewall-surface which recedes from the edge of the substrate on a sidewall surface of the thin-film crystal layer; and

the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) at least, covering the setback-sidewall-surface at a position distant from the light-emitting-element edge.

2. The light-emitting-element according to claim 1, having, in relation to the setback-sidewall-surface of the thin-film crystal layer, a configuration

(i) where a part of the light-uniforming layer forms a setback-sidewall-surface in combination and forms an edge-step-face with a non-setback-sidewall-surface which has not receded in the light-uniforming layer, or
(ii) where parts of the light-uniforming layer and of the buffer layer form a setback-sidewall-surface in combination and forms an edge-step-face with a non-setback-sidewall-surface which has not receded in the buffer layer, or
(iii) where the whole of the light-uniforming layer and of the buffer layer have receded and the exposed part of the substrate forms an edge-step-face; and
wherein the insulating film covers the edge-step-face from a position distant from the light-emitting-element edge, and the surface in line with the setback-sidewall-surface in the first-conductivity-type semiconductor layer.

3. The light-emitting-element according to claim 1, having, in relation to the setback-sidewall-surface of the thin-film crystal layer, a configuration

(i) where a part of the light-uniforming layer forms a setback-sidewall-surface in combination and forms an edge-step-face with a non-setback-sidewall-surface which has not receded in the light-uniforming layer, or
(ii) where parts of the light-uniforming layer and of the buffer layer form a setback-sidewall-surface in combination and forms an edge-step-face with a non-setback-sidewall-surface which has not receded in the buffer layer, or
(iii) where the whole of the light-uniforming layer and of the buffer layer have receded and the exposed part of the substrate forms an edge-step-face; and
wherein the insulating film covers at least a part of the setback-sidewall-surface of the light-uniforming layer and the buffer layer and does not cover the edge-step-face.

4. The light-emitting-element according to any one of claims 1 to 3, wherein the light-uniforming layer is a layer formed between the substrate and the first-conductivity-type cladding layer as a part of the thin-film crystal layer.

5. The light-emitting-element according to any one of claims 1 to 4, wherein when an average refractive index of the substrate is $n_{sb}$ and an average refractive index of the light-uniforming layer is $n_{oc}$ and an average refractive index of the first-conductivity-type semiconductor layer is $n_1$, each at an emission wavelength, the relation:

$$n_{sb} < n_{oc} \text{ and } n_1 < n_{oc}$$

is satisfied.

6. The light-emitting-element according to any one of claims 1 to 5, wherein when an emission wavelength of the light-emitting-element is $\lambda$ (nm), an average refractive index of the substrate is $n_{sb}$ and an average refractive index of the light-uniforming layer is $n_{oc}$, each at an emission wavelength, and a physical thickness of the light-uniforming layer is $t_{oc}$ (nm) and where a relative refractive index difference $\Delta_{(oc\text{-}sb)}$ between the light-uniforming layer and the substrate is defined as:

$$\Delta_{(oc\text{-}sb)} \equiv ((n_{oc})^2 - (n_{sb})^2)/(2 \times (n_{oc})^2),$$

$t_{oc}$ is selected such that the relation:

$$(\sqrt{(2\times\Delta_{(oc\text{-}sb)})}\times n_{oc}\times\pi\times t_{oc})/\lambda\geq\pi/2$$

is satisfied.

7. The light-emitting-element according to any one of claims 1 to 6, wherein when an emission wavelength of the light-emitting-element is $\lambda$ (nm), an average refractive index of the light-uniforming layer at an emission wavelength is $n_{oc}$, an average refractive index of the first-conductivity-type semiconductor layer at an emission wavelength is $n_1$ and a physical thickness of the light-uniforming layer is $t_{oc}$ (nm) and a relative refractive index difference $\Delta_{(oc\text{-}1)}$ between the light-uniforming layer and the first-conductivity-type semiconductor layer is defined as

$$\Delta_{(oc\text{-}1)}\equiv((n_{oc})^2\text{-}(n_1)^2)/(2\times(n_{oc})^2),$$

$t_{oc}$ is selected such that the relation:

$$(\sqrt{(2\times\Delta_{(oc\text{-}1)})}\times n_{oc}\times\pi\times t_{oc})/\lambda\geq\pi/2$$

is satisfied.

8. The light-emitting-element according to any one of claims 1 to 7, wherein an overall specific resistance of the light-uniforming layer $\rho_{oc}(\Omega\cdot cm)$ satisfies the relation:

$$0.5\leq\rho_{oc}\quad.$$

9. The light-emitting-element according to any one of claims 1 to 8, wherein the light-uniforming layer has a stacked structure consisting of multiple layers.

10. The light-emitting-element according to any one of claims 1 to 9, wherein the narrowest width $L_{1w}$ of a part where the first-conductivity-type-side electrode is contacting the insulating layer is 5 $\mu$m or more.

11. The light-emitting-element according to any one of claims 1 to 10, wherein the narrowest width $L_{2w}$ of a part where the second-conductivity-type-side electrode is covered by the insulating layer is 15 $\mu$m or more.

12. The light-emitting-element according to claim 11, wherein the $L_{2w}$ is 100 $\mu$m or more.

13. The light-emitting-element according to any one of claims 1 to 12, wherein the narrowest width $L_{ws}$ of an end-face-part on the substrate surface exposed by recession of the sidewall surface of the thin-film crystal layer and uncovered by the insulating layer is 15 $\mu$m or more.

14. The light-emitting-element according to any one of claims 1 to 13, wherein the first-conductivity-type-side electrode comprises a layer made of material containing an element selected from the group consisting of Ti, Al, Ag, Mo and a combination of two or more of these.

15. The light-emitting-element according to any one of claims 1 to 14, wherein the second-conductivity-type-side electrode comprises a layer made of material containing an element selected from the group consisting of Ni, Pt, Pd, Mo, Au and a combination of two or more of these.

16. The light-emitting-element according to any one of claims 1 to 15, wherein the insulating layer is a single layer of material selected from the group consisting of $SiO_x$, $AlO_x$, $TiO_x$, TaOx, $HfO_x$, ZrOx, $SiN_x$, $AlN_x$, $AlF_x$, $BaF_x$, $CaF_x$, $SrF_x$ and $MgF_x$.

17. The light-emitting-element according to any one of claims 1 to 15, wherein the insulating layer is a dielectric multilayer film consisting of multiple layers.

18. The light-emitting-element according to claim 17, wherein at least one of the layers constituting the insulating layer is made of material containing fluoride.

19. The light-emitting-element according to claim 18, wherein the fluoride is selected from the group consisting of $AlF_x$, $BaF_x$, $CaF_x$, $SrF_x$ and $MgF_x$.

20. The light-emitting-element according to any one of claims 1 to 19, wherein when R2 is a reflectance of reflection by the light-uniforming layer, of a light having an emission wavelength of the light-emitting-element vertically incoming from the first-conductivity-type semiconductor layer side to the light-uniforming layer, R12 is a reflectance of reflection by the insulating layer, of a light having an emission wavelength of the light-emitting-element vertically incoming from the second-conductivity-type semiconductor layer side to the insulating layer, R11 is a reflectance of reflection by the insulating layer, of a light having an emission wavelength of the light-emitting-element vertically incoming from the first-conductivity-type semiconductor layer side to the insulating layer and R1q is a reflectance of reflection by the insulating layer, of a light having an emission wavelength of the light-emitting-element vertically incoming from the active layer structure side to the insulating layer, the insulating layer is configured such that all of the conditions:

    (Relation 1) R2 < R12
    (Relation 2) R2 < R11
    (Relation 3) R2 < R1q

are satisfied.

21. The light-emitting-element according to any one of claims 1 to 20, wherein the substrate is selected from the group consisting of sapphire, SiC, GaN, $LiGaO_2$ ZnO, $ScAlMgO_4$, $NdGaO_3$ and MgO.

22. The light-emitting-element according to any one of claims 1 to 21, wherein the surface of the light-extraction side of the substrate is not flat.

23. The light-emitting-element according to any one of claims 1 to 22, wherein when R3 is a reflectance of reflection by the substrate, of a light having an emission wavelength of the light-emitting-element vertically incoming from the light-uniforming layer to the substrate side and R4 is a reflectance of reflection by an interface with a space, of a light having an emission wavelength of the light-emitting-element vertically incoming from the substrate to the space of the light-extraction side, a low-reflecting optical film is formed in the light-extraction side of the substrate such that the relation:

    R4 < R3

is satisfied.

24. The light-emitting-element according to any one of claims 1 to 23, wherein the compound semiconductor thin-film crystal layer is made of a Group III-V compound semiconductor containing nitrogen as a Group V atom, and the first-conductivity-type cladding layer, the active layer structure and the second-conductivity-type cladding layer contains an element selected from the group consisting of In, Ga and Al.

25. The light-emitting-element according to any one of claims 1 to 24, wherein the active layer structure consists of quantum well layer and barrier layer and when B is the number of the barrier layer and W is the number of the quantum well layer, B and W satisfy the relation:

$$B = W+1.$$

26. The light-emitting-element according to any one of claims 1 to 25, wherein the first-conductivity-type is n-type and the second-conductivity-type is p-type.

27. The light-emitting-element according to any one of claims 1 to 25, wherein the first-conductivity-type-side electrode and the second-conductivity-type-side electrode are bonded to a submount having a metal layer via a solder.

28. A compound semiconductor light-emitting-element comprising a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer in this order; a second-conductivity-type-side electrode; and a first-conductivity-type-side electrode, in which a main light-extraction direction is a buffer layer side in relation to the active layer structure, wherein:

the first-conductivity-type-side electrode and the second-conductivity-type-side electrode are not spatially overlapped and are formed on the opposite side to the main light-extraction direction;

the light-emitting-element comprises a light-uniforming layer, for improving uniformity of a light outgoing from a light-extraction-face, between the buffer layer and the first-conductivity-type semiconductor layer;

at the edge of the light-emitting-element, sidewalls of at least the first-conductivity-type semiconductor layer, the active layer structure and the second-conductivity-type semiconductor layer form a setback-sidewall-surface, which has receded when forming a light-emitting-element separation-trench in a manufacturing process, on a sidewall surfaces of the thin-film crystal layers;

the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) in relation to the setback-sidewall-surface of the thin-film crystal layer,

(i) if a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer,
at least, the insulating layer being formed from a position distant from the light-emitting-element edge, or
(ii) if the light-uniforming layer and the buffer layer form a setback-sidewall-surface in combination and an edge-step-face is not present,
the insulating layer being not formed at least on the part of the buffer layer at the side of main light-extraction direction but covering the setback-sidewall-surface from the intermediate portion of the buffer layer or the light-uniforming layer; and

the light-emitting-element further comprises a support supporting the light-emitting-element, to which the first-conductivity-type-side electrode and the second-conductivity-type-side electrode are connected.

29. The light-emitting-element according to claim 28, having, in relation to the setback-sidewall-surface of the thin-film crystal layer, a configuration

(ii) where the light-uniforming layer and the buffer layer form a setback-sidewall-surface in combination and an edge-step-face is not present,
the insulating layer being not formed at least on the part of the buffer layer at the side of main light-extraction direction but covering the setback-sidewall-surface from the intermediate portion of the buffer layer or the light-uniforming layer.

30. The light-emitting-element according to claim 28, having, in relation to the setback-sidewall-surface of the thin-film crystal layer, a configuration

(i) where a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer,
the insulating layer being formed from a position distant from the light-emitting-element edge, and
wherein the insulating film covers at least a part of the setback-sidewall-surface of the light-uniforming layer and the buffer layer and does not cover the edge-step-face.

31. The light-emitting-element according to claim 28, having, in relation to the setback-sidewall-surface of the thin-film crystal layer, a configuration

(i) where a part of the light-uniforming layer, or the whole part of the light-uniforming layer and a part of the buffer layer forms a setback-sidewall-surface in combination and forms an edge-step-face with the non-setback-sidewall-surface which has not receded in the light-uniforming layer or the buffer layer, the insulating layer being formed from a position distant from the light-emitting-element edge, and wherein the insulating film covers the edge-step-face from a position distant from the light-emitting-element edge, and the surface in line with the setback-sidewall-surface in the first-conductivity-type semiconductor layer.

32. A process for manufacturing a light-emitting-element, comprising

step (a): depositing a buffer layer and a light-uniforming layer on a substrate in this order;
step (b): depositing a thin-film crystal layer having at least a first-conductivity-type semiconductor layer containing a first-conductivity-type cladding layer, an active layer structure and a second-conductivity-type semiconductor layer containing a second-conductivity-type cladding layer, in this order from the side of the substrate;
step (c): forming a second-conductivity-type-side electrode on the surface of the second-conductivity-type semiconductor layer;
first etching step (d): etching a part of the region where the second-conductivity-type-side electrode is not formed, to expose a part of the first-conductivity-type semiconductor layer;
second etching step (e): for forming a light-emitting-element separation-trench separating adjacent light-emitting-elements, etching a part of the region where the second-conductivity-type-side electrode is not formed, from its surface, to such a depth (i) that at least a part of the light-uniforming layer is removed, (ii) that at least a part of the buffer layer is removed, or (iii) that the etching reaches at least the substrate, whereby forming the light-emitting-element separation-trench;
step (f): forming an insulating layer on the whole surface including the second-conductivity-type-side electrode, the first-conductivity-type semiconductor layer exposed by the first etching step and the inside of the light-emitting-element separation-trench;
step (g): removing the insulating layer in a region including at least the trench center of the trench bottom surface in the light-emitting-element separation-trench,
step (h): removing a part of the insulating layer formed on the first-conductivity-type semiconductor layer to form an opening to be a first current injection region,
step (i): removing a part of the insulating layer formed on the surface of the second-conductivity-type-side electrode to expose a part of the second-conductivity-type-side electrode, and
step (j): forming a first-conductivity-type-side electrode in contact with the first current injection region opened in step (h).

33. The process according to claim 32, wherein step (g) comprises removing the insulating layer in the region including only the trench center on the trench bottom surface in the light-emitting-element separation-trench, while leaving the insulating layer formed in the sidewall of the light-emitting-element separation-trench.

34. The process according to claim 32, wherein step (g) comprises removing the whole insulating layer formed on the trench bottom surface within the light-emitting-element separation-trench and at least a portion near the trench bottom surface, of the insulating layer formed on the sidewall within the light-emitting-element separation-trench.

35. A compound semiconductor light-emitting-element comprising, on a substrate transparent to an emission wavelength, a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer; a second-conductivity-type-side electrode; and a first-conductivity-type-side electrode, in which a main light-extraction direction is the side of the substrate, wherein:

the first-conductivity-type-side electrode and the second-conductivity-type-side electrode are not spatially overlapped and are formed on the opposite side to the main light-extraction direction;
at the edge of the light-emitting-element, sidewalls of at least the first-conductivity-type semiconductor layer, the active layer structure and the second-conductivity-type semiconductor layer form a setback-sidewall-surface which recedes from the edge of the substrate on a sidewall surface of the thin-film crystal layers; and
the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) at least, covering the setback-sidewall-surface at a position distant from the light-emitting-element edge.

36. The light-emitting-element according to claim 35, having, in relation to the setback-sidewall-surface of the thin-film crystal layer, a configuration

(i) where a part of the buffer layer form a setback-sidewall-surface in combination and forms an edge-step-face with a non-setback-sidewall-surface which has not receded in the buffer layer, or
(ii) where the whole of the buffer layer have receded and the exposed part of the substrate forms an edge-step-face; and
wherein the insulating film covers the edge-step-face from a position distant from the light-emitting-element edge, and the surface in line with the setback-sidewall-surface in the first-conductivity-type semiconductor layer.

37. The light-emitting-element according to claim 35, having, in relation to the setback-sidewall-surface of the thin-film crystal layer, a configuration

(i) where a part of the buffer layer form a setback-sidewall-surface in combination and forms an edge-step-face with a non-setback-sidewall-surface which has not receded in the buffer layer, or
(ii) where the whole of the buffer layer have receded and the exposed part of the substrate forms an edge-step-face; and
wherein the insulating film covers at least a part of the setback-sidewall-surface of the buffer layer and does not cover the edge-step-face.

38. A compound semiconductor light-emitting-element comprising a compound semiconductor thin-film crystal layer having a buffer layer, a first-conductivity-type semiconductor layer containing a first-conductivity-type cladding layer, an active layer structure and a second-conductivity-type semiconductor layer containing a second-conductivity-type cladding layer in this order; a second-conductivity-type-side electrode; and a first-conductivity-type-side electrode, in which a main light-extraction direction is a buffer layer side in relation to the active layer structure, wherein:

the first-conductivity-type-side electrode and the second-conductivity-type-side electrode are not spatially overlapped and are formed on the opposite side to the main light-extraction direction;
the light-emitting-element comprises a support supporting the light-emitting-element, to which the first-conductivity-type-side electrode and the second-conductivity-type-side electrode are connected;
at the edge of the light-emitting-element, sidewalls of at least the first-conductivity-type semiconductor layer, the active layer structure and the second-conductivity-type semiconductor layer form a setback-sidewall-surface, which has receded when forming a light-emitting-element separation-trench in a manufacturing process, on a sidewall surfaces of the thin-film crystal layers;
the light-emitting-element comprises an insulating layer at least covering the setback-sidewall-surface of the first-conductivity-type semiconductor layer, the active layer structure and the second-conductivity-type semiconductor layer; the insulating layer (a) being in contact with a part of the first-conductivity-type-side electrode at the side of the main light-extraction direction and covering a part of the second-conductivity-type-side electrode on the side opposite to the main light-extraction direction and (b) in relation to the setback-sidewall-surface of the thin-film crystal layer,

(i) if a part of the buffer layer form a setback-sidewall-surface in combination and forms an edge-step-face with the non-setback-sidewall-surface which has not receded in the buffer layer,
at least, the insulating layer being formed from a position distant from the light-emitting-element edge, or
(ii) if the buffer layer form a setback-sidewall-surface in combination and an edge-step-face is not formed, the insulating layer being not formed at least on the part of the buffer layer at the side of main light-extraction direction but covering the setback-sidewall-surface from the intermediate portion of the buffer layer or the light-uniforming layer,

39. The light-emitting-element according to claim 38, having, in relation to the setback-sidewall-surface of the thin-film crystal layer, a configuration

(ii) where the buffer layer form a setback-sidewall-surface in combination and an edge-step-face is not present,

the insulating layer being not formed at least on the part of the buffer layer at the side of main light-extraction direction but covering the setback-sidewall-surface from the intermediate portion of the buffer layer.

40. The light-emitting-element according to claim 38, having, in relation to the setback-sidewall-surface of the thin-film crystal layer, a configuration

    (i) where a part of the buffer layer forms a setback-sidewall-surface in combination and forms an edge-step-face with the non-setback-sidewall-surface which has not receded in the buffer layer,
    the insulating layer being formed from a position distant from the light-emitting-element edge, and
    wherein the insulating film covers at least a part of the setback-sidewall-surface of the buffer layer and does not cover the edge-step-face.

41. The light-emitting-element according to claim 38, having, in relation to the setback-sidewall-surface of the thin-film crystal layer, a configuration

    (i) where a part of the buffer layer forms a setback-sidewall-surface in combination and forms an edge-step-face with the non-setback-sidewall-surface which has not receded in the buffer layer,
    the insulating layer being formed from a position distant from the light-emitting-element edge, and
    wherein the insulating film covers the edge-step-face from a position distant from the light-emitting-element edge, and the surface in line with the setback-sidewall-surface in the first-conductivity-type semiconductor layer.

42. A process for manufacturing a light-emitting-element, comprising
    step (a): depositing a buffer layer on a substrate;
    step (b): depositing a thin-film crystal layer having at least a first-conductivity-type semiconductor layer containing a first-conductivity-type cladding layer, an active layer structure and a second-conductivity-type semiconductor layer containing a second-conductivity-type cladding layer, in this order from the side of the substrate;
    step (c): forming a second-conductivity-type-side electrode on the surface of the second-conductivity-type semiconductor layer;
    first etching step (d): etching a part of the region where the second-conductivity-type-side electrode is not formed, to expose a part of the first-conductivity-type semiconductor layer;
    second etching step (e): for forming a light-emitting-element separation-trench separating adjacent light-emitting-elements, etching a part of the region where the second-conductivity-type-side electrode is not formed, from its surface, to such a depth (i) that at least a part of the buffer layer is removed or (ii) that the etching reaches at least the substrate, whereby forming the light-emitting-element separation-trench;
    step (f): forming an insulating layer on the whole surface including the second-conductivity-type-side electrode, a first-conductivity-type semiconductor layer exposed by the first etching step and the inside of the light-emitting-element separation-trench;
    step (g): removing the insulating layer in a region including at least the trench center of the trench bottom surface in the light-emitting-element separation-trench,
    step (h): removing a part of the insulating layer formed on the first-conductivity-type semiconductor layer to form an opening to be a first current injection region,
    step (i): removing a part of the insulating layer formed on the surface of the second-conductivity-type-side electrode to expose a part of the second-conductivity-type-side electrode, and
    step (j): forming a first-conductivity-type-side electrode in contact with the first current injection region opened in step (h).

43. The process according to claim 42, wherein step (g) comprises removing the insulating layer in the region including only the trench center on the trench bottom surface in the light-emitting-element separation-trench, while leaving the insulating layer formed in the sidewall of the light-emitting-element separation-trench.

44. The process according to claim 42, wherein step (g) comprises removing the whole insulating layer formed on the trench bottom surface within the light-emitting-element separation-trench and at least a portion near the trench bottom surface, of the insulating layer formed on the sidewall within the light-emitting-element separation-trench.

FIG. 1-1A

FIG. 1-1B

Main light-extraction direction
⇑

21  $L_{WS}$

A

22

30

23

24

B

25

26

28

27

C

$L_{1w}$

$L_{2w}$

EP 2 023 412 A1

103

FIG. 1-1C

FIG. 1-1D

EP 2 023 412 A1

50a

55   21   A

22

30   23   55

24

25

26   30

27   28

42   42

40   41

FIG. 1-2A

FIG. 1-2B

Main light-extraction direction

⇑

FIG. 1-2C

50a

A

55

15

30

28

42

41

21

22

23

24

25

26

27

40

42

55

30

10

EP 2 023 412 A1

FIG. 1-2D

FIG. 1-2E

FIG. 1-3A

Main light-extraction direction

10
Light-emitting-element

14 Scribe region

EP 2 023 412 A1

FIG. 1-3B

Main light-extraction direction

10
Light-emitting-element

EP 2 023 412 A1

FIG. 1-4

## Active layer structure

| Barrier layer |
| --- |
| Quantum well layer |
| Barrier layer |
| Quantum well layer |
| Barrier layer |
| Quantum well layer |
| Barrier layer |
| Quantum well layer |
| Barrier layer |
| Quantum well layer |
| Barrier layer |

FIG. 1-5

27 Second-conductivity-type-side electrode

26 Second-conductivity-type cladding layer

25 Active layer structure

First-conductivity-type cladding layer 24

Light-uniforming layer 23

Buffer layer 22

Substrate 21

EP 2 023 412 A1

FIG. 1-6

Active layer structure 25   27 Second-conductivity-type-side electrode

26 Second-conductivity-type
cladding layer

First-conductivity-type cladding layer 24

Light-uniforming layer 23

Buffer layer 22

Substrate 21

EP 2 023 412 A1

FIG. 1-7

EP 2 023 412 A1

FIG. 1-8

FIG. 1-9A

EP 2 023 412 A1

FIG. 1-9B

FIG. 1-10

FIG. 1-11

45  Low-reflecting optical film

22a

22b                    21

24b                    23            30  Insulating layer
24c                                      (dielectric multilayer film)
24a
25
26a
26b                                  28
26c
                                     42
27                                   41

40  Submount

EP 2 023 412 A1

FIG. 1-12

EP 2 023 412 A1

FIG. 1-13

(a)

(b)

FIG. 1-14

FIG. 1-15

45 Low-reflecting optical film

30 Insulating layer (dielectric multilayer film)

FIG. 1-16

FIG. 2-1A

Main light-extraction direction

Light-emitting-element 10

50b Light-extraction-face

A

15 Region without an insulating layer

B

30 Insulating layer

28 First-conductivity-type-side electrode

42 Metal solder

41 Metal layer

Insulating layer 30

Buffer layer 22

Light-uniforming layer 23

First-conductivity-type cladding layer 24

Active layer structure 25

Second-conductivity-type cladding layer 26

Second current injection region 35

Second-conductivity-type-side electrode 27

C

42 Metal solder

Support 40

FIG. 2-1B

Main light-extraction direction

FIG. 2-2A

FIG. 2-2B

EP 2 023 412 A1

FIG. 2-2C

FIG. 2-3A

FIG. 2-3B

FIG. 2-3C

FIG. 2-4A

FIG. 2-4B

10
Light-emitting-element

EP 2 023 412 A1

FIG. 2-4C

10
Light-emitting-element

EP 2 023 412 A1

FIG. 2-5

Main light-extraction direction

EP 2 023 412 A1

FIG. 2-7

27 Second-conductivity-type-side electrode

26 Second-conductivity-type
cladding layer

25 Active layer structure

First-conductivity-type cladding layer 24

Light-uniforming layer 23

Buffer layer 22

Substrate  21

FIG. 2-8

Active layer structure 25   27 Second-conductivity-type-side electrode

26 Second-conductivity-type
cladding layer

First-conductivity-type cladding layer 24

Light-uniforming layer 23

Buffer layer 22

Substrate  21

FIG. 2-9

FIG. 2-10

FIG. 2-11

FIG. 2-12

EP 2 023 412 A1

FIG. 2-13

FIG. 2-14

47 Separation region

FIG. 2-15

30 Insulating layer
(dielectric multilayer film)

22a
22b
24b
24c
24a
25
26a
26b
26c
27
23
28
42
41
40

FIG. 2-16

FIG. 2-19

EP 2 023 412 A1

FIG. 3

FIG. 4-1A

Main light-extraction direction

⇑

Light-emitting-element 10

Substrate 21

A

Insulating layer 30

Buffer layer 22

B

36 First current injection region

First-conductivity-type cladding layer 24

30 Insulating layer

Active layer structure 25

Second-conductivity-type cladding layer 26

28 First-conductivity-type-side electrode

Second current injection region 35

Second-conductivity-type-side electrode 27

42 Metal solder

C

42 Metal solder

Submount 40

41 Metal layer

EP 2 023 412 A1

FIG. 4-1B

Main light-extraction direction

⇑

Second-conductivity-type-side electrode exposed part 37

EP 2 023 412 A1

FIG. 4-1C

FIG. 4-2A

Main light-extraction direction

⇑

Light-emitting-element  10

Substrate 21 — A

15 Region without an insulating layer

Insulating layer  30

Buffer layer 22

B

36 First current injection region

First-conductivity-type cladding layer 24

30 Insulating layer

Active layer structure 25

Second-conductivity-type cladding layer 26

28 First-conductivity-type-side electrode

Second current injection region  35

Second-conductivity-type-side electrode 27

42 Metal solder

C

42 Metal solder

Support 40

41 Metal layer

EP 2 023 412 A1

FIG. 4-2B

Main light-extraction direction

FIG. 4-2C

FIG. 4-3A

FIG. 4-3B

10
Light-emitting-element

Main light-extraction direction

FIG. 4-5

27 Second-conductivity-type-side electrode

26 Second-conductivity-type cladding layer

25 Active layer structure

First-conductivity-type cladding layer 24

Buffer layer 22

Substrate 21

EP 2 023 412 A1

FIG. 4-6

Active layer structure 25

27 Second-conductivity-type-side electrode

26 Second-conductivity-type cladding layer

First-conductivity-type cladding layer 24

Buffer layer 22

Substrate 21

EP 2 023 412 A1

FIG. 4-7

26

27

25

13

13

24

Buffer layer 22

Substrate 21

FIG. 4-8

FIG. 4-9A

FIG. 4-9B

FIG. 4-10

Buffer layer 22

24

Substrate 21

13 13 25 27 30 26 28 28 28 30 14

EP 2 023 412 A1

FIG. 4-11

45 Low-reflecting optical film

21

22a

22b

24b

24c

24a

25

26a

26b

26c

27

30 Insulating layer
(dielectric multilayer film)

28

42

41

40 Submount

EP 2 023 412 A1

FIG. 4-12

FIG. 4-15

45 Low-reflecting optical film

22a

22b

24b

24c

24a

25

26a

26b

26c

27

21

23

30 Insulating layer
(dielectric multilayer film)

28

42

41

40

FIG. 4-16

24

22

21

EP 2 023 412 A1

FIG. 5-1A

Main light-extraction direction

⇑

Light-emitting-element　10

A

15 Region without an insulating layer

B

Insulating layer 30

Buffer layer 22

First-conductivity-type cladding layer 24

30 Insulating layer

Active layer structure 25

Second-conductivity-type cladding layer 26

28 First-conductivity-type-side electrode

Second-conductivity-type-side electrode 27

42 Metal solder

C

42 Metal solder

Support 40

41 Metal layer

Second-conductivity-type-side electrode
exposed part 37

EP 2 023 412 A1

FIG. 5-1B

Main light-extraction direction

FIG. 5-2

FIG. 5-3A

FIG. 5-3B

FIG. 5-4

Main light-extraction direction

10
Light-emitting-element

FIG. 5-4B

EP 2 023 412 A1

27
30
26
28
25
13
13
37
35
36

$L_{2w}$
$L_{1w}$

24
22
21

14 Scribe region

$L_{WS}$
$L_{WS}$

10
Light-emitting-element

FIG. 5-5

Main light-extraction direction

41 Metal layer

47 Separation region

40 Support

Metal layer 41

47

Separation region

$L_{WSPT2 \, (right)}$

$L_{WSPT2 \, (left)}$

FIG. 5-7

27 Second-conductivity-type-side electrode

26 Second-conductivity-type
cladding layer

25 Active layer structure

First-conductivity-type cladding layer 24

Buffer layer 22

Substrate 21

FIG. 5-8

Active layer structure 25  27 Second-conductivity-type-side electrode

26 Second-conductivity-type
cladding layer

First-conductivity-type cladding layer 24

Buffer layer 22

Substrate  21

EP 2 023 412 A1

FIG. 5-9

FIG. 5-10

EP 2 023 412 A1

13  30  13  25  27  30  26

24

Buffer layer 22

Substrate 21

FIG. 5-11

Substrate 21

Buffer layer 22

24

FIG. 5-12

FIG. 5-13

Substrate 21

22

30

24

25

26

27

28

42

42

41

Support 40

EP 2 023 412 A1

FIG. 5-14

EP 2 023 412 A1

FIG. 5-15

45 Low-reflecting optical film

21

22a

22b

24b

24c

24a

25

26a

26b

26c

27

30 Insulating layer
(dielectric multilayer film)

28

42

41

40

FIG. 5-16

FIG. 5-19

EP 2 023 412 A1

FIG. 6

```
        ┌───────────┐
        │   ( a )   │
        └───────────┘
              │
              ▼
        ┌───────────┐
        │   ( b )   │
        └───────────┘
              │
              ▼
        ┌───────────┐
        │   ( c )   │
        └───────────┘
              │
              ▼
  ┌──────────────────────┐
  │ ┌───────┐  ┌───────┐ │
  │ │ ( d ) │  │ ( e ) │ │
  │ └───────┘  └───────┘ │
  └──────────────────────┘
              │
              ▼
        ┌───────────┐
        │   ( f )   │
        └───────────┘
              │
              ▼
 ┌────────────────────────────┐
 │ ┌─────┐ ┌─────┐ ┌─────┐    │
 │ │( g )│ │( h )│ │( i )│    │
 │ └─────┘ └─────┘ └─────┘    │
 └────────────────────────────┘
              │
              ▼
        ┌───────────┐
        │   ( j )   │
        └───────────┘
```

<table>
<tr><td colspan="2">**INTERNATIONAL SEARCH REPORT**</td><td>International application No.<br>PCT/JP2007/059276</td></tr>
</table>

A. CLASSIFICATION OF SUBJECT MATTER
*H01L33/00*(2006.01)i, *H01L21/3065*(2006.01)i

According to International Patent Classification (IPC) or to both national classification and IPC

B. FIELDS SEARCHED

Minimum documentation searched (classification system followed by classification symbols)
H01L33/00, H01L21/3065

Documentation searched other than minimum documentation to the extent that such documents are included in the fields searched

Jitsuyo Shinan Koho        1922-1996   Jitsuyo Shinan Toroku Koho   1996-2007
Kokai Jitsuyo Shinan Koho  1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2003-023179 A (Ricoh Co., Ltd.), 24 January, 2003 (24.01.03), Full text; all drawings (Family: none) | 1-44 |
| A | JP 2004-006893 A (LumiLeds Lighting U.S., LLC), 08 January, 2004 (08.01.04), Full text; all drawings & US 2002/0190260 A1 | 1-44 |
| A | JP 10-242507 A (Oki Electric Industry Co., Ltd.), 11 September, 1998 (11.09.98), Full text; all drawings (Family: none) | 1-44 |

| ☒ | Further documents are listed in the continuation of Box C. | ☐ | See patent family annex. |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>21 May, 2007 (21.05.07) | Date of mailing of the international search report<br>29 May, 2007 (29.05.07) |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2007/059276

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-347647 A (Sony Corp.), 15 December, 2005 (15.12.05), Full text; all drawings (Family: none) | 1-44 |
| A | JP 08-274376 A (Texas Instruments Inc.), 18 October, 1996 (18.10.96), Full text; all drawings (Family: none) | 1-44 |
| A | JP 01-115174 A (NEC Corp.), 08 May, 1989 (08.05.89), Full text; all drawings (Family: none) | 1-44 |

Form PCT/ISA/210 (continuation of second sheet) (April 2005)

**REFERENCES CITED IN THE DESCRIPTION**

**Patent documents cited in the description**

- JP 3453238 B
- JP 2001127348 A
- JP 2003017757 A
- JP 11251633 A
- JP 2000114595 A